(19) **Europäisches Patentamt / European Patent Office / Office européen des brevets**

(11) **EP 4 199 347 A1**

(12) # EUROPEAN PATENT APPLICATION

(43) Date of publication:
**21.06.2023   Bulletin 2023/25**

(21) Application number: **22214740.7**

(22) Date of filing: **19.12.2022**

(51) International Patent Classification (IPC):
***H02S 40/34*** (2014.01)

(52) Cooperative Patent Classification (CPC):
**H02S 40/34**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.12.2021   US 202163290767 P
17.12.2021   US 202163290983 P
19.01.2022   US 202263300847 P
07.11.2022   US 202263423182 P**

(71) Applicant: **Solaredge Technologies Ltd.
Herzeliya 4673335 (IL)**

(72) Inventors:
- **YOSCOVICH, Ilan
  4673335 Herzeliya (IL)**
- **LOEWENSTERN, Yakir
  4673335 Herzeliya (IL)**
- **GALIN, Yoav
  4673335 Herzeliya (IL)**

(74) Representative: **V.O.
P.O. Box 87930
2508 DH Den Haag (NL)**

(54) **ARRANGEMENTS OF SUBSTRINGS IN PHOTOVOLTAIC MODULES**

(57)    Aspects of the disclosure relate to static configurations and arrangement of substrings of photovoltaic (PV) cell arrays or PV modules to electrically parallelly connect and spatially distribute substrings in PV cell arrays mitigating the partial shade and/or mismatch condition and decrease complexity of PV module production. Further aspects relate to substrings of serially electrically connected PV cells that may be electrically connected in parallel and arranged such that conductor intersection is minimized or substantially eliminated outside of a junction box. Further aspects of the disclosure relate to utilizing rear contact PV cells and conductive backsheets to effectuate electrically parallel connected and spatially distributed substrings.

*FIG. 1A*

## Description

### CROSS-REFERENCE TO RELATED APPLICATIONS

This application claims priority to U.S. Provisional Patent Application No. 63/423,182, filed on November 7, 2022, titled "Arrangements of Substrings in Photovoltaic Modules," and claims priority to U.S. Provisional Patent Application No. 63/300,847, filed on January 19, 2022, titled "Arrangements of Substrings in Photovoltaic Modules," and claims priority to U.S. Provisional Patent Application No. 63/290,767, filed on December 17, 2021, titled "Arrangements of Substrings in a Photovoltaic Module," and claims priority to U.S. Provisional Patent Application No. 63/290,983, filed on December 17, 2021, titled "Arrangements of Substrings in Conductive Backsheet Photovoltaic Modules." The contents of all of the aforementioned applications are incorporated herein by reference in their entirety.

### FIELD

Aspects of the present disclosure relate generally to photovoltaic (PV) modules and installations. In particular, one or more aspects of the disclosure relate to apparatuses, systems, and methods for static arrangements of PV cell substrings in a PV module improving mismatch condition mitigation and apparatuses, systems and methods to improve PV module and PV cell array efficiency.

### BACKGROUND

As the world moves away from non-renewable energy sources, the need for efficient and reliable renewable energy sources grows ever more important. One important renewable energy source is photovoltaic (PV) electrical energy. As a cost effective and clean energy option, photovoltaics are crucial to the shift away from non-renewable energy sources.

However, current PV solutions have their limitations. One major limitation in PV energy production is the mismatch or partial shading condition problem. Currently, in order to get useful power from a PV module, multiple PV cells are connected serially in a string to provide a useful electric potential and current output from the string. However, if one or more PV cells in a series connected string experiences reduced irradiation and reduced current production due to partial or complete shading, the production of the entire series connected string will be reduced and the healthy cells will be forward biased. Further, the forward bias across the productive cells, may reverse bias the reduced cells and the current of the productive PV cells in the string may be dissipated in the reduced cell causing "hot-spots" and possible damage to the PV module.

### BRIEF SUMMARY

Aspects of the present disclosure provide technical solutions that overcome one or more of the technical problems described above and/or other technical challenges. Aspects of the present disclosure additionally relate to improved efficiency and mismatch condition mitigation for photovoltaic (PV) modules and/or PV cell arrays. For instance, one or more aspects of the present disclosure relate to static arrangements, topologies and electrical connections of photovoltaic (PV) cells, substrings, and arrays. Additionally, aspects relate to the use of rear contact PV cells and conductive backsheets to effectuate such PV cell array arrangements and topologies. Further, aspects relate to roof tile PV cell arrays utilizing various aspects of the present disclosure. Aspects herein further relate to the incorporation of power electronics with PV cell arrays to variously improve PV energy generation.

### BRIEF DESCRIPTION OF THE DRAWINGS

Some features of the present disclosure are presented by way of example, and not by way of limitation, in the accompanying drawings. In the drawings, like numerals (for example, numerals which end in the same two number) may reference like elements and in which:

FIG. 1A depicts an example photovoltaic (PV) module and PV cell array in accordance with one or more aspects of the present disclosure as described herein.

FIG. 1B depicts an example electrical schematic of an example of the PV module and PV cell array of FIG. 1A.

FIG. 2A depicts an example PV module and PV cell array with electrically parallel substrings in accordance with one or more aspects of the present disclosure.

FIG. 2B depicts an example electrical schematic of an example of the PV module and PV cell array of FIG. 2A.

FIG. 3A depicts an example PV module and PV cell array with electrically parallel substrings in accordance with one or more aspects of the present disclosure.

FIG. 3B depicts an example electrical schematic of an example of the PV module and PV cell array of FIG. 3A.

FIG. 3C depicts an example PV module and PV cell array with electrically parallel substrings in accordance with one or more aspects of the present disclosure.

FIG. 3D depicts an example electrical schematic of an example of the PV module and PV cell array of FIG. 3C.

FIG. 3E depicts an example PV module and PV cell array according to one or more aspects of the present disclosure.

FIG. 3F depicts an example electrical schematic of an example of the PV module and PV cell array of FIG. 3E.

FIG. 3G depicts an example PV module and PV cell array having an interleaved configuration according to the present disclosure.

FIG. 3H depicts an example electrical schematic of an example of the PV module and PV cell array of FIG 3G.

FIG. 3I depicts the PV module and PV cell array of FIG. 3G in the context of partial shade conditions.

FIG. 3J depicts a PV module and PV cell array having an interleaved configuration according to the present disclosure.

FIG. 3K depicts an example electrical schematic of an example of the PV module and PV cell array of FIG. 3J.

FIG. 3L depicts a PV module and PV cell array having an interleaved configuration according to the present disclosure.

FIG. 3M depicts an example electrical schematic of an example of the PV module and PV cell array of FIG. 3L.

FIG. 4A depicts an example PV module and PV cell array with electrically parallel substrings according to one or more aspects of the present disclosure.

FIG. 4B depicts an example electrical schematic of an example of the PV module and PV cell array of FIG. 4A.

FIG. 5A depicts an example PV module and PV cell array with electrically parallel substrings in accordance with one or more aspects of the present disclosure.

FIG. 5B depicts an example electrical schematic of an example the PV module and PV cell array of FIG. 5A.

FIG. 6A depicts an example PV module with a PV cell array in accordance with one or more aspects of the present disclosure as described herein.

FIG. 6B depicts an example electrical schematic of an example of the PV module and PV cell array of FIG. 6A.

FIG. 7A depicts an example PV module and PV cell array in accordance with one or more aspects of the present disclosure.

FIG. 7B depicts an example electrical schematic of an example of the PV module and PV cell array of FIG. 7A.

FIG. 8 depicts an example two-row substring PV module with a $\frac{1}{2}$ cut PV cell array according to one or more aspects of the present disclosure as described herein.

FIG. 9A depicts an example conductive backsheet of the example distributed PV cell array of FIGS. 10A-10B.

FIG. 9B depicts an example conductive backsheet according to one or more aspects of the present disclosure.

FIG. 9C depicts a cross section of an example conductive backsheet of FIG. 9A having multiple thicknesses.

FIG. 9D depicts a cross section of an example conductive backsheet 901 of FIG. 9A as a PCB type backsheet.

FIG. 10A depicts the electrical interconnectivity of an example 3x3, substring total-cross tied (TCT) distributed PV cell array according to one or more aspects of the present disclosure.

FIG. 10B depicts an example layout of distributed substring of the distributed PV cell array of FIG. 10A.

FIG. 11A depicts the electrical interconnectivity of an example 4x4 cross tied distributed PV cell array according to one or more aspects of the present disclosure.

FIG. 11B depicts an example distributed substring arrangement of the PV cell array of FIG. 11A.

FIG. 11C depicts the electrical interconnectivity of an example 3x2 distributed PV cell array according to one or more aspects of the present disclosure.

FIG. 11D depicts an example physical distributed substring arrangement of the example 3x2 PV cell array of FIG. 11C.

FIG. 11E depicts an example conductive backsheet of the example distributed PV cell array of FIGS. 11C-11D according to one or more aspects of the present disclosure.

FIG. 11F depicts the electrical interconnectivity of an example 2x6 distributed PV cell array according to one or more aspects of the present disclosure.

FIG. 11G depicts an example physical arrangement of the example 2x6 distributed PV cell array of FIG. 11F according to one or more aspects of the present disclosure.

FIG. 11H depicts the electrical interconnectivity of an example 2x5 distributed PV cell array according to one or more aspects of the present disclosure.

FIG. 11I depicts an example physical arrangement of the example 2x5 distributed PV cell array of FIG. 11H according to one or more aspects of the present disclosure.

FIG. 11J depicts an example electrical interconnection scheme of distributed PV cell array of FIG. 11G according to one or more aspects of the present disclosure.

FIG. 11K depicts an example electrical interconnection scheme of distributed PV cell array of FIG. 11I according to one or more aspects of the present disclosure.

FIG. 11L depicts an example conductive backsheet of distributed PV cell array of FIG. 11G according to one or more aspects of the present disclosure.

FIG. 11M depicts an example conductive backsheet of distributed PV cell array of FIG. 11I according to one or more aspects of the present disclosure.

FIG. 11N depicts the electrical interconnectivity of an example 2x5 distributed PV cell array according to one or more aspects of the present disclosure.

FIG. 11O depicts an example physical arrangement of the example 2x5 distributed PV cell array of FIG. 11N according to one or more aspects of the present disclosure.

FIG. 12A depicts a partially shaded example physical distributed substring 1002 arrangement of the example 4x4 PV cell array of FIG. 12B according to one or more aspects of the present disclosure.

FIG. 12B depicts an example electrical interconnectivity scheme of the example partially shaded physical distributed substring arrangement of FIG. 12A according to one or more aspects of the present disclosure.

FIG. 13A depicts an example PV cell array effecting conductive backsheet according to one or more aspects of the present disclosure.

FIG. 13B depicts an example PV cell array effecting conductive backsheet according to one or more aspects of the present disclosure.

FIG. 13C depicts an example PV cell array effecting conductive backsheet according to one or more aspects of the present disclosure.

FIG. 14A, depicts an example electrical interconnectivity of a 2x2 TCT spatially distributed roof tile PV cell array according to one or more aspects of the present disclosure.

FIG. 14B, depicts an example spatially distributed physical arrangement of substrings of FIG. 14A

FIG. 15 depicts an example roof tile PV cell array topology of a 2x2 TCT and spatially distributed PV cell array and PV module of FIGS. 14A-14B according to one or more aspects of the present disclosure.

FIG. 16 depicts an example conductive backsheet that may effectuate the example TCT spatially distributed roof tile PV cell array of FIG. 15 according to the present disclosure.

FIG. 17 depicts an example roof tile PV cell array and example roof tile PV module according to one or more aspects of the present disclosure.

FIG. 18 depicts an example conductive backsheet to effectuate the example roof tile PV cell array of FIG. 17

FIG. 19A, depicts an example roof tile PV cell array topology of a 2x2 TCT and spatially distributed roof tile vertical PV cell array and PV module of FIGS. 14A-14B according to one or more aspects of the present disclosure.

FIG. 19B depicts an example vertical roof tile PV cell array according to one or more aspects of the present disclosure.

FIG. 19C depicts an example TCT spatially distributed roof tile vertical PV cell array 1910C with an example junction box disposed proximate to the PV cell array side according to one or more aspects of the present disclosure.

FIG. 19D depicts an example TCT spatially distributed roof tile vertical PV cell array with two junction boxes according to one or more aspects of the present disclosure.

FIG. 19E depicts a system of connected roof tile PV modules of the present disclosure.

FIG. 20A depicts an example conductive backsheet that may effectuate the example roof tile vertical PV cell array of FIG. 19A.

FIG. 20B depicts an example conductive backsheet that may effectuate the example roof tile vertical PV cell array of FIG. 19B.

FIG. 20C depicts an example conductive backsheet that may effectuate the example roof tile vertical PV cell array of FIG. 19C.

FIG. 21A depicts an example electrical schematic of a 1x8 fully parallel roof tile PV cell array according to one or more aspects of the present disclosure.

FIG. 21B depicts an example physical arrangement of the fully parallel PV cell array of FIG. 21A.

FIG. 22A depicts an example fully parallel roof tile PV cell array and an example fully parallel roof tile PV module according to one or more aspects of the present disclosure.

FIG. 22B depicts another example topology of an example fully parallel roof tile PV module and example fully parallel roof tile PV cell array.

FIG. 22C depicts an example topology of an example fully parallel roof tile PV cell array comprising U-shaped substrings.

FIG. 23A depicts an example topology of an example fully parallel roof tile PV cell array comprising U-shaped substrings.

FIG. 23B depicts the topology of FIG. 23A with an even number of substrings with four substrings per each half of the PV cell array and midpoint cross-tie conductors.

FIG. 23C depicts the topology of FIG. 23A with an odd number of substrings with three and a half substrings per each half of the PV cell array, and midpoint cross-tie conductors.

FIG. 24A depicts an example conductive backsheet that may effectuate the example roof tile vertical PV cell array of FIG. 20A.

FIG. 24B depicts an example conductive backsheet that may effectuate the example roof tile vertical PV cell array of FIG. 20B.

FIG. 24C depicts an example conductive backsheet that may effectuate the example roof tile vertical PV cell array of FIG. 20C.

FIG. 25 depicts an example extension integrated power device according to one or more aspects of the present disclosure.

FIG. 26 depicts an example extension integrated cartridge power device.

FIG. 27A depicts an example extension integrated power device according to one or more aspects of the present disclosure.

FIG. 27B depicts another example extension integrated power device according to one or more aspects of the present disclosure.

FIG. 28 depicts an example split junction box extension integrated power device according to one or more aspects of the present disclosure.

FIGS. 29A-29B, depict an example extension integrated power device in context of PV module and PV cell array according to one or more aspects of the present disclosure.

FIGS. 30A-30B depict example alternative configurations of example extension integrated power devices according to the present disclosure.

FIGS. 31A and 31B depict example extension integrated power devices in the context of being installed to an example roof tile PV module according to the present disclosure.

FIG. 32 depicts an example power electronics according to one or more aspects of the present disclosure.

FIGS. 33A-33D depict various examples of module level power electronic (MI,PE) incorporation according to one or more aspects of the present disclosure.

FIG. 34A depicts an example PV module and PV cell array circuit with power electronics (PE) incorporation on the PV module, or multi-module level according to one or more aspects of the present disclosure.

FIG. 34B depicts an example PV module and PV cell array circuit with PE incorporation on the substring level and PV module or multi-PV module level.

DETAILED DESCRIPTION

The accompanying drawings, which form a part hereof, show examples of the disclosure. It is to be understood that the examples shown in the drawings and/or discussed herein are non-exclusive and that there are other examples of how the disclosure may be practiced. As described herein, photovoltaic (PV) cell arrays and PV modules may be comprised of substrings of serially connected PV cells. Substrings of serially connected PV cells may operate in accordance with the weakest PV cell in the substring. When one or more PV cells in a substring of otherwise normally irradiated PV cells experiences shading or other reduced irradiance, the shaded PV cells may produce less current than the otherwise normally irradiated PV cells-producing a mismatch condition. In such a case, the entire substring may operate at a reduced level, where the normally irradiated PV cells may become forward biased and the reduced PV cell may become reverse biased and absorb the excess energy produced by the normally irradiated PV cells. Thus, in some instances, the production of an entire PV cell array may be reduced by up to 100% when only a fraction of the PV cell array is shaded or otherwise experiences reduced irradiation or production. Further, the absorption of energy in the reversed biased PV cell (or other PV generator (e.g., substring, PV cell arrays, PV modules, PV module array) may cause "hot-spotting" and may possibly damage the PV cell, PV cell array, and/or PV module.

Aspects of the present disclosure relate to static reconfiguration of PV cell arrays and PV modules to improve mismatch or partial shade condition mitigation. Further, aspects of this disclosure relate to improving mismatch mitigation and improved methods of PV cell array production and manufacturing. To those ends, some aspects of the present disclosure relate to variously arranging and electrically connecting substrings in a PV cell array (e.g., in parallel, in series-parallel and/or cross-tied (e.g., total-cross tied (TCT)) while maintaining ease of manufacturing and assembling. Further to those ends, some aspects of the present disclosure relate to the use of conductive backsheets and rear contact PV cells to produce beneficial PV cell electrical interconnectivity (to, among other things, mitigate the mismatch condition) and varying PV cell and substring spatial topologies. Such configurations may be associated with reduced complexity of manufacturing and production of varied electrically connected and spatially arranged PV cell arrays utilizing conductive backsheets and rear contact PV cells.

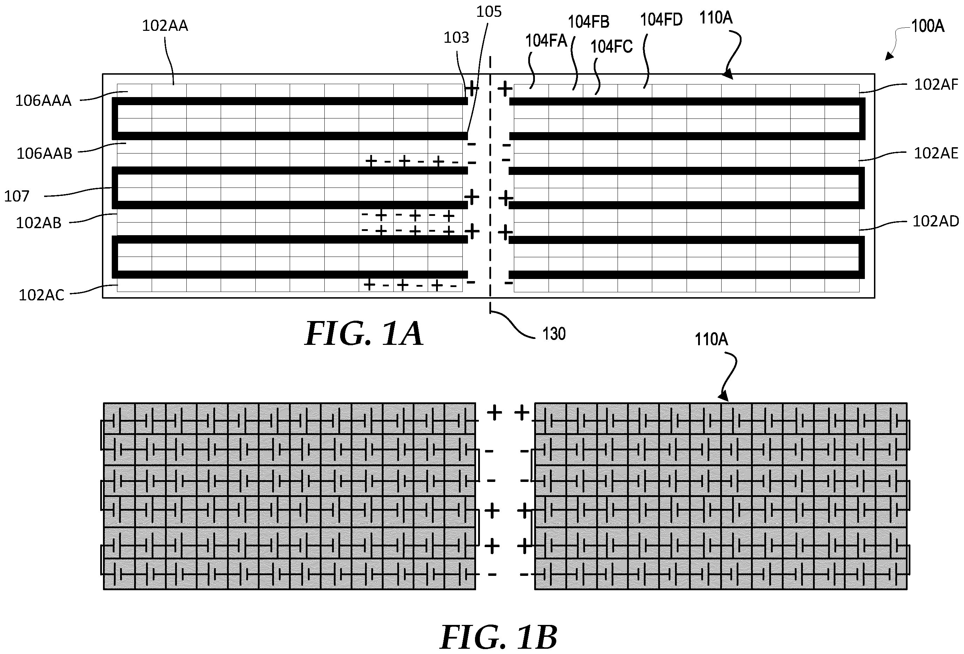

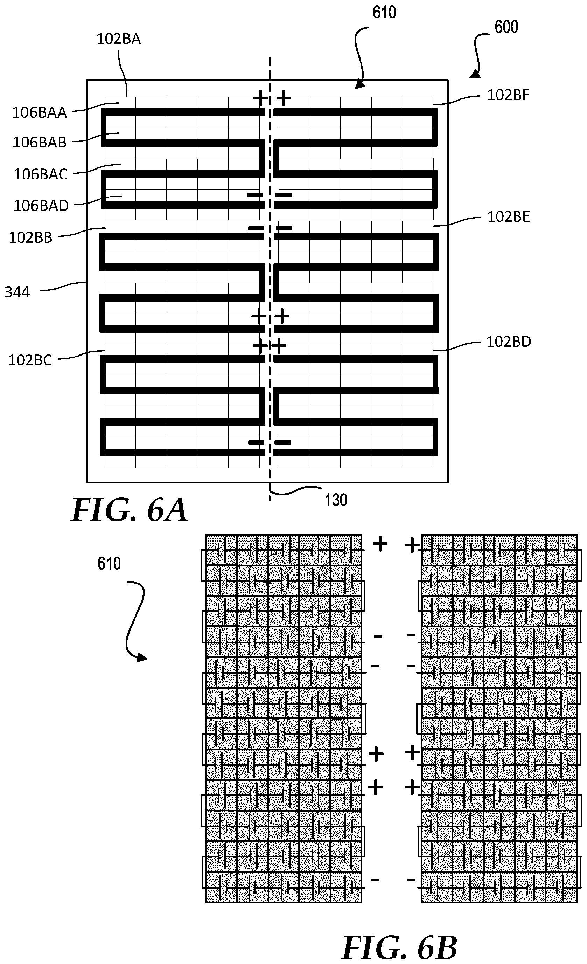

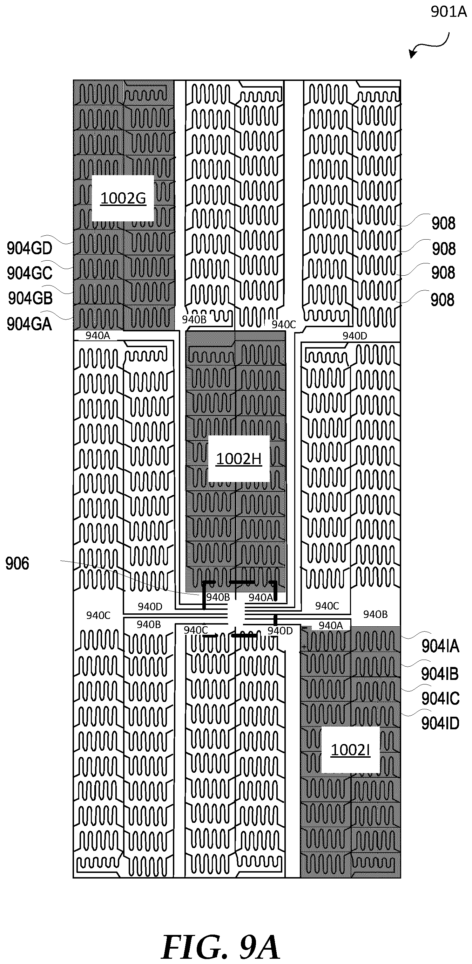

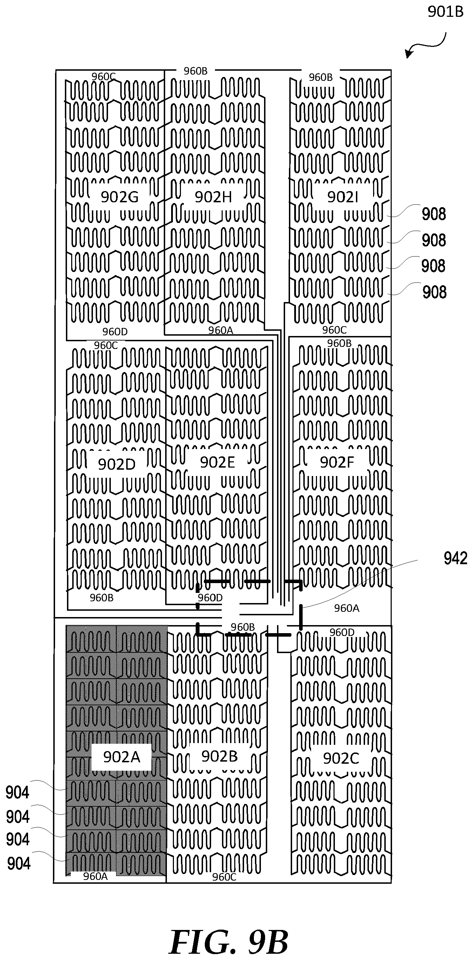

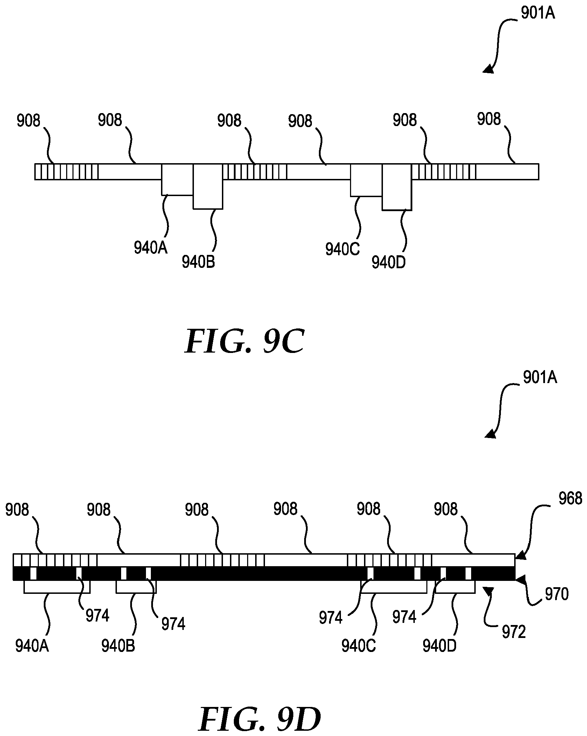

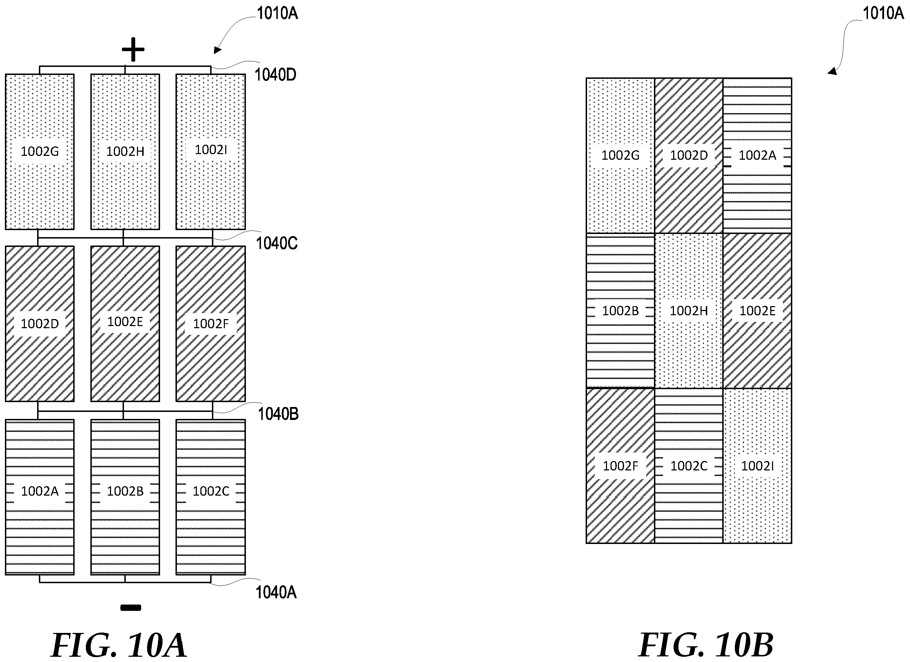

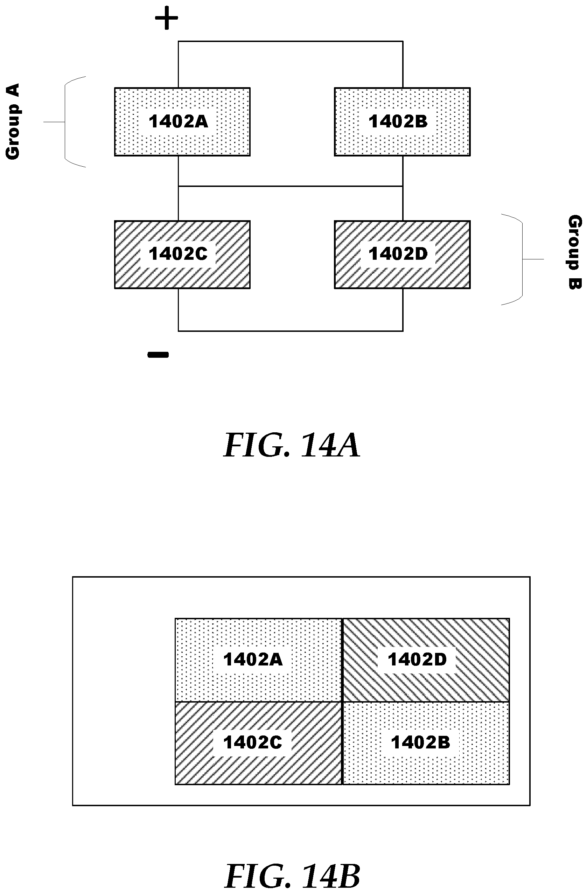

FIG. 1A depicts an example PV module 100 and PV cell array 110 in accordance with one or more examples of the present disclosure. Numerous PV cell arrays (e.g., landscape-oriented PV cell arrays (e.g., as depicted in FIGS. 1A-5B), portrait-oriented PV cell arrays (e.g., as depicted in FIGS. 6A-7B), distributed PV cell arrays (e.g., as depicted in FIGS. 10A-12B), roof tile PV cell arrays (e.g., as depicted in FIGS. 14A-19D), etc.) are depicted herein and are generally referred to as PV cell arrays. Referring to FIG. 1A, PV module 100A may comprise PV cell array 110A. PV cell array 110A may comprise several substrings 102 (e.g., two-row substrings 102AA, 102AB, 102AC, etc. Numerous substrings are described herein (e.g., two-row substrings 102AA, 102AB, 102AC, etc. (e.g., as depicted in FIGS. 1A-5B), four-row substrings 102BA, 102BB, 102BC (e.g., as depicted in FIGS. 6A-7B), distributed substrings 1002, 1402, 1502, 1602, 1702, 1802, and 1902 (e.g., as depicted in FIGS. 9A-19D), etc.) and are generally referred to as substrings. Each substring may include a plurality of PV cells (e.g., PV cells 104A, 104B, 104C, etc.) serially electrically connected. Numerous PV cells are described herein (e.g., 104FA, 104FB, 104FC (e.g., as depicted in FIG. 1A), rear contact PV cells 904 (e.g., as depicted in FIG. 9, etc.) and are generally referred to as PV cells. PV cells of the present disclosure may include monocrystalline silicon, polycrystalline silicon, thin film, gallium arsenide, multi-junction, perovskite, organic solar cells, dye-sensitized solar cells, quantum dots, etc. Substrings may be formed of and/or comprise full PV cells (e.g., PV cells 104), $^1/_2$ cut PV cells (e.g., PV cells 804), $^1/_4$ cut PV cells or any fractionally cut PV cell as described in further detail herein, and are generally referred to as PV cells herein. Further, substrings may include any number of PV cells. PV cells in a substring may have positive and negative terminals and may be electrically connected in series to form the substring. For example, the positive terminal(s) of PV cell 104FA may be connected to the negative terminal(s) of PV cell 104FB, the positive terminal(s) of PV cell 104FB may be connected to the negative terminal(s) of PV cell 104FC, etc. Substrings, therefore, may terminate in positive terminals (e.g., positive terminal 103) and negative terminals (e.g., negative terminals 105).

Substrings 102 may be electrically connected to each other in parallel establishing a PV cell array 110 of electrically parallelly connected substrings 102 of electrically serially connected PV cells 104. PV cells 104, substrings 102, PV cell arrays 110, and PV modules 100 are all examples of PV power generators. Substrings 102 may comprise any number of PV cells 104 (e.g., 20 PV cells, 30 PV cells, etc.). Solid black lines shown in FIG. 1A depict a conductive path. The conductive path may be through any number of different conductive media, for example, through PV cells, silver fingers, busbars, conductive backsheets, ribbon wire, etc. FIG. 1B depicts an example electrical schematic of an example of the PV module 100 and PV cell array 110A of FIG. 1A.

The several substrings 102 of the PV module 100 or PV cell array 110 may be arranged on the PV module 100 such that all substring terminals 103, 105 may terminate in a connection region. In the connection region, a midline 130 of the PV module 100 and/or PV cell array is located. The midline 130 is shown as being at the geometric center of the PV module 100 or PV cell array 110 in, for example, Figures 1-8. However, this need not be case and the midline and connection region may be offset from the geometric center. As shown in FIGS. 1A and 1B, the PV cell array 110 includes six substrings 102. Alternatively, in some examples, PV cell arrays 110 may be provided with any number of substrings 102. The PV module 100 and/or PV cell array 110 may include a first half and a second half; a first half of the substrings 102 may be disposed on the first half on one side of connection region, and a second half of the substrings 102 may be disposed on the second half on the other side of the connection region, with their terminals 103, 105 all terminating in the connection region located between the first half of the substrings and the second half of the substrings.. For example, for a PV module 100 with six substrings 102 (e.g., two-row substrings 102AA-102AF): three substrings (e.g., 102AA, 102AB, and 102AC) may be disposed on the first half of PV module 100, and three substrings 102 (e.g., 102AD, 102AE, and 102AF) may be disposed on the second half of PV module 100. Each substring may have at least two neighboring substrings. Substrings 102 may have neighboring substrings 102 above (e.g., two-row substring 102AA may be considered the above neighbor of two-row substring 102AB), below (e.g., two-row substring 102AB may be considered the below neighbor of two-row substring 102AA), to the right (e.g., two-row substring 102AF may be considered the right neighbor of two-row substring 102AA), and/or to the left (e.g., two-row substring 102AA may be considered the left neighbor of two-row substring 102AF) in any combination thereof. The substrings 102 may be arranged on the PV module 100 and/or in the PV cell array 110 such that the negative terminal 105 of each substring 102 may terminate proximate to the negative terminal 105 of a first neighboring substring 102, and the positive terminal 103 of each substring 102 may terminate proximate to the positive terminal 103 of a second neighboring substring 102. This proximate arrangement with the terminals 103, 105 terminating in the connection region may, in some cases, simplify the parallel connection of different substrings. For example, the negative terminal 105 of two-row substring 102AA may terminate proximate to the negative terminal 105 of first neighboring two-row substring 102AB (below two-row substring 102AA), and the positive terminal 103 of two-row substring 102AA may terminate proximate to the positive terminal 103 of second neighboring two-row substring 102AF (to the right of two-row substring 102AA). The terms first neighbor and second neighbor are arbitrary and are for referential and purposes of example only and are not intended to be limiting. FIGS. 1A and 1B depict the intra-substring connections but do not depict the inter-substring connections.

For purposes of depiction, each substring 102 may be further divided into rows of sub-substrings for example, two-row substring 102AA may be divided into two rows of sub-substrings, sub-substring 106AAA and sub-substring 106AAB. Many examples of two-row substrings 102A are provided herein (e.g., 102AA, 102AB, 102AC, etc.) and may be referred to generally as two-row substrings 102A. Alternatively, substrings 102 may be divided into four (as described in further detail herein), six, eight, etc. sub-substrings 106. Two-row substring 102A may be arranged in two rows of sub-substrings 106, sub-substring 106AAA and sub-substring 106AAB. As described above, half of the total number of substrings 102 of the PV cell array 110 may be disposed on either side of PV module 100 and/or PV cell array 110. As shown in FIGS. 1A and 1B, two-row substrings 102A may be arranged on the PV module 100 in rows of sub-substrings 106 equal to the number of two-row substrings 102A per half of PV module 100 times two. For example, three two-row substrings 102A (e.g., two-row substrings 102AA-102AC) may be disposed on a first half of PV module 100, the three two-row substrings 102A (e.g., two-row substrings 102AA-102AC) may be further divided into six sub-substrings 106.

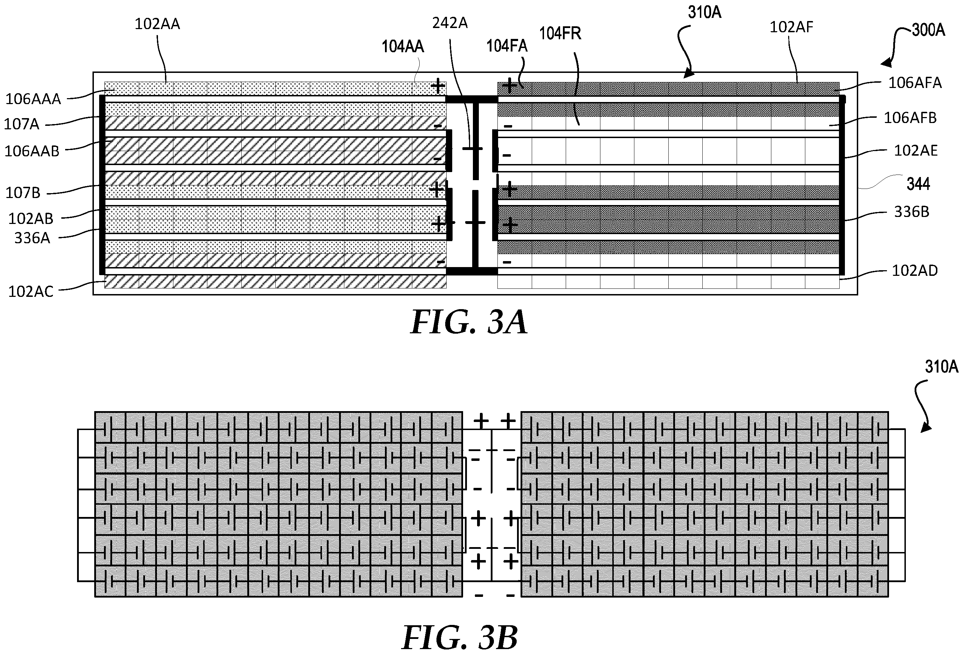

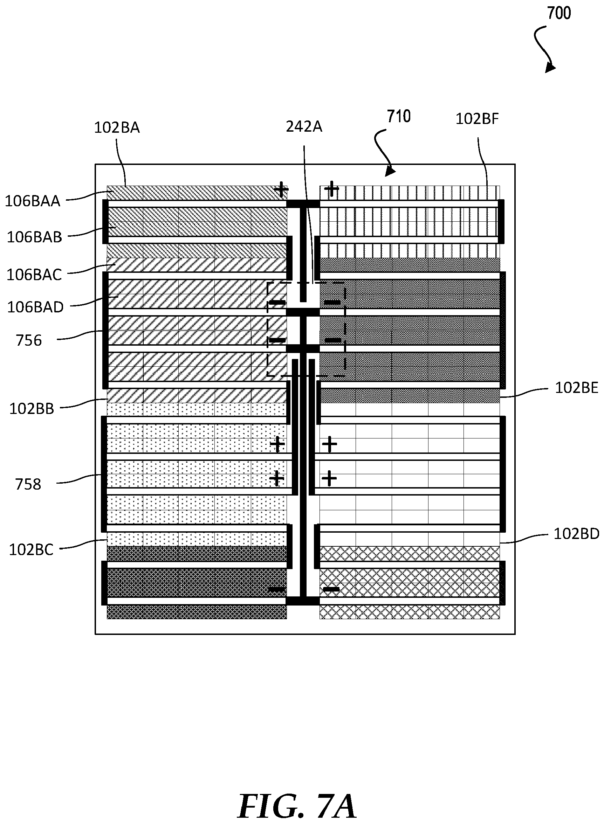

As shown in FIGS. 1A and 1B, each sub-substring 106 may extend from a substring positive terminal 103 to a substring midpoint 107 (e.g., a substring electrical potential midpoint), or from a substring negative terminal 103 to the substring midpoint 107. Substring midpoints 107 on PV module 100 may be equipotential or have substantially the same electrical potential under similar operating conditions. In some cases, as described herein (for example, with reference to FIGS. 3A-5B, substring midpoints 107 (and, in some configurations, quarter points and/or three quarter points, for example as described in relation to FIG. 7A) may be electrically connected to one another, to create parallel connection of sub-substrings.

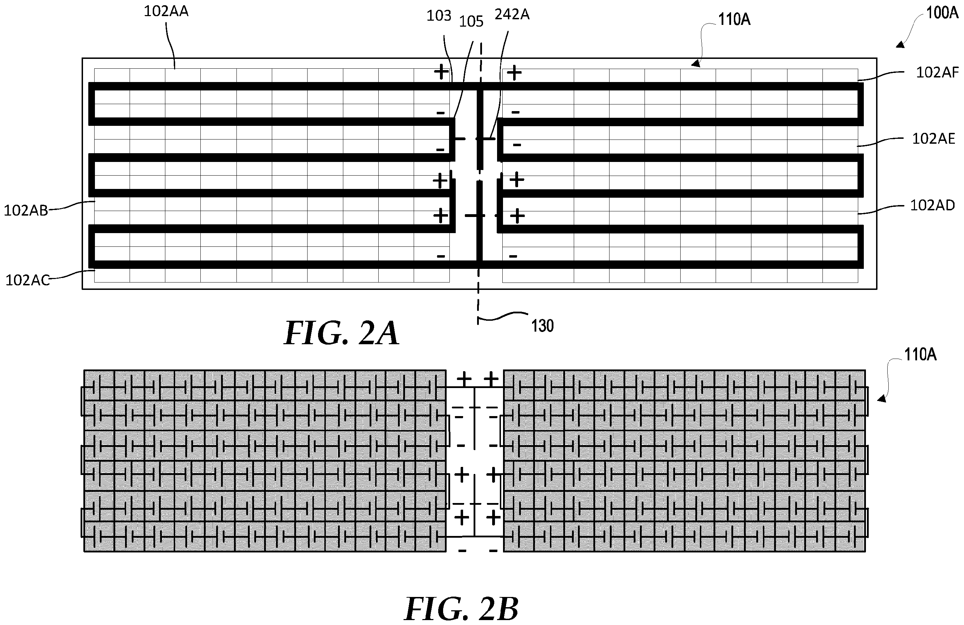

FIG. 2A depicts an example PV module 100 and PV cell array 110A with electrically parallel substrings in accordance with one or more aspects of the present disclosure. Solid black lines shown in FIG. 2A depict a conductive path. The conductive path may be through any number of different conductive media, for example, through PV cells, silver fingers, busbars, conductive backsheets, ribbon wire, etc. FIG. 2B depicts an example electrical schematic of an example of the PV module 100 and PV cell array 110A of FIG. 2A. As described herein, and as shown in FIGS. 2A and 2B, the substrings 102 (e.g., two-row substrings 102AA-102AF) may be arranged such that each substring negative terminal 105 may terminate proximate to the negative terminal 105 of a first neighboring substring 102, and each substring positive terminal 103, may terminate proximate to the positive terminal 103 of a second neighboring substring 102. The neighboring terminals may then be electrically connected. For example, the negative terminal 105 of two-row substring 102AA may terminate proximate to and electrically connect to the negative terminal 105 of two-row substring 102AB. Additionally, the positive terminal 103 of two-row substring 102AA may terminate proximate to and electrically connect to the positive terminal 103 of two-row substring 102AF. Such a substring 102 arrangement may allow for the parallel connection of all substrings 102 of PV module 100 with reduced production complexity. For example, such an arrangement may allow for the parallel connection of all substrings 102 of the PV array 110A without conductor intersections (e.g., ribbon wire, etc.) outside of a PV module junction box (e.g., junction box 242A), reducing the cost of material and labor for PV module production. Such electrical connections between neighboring substring terminals may be made, for example, by soldering ribbon wire, or any other conductor, directly to the PV cell terminals. Further, by arranging the substrings 102 as depicted in FIGS. 2A and 2B, conductor intersections outside of a junction box (e.g., junction box 242A) may be minimized or substantially eliminated.

Still referring to FIGS. 2A and 2B, an example electrical circuit of the PV cell array may be as follows: the negative terminal 105 of two-row substring 102AA may terminate proximate to and electrically connect to the negative terminal 105 of neighboring two-row substring 102AB; the positive terminal 103 of two-row substring 102AB may terminate proximate to and electrically connect to the positive terminal 103 of neighboring two-row substring 102AC; the negative terminal 105 of two-row substring 102AC may terminate proximate to and electrically connect to the negative terminal 105 of neighboring two-row substring 102AD; the positive terminal 103 of two-row substring 102AD may terminate proximate to and electrically connect to the positive terminal 103 of neighboring two-row substring 102AE; the negative terminal 105 of two-row substring 102AE may terminate proximate to and electrically connect to the negative terminal 105 of neighboring two-row substring 102AF; the positive terminal 103 of two-row substring 102AF may terminate proximate to and electrically connect to the positive terminal 103 of neighboring two-row substring 102AA. The above example schematic may achieve the electrical connections without conductor intersection, or significantly reducing conductor intersection outside of junction box 242A. While FIGS. 2A and 2B depict substring interconnection schemes with the example of two-row substrings 102A, the same scheme may be used for substrings comprising more rows (e.g., four-row substring 102B, etc.).

To electrically connect all of the substrings 102 in parallel, remaining connections may take place. Such remaining connections may be achieved proximate to the midline 130 of PV module 100 and may be made in a single junction box 242A. Numerous junction boxes are referenced herein (e.g., single junction box 242A, first junction box 242BA, second junction box 242BB, junction box 1142, 1542, 1742, 1942, etc.) and are generally referred to as junction box. In some instances, all substrings 102 may terminate proximate to and facing the midline 130 of PV module 100. Therefore, routing PV module busses and/or electrical lines (e.g., conductor(s)) into the junction box 242 located proximate the PV module midline 130 may decrease PV module 100 production complexity. The positive bus and negative bus of the PV cell array may be routed into single junction box 242A where positive lines (e.g., conductors) may be connected to the positive bus and negative lines may be connected to the negative bus. For example, a conductor (e.g., ribbon wire) may be connected to the negative connection between two-row substring 102AC and two-row substring 102AD and routed into single junction box 242A. Similarly, a conductor may be connected to the positive connection between two-row substring 102AA and two-row substring 102AF and routed into single junction box 242A. The negative connections between: two-row substring 102AA and two-row substring 102AB; and between two-row substring 102AF and two-row substring 102AE may similarly be routed into single junction box 242A. Additionally, the positive connection between: two-row substring 102AB and two-row substring 102AC; and two-row substring 102AD and two-row substring 102AE may be routed into single junction box 242A. It may be appreciated that due to the arrangement of substrings 102 as described herein, the terminals may be disposed proximate to single junction box 242A and may be routed into single junction box 242A without conductor intersection or interference. This may increase the ease of manufacture by minimizing conductor shielding, insulation, etc. In single junction box 242A, the positive lines may be tied together and the negative lines may be tied together effectively wiring the substrings 102 in parallel without conductor intersection outside of single junction box 242A. Wiring the substrings 102 in parallel as described herein may increase mismatch condition mitigation, and may increase the efficiency, of the PV cell array 110 and PV module 100.

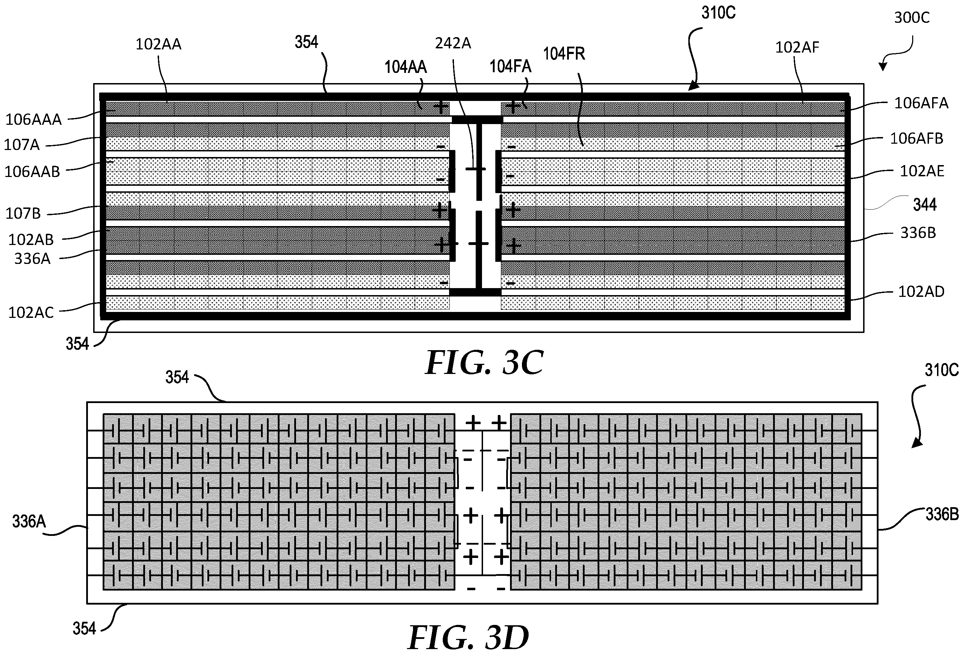

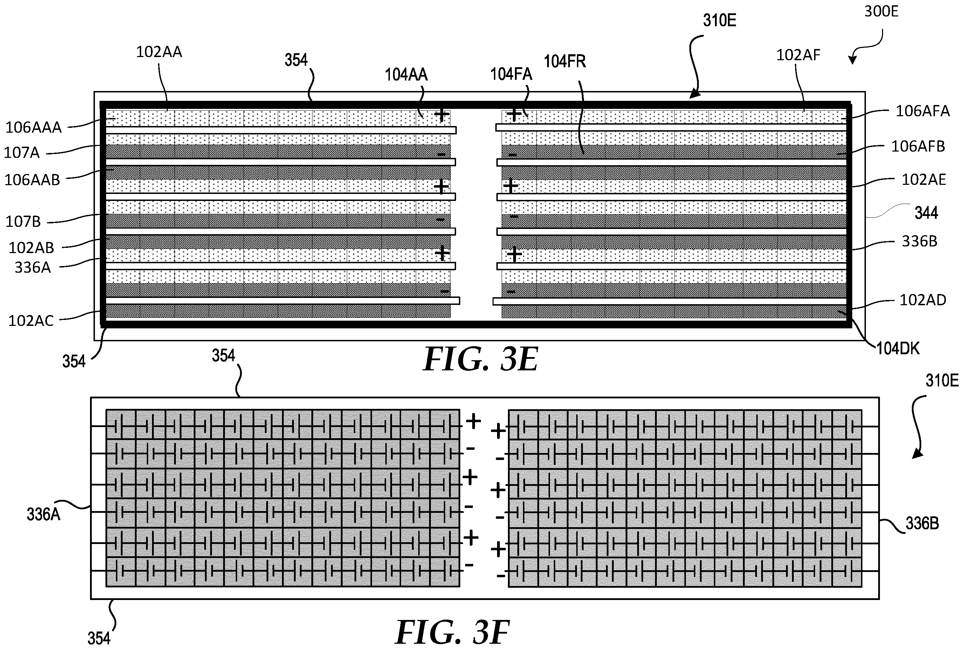

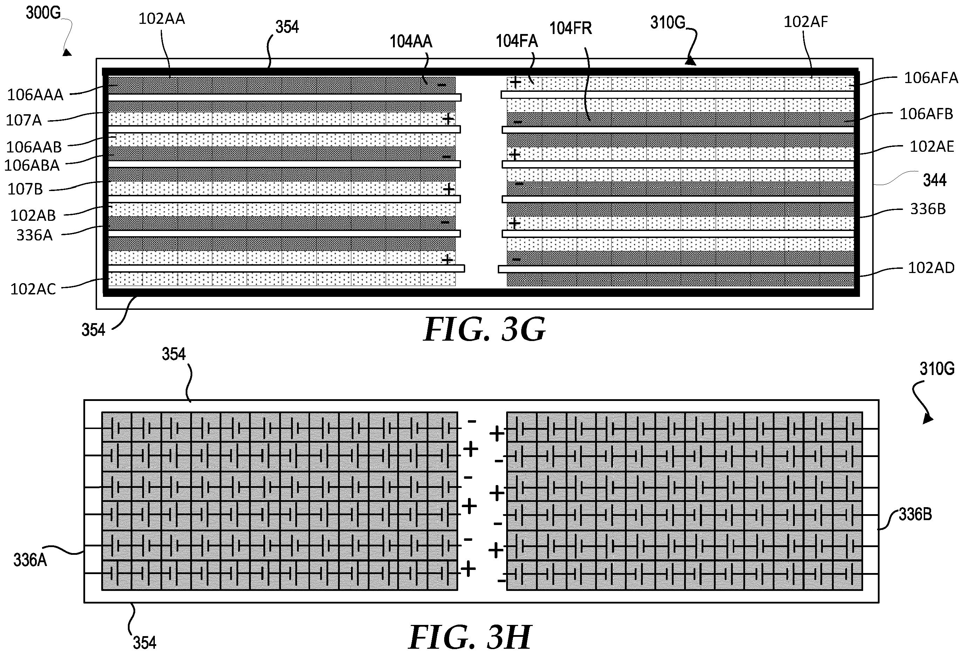

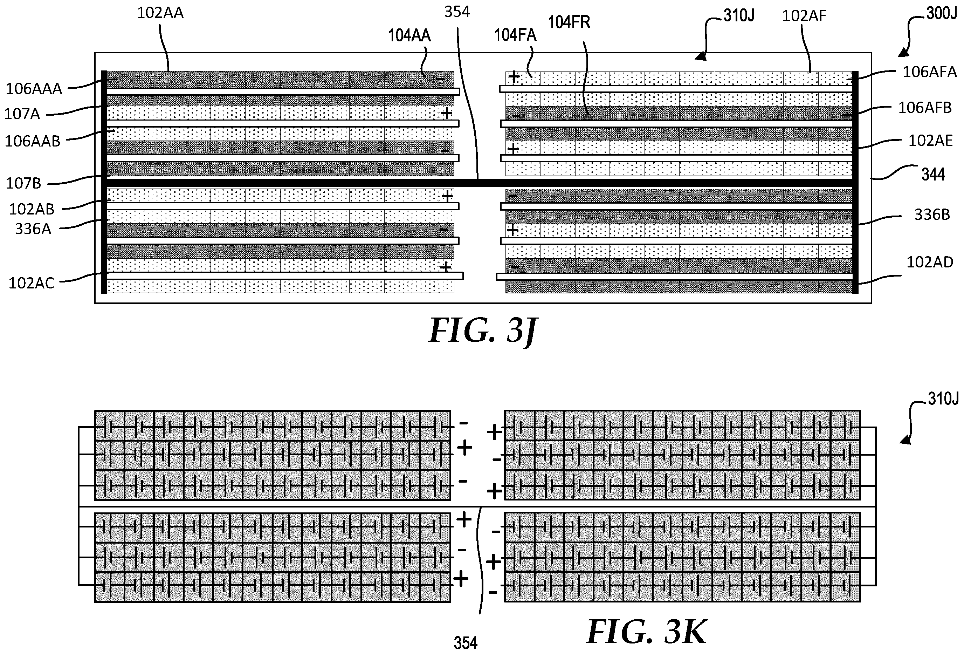

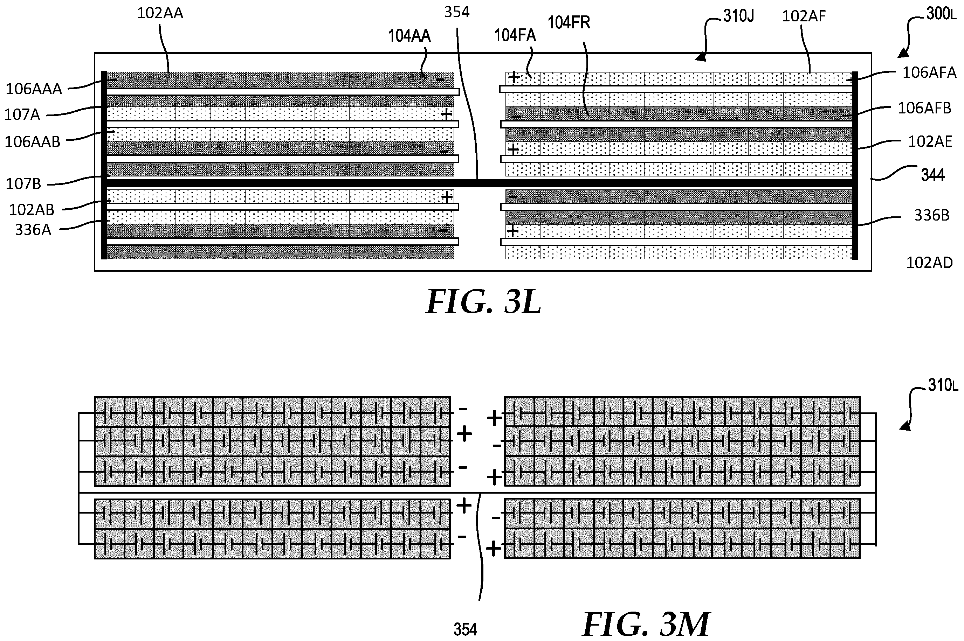

FIG. 3A depicts an example PV module 300A (generally PV module 300) and PV cell array 310A (generally PV cell array 310) with electrically parallel substrings in accordance with one or more aspects herein. FIGS. 3A-3M depict example PV modules 300 and/or PV cell arrays 310. Solid black lines and solid white lines shown in FIGS. 3A, 3C, 3E, 3G, 3J, 3L, depict conductive paths. For example, solid white lines may be conductive paths through PV cell 104 silicon, and solid black lines may be conductive paths through, for example, ribbon wire. However, the conductive paths may be through any number of different conductive media, for example, through PV cells, silver fingers, busbars, conductive backsheets, ribbon wire, etc. FIG. 3B depicts an example electrical schematic of an example the PV module 300A and PV cell array 310A of FIG. 3A. Substrings 102 (e.g., two-row substrings 102AA-102AF) may have substring electrical potential midpoints 107. For example, two-row substring 102AA may have electric potential midpoint 107A, and two-row substring 102AB may have electric potential midpoint 107B. PV modules 300 may include one or more substring midpoint cross-ties 336 (e.g., conductors). Substring midpoint cross-ties 336 may electrically connect the electric potential midpoints 107 of multiple substrings 102. Substring midpoint cross-ties 107 may improve the power output of the PV cell array 310A under different partial shading or otherwise mismatched conditions, for example, by increasing parallelization of the substrings 102 and PV cell array 310A to essentially parallelize top halves and bottom halves of sub-substrings 106. Additionally, substring midpoint cross-ties 336A and 336B may symmetrize portions of the PV cell array 310A resulting in additional shade and/or other mismatch condition mitigation robustness. sub-substrings 106 (e.g., rows) depicted in FIG. 3A with the same pattern may be considered symmetric (for example, one symmetric row may conduct in the place of another). The substring midpoint cross-ties 336 may electrically connect the electrical potential midpoints 107 of all substrings 102 disposed on a PV module 300 half. For example, referring to FIG. 3A, substring midpoint cross-tie 336A may electrically connect the electrical potential midpoints 107 of two-row substring 102AA, two-row substring 102AB, and two-row substring 102AC. Similarly, substring midpoint cross-tie 336B may electrically connect the electrical potential midpoints 107 of two-row substring 102AD, two-row substring 102AE, and two-row substring 102AF. Substring midpoint cross-ties 336A and 336B may be routed into junction box 242. There, the two substring midpoint cross-ties 336 may be connected together, for example, further parallelize the PV cell array 310A as described. Additionally or alternatively, the electrical potential midpoints 107 may be used in conjunction with power electronics (PE) to, for example, affect the power produced by the PV cell array 310A, for example, optimize the PV cell array 310A as discussed in more detail herein.

Substring midpoint cross-ties 336 may further electrically parallelize the PV cell array 310A and may allow for additional mismatch or partial shade condition mitigation and/or increased efficiency. As described herein, a string of serially connected PV cells 104 (e.g., substring 102) may generate electrical power in accordance with the weakest PV cell 104 in the string. When one or more PV cells 104 in a string of otherwise normal state PV cells 104 experiences shading or other reduced irradiance, the shaded PV cell 104 may produce less current than the otherwise normal state PV cells 104. In such a case, the entire string may operate at a reduced level, and the reduced PV cell 104 may become reverse biased and/or absorb the excess energy produced by the normal state PV cells 104. This absorption of energy may cause "hot-spotting" (e.g., by reverse biasing the reduced PV cell 104) and may possibly damage the PV cell 104, PV cell array 310, and/or PV module 300. To illustrate an example partial shade condition mitigation of the configuration of FIG. 3A, assume PV cell 104AA in sub-substring 106AAA and PV cell 104CK in sub-substring 106ACB are experiencing shading or other reduced irradiance. Due to the configuration shown in FIG. 3A, substantially, sub-substring 106AAA and sub-substring 106ACB may be affected alone (a sixth of the PV cell array). However, in a configuration lacking substring midpoint cross-tie 336A, one-third of the PV cell array may operate at a reduced level since two-row substring 102AA and two-row substring 102AC may be affected by the shaded PV cells 104AA and 104CK. While allowing for increased power production during mismatch and/or partial shade conditions, substring midpoint cross-ties 336 may also improve resistance to PV module damage from "hot-spotting" as described herein.

FIG. 3C depicts an example PV module 300C and PV cell array 310C with electrically parallel substrings in accordance with one or more aspects of the present disclosure. FIG. 3D depicts an example electrical schematic of an example of the PV module 300C and PV cell array 310C of FIG. 3C. Referring to FIGS. 3C and 3D it may be further advantageous to electrically connect substring midpoint cross-ties 336A and 336B. Midpoint cross-tie connectors 354 may be connected between substring midpoint cross-tie 336A and 336B electrically connecting the substring midpoint cross-ties 336A and 336B. The midpoint cross-tie connectors 354 may be any conductor (e.g., ribbon wire). FIG. 3C depicts a PV cell array 310C having two midpoint cross-tie connectors 354, however any number of midpoint cross-tie connectors 354 may be used. By further parallelizing and symmetrizing the PV cell array 310C, midpoint cross-tie connectors 354 may increase PV module efficiency and further improve the resistance of PV module 300C to different partial shade conditions. Sub-substrings 106 (e.g., rows) depicted in FIG. 3C with the same pattern may be considered symmetric.

It may be appreciated that when substrings 102 are arranged according to one or more aspects of the present disclosure, substring electric potential midpoints 107 may be disposed proximate to a PV module edge 344. A substring midpoint cross-tie 336 may be connected directly to the PV cells 104 at the substring electrical potential midpoint 107, by for example soldering a conductor (e.g., ribbon wire) directly to the PV cells 104 at the substring electrical potential midpoints 107. Additionally or alternatively, substring midpoint cross-tie 336 may be connected to substring electrical potential midpoints 107 off of PV cells 104 proximate to PV module edge 344. Such a layout and method, among other advantages as described herein, may increase the simplification and convenience of PV module production and/or manufacturing.

FIG. 3E depicts an example PV module 300E and PV cell array 310E according to one or more aspects of the present disclosure. FIG. 3F depicts an example electrical schematic of an example of the PV module 300E and PV cell array 310E of FIG. 3E. FIGS. 1A-3D depict PV cell arrays in which both terminals of each substring 102 are disposed proximate to terminals of like polarity of neighboring substrings. In different configurations, substrings 102 may be arranged differently. Referring to FIGS. 3E and 3F, it may be advantageous, for example, in consideration of different shade conditions, to dispose the substrings 102A in the PV cell array 310E such that terminals are arranged according to FIG. 3E, for example as follows:
$$\begin{bmatrix} + & + \\ - & - \\ + & + \\ - & - \\ + & + \\ - & - \end{bmatrix}$$
. According to such a configuration, both halves of the PV cell array may be considered mirrored about the PV cell array midline. All of the substrings 102A may be connected in parallel. Midpoint cross-ties 336A and 336B may be connected to the midpoints 107 of the substrings 102A. Midpoint cross-tie connectors 354 may be connected to the midpoint cross-ties 336. Accordingly, the PV cell array 310E may be parallelized and symmetrized according to FIG. 3E and as described herein. Sub-substrings 106 (e.g., rows) depicted in FIG. 3E with the same pattern may be considered symmetric. Thus, due to the configuration of FIG. 3E, for example, a shade condition covering PV cell 104AA, and a shade condition covering PV cell 104DK, though on different sides of the module and affecting different substrings, may only reduce 1/6 of the PV cell array 310E.

FIG. 3G depicts an example PV module 300G and PV cell array 310G having an interleaved configuration according to the present disclosure. FIG. 3H depicts an example electrical schematic of an example of the PV module 300G and PV cell array 310G of FIG 3G. FIG. 3E depicts an example of a PV cell array 310 substantially mirrored about the midline. Depending on considerations, for example, shade condition considerations, it may be advantageous to dispose the substrings in the PV cell array 310 such that the terminals are interleaved. For example, referring to FIG. 3G, the substrings 102A may be arranged such that they terminate proximate to the

$$\begin{bmatrix} + & - \\ - & + \\ + & - \\ - & + \\ + & - \\ - & + \end{bmatrix}$$
midline of the PV cell array 310G as follows:
. Thus, each terminal of the first half of the PV cell array 310G may be disposed across from a terminal of an opposing polarity on the second half of the PV cell array 310G. All of the substrings 102A may be connected in parallel. Midpoint cross-ties 336A and 336B may be connected to the midpoints 107 of the substrings 102A. Midpoint cross-tie connectors 354 may be connected to the midpoint cross-ties 336. Accordingly, the PV cell array 310G may be parallelized and symmetrized according to FIG. 3G. Sub-substrings 106 (e.g., rows) depicted in FIG. 3G with the same pattern may be considered symmetric.

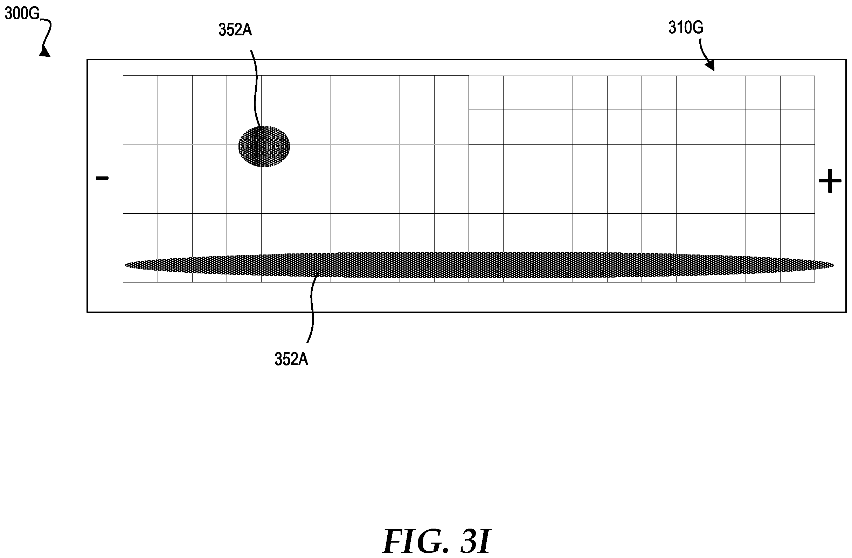

FIG. 3I depicts the PV module 300G and PV cell array 310G of FIG. 3G in the context of partial shade conditions. Some advantages of the configuration of FIG. 3G may be understood with reference to FIG. 3I. Shade conditions often arise from fixed elements (e.g., branches, leaves, static elements of nearby structures, etc.) therefore, shade conditions are often discrete (as opposed to dispersed). Referring to FIG. 3I, first shade condition 352A is affecting the entire bottom row of PV cell array 310G. Thus, the first shade condition 352A is affecting cells of two different substrings 102A (substrings 102AC and 102AD). Additionally, the affected substrings are on different halves of the PV cell array 310G. In other configurations, such a shade condition may reduce the production of a larger portion of the PV cell array (e.g., 1/3, 1/2, whole array, etc.). However, due to the configuration and symmetry of PV cell array 310G (of FIG. 3G), only 1/6 of the PV cell array 310G may be reduced (only the rows beneath the shade condition), and the unshaded substrings halves (e.g., unshaded rows) may continue conducting. Similarly, the second shade condition 352B is depicted as affecting the second and third rows of one side of the PV cell array 310G (sub-substrings 106 AAB and 106ABA). Thus, the second shade condition 352B is covering (e.g., reducing irradiance to) cells of two substrings 102 (substrings 102AA and 102AB). In other configurations, such a shade condition may reduce the production of a larger portion of the PV cell array (e.g., 1/3, 1/2, whole array, etc.). However, due to the configuration and symmetry of PV cell array 310G (of FIG. 3G), only 1/6 of the array may be reduced (only the rows beneath the shade condition), and the unshaded substring halves (e.g., unshaded rows) may continue conducting.

FIG. 3J depicts a PV module 300J and PV cell array 310J having an interleaved configuration according to the present disclosure. FIG. 3K depicts an example electrical schematic of an example of the PV module 300J and PV cell array 310J of FIG. 3J. As described above, PV cell arrays may comprise a single midpoint cross-tie connector 354 (or any other quantity thereof). FIG. 3J depicts a PV cell array 310J with an interleaved configuration, substantially similar to the PV cell array 310G of FIG. 3G, with only a single midpoint cross-tie connector 354. The single midpoint cross-tie connector 354 may extend from the two midpoint cross-ties 336A and 336B. The midpoint cross-tie connector 354 may be placed proximate to a midline (e.g., transverse midline) of the PV cell array 310J. Such a placement may reduce conduction losses over other configurations. Alternatively, the single midpoint cross-tie connector 354 may be in a different location (e.g., above or below the PV cell array 310J). The midpoint cross-tie connector 354 may be routed between any of the substring 102 rows (e.g., as depicted in in FIG. 3J). Additionally or alternatively, for example to save space in the PV cell array 310J, the midpoint cross-tie connector 354 may be routed behind (e.g., underneath) the PV cell array 310J.

FIG. 3L depicts a PV module 300L similar to a PV module 300J and PV cell array 300J, but having an odd number of interleaved PV substring rows. FIG. 3M depicts an example electrical schematic of an example of the PV module 300L and PV cell array 310L of FIG. 3L. This arrangement may be useful when a size of a photovoltaic module is sized to prefer an odd number of PV cell rows and/or when a preferred total current of the photovoltaic module corresponds to an odd number of PV cell columns. For example, where 210mm-wide solar cells are used and a PV module having a desired dimension of under 1100mm is desired, it may be preferable to arrange five rows of solar cells in the manner depicted in Fig. 23L. Due to the parallel interconnection of PV substrings, it is possible to have an odd number of substring rows and still terminate substrings at a point of the PV module which is not necessarily a module edge.

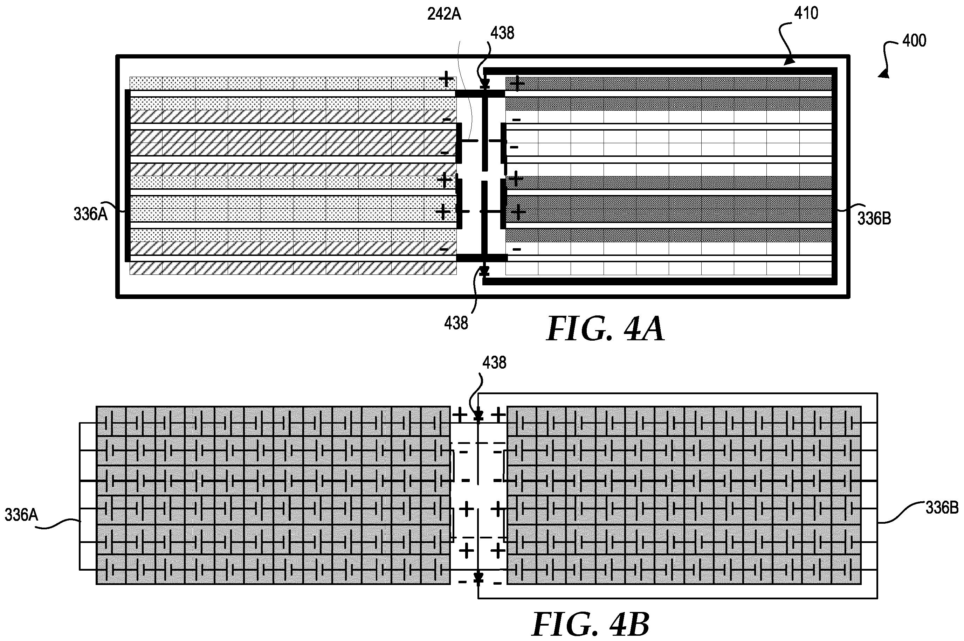

FIG. 4A depicts an example PV module 400 and PV cell array 410 with electrically parallel substrings in accordance with one or more aspects of the present disclosure. Solid black lines and solid white lines shown in FIG. 4A depict conductive paths. For example, solid white lines may be conductive paths through PV cell 104 silicon, and solid black lines may be conductive paths through, for example, ribbon wire. However, the conductive paths may be through any number of different conductive media, for example, through PV cells, silver fingers, busbars, conductive backsheets, ribbon wire, etc. FIG. 4B depicts an example electrical schematic of an example of the PV module 400 and PV cell array 410 of FIG. 4A. Referring to FIGS. 4A and 4B, bypass diodes 438 may be added to the PV module 400. Bypass diodes 438 may be added between substring midpoint cross-tie 336 and the negative bus of the PV module 400, and between substring midpoint cross-tie 336 and a positive bus of the PV module 400. Bypass diodes 438 may allow for the bypass of a portion (e.g., a half) of the PV cell array 410 in the case where the portion of the PV cell array 410 is, for example, shaded or experiencing reduced irradiance. Bypass diodes 438 may be added between substring midpoint cross-ties 336 and the positive and/or negative busses of PV module 400, for example, at the location depicted in FIG. 4A or elsewhere, and may be added on the PV module 400 (e.g., on a conductive backsheet as described in more detail herein) or may be added in a junction box 242 (e.g., single junction box 242A). Further, bypass diodes 438 may be added at either or both substring midpoint cross-ties 336A, 336B. Alternatively, bypass diodes 438 may be omitted from the configuration. According to some aspects of the present disclosure, power electronics 3202 as described herein may be utilized to, among other functions as described herein (e.g., DC-DC convert, invert, etc.), control the behavior of substrings 102 under mismatch and/or the partial shade condition (e.g., by bypassing a substring and/or optimizing a substring, moving a substring to a safe operating point, etc.). Power electronics 3202 may be utilized in conjunction with bypass diodes 438 or without bypass diodes 438.

For example, any of the PV generators (e.g., PV cells, PV cell strings, PV cell arrays, etc.) described herein may be used with bypass diodes or may be used without bypass diodes. For example, diodes may be connected in parallel with one PV generator or in parallel with a plurality of serially connected PV generators. Such diodes may act to bypass the PV generator(s) to which the diode may be connected. For example, bypass diodes may provide a low resistance path around one or more PV generators of a PV array that may be experiencing reduced production (e.g., partial shade condition). Alternatively, any of the PV generators described herein may be combined with power electronics (e.g., PE 3202) without bypass diodes. For example, power electronics 3202 may be connected in parallel with one PV generator or in parallel with a plurality of serially connected PV generators. Additionally or alternatively, a plurality of serially connected groups of PV generators may be connected to a single power electronics circuit. For example, multiple substrings of a PV cell array may be connected to a single power electronic device and/or multiple PV modules may connected to a single power electronic device. The power electronics 3202 may detect the operating conditions of the PV generator(s), or a portion of the PV generators to which the power electronics 3202 is connected (e.g., the power electronics 3202 may detect or sense the power, the current, and/or the voltage of the PV generator(s)). The power electronics 3202 may change the operating point of one or more of the PV generator(s) to which it is connected. For example, the power electronics 3202 may detect and/or sense a partial shade condition or other reduced irradiance condition in the PV generators, or a portion of the PV generators to which the power electronics 3202 is connected. The power electronics 3202 may bypass the affected PV generators. Alternatively, the power electronics 3202 may move and/or alter the operating point of the affected PV generators, for example, to a safe and/or efficient operating point. The power electronics 3202 may comprise, for example, power converters configured to operate the PV generator(s) or a portion of the PV generators according to a maximum power tracking (MPPT) algorithm.

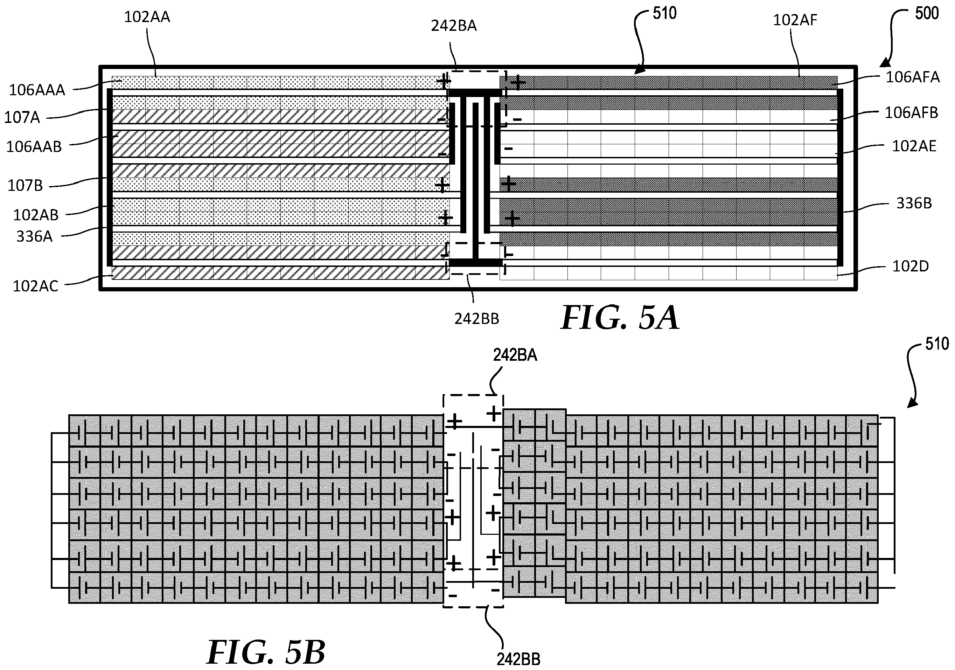

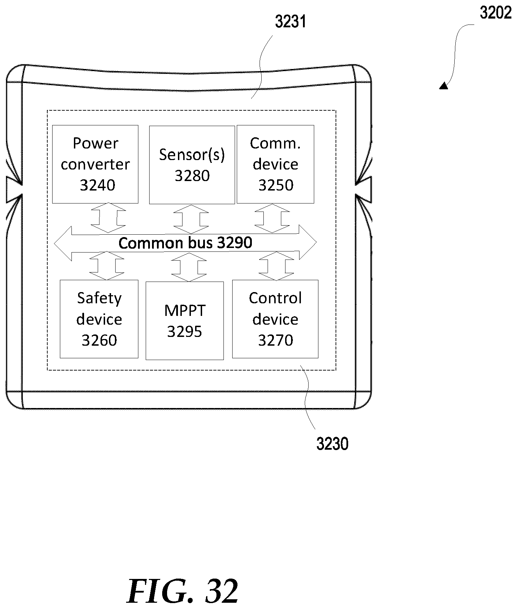

FIG. 5A depicts an example PV module 500 and PV cell array 510 with electrical parallel substrings 102 in accordance with one or more aspects. Solid black lines and solid white lines shown in FIG. 5A depict conductive paths. For example, solid white lines may be conductive paths through PV cell 104 silicon, and solid black lines may be conductive paths through, for example, ribbon wire. However, the conductive paths may be through any number of different conductive media, for example, through PV cells, silver fingers, busbars, conductive backsheets, ribbon wire, etc. FIG. 5B depicts an example electrical schematic of an example of the PV module 500 and PV cell array 510 of FIG. 5A. As discussed herein, PV modules may have a single junction box 242A where electrical connections may be disposed as described herein. Further, PV module 500 may have a positive and a negative terminal, or leads, connected to the positive and negative busses respectively of the PV cell array 510. The leads may emerge from or be connected with a junction box (e.g., first junction box 242BA and/or second junction box 242BB). As shown in FIG. 5A, PV module 500 may include first junction box 242BA and second junction box 242BB. Substring 102 connections may be made in either first junction box 242BA and/or second junction box 242BB. PV module leads may be connected with either first junction box 242BA and/or second junction box 242BB. For example, the positive lead may connect to the positive bus of PV module 500 in first junction box 242BA and emerge from and/or be connected with first junction box 242BA; and the negative lead may connect to the negative bus of PV module 500 in second junction box 242BB and emerge from and/or be connected with second junction box 242BB. Either lead may be connected with and/or emerge from either first junction box 242BA or second junction box 242BB. Alternatively, both leads may emerge from and/or be connected with a single of the two junction boxes 242BA and/or 242BB. Further, either of the two junction boxes 242BA or 242BB may house and/or integrate (e.g., with the PV cell array 510) power electronics (PEs) (e.g., PE 3202 as shown in FIG. 32) or other electronics as described in further detail herein.

Depending on the application and circumstances, it may be advantageous to selectively orient PV modules and the PV cell array disposed on PV module. For example, PV modules (e.g., PV modules 100, 200, 300, 400 and 500) may be rectangular in shape (e.g., having a long end and a short end) and depending on the installation surface, the surrounding area, shading concerns, azimuth, etc. it may be advantageous to install PV modules in a landscape orientation (e.g., with the PV module long end extending in a left-right direction, or in portrait orientation (e.g., with the PV module short end extending in a left-right direction). As described herein, PV modules may be divided in half along substantially a midline with a first half of substrings 102 disposed on the first half of PV module, and a second half of substrings 102 disposed on the second half of PV module. In some aspects and applications, PV modules may be partitioned by a reference midline dividing the PV module length. Such a reference midline need not divide the PV module length/width into two equal lengths/widths. In such aspects, rows of sub-substrings 106 may extend from the midline to a PV module short side, extending substantially half of the PV module length (defining a landscape-oriented PV cell array). It may be appreciated that according to some applications, PV modules with landscape-oriented PV cell array, may be installed either in landscape or portrait orientations with respect to the horizon. PV modules with landscape-oriented PV cell array may contain two-row substrings 102A, four-row substrings 102B, or substrings 102 with an alternate number of rows. In other aspects and applications, PV modules may be, for purposes of example, partitioned by a midline dividing the PV module width. In such aspects, rows of sub-substrings 106 may extend from the midline to a PV module long edge, extending substantially half of the PV module width (defining a portrait-oriented PV cell array). It may be appreciated that according to applications, PV modules with portrait-oriented PV cell arrays, may be installed either in landscape or portrait orientation with respect to the horizon. PV modules with portrait-oriented PV cell arrays may contain two-row substrings 102A, four-row substrings 102B, or substrings with an alternate number of rows. According to aspects of the present disclosure, PV modules and PV cell arrays may have a substantially square aspect ratio. PV modules with square PV cell arrays may contain two-row substrings 102A, four-row substrings 102B, or substrings with an alternate number of rows.

FIG. 6A depicts an example PV module 600 with a PV cell array 610 having a portrait orientation. Solid black lines shown in FIG. 6A depict a conductive path. The conductive path may be through any number of different conductive media, for example, through PV cells, silver fingers, busbars, conductive backsheets, ribbon wire, etc. FIG. 6B depicts an example electrical schematic of an example of the PV module 600 and PV cell array 610 of FIG. 6A. Similar to PV cell arrays having a landscape orientation, the PV cell array 610, oriented in portrait, may be arranged such that all substrings may be electrically connected in parallel with minimal conductor intersection outside of a junction box (e.g., junction box 242A). Such arrangements may allow for improved PV module performance and reduced cost and complexity of manufacturing, for example, reducing conductor shielding and/or insulation. Substrings may be disposed on PV module 600 as four-row substrings 102B in rows of four quad sub-substrings 106B. For example, four-row substring 102BA, may be divided into four quad sub-substrings 106BAA, 106BAB, 106BAC, and 106BAD. Accordingly, the number of quad sub-substrings 102B per half of the PV module 600, may equal the number of four-row substrings 102B per half of the PV module 600 multiplied by four. Each four-row substring 102B may extend as follows: the first quad sub-substring 106B (e.g., quad sub-substring106BAA) may extend from a positive terminal proximate a PV module midline to a substring electric potential quarter point proximate a PV module edge; the second quad sub-substring 106B (e.g., quad sub-substring 106BAB) may extend from the substring electric potential quarter point to a substring electric potential midpoint proximate the PV module midline; the third quad sub-substring 106B (e.g., quad sub-substring 106BAC) may extend from the electric potential midpoint to a substring electric potential three-quarter point proximate the PV module edge; and the fourth quad sub-substring 106B (e.g., quad sub-substring 106BAD) may extend from the substring electric potential three-quarter point to the substring negative terminal proximate the PV module midline.

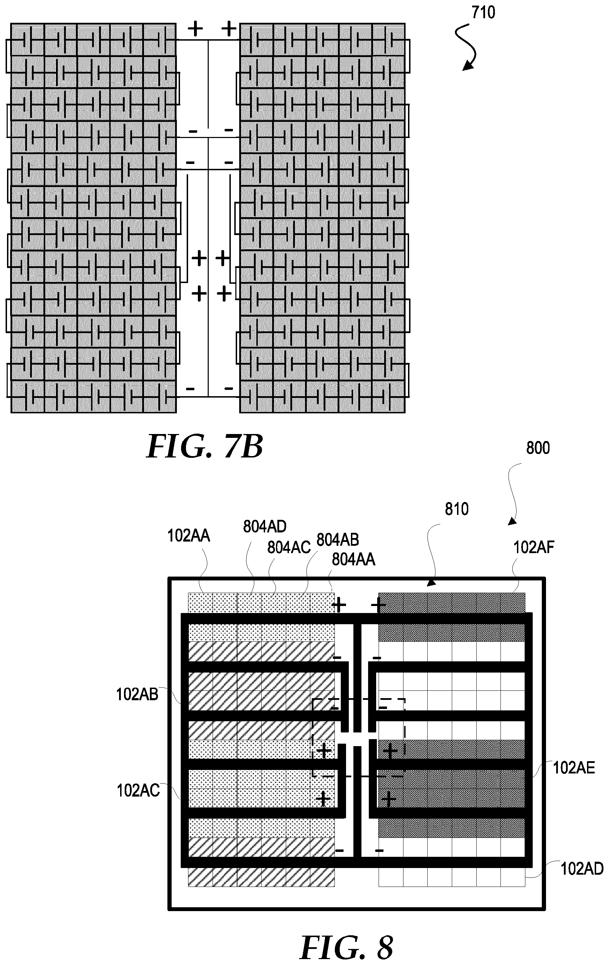

FIG. 7A depicts an example PV module 700 and PV cell array 710 having a portrait orientation in accordance with one or more aspects of the present disclosure. Solid black lines and solid white lines shown in FIG. 7A depict conductive paths. For example, solid white lines may be conductive paths through PV cell 104 silicon, and solid black lines may be conductive paths through, for example, ribbon wire. However, the conductive paths may be through any number of different conductive media, for example, through PV cells, silver fingers, busbars, conductive backsheets, ribbon wire, etc. FIG. 7B depicts an example electrical schematic of an example of the PV module 700 and PV cell array 710 of FIG. 7A. Referring to FIGS. 7A and 7B, similar to two-row substrings 102A as described herein, positive terminals of each four-row substring 102B may terminate proximate to and electrically connect to the positive terminal of a first neighboring four-row substring 102B, and negative terminals of each four-row substring 102B may terminate proximate to and electrically connect to the negative terminal of a second neighboring four-row substring 102B. For example, the positive terminal of four-row substring 102BA may terminate proximate to and electrically connect to the positive terminal of first neighboring four-row substring 102BF, and the negative terminal of four-row substring 102BA may terminate proximate to and electrically connect to the negative terminal of second neighboring four-row substring 102BB.

Similar to two-row substring 102A PV modules as described herein, four-row substring 102B PV modules (e.g., PV modules 600 and 700) may include junction box 242A. Electrical connections may remain to complete the parallel connection of the four-row substrings 102B. Junction box 242A may facilitate such electrical connections where positive and negative PV cell array busses (e.g. conductors) may be routed into a junction box 242A and the positive and negative lines of the PV cell array 710 may be connected to the respective busses. For example, conductors may be electrically connected to the positive connections between: four-row substrings 102BA and 102BF, four-row substrings 102BB and 102BC, and four-row substrings 102BD and 102BE. The conductors may be routed into junction box 242A and connected to one another. Additionally, conductors may be electrically connected to the negative connections between: four-row substrings 102BA and 102BB; four-row substrings 102BC and 102BD, four-row substrings 102BE and 102BF. The conductors may be routed into junction box 242A and may be connected to one another. As it will be appreciated, arranging the four-row substrings 102B in accordance with one or more aspects of the present disclosure may allow the parallel connection of all four-row substrings 102B absent conductor intersections outside of junction box 242A. PV module positive and negative leads may be added to the positive and negative busses of the PV cell array and may emerge from, be disposed in, or connected with a junction box 242. The four-row substring 102B PV module may then be used in power systems and as described herein.

Similar to two-row substring 102A PV modules, four-row substring 102B PV modules may contain multiple junction boxes (e.g., first junction box 242BA and second junction box 242BB). Substring 102 connections as described herein may be made in any junction box. PV module leads may be connected with any junction box 242. Either lead may be connected with and/or emerge from any junction box 242. Alternatively, both leads may emerge from and/or be connected with a single of the multiple junction boxes 242. Further, any of the junction boxes 242 may house and/or integrate power electronics (PEs) (e.g., PE 3202 as shown in FIG. 32) or other electronics as described in further detail herein.

Still referring to FIGS. 7A and 7B, PV modules 700 may contain one or more substring three-quarter point cross-ties 756 (e.g., positioned at the substring electric potential three-quarter point) and one or more substring quarter point cross-ties 758 (e.g., positioned at the substring electric potential quarter point). Substring three-quarter point cross-ties 756 and substring quarter point cross-ties may improve power output of the PV cell array 710 under partial shading or otherwise mismatched conditions, for example, by increasing the level of parallelization of four-row substrings 102B and the PV cell array 710. Substring three-quarter point cross-ties 756 may electrically connect the electric potential three-quarter point of two neighboring substrings 102. Similarly, substring quarter point cross-ties 758 may electrically connect the electric potential quarter points of two neighboring substrings. For example, substring three-quarter point cross-tie 756 may electrically connect the electric potential three-quarter point of four-row substring 102BA to the electric potential three-quarter point of four-row substring 102BB. Further, substring quarter point cross-tie 758 may electrically connect the electric potential quarter point of four-row substring 102BB to the electric potential quarter point of four-row substring 102BC. PV modules 700 may contain substring three-quarter point cross-ties 756 alone, substring quarter point cross-ties 758 alone, or both.

If four-row substrings 102B are arranged in accordance with one or more aspects of the present disclosure, substring electric potential three-quarter points, and substring electric potential quarter points may be disposed proximate to a PV module edge and/or a PV cell array edge. Further, as a consequence of the four-row substring 102B arrangement of the present disclosure, the electric potential three-quarter points of a four-row substring 102B (e.g., four-row substring 102BB) and a first neighboring four-row substring 102B (e.g., four-row substring 102BA), and the electric potential quarter points of a four-row substring 102B (e.g., four-row substring 102BB) and a second neighboring four-row substring 102B (e.g., four-row substring 102BC), may be proximate to each other without any other electric potential points intervening. The terms first neighbor and second neighbor are for purposes of depiction only and are not intended to be limiting. It may be appreciated that, among other methods of connection, a ribbon wire or other conductor may be soldered directly to, or otherwise electrically connected to the electric potential three-quarter points of neighboring four-row substrings 102B absent conductor intersection from other conductors. Similarly, it may be appreciated that, among other methods of connection, a single ribbon wire or other conductor may be soldered directly to, or otherwise electrically connected to the electric potential quarter points of two neighboring four-row substrings 102B absent conductor intersection from other conductors. Such apparatuses and methods may allow for the increased ease and reduced cost and complexity of manufacturing PV modules according to the present disclosure.

Two-row substrings and four-row substrings are depicted and described in detail herein, but it will be appreciated by those of ordinary skill in the art that the present disclosure contemplates substrings comprising additional rows of sub-substrings. Specifically, for example, the present disclosure may be practiced with substrings comprising rows of sub-substrings at least in any even number. For a substring comprising any even number of sub-substrings the positive terminals of all of the substrings may terminate proximate to the positive terminals of a first neighboring substring, and the negative terminals of all of the substrings may terminate proximate to the negative terminal of a second neighboring substring. Further, it may be appreciated that the $\frac{n-1}{n}$ electric potential point of a substring may be cross-tied to the $\frac{n-1}{n}$ electric potential point of a first above or below neighboring substring and the $\frac{1}{n}$ electric potential point of a substring may be cross-tied to the $\frac{1}{n}$ electric potential point of a second above or below neighboring substring; where n is the number of rows of sub-substrings in the substring.

Additional static reconfiguration may be utilized to further mitigate the effects of mismatch or the partial shade condition and/or reduce manufacturing complexities. High degrees of substring parallelization may be achieved while maintaining substring spatial separation and simplified rear PV cell array connection and manufacturing. Additionally or alternatively, high degrees of cross-tie electrical connection as described herein may be achieved according to aspects of the present disclosure. Such arrangements may allow for increased mismatched condition mitigation and increased performance by distributing the effects of reduced irradiation, or the partial shading condition, over a larger area of a PV cell array by decreasing the occurrence of shading in the same substring group. Further, the arrangements of the present disclosure may additionally or alternatively decrease manufacturing difficulty by utilizing conductive backsheets as described herein. Such arrangements may be achieved with rear contact PV cells 904 (e.g., metal wrap through (MWT), interdigitated back contact (IBC), etc.) and conductive backsheets 901.

FIG. 9A depicts an example conductive backsheet 901A of the example distributed PV cell array 1010 of FIGS. 10A-10B. Conductive backsheet 901 may be fabricated from any conductive material (e.g., copper, silver, etc.). Conductive backsheet 901, may be cut (depicted as black lines in FIG. 9A) via, for example, laser cutter, plasma cutter, etc., in particular patterns to form conductive regions (depicted as white spaces between cuts) as desired. Conductive regions may be categorized as conductive pads 908 configured to electrically join adjacent rear contact PV cells 904 (e.g., conductive pads 908 configured to electrically serially connect two adjacent rear contact PV cells 904) and conductive traces 940 and 912 configured to transmit electrical power (e.g., conductive traces 940A, 940B, 940C, 940D, 960A, and 960B etc.). The terms conductive pads 908 and conductive traces 940 and 960 are merely example terms of the more general conductive regions and should not be construed to limit the scope of the present disclosure. Conductive pads 908 may terminate in conductive traces 940 or 960 (see, e.g., conductive trace 960A of TCT substring 902A of FIG. 9B) and conductive traces 940 or 960 may terminate in conductive pads 908. Additionally or alternatively, conductive regions may function as both conductive pads 908 and conductive traces 940 or 960 or function as neither. Rear contact PV cells 904 may be electrically attached to conductive backsheet 901 by, for example, conductive paste, forming a desired distributed PV cell array 1010 as described herein. Various forms of conductive backsheets are contemplated and some are described in more detail herein.

All conductive backsheets described herein may facilitate the connection and/or use of one or more electronics (e.g., power electronics (e.g., PE 3202), passive electronics, etc.) with the conductive backsheet PV cell array by directly incorporating circuitry and/or circuit paths with the conductive backsheet. For example, conductive paths (e.g., conductive traces) may be etched and/or otherwise formed in the conductive backsheets. The conductive paths may be formed such that electronics (e.g., power electronics (e.g., PE 3202), passive electronics, etc.) may be easily added (e.g., plugged, connected, soldered, etc.) to the backsheet which may consequently connect the electronics to one or more additional electronics and/or PV generators of the conductive backsheet PV cell array. For example, power electronics (e.g., PE 3202) may be provided as one or more application-specific integrated circuits (ASICs). One or more conductive traces may be etched and/or otherwise formed in any conductive backsheet herein such that one or more power electronic ASICs may be simply connected to the conductive backsheet (e.g., plugged into, soldered onto, etc.). The conductive traces etched and/or otherwise formed in the conductive backsheet may connect the one or more power electronic ASICs with one or more PV generators of the PV cell array of the conductive backsheet. In such a manner, power electronics may be simply connected with a conductive backsheet PV cell array at different levels of granularity. For example, in such a manner, power electronics may be added and connected for each PV cell, for each string of PV cells, and/or for the entire PV cell array (e.g., PV module) of the conductive backsheet. Such electronics may be incorporated with the PV cell array at the production stage. Additionally, such electronics may reduce the parts required for incorporated electronics (e.g., as opposed to electronics incorporated with the conductive backsheet, electronics added to a PV cell array post array production may require dedicated housings, dedicated connectors, extended conductors, etc.). Additionally, such electronics may be incorporated with the PV cell array on differing levels of granularity. For example, electronics added to a PV cell array post array production may only act on the power produced by the entire array (e.g., because such electronics may be connected to the PV array leads). Whereas, incorporating electronics with the conductive backsheet may allow for the incorporation of electronics on any level of the PV cell array, for example, a PV string level or even a PV cell level. As such, incorporating electronics with the conductive backsheet as described herein may reduce the cost and increase the efficiency of the PV cell arrays.

FIG. 10A depicts the electrical interconnectivity of an example 3x3, substring cross tied distributed PV cell array 1010 according to one or more aspects. For purpose of description only, distributed substrings 1002 (e.g., distributed substring 1002A, 1002B etc.) are patterned in the drawings. Many examples of distributed substrings 1002 are provided herein (e.g., 1002A, 1002B, 1002C, etc.) and are referred to generally as distributed substrings. Distributed substrings 1002 of the same referential pattern (e.g., 1002A, 1002B, and 1002C) may be electrically connected in parallel. Electrical connections between distributed substrings 1002 may be referred to as electrical bus 1040A, 1040B, 1040C, and 1040D (e.g. conductors) in FIG. 10A and correspond to the electrical connections effected by, for example, conductive trace 940A, 940B, 940C, and 940D of FIG. 9A respectively.

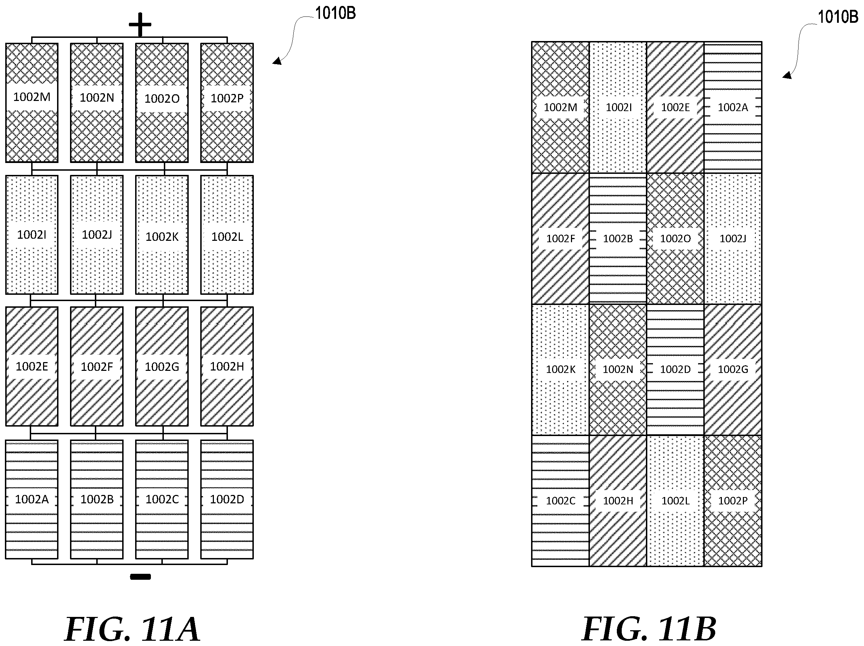

FIG. 10B depicts an example physical layout of distributed substring 1002 of the example 3x3 conductive backsheet PV cell array 1010A of FIG. 10A according to one or more aspects. Distributed substrings 1002 may be arranged and/or disposed in the distributed PV cell array 1010A in a quantity of rows and columns (e.g., three rows by three columns). FIGS. 10A-10B depict example PV cell arrays having three rows and three columns, however persons of ordinary skill will recognize that the principles herein may be applied to PV cell arrays having different numbers of rows and/or columns (e.g., PV cell arrays depicted in FIGS. 11A-12B, and 14A-24B). Distributed substrings 1002, may be electrically connected in parallel (e.g., as in FIG. 10A), and may be spatially arranged variously (e.g., as in FIG. 10B), for example spatially distributed (e.g., parallelly connected substrings 1002 disposed in different rows and/or different columns) within a distributed PV cell array 1010A and/or on a PV module. For example, referring to FIG. 10A, distributed substrings 1002A and 1002B may be electrically connected in parallel. However, referring to FIG. 10B, distributed substrings 1002A and 1002B may be physically nonadjacent, for example, disposed in different rows and/or different columns. Such an arrangement may allow for the distribution of shading effects over an entire distributed PV cell array 1010A, maximizing power output under the mismatch or partial shading condition.

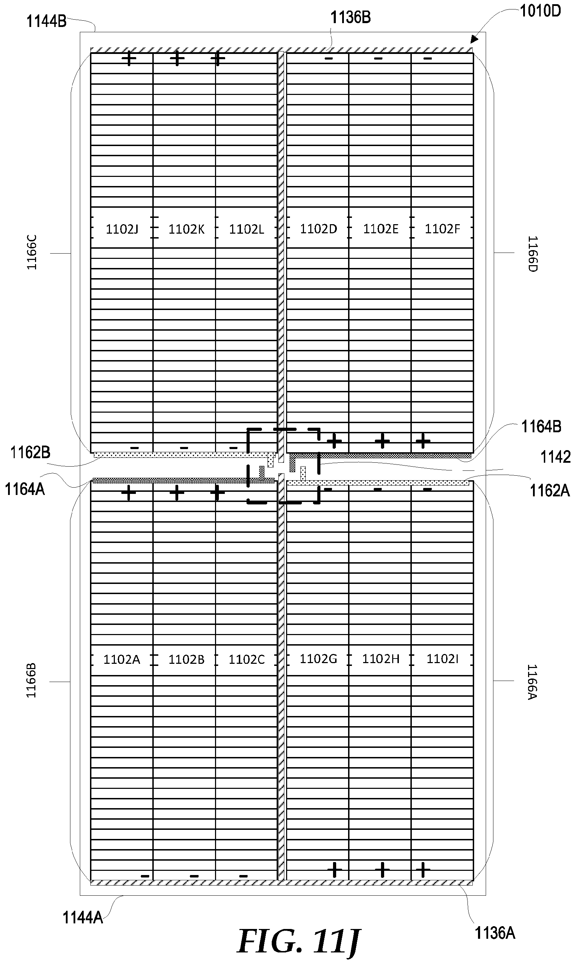

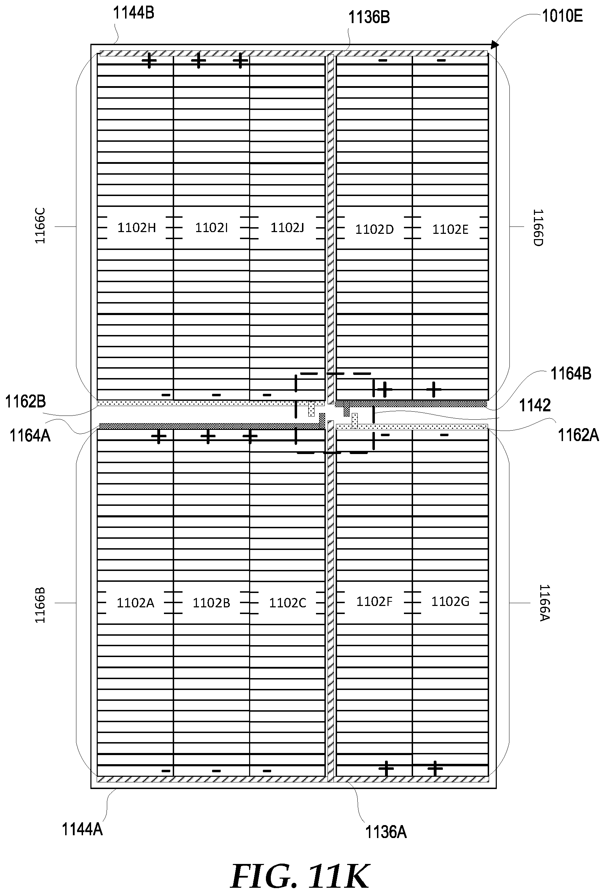

Using conventional methods of PV cell array production, electrically connecting such an electrically parallel spatially distributed PV cell array can, be complex, and design time and design cost consuming. Conventional methods may reduce the overall cost in production but create additional design constraints. Utilizing the apparatuses, systems, and methods of the present disclosure, such increased partial shade condition mitigation may be achieved with reduced complexity of electrically connecting the PV array. For example, conductive regions effecting the highly parallelized, spatially distributed PV cell array topologies of the present disclosure may be simply patterned, for example, into conductive backsheet 901 as described herein (further, arrangements as described with respect to FIGS. 11J and 11K may be leveraged to effectuate simplified electrically parallel connected spatially distributed PV cell arrays without the use of conductive backsheets).

Referring to FIG. 9A, conductive backsheet 901A may be patterned forming desired conductive regions. Cuts or areas lacking conductive material in conductive backsheet 901A may be depicted as black lines while conductive regions may be depicted by the regions remaining following the example conductive material removal and/or conductive material deposit as described herein. Rear contact PV cells 904 may be placed on, and electrically connected to, the conductive regions forming distributed substrings 1002. Multiple examples of rear contact PV cells 904 are depicted herein (e.g., rear contact PV cells 904IA, 904IB, 904GA, 904GB, etc.) and are generally referred to as rear contact PV cells 904. FIG. 9A depicts three distributed substrings 1002 (distributed substrings 1002 that correspond with distributed substrings 1002G, 1002H, and 1002I of FIGS. 10A-10B) with example transparent rear contact PV cells 904 overlaid on the conductive backsheet 901A. Rear contact PV cells 904 corresponding to other distributed substrings 1002 (e.g., distributed substrings 1002A, 1002B, etc.) have been omitted from FIG. 9A for clarity of depiction and description. Conductive traces 940A, 940B, 940C and 940D of FIG. 9A correspond to electrical buses 1040A, 1040B, 1040C, and 1040D of FIG. 10A respectively. According to aspects of the present disclosure, distributed substrings 1002 may be electrically connected in parallel and maintain spatial distribution within the distributed PV cell array 1010A. For example, distributed substrings 1002G, 1002H and 1002I may be connected in parallel via conductive trace 940A (corresponding to electrical bus 1040A) and conductive trace 940B (corresponding to electrical bus 1040B) but may be spatially nonadjacent (e.g., in a different row and column) and arranged diagonally across conductive backsheet 901A and distributed PV cell array 1010A. Such parallel electrical configuration along with distributed spatial arrangement may increase the PV module resistance to the effects of mismatch or the partial shading condition as described herein. Additionally, the use of conductive backsheet 901 and rear contact PV cells 904 may alleviate some of the complex and time-consuming electrical connection necessary to effectuate distributed PV cell arrays 1010. Additionally, the use of conductive backsheet 901 and rear contact PV cells 904 may reduce the occurrences of imperfect electrical connections among conventional PV cell array production.

Still referring to FIG. 9A, distributed PV modules may have a junction box 942. Some, or all, of the conductive traces 940 (e.g., conductive trace 940A, conductive trace 940B, conductive trace 940C, etc.) may terminate in junction box 942. Conductive traces 940 may then be selectively electrically connected completing the distributed PV cell array circuitry. Conductive backsheet PV module terminals or leads may be connected to the conductive backsheet PV module at junction box 942. Conductive backsheet PV module leads may allow access to the power produced by conductive backsheet PV module and may allow for the addition of conductive backsheet PV module into a larger power system. Conductive backsheet PV module leads may allow, for example, conductive backsheet PV module to be connected to other PV modules in either series, parallel or any other arrangement. Additionally or alternatively, conductive backsheet PV module leads may allow for the connection of power optimizers, maximum power point trackers (MPPTs), DC-DC converters, string inverters, micro-inverters, batteries, etc. to the conductive backsheet PV module as described in more detail herein.

FIG. 9B depicts an example conductive backsheet 901B according to one or more aspects of the present disclosure. Conductive backsheet 901B may be similar to aspects of conductive backsheet 901A, 901C, 901F, 901G, and 901H (and that which is described in relation to conductive backsheets 901 generally) (e.g., methods of production, methods of electrically connecting rear contact PV cells, etc.) unless otherwise described in relation to conductive backsheet 901B. Referring to FIG. 9B, additional and/or alternative substring interconnectivity schemes may be realized utilizing aspects of the present disclosure. For purposes of example, FIG. 9B depicts ten row TCT substrings 902 of two rear contact PV cells 904 per row. Rear contact PV cells 904 are depicted as translucent for purposes of depiction. Black lines represent areas lacking conductive material and white spaces between black lines represent conductive regions. By removing or not removing specific areas of conductive backsheet 901B, cross-ties between parallel connected rear contact PV cells 904 may be easily gained. Referring to FIG. 9B, each row of TCT substrings 902 may contain two rear contact PV cells 904 electrically connected to each other, via conductive pads 908, in parallel (i.e., the terminals of one polarity of each rear contact PV cell 904 may be electrically connected to the terminals of the same polarity of rear contact PV cells 904 on the same substring row). The substring rows may be connected to the rows above and/or below, via conductive pads, in series (where the terminals of one polarity of each row may be electrically connected to the terminals of the opposite polarity of the above and/or below rows). Further, by not removing the conductive material between rear contact PV cells 904 of a row, adjacent rows may be electrically connected in series-parallel with total-cross ties (TCT) as TCT substrings 902 (e.g., 902A, 902B, etc.) further improving the partial shade condition mitigation and/or mismatch condition mitigation of the PV cell array. TCT substrings 902 (e.g., 902A) may be serially connected to other TCT substrings 902 (e.g., 902B). Referring to FIG. 9B, TCT substring 902A may be serially connected to TCT substring 902B, via conductive trace 960B. Similarly, TCT substring 902B may be serially connected to TCT substring 902C via conductive trace 960C. Alternatively, some or all of TCT substrings 902 may be electrically connected in parallel. It may be appreciated that similar to other example aspects, conductive backsheet 901B of FIG. 9B may contain conductive pads 908 that terminate in conductive traces 960 and vice versa. Thus, the depiction of a conductive pad 908 and conductive trace 960 as one contiguous conductive region.

Power produced by TCT substrings 902 may be transmitted to junction box 942 via conductive traces 960 (e.g., 960A, 960B, etc.). Some or all of conductive traces 960 may terminate in junction box 942. Conductive traces 960 may then be selectively electrically connected, completing the circuitry of distributed PV cell array of conductive backsheet 901B. TCT substrings 902 may be further connected in series, series-parallel, parallel and/or TCT in junction box 942. Conductive traces 960 may route along the sides of substrings (e.g., conductive trace 960A along distributed substring 902A), between substrings (e.g., conductive trace 960C between distributed substrings 902E and 902F), along a side of conductive backsheet 901B (e.g., conductive trace 960A along distributed substring 902A), toward the middle of conductive backsheet 901B (e.g., conductive trace 960A along distributed substring 902A), or anywhere else on conductive backsheet 901B in any combination of the above. FIG. 9B depicts conductive backsheet PV module with single junction box 942. According to other aspects of the present disclosure, distributed PV modules may include multiple junction boxes. Some electrical connections between conductive traces 960 may be effectuated in one junction box while other electrical connections between conductive traces 960 may be effectuated in another junction box. Conductive backsheet PV module terminals or leads may be disposed in junction box 942. Alternatively, in multi-junction box configurations, conductive backsheet PV module terminals or leads may be disposed in any of the plurality of junction boxes and/or may be differently divided among the plurality of junction boxes.

FIG. 9C depicts a cross section of an example conductive backsheet 901A of FIG. 9A having multiple thicknesses. Conductive backsheet 901 (e.g., conductive backsheet 901A-901G) may be of uniform thickness. Alternatively, conductive backsheet 901 (e.g., conductive backsheet 901A-901G) may be of nonuniform thickness (e.g., comprise different and/or multiple thicknesses). Advantages of a nonuniform thickness (e.g., multiple thickness) backsheet 901 may be realized for conductive traces 940 (and 960) or pads 908 requiring increased current carrying capabilities. For example, referring to FIG. 9A, conductive trace 940A may be routed from distributed substring 1002G (at the upper left most corner of the PV cell array) to junction box 942. Conductive trace 940A may carry current produced by distributed substring 1002G to junction box 942. Therefore, it may be advantageous for conductive trace 940A (and/or other conductive traces 940) to be of sufficient cross section to carry the produced current while minimizing resistance. Further, conductive trace 940A (and other conductive traces 940) may be routed alongside other distributed substrings (e.g., conductive trace 940 from distributed substring 1002G may be routed between distributed substring 1002H and the distributed substring 1002 adjacent to the right of distributed substring 1002H), adding "dead space" to the distributed PV cell array 1100 where rear contact PV cells may not be disposed. Therefore, increasing the width of a conductive trace 940 (e.g., conductive trace 940A from distributed substring 1002G) may increase the "dead space" and overall size of a distributed PV cell array 1010, and decreasing the width of a conductive trace 940 (e.g., conductive trace 940A from distributed substring 1002G) may cause increased resistance to current flow along the conductive trace 940.

To relieve this conflict, conductive backsheet 901 (e.g., conductive backsheet 901A-901G) may be of multiple (e.g., nonuniform) thicknesses. For example, conductive backsheet 901 may be one thickness for conductive pads 908 and areas backing rear contact PV cells 904 and may be another thickness (e.g., thicker) for areas of longer conductive traces 940 (e.g., conductive trace 940A of FIG. 9A routed from distributed substring 1002G to junction box 942, or conductive trace 960A of FIG. 9B routed from TCT substring 902A to junction box 942) or for traces intended to carry an increased current compared to other traces. Conductive backsheet 901 may have multiple different areas of multiple different thicknesses depending on the application. Multiple (e.g., nonuniform) thickness conductive backsheets 901 may be patterned from a nonuniform thickness stock conductive backsheet. Additionally or alternatively, layers of conductive material may be added to a uniform or otherwise nonuniform thickness conductive backsheet 901. For example, conductive material may be deposited on the backside of conductive trace 940A routing from distributed substring 1002G, thereby increasing the cross-sectional area of the conductive trace 940A and resulting in a multiple thickness conductive backsheet 901.

FIG. 9D depicts a cross section of an example conductive backsheet 901 of FIG. 9A as a PCB type backsheet. Conductive backsheet 901 (e.g., conductive backsheet 901A-901G) may comprise a printed circuit board (PCB) type design. PCB type conductive backsheets 901 may comprise a single layer, or multiple layers, of conductive material disposed on a single layer, or multiple layers of a dielectric substrate (e.g., fiberglass, a prepreg, etc.). Conductive regions and circuits may be etched or otherwise patterned into the conductive layers. Additionally or alternatively, conductive regions may be deposited on a dielectric substrate (via e.g., chemical vapor deposition, atomic layer deposition, etc.) Multiple layers of conductive material may be used. For example, a two conductive layer PCB style conductive backsheet 901 may have a first (e.g., top) conductive layer 968, a middle dielectric layer 970 and a second (e.g., bottom) conductive layer 972. Conductive layers (e.g., top conductive layer and bottom conductive layer) may be electrically connected through, for example, via holes 974 where desired. Such PCB type conductive backsheet 901 design may minimize or substantially eliminate conducive pathway "dead space." For example, the top conductive layer 968 may only contain the conductive regions (e.g., conductive pads 908) functioning to serially connect the rear contact PV cells 904 of each distributed substring 1002, but may not contain the conductive traces 940 or 960 to interconnect the distributed substrings 1002. According to such configurations, distributed substrings 1002 and TCT substrings 902 may be disposed substantially proximate to one another without "dead space" for the conductive pathways 940 or 960. The conductive traces 940 or 960, to interconnect the distributed substrings 1002 or TCT substrings 902, may be disposed on the bottom conductive layer 972. The conductive regions (e.g., conductive pads 908) at the terminal of each or some distributed substrings 1002 or TCT substrings 902 may connect to conductive regions (e.g., conductive traces 940) on the bottom conductive layer 972. The top conductive layer 968 and bottom conductive layer 972 may electrically connect to each other with, for example, via holes 974 through the dielectric substrate 970. The top and/or bottom conductive layers may contain conductive regions to effectuate other electrical connections as necessary (e.g., integrating electronics as discussed herein). Utilizing such a PCB type conductive backsheet may allow for conductive pathways 940 and 960 of varied cross-sectional area and reduce or substantially eliminate conductive pathway "dead space," by utilizing multiple layers of conductive material. PCB type conductive backsheets may contain 1, 2, or more layers of conductive material, each layer may be separated by a dielectric (e.g., fiberglass, a prepreg, etc.). Such PCB type conductive backsheets may facilitate the incorporation of electronics (e.g., power electronics as discussed in further detail herein), with a conductive backsheet PV module by directly incorporating circuitry for such electronics with the PCB type conductive backsheet.

Various sized distributed PV cell arrays 1010 may be practiced utilizing aspects of the present disclosure. FIG. 11A depicts the electrical interconnectivity of an example 4x4 cross tied distributed PV cell array. Similar to FIGS. 10A-10B, distributed substrings 1002 depicted with similar patterns (e.g., distributed substrings 1002A, 1002B, 1002C, and 1002D) may be electrically connected in parallel. FIG. 11B depicts an example distributed substring 1002 arrangement of the example 4x4 PV cell array of FIG. 11A according to one or more aspects. According to aspects herein it may be simplified to produce PV cell arrays of electrically parallel connected and spatially distributed substrings 1002. Using conventional methods of PV cell array production, electrically connecting such electrically parallel spatially distributed PV cell arrays may carry high design time and design costs. Such production may require, for example, complex conductor wiring that may require, for example, multiple layers of insulation and/or shielding. As it may be appreciated, electrically parallel connected and varied spatially distributed substrings may be achieved with distributed PV cell arrays 1010 of the present disclosure. For example, FIG. 11A depicts the four distributed substrings 1002A, 1002B, 1002C, and 1002D connected in parallel. FIG. 11B depicts an example spatially distributed layout or topology where distributed substrings 1002A, 1002B, 1002C, and 1002D are spatially distributed throughout the distributed PV cell array 1 010. Using conventional methods, in order to effectuate such a scheme, conductive wire (e.g., ribbon wire) may be routed up and down the PV cell array. The conductive wires may further require shielding and insulation from other conductive wires. Whereas, utilizing aspects of the present disclosure, patterns of conductive paths may be fabricated in a conductive backsheet 901 effecting distributed PV cell arrays of electrically parallelly connected and spatially distributed (i.e., nonadjacent) distributed substrings 1002. A similar simplified electrical interconnectivity may hold true for all distributed PV cell array topologies and configurations of the present disclosure.

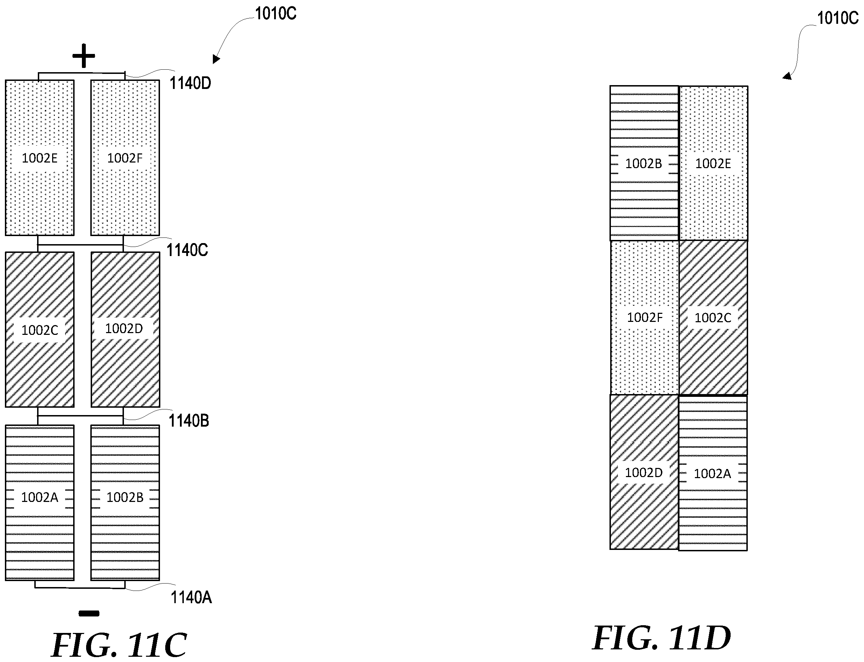

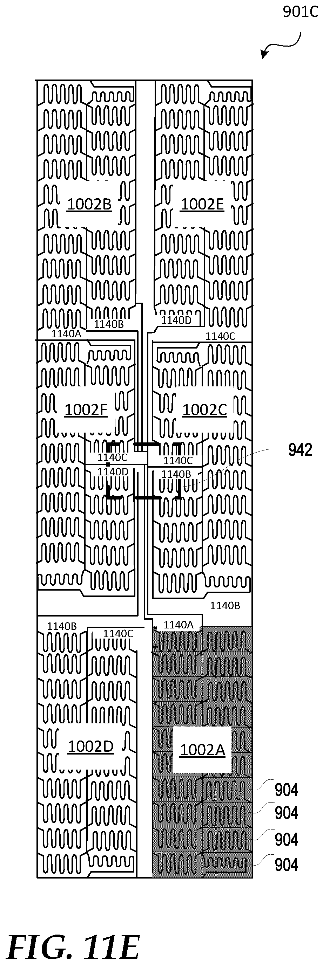

FIG. 11C depicts the electrical interconnectivity of an example 3x2 distributed PV cell array according to one or more aspects. 3x3 (see, e.g., FIGS. 9A, 10A-10B and related description) and 4x4 (see, e.g., FIGS. 11A-11B, and related description) conductive backsheet PV cell arrays have been depicted, larger and smaller arrays (e.g., 2x2, 5x5, etc.) may be similarly practiced and are contemplated herein. Symmetric conductive backsheet PV arrays 1010A and 1010B (e.g., 3x3 as depicted in FIGS. 10A-10B, 4x4 as depicted in FIGS. 11A-11B) have been depicted, asymmetric conductive backsheet PV arrays (e.g., 3x4, 4x3, etc.) may be similarly practiced and are contemplated herein. Referring to FIG. 11C, aspects of the present disclosure may be practiced with asymmetric conductive backsheet PV cell arrays 100C. FIG. 11C depicts a 3x2 conductive backsheet PV cell array 100C. Similar to FIGS. 10A-10B and 11A-11B, distributed substrings 1002 with a similar example pattern (e.g., distributed substring 1002A and 1002B) may be electrically connected to each other in parallel. FIG. 11D depicts an example distributed substring 1002 arrangement of the example 3x2 PV cell array 1010C of FIG. 11C according to or more aspects. Referring to FIG. 11D, distributed substrings 1002A and 1002B may be electrically connected to each other in parallel. However, distributed substrings 1002A and 1002B may be spatially nonadjacent to one another. The same may hold true for all or some of the distributed substrings that are electrically connected in parallel with each other. Referring to FIG. 11D, as an example, distributed substring 1002A may be element $a_{32}$ in the 3x2 matrix (the lower right-hand corner element) and distributed substring 1002B may be element $a_{11}$ in the 3x2 matrix (the upper left-hand corner element). Alternatively, parallelly electrically connect distributed substrings (e.g., distributed substrings 1002A and 1002B) may be adjacent to each other (e.g., distributed substrings 1002A and 1002B may be adjacent to one another). In yet other aspects, electrically parallelly connected distributed substrings 1002 may be variously spatially oriented as desired. Electrical connections between distributed substrings 1002 may be referred to as electrical bus 1040A, electrical bus 1040B, electrical bus 1040C, and electrical bus 1040D in FIG. 11C and correspond to the electrical connections effectuated by conductive trace 1140A, conductive trace 1140B, conductive trace 1140C, and conductive trace 1140D of FIG. 11E respectively.

FIG. 11E depicts an example conductive backsheet 901C of the example distributed PV cell array 1010C of FIGS. 11C-11D. Conductive backsheet 901C may be similar to aspects of conductive backsheet 901A, 901B, 901F, 901G, and 901H (and that which is described in relation to conductive backsheets 901 generally) unless otherwise described in relation to conductive backsheet 901C. Rear contact PV cells 904 are depicted as translucent for clarity of depiction and description. Only rear contact PV cells 904 of distributed substring 1002A are depicted while rear contact PV cells 904 of other distributed substrings 1002 (e.g., 1002B, 1002C, 1002D, etc.) have been omitted for clarity of depiction. Black lines represent areas lacking conductive material and white spaces between black lines represent conductive regions. Referring to FIG. 11E, conductive regions may be cut effectuating distributed substrings 1002 that are substantially "U" shaped (starting at the physical top (or bottom) and ending near the physical top (or bottom) of the substrings). For example, distributed substring 1002A of FIG. 11E (see also, e.g., distributed substrings 1002I, 1002H, and 1002G of FIG. 9A). However, conductive backsheets 901 (e.g., conductive backsheets 901A, 901B, etc.) may be cut to effectuate distributed substrings 1002 of various shapes and configurations. For example, referring to FIG. 11E, distributed substring 100F and 1002C may be substantially "C" shaped (starting near the physical middle of the substring and ending near the physical middle of the substring). Such flexibility may be advantageous for different reasons. For example, in FIG. 11E it may be advantageous for distributed substrings 1002F and 1002C to terminate at or near junction box 942. Such a configuration may reduce or eliminate some or all conductive traces that transmit the power produced by a distributed substring to junction box 942. Further, in some aspects, distributed substrings may be differently and variously shaped (e.g., distributed substrings may follow a zig-zag pattern). A single conductive backsheet 901 may include variously shaped distributed substrings 1002. Distributed substrings 1002 may be variously shaped for various considerations, for example, distributed substrings may be variously shape for power routing considerations, mismatch or shade tolerance considerations, for design or manufacture convenience considerations, etc.

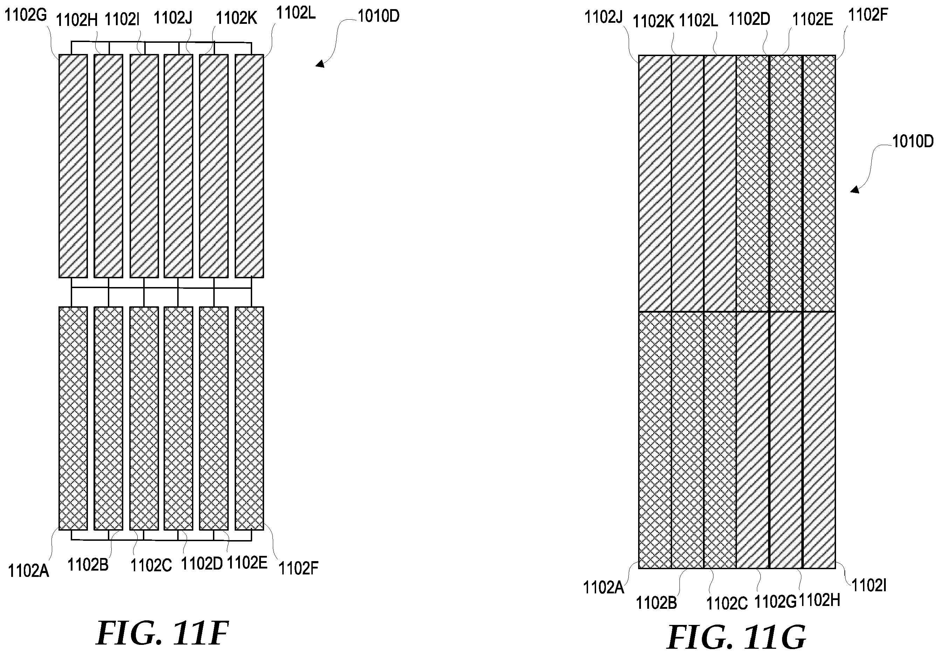

FIG. 11F depicts the electrical interconnectivity of an example 2x6 distributed PV cell array 1010D according to one or more aspects of the present disclosure. FIG. 11C depicts a distributed PV cell array 1010C having more rows of substrings than columns. Referring to FIG. 11F, distributed PV cell array 1010D may include more columns than rows. (It should be noted that columns and rows are intended to be relative terms, and depending on the orientation of the PV cell array and PV module, columns may be considered rows and rows may be considered columns). Distributed PV cell array 1010D may include twelve distributed substrings 1102A - 1102L. Distributed substrings may include a plurality of electrically serially connected PV cells. PV cells of distributed substrings 1102A - 1102L may include rear contacts PV cells (as described herein), non-rear contact PV cells, shingled PV cells, or any other type of PV cell. In the example of rear contact PV cells, PV cells of distributed substrings 1102A - 1102L may be electrically connected to each other via a conductive backsheet (as described in more detail). In the example of non-rear contact PV cells, the PV cells in distributed substrings 1102A - 1102L may be electrically connected to each other variously, including via conductors (e.g., soldered ribbon wire). Alternatively, PV cells of distributed substrings 1102A - 1102L may include shingled PV cells. Such PV cells may be overlaid to form the electrical connections between adjacent PV cells. For example, the leads of one polarity of one PV cell may be overlaid over leads of the opposing polarity of an adjacent PV cell. The electrical connection between the adjacent PV cells may be accomplished with, for example, electrically conductive adhesive or paste between the opposing leads of the adjacent PV cells.

Referring to FIG. 11F, distributed substrings 1102A - 1102F of the same electrical row (and depicted with the same pattern) may be electrically parallelly connected to each other, and distributed substrings 1102G - 1102L of the same electrical row (and depicted with the same pattern) may be electrically parallelly connected to each other. Distributed substrings of the same electrical column of FIG. 11F (e.g., distributed substrings 1102G and 1102A) may be electrically serially connected to each other. Further, the electrical column midpoints of the array may be cross-tied (i.e., electrically connected) with the other electrical column midpoints of the PV cell array further parallelizing distributed PV cell array 1010D. The columns of FIG. 11F may be electrically parallelly connected to each other. The electrical interconnection between distributed substrings 1102A - 1102L may follow the schematic of FIG. 11F.

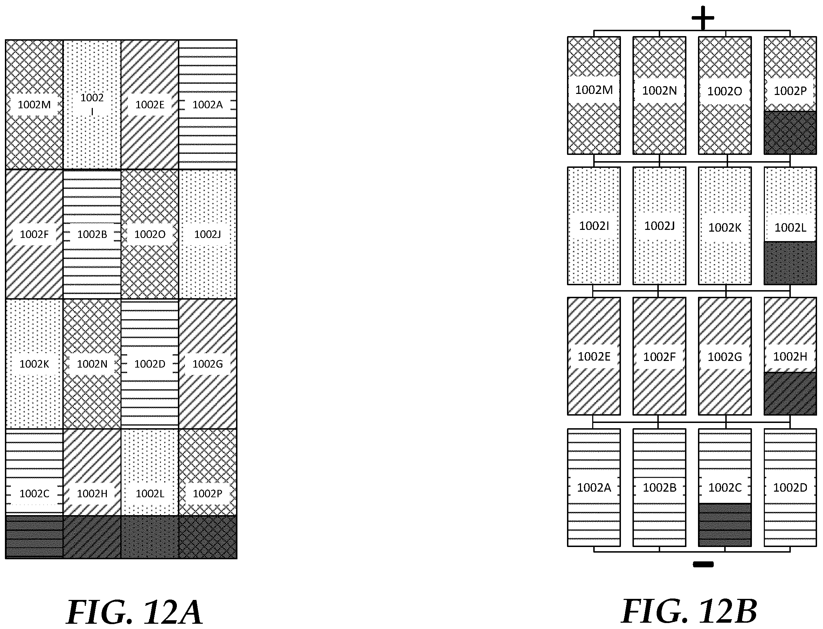

FIG. 11G depicts an example physical arrangement of the example 2x6 distributed PV cell array 1010D of FIG. 11F. Referring to FIG. 11G, electrically parallelly connected distributed substrings 1102A - 1102L may be variously physically distributed in the PV cell array. Referring to FIG. 11F, distributed substrings 1102A - 1102L of the same electrical row (depicted with the same pattern) (e.g., distributed substrings 1102L and 1102G) may be electrically parallelly connected and distributed variously. Distributed substrings 1102A - 1102C may be physically disposed at physical row 1, physical columns row 1-3. Distributed substrings 1102G - 1102I may be physically disposed at physical row 1, physical columns 4-6. Distributed substrings 1102J - 1102L may be physically disposed at physical row 2, physical columns 1-3. Distributed substrings 1102D - 1102F may be disposed at physical row 2, physical columns 4 - 6. In this way, electrically parallelly connected substrings of the same electrical row of FIG. 11F, may be physically distributed throughout a PV cell array variously. Such electrical connection and physical disposition may operate to distribute a shade pattern over distributed PV cell array 1010D and may allow for increased shade condition and/or other mismatch condition mitigation as described in more detail herein (e.g., with reference to FIGS. 12A - 12B). The distributed substrings physically disposed and arranged according to the arrangements of FIG. 11G may be electrically interconnected according to the schematics of FIG. 11F. The physical arrangements of the distributed substrings of FIG. 11F are not limited to those depicted in FIG. 11G, rather, according to aspects, distributed substrings may be distributed variously throughout distributed PV cell array 1010D.

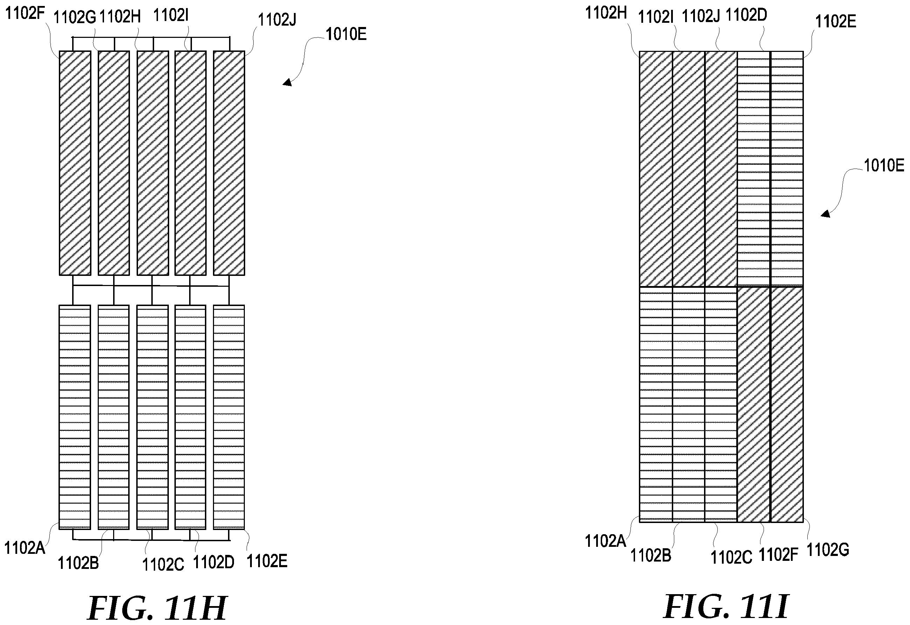

FIG. 11H depicts the electrical interconnectivity of an example 2x5 distributed PV cell array 1010E according to one or more aspects of the present disclosure. Distributed PV cell array 1010E may be similar to PV cell array 1010D in all respects except as explicitly described herein. Referring to FIG. 11H, distributed PV cell array 1010E may include an odd number of columns. Distributed substrings 1102A - 1102E of the same electrical row (and depicted with the same pattern) may be electrically parallelly connected to each other, and distributed substrings 1102F - 1102J of the same electrical row (and depicted with the same pattern) may be electrically parallelly connected to each other. Distributed substrings of the same electrical column of FIG. 11H (e.g., distributed substrings 1102F and 1102A) may be electrically serially connected to each other. Further, the electrical column midpoints of the array may be cross-tied (i.e., electrically connected) with the other electrical column midpoints of PV cell array 1010E further parallelizing the electrical connections of PV cell array 1010E. The electrical columns of FIG. 11H may be electrically parallelly connected to each other. The electrical interconnection between distributed substrings 1102A - 1102J may follow the schematic of FIG. 11H.

FIG. 11I depicts an example physical arrangement of the example 2x5 distributed PV cell array 1010E of FIG. 11H. Referring to FIG. 11I, electrically parallelly connected distributed substrings 1102A - 1102J may be variously physically distributed in PV cell array 1010E. Referring to FIG. 11FH, distributed substrings 1102A - 1102J of the same electrical row (depicted with the same pattern) (e.g., distributed substrings 1102F and 1102J) may be electrically parallelly connected and distributed variously. Distributed substrings 1102A - 1102C may be physically disposed at physical row 1, physical columns row 1-3. Distributed substrings 1102F - 1102G may be physically disposed at physical row 1, physical columns 4-5. Distributed substrings 1102H - 1102J may be physically disposed at physical row 2, physical columns 1-3. Distributed substrings 1102D - 1102E may be disposed at physical row 2, physical columns 4 - 5. In this way, electrically parallelly connected substrings, may be physically disposed throughout a PV cell array variously. Such electrical connection and physical disposition may operate to distribute a shade pattern over distributed PV cell array 1010E and may allow for increased shade condition and/or other mismatch condition mitigation as described in more detail herein (e.g., with reference to FIGS. 12A - 12B). The distributed substrings, physically disposed and arranged according to the arrangements of FIG. 11I, may be electrically interconnected according to the schematics of FIG. 11H. The physical arrangements of the distributed substrings of FIG. 11H are not limited to those depicted in FIG. 11I, rather, according to aspects, distributed substrings may be distributed variously throughout distributed PV cell array 1010E.

As described above, the PV cells of distributed PV cell array 1010D of FIGS. 11F - 11G, and of distributed PV cell array 1010E of FIGS. 11H - 11I may include any kind of PV cells including rear contact, non-rear contact, shingled cells, etc. Non-rear contact, and/or shingled PV cells may use conductors (e.g., ribbon wire) to effectuate some or all of the electrical interconnections between distributed substrings. FIG. 11J depicts an example electrical interconnection scheme of distributed PV cell array 1010D of FIG. 11G according to one or more aspects of the present disclosure. As described, conductor wire (e.g., ribbon wire) may be used to effectuate the electrical interconnection of distributed PV cell array 1010D as depicted in FIG. 11F. Lines of different patterns in FIG. 11J may depict various electrical conductors effectuating various electrical connections as described herein. Each PV cell of distributed substrings 1102A - 1102L may terminate in a positive electrical potential terminal (also referred to as positive terminal) and a negative electrical potential terminal (also referred to as negative terminal) across which the electrical potential of the PV cell may be measured. Subsequently, distributed substrings 1102A - 1102L, of electrically serially connected PV cells, may similarly terminate in positive electrical potential terminals (also referred to as positive terminals) and negative electrical potential terminals (also referred to as negative terminals) across which the electrical potential produced by distributed substring may be measured.

Referring to FIG. 11J, distributed PV cell array 1010D may include two rows and six columns of distributed substrings. Each column may, therefore, include two distributed substrings (e.g., distributed substrings 1102A and 1102J). Distributed PV cell array 1010D may be divided by substantial midlines for purposes of depiction. Longitudinal midline may divide PV cell array 1010D in a left and a right half, and a latitudinal midline may divide PV cell array 1010D in a top and a bottom half. The top and bottom halves of the PV cell array may each include two sets of electrically parallelly connected distributed substrings. Distributed substrings 1102G - 1102I may be electrically parallelly connected to each other and may be disposed on the bottom half of PV cell array 1010D as substring group 1166A. Further, distributed substrings 1102A - 1102C may be electrically parallelly connected and may be disposed on the bottom half of the PV cell array 1010D as substring group 1166B. Substring group 1166A may be arranged such that the positive terminals of distributed substrings 1102G- 1102I may be disposed proximate to the PV cell array bottom edge 1144A. Distributed substrings of substring group 1166A may extend from the PV cell array bottom edge 1144A toward the latitudinal midline. The distributed substrings of substring group 1166A may terminate in a negative terminal substantially proximate to the latitudinal midline. Substring group 1166B may be arranged such that the negative terminals of distributed substrings 1102A - 1102C may be disposed proximate to the PV cell array bottom edge 1144A. Distributed substrings of substring group 1166B may extend from the PV cell array bottom edge 1144A toward the latitudinal midline. The distributed substrings of substring group 1166B may terminate in a positive terminal substantially proximate to the latitudinal midline of the PV cell array. Electrical midpoint conductor 1136A (e.g., ribbon wire) may be electrically connected to the positive terminals of substring group 1166A and the negative terminals of substring group 1166B, thereby facilitating the electrical parallel connection of the distributed substrings of each group (i.e., parallel electrical connection of distributed substrings 1102A - 1102C, and the parallel electrical connection of distributed substrings 1102G- 1102I) and electrically serially connecting substring groups 1166A and 1166B. Electrical midpoint conductor 1136A may be routed into junction box 1142 to avail the electrical column midpoint (electrical column midpoint of FIG. 11F) for further electrical connection (e.g., cross-tie connection to other electrical column midpoints as described with reference to FIG. 11F). With reference to FIGS. 11F and 11J, substring groups 1166C and 1166A may be electrically parallelly connected to each other. Substring groups 1166C and 1166A may, thus, be portions of a larger substring group comprising both substring groups 1166C and 1166A parallelly connected.

Similarly to the above, distributed substrings 1102J - 1102L may be electrically parallelly connected to each other and may be disposed on the top half of PV cell array 1010D as substring group 1166C. Further, distributed substrings 1102D - 1102F may be electrically parallelly connected and may be disposed on the top half of PV cell array 1010D as substring group 1166D. Substring group 1166C may be arranged such that the positive terminals of distributed substrings 1102J - 1102L may be disposed proximate to the PV cell array top edge 1144B. Distributed substrings of substring group 1166C may extend from the PV cell array top edge 1144B toward the latitudinal midline. The distributed substrings of substring group 1166C may terminate in a negative terminal substantially proximate to the latitudinal midline. Substring group 1166D may be arranged such that the negative terminals of distributed substrings 1102D - 1102F may be disposed proximate to the PV cell array top edge 1144B. Distributed substrings of substring group 1166D may extend from the PV cell array top edge 1144B toward the latitudinal midline. The distributed substrings of substring group 1166D may terminate in a positive terminal substantially proximate to the latitudinal midline of PV cell array 1010D. Electrical midpoint conductor 1136B (e.g., ribbon wire) may be electrically connected to the positive terminals of substring group 1166C and the negative terminals of substring group 1166D, thereby facilitating the electrical parallel connection of the distributed substrings of each group (i.e., parallel electrical connection of distributed substrings 1102J - 1102L, and the parallel electrical connection of distributed substrings 1102D -1102F) and electrically serially connecting substring groups 1166C and 1166D. Electrical midpoint conductor 1136B may be routed into junction box 1142 to avail the electrical column midpoint (electrical column midpoint of FIG. 11F) for further electrical connection (e.g., cross-tie connection to other electrical column midpoints as described with reference to FIG. 11F, PV module leads and/or electronics (e.g., PE 3202 as described herein). With reference to FIGS. 11F and 11J, substring groups 1166B and 1166D may be electrically parallelly connected to each other. Substring groups 1166B and 1166D may, thus, be portions of a larger substring group comprising both substring groups 1166B and 1166D parallelly connected.

Similar to electrical midpoint conductors 1136A and 1136B, negative bus conductor 1162A (e.g., ribbon wire) may be electrically connected to the negative terminals of distributed substrings 1102G - 1102I. Further, negative bus conductor 1162B may be electrically connected to the negative terminals of distributed substrings 1102J - 1102L. Negative bus conductor 1162A and 1162B may be routed into junction box 1142 such that the remaining electrical connections of distributed PV cell array 1010D may be completed (as described in more detail herein), and may avail themselves to various electrical connections (e.g., to PV module leads, to PE 3202, etc.). Similarly, positive bus conductor 1164A (e.g., ribbon wire) may be electrically connected to the positive terminals of distributed substrings 1102A - 1102C. Further, positive bus conductor 1164B may be electrically connected to the positive terminals of distributed substrings 1102D - 1102F. positive bus conductors 1164A and 1164B may be routed into junction box 1142 such that the remaining electrical connections of distributed PV cell array 1010D may be completed (as described in more detail herein) and may avail themselves to various electrical connections (e.g., to PV module leads, to PE 3202, etc.).

Electrical connections that may take place in junction box 1142 are not shown but rather conductors are depicted as terminating at junction box 1142. However, the electrical scheme as described in relation to FIG. 11F may be completed injunction box 1142. Injunction box 1142, positive bus conductors 1164A and 1164B may be electrically connected to each other. Further, in junction box 1142, negative bus conductors 1162A and 1162B may be electrically connected to each other. Further, in junction box 1142, electrical midpoint conductors 1136A and 1136B may be electrically connected to each other. As such, distributed PV cell array 1010D having electrically parallelly connected and spatially distributed substrings may be easily effectuated. Further, as described herein, additional components may be added to distributed PV cell array 1010D at j unction box 1142, for example, PV module leads (that may avail the power produced by distributed PV cell array 1010D), electronics (e.g., bypass diodes, active bypasses, PE 3202, etc.), etc. Further, as described, conductor intersection outside of a junction box and complex conductor layout and wiring may increase labor and cost of production. It should therefore be appreciated, that utilizing the layouts and connections of FIGS. 11F, 11G, and 11J, electrically parallel and spatially distributed PV cell array 1010D may be produced and manufactured without such excessive complexity or cost.

According to some aspects herein, electrical midpoint conductors 1136A and 1136B may not be connect to each other. Further, according to such aspects, electrical midpoint conductors 1136A and 1136B may be routed into junction box 1142 to be variously utilized (for example, by PE, 3202) or may not be routed into junction box 1142 (where electrical midpoint conductors 1136A and 1136B may still be utilized outside of junction box 1142). According to aspects where electrical midpoint conductors 1136A and 1136B are not connected, a cross-tie may be lost between the top and bottom half of the distributed PV cell array (i.e., substring groups 1166A and 1166B may not be cross-tied with substring groups 1166C and 1166D).

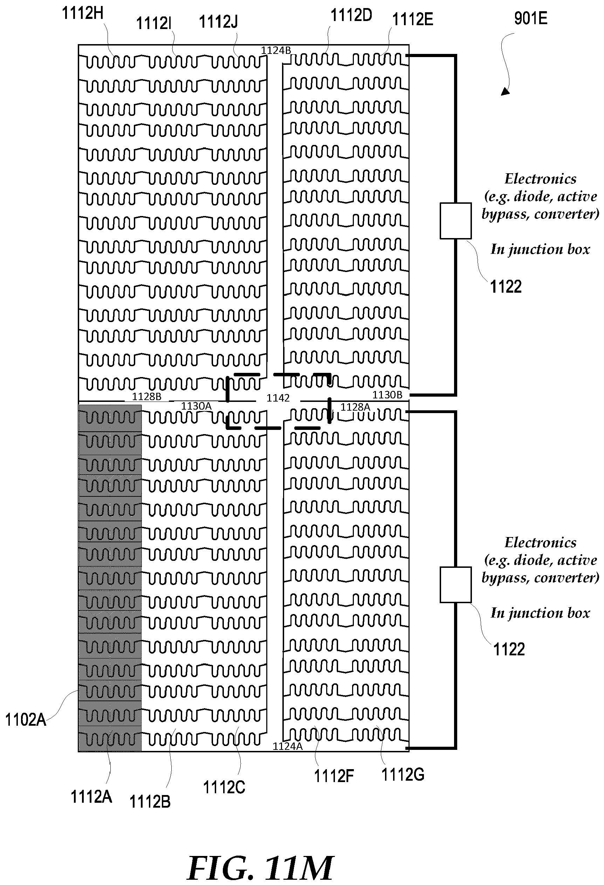

FIGS. 11F - 11G, and 11J depict an example distributed PV cell array having twelve distributed substrings. According to aspects, distributed PV cell arrays may have any number of substrings (e.g., 2, 4, 10, 13, 20, 25, etc.). FIGS. 11F - 11G, and 11J depict an example distributed PV cell array being symmetric over the longitudinal and latitudinal midlines. According to aspects herein, distributed PV cell arrays may be asymmetric over the longitudinal and/or latitudinal midline (as will be expounded upon with relation to FIGS. 11H - 11I, 11K, and 11M-11O). The PV cells of distributed PV cell array 1010D may be adapted for monofacial applications (where substantially all irradiance occurs on a single face of the PV cell) or bifacial applications (where the PV cell and application are designed to be irradiated on both faces of the PV cells). Referring to FIG. 11J, if PV cell array 1010D is adapted for bifacial applications, electrical midpoint conductors 1136A and 1136B may be routed between distributed substrings (e.g., between distributed substring 1102C and 1102G and between distributed substrings 1102L and 1102D). Where PV cell array 1010D is adapted for monofacial applications, the backside faces of the PV cells may be covered, therefore, electrical midpoint conductors 1136A and 1136B may be routed behind a portion of the distributed substrings (e.g., behind distributed substrings 1102C and 1102L). Electrical midpoint conductors 1136A and 1136B (whether in a monofacial or bifacial application) may be routed elsewhere. For example, due to configurations, there may be space along the edges of distributed PV cell array to run conductors (e.g., ribbon wire), in such applications it may be advantageous to route midpoint conductors 1136A and 1136B along the edges of distributed PV cell array 1010D (e.g., along distributed substring 1102A and 1102J). Distributed substrings 1102A - 1102L of FIGS. 11F - 11G, and 11J may include any number of PV cells per substrings (e.g., 10, 12, 16, 30, 35, etc.). PV cells of distributed substrings 1102A-1102L of FIGS. 11F - 11G, and 11J may be any sized PV cell (e.g., standard size G1, G12, etc., or any other sized PV cell). Further, PV cells of distributed substrings 1102A - 1102L of FIGS. 11F - 11G, and 11J may be rear contact PV cells, non-rear contact PV cells, shingled PV cells, or any other kinds of PV cell.

FIG. 11J depicts a distributed PV cell array having equally sized substrings groups 1166A - 1166D. FIG. 11K depicts an example electrical interconnection scheme of distributed PV cell array 1010E of FIG. 11I. Referring to FIG. 11K, substring groups 1166A - 1166D may be variously sized. As described, conductor wire (e.g., ribbon wire) may be used to effectuate the electrical interconnection of distributed PV cell array 1010E as depicted in FIG. 11H. Lines of different patterns in FIG. 11K may depict various electrical conductors which may effectuate various electrical connections as described herein. Each PV cell of distributed substrings 1102A - 1102J may terminate in a positive electrical potential terminal (also referred to as positive terminal) and a negative electrical potential terminal (also referred to as negative terminal) across which the electrical potential of the PV cell may be measured. Subsequently, distributed substrings 1102A - 1102J, of electrically serially connected PV cells, may similarly terminate in positive electrical potential terminals (also referred to as positive terminals) and negative electrical potential terminals (also referred to as negative terminals) across which the electrical potential produced by distributed substring may be measured. Referring to FIG. 11K, PV cell array 1010E may include two rows and five columns of distributed substrings. Each column may, therefore, include two distributed substrings (e.g., distributed substrings 1102A and 1102H). Distributed PV cell array 1010E may be divided by substantial midlines for purposes of depiction. Latitudinal midline may divide PV cell array 1010E in a top and a bottom half. The top and bottom halves of the PV cell array may each include two sets of electrically parallelly connected distributed substrings. Distributed substrings 1102F and 1102G may be electrically parallelly connected to each other and may be disposed on the bottom half of PV cell array 1010E as substring group 1166A. Further, distributed substrings 1102A - 1102C may be electrically parallelly connected and may be disposed on the bottom half of the PV cell array 1010E as substring group 1166B. Substring group 1166A may be arranged such that the positive terminals of distributed substrings 1102F and 1102G may be disposed proximate to the PV cell array bottom edge 1144A. Distributed substrings of substring group 1166A may extend from the PV cell array bottom edge 1144A toward the latitudinal midline. The distributed substrings of substring group 1166A may terminate in a negative terminal substantially proximate to the latitudinal midline. Substring group 1166B may be arranged such that the negative terminals of distributed substrings 1102A - 1102C may be disposed proximate to the PV cell array bottom edge 1144A. Distributed substrings of substring group 1166B may extend from the PV cell array bottom edge 1144A toward the latitudinal midline. The distributed substrings of substring group 1166B may terminate in a positive terminal substantially proximate to the latitudinal midline of the PV cell array 1010E. Electrical midpoint conductor 1136A (e.g., ribbon wire) may be electrically connected to the positive terminals of substring group 1166A and the negative terminals of substring group 1166B, thereby facilitating the electrical parallel connection of the distributed substrings of each group (i.e., parallel electrical connection of distributed substrings 1102A - 1102C, and the parallel electrical connection of distributed substrings 1102F and 1102G) and electrically serially connecting substring groups 1166A and 1166B. Electrical midpoint conductor 1136A may be routed into junction box 1142 to avail the electrical column midpoint (electrical column midpoint of FIG. 11H) for further electrical connection (e.g., cross-tie connection to other electrical column midpoints as described with reference to FIG. 11H). With reference to FIGS. 11H and 11K, substring groups 1166A and 1166C may be electrically parallely connected to each other. Substring groups 1166A and 1166C may, thus, be portions of a larger substring group comprising both substring groups 1166A and 1166C parallely connected.

Similarly to the above, distributed substrings 1102H - 1102J may be electrically parallely connected to each other and may be disposed on the top half of PV cell array 1010E as substring group 1166C. Further, distributed substrings 1102D and 1102E may be electrically parallely connected and may be disposed on the top half of PV cell array 1010E as substring group 1166D. Substring group 1166C may be arranged such that the positive terminals of distributed substrings 1102H - 1102J may be disposed proximate to the PV cell array top edge 1144B. Distributed substrings of substring group 1166C may extend from the PV cell array top edge 1144B toward the latitudinal midline. The distributed substrings of substring group 1166C may terminate in a negative terminal substantially proximate to the latitudinal midline. Substring group 1166D may be arranged such that the negative terminals of distributed substrings 1102D and 1102E may be disposed proximate to the PV cell array top edge 1144B. Distributed substrings of substring group 1166D may extend from the PV cell array edge toward the latitudinal midline. The distributed substrings of substring group 1166D may terminate in a positive terminal substantially proximate to the latitudinal midline of PV cell array 1010E. Electrical midpoint conductor 1136B (e.g., ribbon wire) may be electrically connected to the positive terminals of substring group 1166C and the negative terminals of substring group 1166D, thereby facilitating the electrical parallel connection of the distributed substrings of each group (i.e., parallel electrical connection of distributed substrings 1102H - 1102J, and the parallel electrical connection of distributed substrings 1102D and 1102E) and electrically serially connecting substring groups 1166C and 1166D. Electrical midpoint conductor 1136B may be routed into junction box 1142 to avail the electrical column midpoint (electrical column midpoint of FIG. 11H) for further electrical connection (e.g., cross-tie connection to other electrical column midpoints as described with reference to FIG. 11H, PV module leads and/or electronics (e.g., PE 3202 as described herein).

Similar to electrical midpoint conductors 1136A and 1136B, negative bus conductor 1162A (e.g., ribbon wire) may be electrically connected to the negative terminals of distributed substrings 1102F and 1102G. Further, negative bus conductor 1162B may be electrically connected to the negative terminals of distributed substrings 1102H - 1102J. Negative bus conductors 1162A and 1162B may be routed into junction box 1142 such that the remaining electrical connections of distributed PV cell array 1010E may be completed (as described in more detail herein), and may avail themselves to various electrical connections (e.g., PV module leads, PE 3202, etc.). Similarly, positive bus conductor 1164A (e.g., ribbon wire) may be electrically connected to the positive terminals of distributed substrings 1102A - 1102C. Further, positive bus conductor 1164B may be electrically connected to the positive terminals of distributed substrings 1102D and 1102E. positive bus conductors 1164A and 1164B may be routed into junction box 1142 such that the remaining electrical connections of distributed PV cell array 1010E may be completed (as described in more detail herein) and may avail themselves to various electrical connections (e.g., PV module leads, PE 3202, etc.). With reference to FIGS. 11H and 11K, substring groups 1166B and 1166D may be electrically parallely connected to each other. Substring groups 1166B and 1166D may, thus, be portions of a larger substring group comprising both substring groups 1166B and 1166D parallely connected.

Electrical connections that may take place in junction box 1142 are not shown, rather electrical conductors are depicted as terminating at junction box 1142. However, the electrical scheme as described in relation to FIG. 11H may be completed in junction box 1142. In junction box 1142, positive bus conductors 1164A and 1164B may be electrically connected to each other. Further, in junction box 1142, negative bus conductors 1162A and 1162B may be electrically connected to each other. Further, injunction box, electrical midpoint conductors 1136A and 1136B may be electrically connected to each other. As such, distributed PV cell array 1010E having electrically parallely connected and spatially distributed substrings may be easily effectuated. Further, as described herein, additional components may be added to distributed PV cell array 1010E at junction box 1142, for example, PV module leads (that may avail the power produced by distributed PV cell array 1010E, electronics (e.g., bypass diodes, active bypass, PE 3202, etc.). Further, as described, conductor intersection outside of a junction box and complex conductor layout and wiring may increase labor and cost of production. It should therefore be appreciated, that utilizing the layouts and connections of FIGS. 11H, 11I, and 11K, electrically parallel and spatially distributed PV cell array 1010E may be produced and manufactured without such excessive complexity or cost. It may further be appreciated that aspects of electrically parallely and spatially distributed PV cell arrays may be practiced with PV cell arrays having an odd number of columns as well as an even number of columns.

According to some aspects herein, electrical midpoint conductors 1136A and 1136B may not be connect to each other. Further, according to such aspects, electrical midpoint conductors 1136A and 1136B may be routed into junction box 1142 to be variously utilized (for example, by PE, 3202) or may not be routed into junction box 1142 (where electrical midpoint conductors 1136A and 1136B may still be utilized outside of junction box 1142). According to aspects where electrical midpoint conductors 1136A and 1136B are not connected, a cross-tie may be lost between the top and bottom half of the distributed PV cell array (i.e., substring groups 1166A and 1166B may not be cross-tied with substring groups 1166C and 1166D).

Electrical conductors of FIGS. 11J - 11K (e.g., electrical midpoint conductor 1136A and 1136B, negative bus conductors 1162A and 1162B, and positive bus conductors 1164A and 1164B) may include various forms of conductors. For example, such conductors may include ribbon wire, copper wire etc. The wire or conductor may be stranded or solid. Any combination of conductors in a single PV cell array is contemplated herein. Further, electrical conductors of FIGS. 11J - 11K may be electrically connected to PV cells and components variously. For example, electrical conductors may be soldered, crimped, adhered (via, e.g., conductive adhesive). Various methods of electrical connection in a single PV cell array are contemplated herein. According to aspects, and as described herein, it may be advantageous depending on the application to effectuate electrically parallel spatially distributed PV cell arrays utilizing conductive backsheets. However, depending on considerations it may be advantageous to produce electrically parallel and spatially distributed PV cell arrays without the need to produce a conductive backsheet. For example, production of conductive backsheets may require specialized equipment. As such, electrically parallel connected and spatially distributed PV cell arrays may be achieved utilizing the disclosure in reference to FIGS. 11J - 11K.

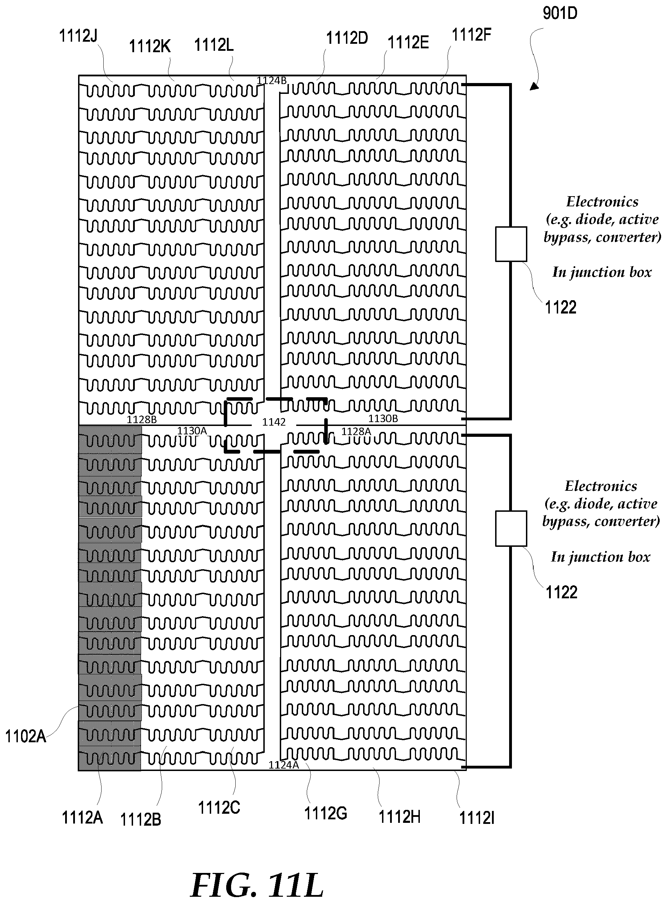

FIGS. 11H - 11I, and 11K depict an example distributed PV cell array having ten distributed substrings. According to aspects, distributed PV cell arrays may have any number of substrings (e.g., 2, 4, 10, 13, 20, 25, etc.). FIGS. 11H - 11I, and 11K depict an example distributed PV cell array as being asymmetric over the longitudinal and latitudinal midlines. According to aspects herein, distributed PV cell arrays may be symmetric over the longitudinal and/or latitudinal midline (as described herein with relation to FIGS. 11F - 11G, 11J, and 11L). The PV cells of distributed PV cell array 1010E may be adapted for monofacial applications (where substantially all irradiance occurs on a single face of the PV cell) or bifacial applications (where the PV cell and application are designed to be irradiated on both faces of the PV cells). Referring to FIG. 11K, where PV cell array 1010E is adapted for bifacial applications, electrical midpoint conductors 1136A and 1136B may be routed between distributed substrings (e.g., between distributed substring 1102C and 1102F and between distributed substrings 1102J and 1102D). Where PV cell array 1010E is adapted for monofacial applications, the backside faces of the PV cells may be covered, therefore, electrical midpoint conductors 1136A and 1136B may be routed behind a portion of the distributed substrings (e.g., behind distributed substrings 1102C and 1102L). Electrical midpoint conductors 1136A and 1136B (whether in a monofacial or bifacial application) may be routed elsewhere. For example, due to configurations, there may be space along the edges of distributed PV cell array to run conductors (e.g., ribbon wire), in such applications it may be advantageous to route midpoint conductors 1136A and 1136B along the edges of distributed PV cell array 1010D (e.g., along distributed substring 1102A and 1102J). Distributed substrings 1102A - 1102J of FIGS. 11H - 11I, and 11K may include any number of PV cells per substrings (e.g., 10, 12, 16, 30, 35, etc.). PV cells of distributed substrings 1102A - 1102L of FIGS. 11H - 11I and 11K may be any sized PV cell (e.g., standard size G1, G12, etc., or any other sized PV cell). Further, PV cells of distributed substrings 1102A - 1102J of FIGS. 11H - 11I, and 11L may be rear contact PV cells, non-rear contact PV cells, shingled PV cells, or any other kinds of PV cell. Fig. 11K depicts substrings groups 1166A - 1166D as having either two or three distributed substrings. According to aspects herein, substring groups may include any number of substrings per group, and the number of substrings per group may vary in a single PV cell array.

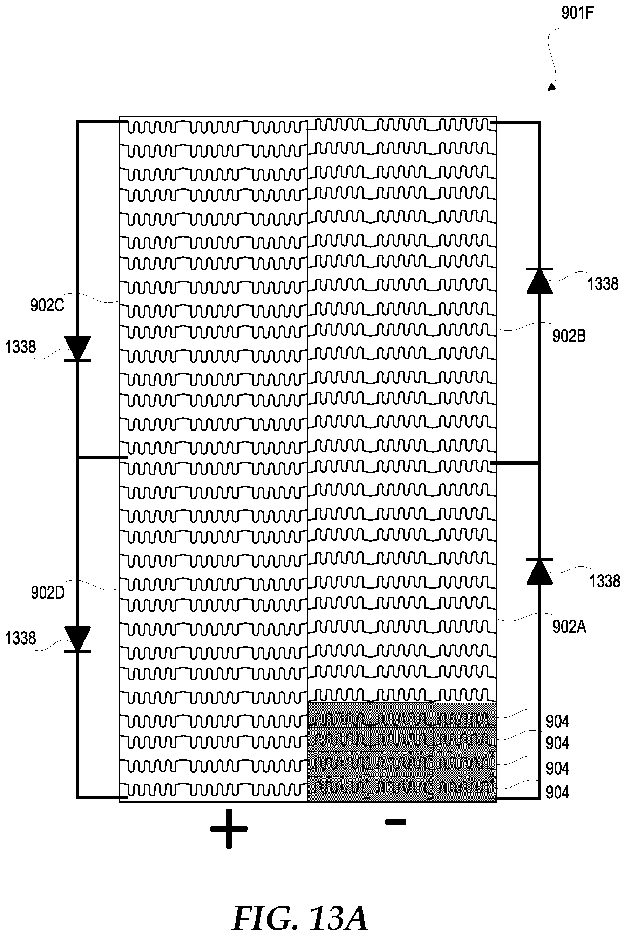

FIG. 11K depicts an electrical connection scheme of distributed PV cell array 1010D utilizing conductor wire. However, parallel connected and spatially distributed PV cell array 1010D of FIG. 11H may be effectuated with rear contact PV cells and conductive backsheet 901D. FIG. 11L depicts an example conductive backsheet 901D of distributed PV cell array 1010D of FIG. 11G according to one or more aspects of the present disclosure. Referring to FIG. 11L, the electrical connections of distributed PV cell array 1010D of FIGS. 11F - 11G may be effectuated utilizing conductive backsheet 901D. conductive backsheet 901D may be similar to aspects of conductive backsheet 901A, 901B, 901C, 901F, 901G, and 901H (and that which is described in relation to conductive backsheets generally) unless explicitly described in relation to conductive backsheet 901D. Rear contact PV cells are depicted as translucent for purposes of depiction. Only rear contact PV cells of distributed substring 1102A are depicted while rear contact PV cells of other distributed substrings (e.g., 1102B, 1102C, 1102D, etc.) have been omitted for clarity of depiction. Conductive backsheet 901D may be patterned forming desired conductive regions. Cuts or areas lacking conductive material in conductive backsheet 901D may be depicted as black lines while conductive regions may be depicted by the regions remaining following the example conductive material removal and/or conductive material deposit as described herein. Rear contact PV cells may be placed on, and electrically connected to, the conductive regions forming distributed substrings. FIG. 11L depicts one distributed substring 1102I (distributed substrings 1102A corresponding to distributed substring 1102A of FIGS. 11F-11G) with example transparent rear contact PV cells overlaid on the conductive backsheet 901D. Rear contact PV cells corresponding to other distributed substrings (e.g., distributed substrings 1102B - 1102L, etc.) have been omitted from FIG. 11L for clarity of depiction. Instead of depicting distributed substrings 1102B - 1102L with transparent PV cells (like distributed substring 1102A), the remaining substrings are depicted only as the substring conductive regions 1112A - 1112L (regions of conductive backsheet 901D that may back distributed substrings 1102A - 1102L of FIGS. 11F - 11G). Conductive traces 1124A, 1124B, 1128A, 1128B, 1130A, and 1130B of FIG. 11L correspond to electrical conductors 1136A, 1136B, 1162A, 1162B, A, and 1164B of FIG. 11J. According to aspects of the present disclosure, distributed substrings may be electrically connected in parallel and maintain spatial distribution within the distributed PV cell array 1010D. Substring conductive regions 1112A - 1112L may each serially connect rear contact PV cells forming distributed substrings. Electrical trace 1136A may electrically connect the positive terminals of distributed substrings of substring conductive regions 1112G - 1112I and the negative terminals of distributed substrings of substring conductive regions 1112A - 1112C. Conductive trace 1136A may be routed into junction box 1142 to avail the electrical column midpoint (electrical column midpoint of FIG. 11F) for further electrical connection (e.g., cross-tie connection to other electrical column midpoints as described with reference to FIG. 11F). Further, by removing or not removing (or having or not having) specific areas of conductive backsheet 901D, cross ties between parallel connected rear contact PV cells may be easily gained (as described in more detail in relation to FIG. 13A).

Electrical connections that may take place in junction box 1142 are not shown. Rather, conductive traces are depicted as terminating at junction 1142. However, the electrical scheme as described in relation to FIG. 11F may be completed in junction box 1142. In junction box 1142, conductive traces 1130A and 1130B may be electrically connected to each other. Further, in junction box 1142, conductive traces 1128A and 1128B may be electrically connected to each other. Further, in junction box 1142, conductive traces 1124A and 1124B may be electrically connected to each other. As such, distributed PV cell array 1010D having electrically parallelly connected and spatially distributed substrings may be effectuated. Further, as described herein, additional components may be added to distributed PV cell array 1010D at junction box 1142, for example, PV module leads (that may avail the power produced by distributed PV cell array 1010D, electronics (e.g., bypass diodes, active bypass, PE 3202, etc.).

As discussed, Conductive backsheet 901D may allow for the simplified incorporation of electronics 1122 into distributed PV cell array 1010D. Electronics 1122 may include, for example, bypass diode, active bypass electronics, converter, PE 3202, etc. Such electronics 1122 may act to process, bypass, and/or utilize the power produced by each half of distributed PV cell array 1010D.

Electronics 1122 are shown outside of the conductive backsheet 901D for schematic purposes only. Electronics 1122 may be added (e.g. connected) to the distributed PV cell array of conductive backsheet 901D at junction box 1142 or anywhere else on conductive backsheet 901D. Further, by not removing the conductive material between substring conductive regions 1112A-1112L adjacent distributed substrings upon substring conductive regions 1112A-1112L may be electrically connected in series-parallel with total-cross ties (TCT) (as discussed in relation to, for example, FIGS. 9B, 11M, and 13B). Such connection may further improve the partial shade condition and/or mismatch condition mitigation of the PV cell array. Such electrical connection may accompany high design and production cost without the use of conductive backsheets and rear contact PV cells.

FIG. 11L depicts an example conductive backsheet 901D of example distributed PV cell array 1010D having twelve distributed substrings. According to aspects, distributed PV cell arrays may have any number of substrings (e.g., 2, 4, 10, 13, 20, 25, etc.). FIG. 11L depicts an example conductive backsheet 901D of example distributed PV cell array 1010D as being symmetric over the longitudinal and latitudinal midlines. According to aspects herein, distributed PV cell arrays may be asymmetric over the longitudinal and/or latitudinal midline (as described herein with relation to FIGS. 11H - 11I, 11K, and 11M-11O). The PV cells of distributed PV cell array 1010D effectuated by conductive backsheet 901D may be adapted for monofacial applications (where substantially all irradiance occurs on a single face of the PV cell) or bifacial applications (where the PV cell and application are designed to be irradiated on both faces of the PV cells). Conductive backsheet 901D is depicted as effectuating distributed substrings of fifteen PV cells each. According to aspects herein, conductive backsheet may be adapted to effectuate distributed substrings having any number of PV cells (e.g., 10, 12, 16, 20, 25, 30, etc.).

FIG. 11K depicts an electrical connection scheme of distributed PV cell array 1010E utilizing conductor wire. However, parallel connected and spatially distributed PV cell array 1010E of FIG. 11H may be effectuated with rear contact PV cells and conductive backsheet 901E. FIG. 11M depicts an example conductive backsheet 901E of distributed PV cell array 1010E of FIG. 11I (and FIG. 11K) according to one or more aspects of the present disclosure. Referring to FIG. 11M, the electrical connections of distributed PV cell array 1010E of FIGS. 11H - 11I may be effectuated utilizing conductive backsheet 901E. conductive backsheet 901E may be similar to aspects of conductive backsheet 901A, 901B, 901C, 901D, 901F, 901G, and 901H (and that which is described in relation to conductive backsheets generally) unless explicitly described in relation to conductive backsheet 901E. Rear contact PV cells are depicted as translucent for purposes of depiction. Only rear contact PV cells of distributed substring 1102A are depicted while rear contact PV cells of other distributed substrings (e.g., 1102B, 1102C, 1102D, etc.) have been omitted for clarity of depiction. Conductive backsheet 901E may be patterned forming desired conductive regions. Cuts or areas lacking conductive material in conductive backsheet 901E may be depicted as black lines while conductive regions may be depicted by the regions remaining following the example conductive material removal and/or conductive material deposit as described herein. Rear contact PV cells may be placed on, and electrically connected to, the conductive regions forming distributed substrings. FIG. 11M depicts one distributed substring 1102I (distributed substrings 1102A corresponding to distributed substring 1102A of FIGS. 11H-11I) with example transparent rear contact PV cells overlaid on the conductive backsheet 901E. Rear contact PV cells corresponding to other distributed substrings (e.g., distributed substrings 1102B - 1102J) have been omitted from FIG. 11M for clarity of depiction. Instead of depicting distributed substrings 1102B - 1102J with transparent PV cells (like distributed substring 1102A), the remaining substrings are depicted only as the substring conductive regions 1112A - 1112L (regions of conductive backsheet 901E that may back distributed substrings 1102A - 1102L of FIGS. 11H - 11I). Conductive traces 1124A, 1124B, 1128A, 1128B, 1130A, and 1130B of FIG. 11M correspond to electrical conductors 1136A, 1136B, 1162A, 1162B, 1164A, and 1164B of FIG. 11K. According to aspects of the present disclosure, distributed substrings may be electrically connected in parallel and maintain spatial distribution within the distributed PV cell array 1010E. Substring conductive regions 1112A - 1112L may each serially connect rear contact PV cells forming distributed substrings. Electrical trace 1136A may electrically connect the positive terminals of distributed substrings of substring conductive regions 1112G - 1112I and the negative terminals of distributed substrings of substring conductive regions 1112A - 1112C. Conductive trace 1136A may be routed into junction box 1142 to avail the electrical column midpoint (electrical column midpoint of FIG. 11H) for further electrical connection (e.g., cross-tie connection to other electrical column midpoints as described with reference to FIG. 11H). Further, by removing or not removing (or having or not having) specific areas of conductive backsheet 901E, cross ties between parallel connected rear contact PV cells may be easily gained (as described in more detail in relation to FIG. 13A).

Electrical connections that may take place in junction box 1142 are not shown. Rather, conductive traces are depicted as terminating at junction 1142. However, the electrical scheme as described in relation to FIG. 11F may be completed in junction box 1142. In junction box 1142, conductive traces 1130A and 1130B may be electrically connected to each other. Further, in junction box 1142, conductive traces 1128A and 1128B may be electrically connected to each other. Further, in junction box 1142, conductive traces 1124A and 1124B may be electrically connected to each other. As such, distributed PV cell array 1010E having electrically parallelly connected and spatially distributed substrings may be effectuated. Further, as described herein, additional components may be added to distributed PV cell array 1010E at junction box 1142, for example, PV module leads (that may avail the power produced by distributed PV cell array 1010E), electronics (e.g., bypass diodes, active bypass, PE 3202, etc.), etc.

As discussed, Conductive backsheet 901E may allow for the simplified incorporation of electronics 1122 into distributed PV cell array 1010E. Electronics 1122 may include, for example, bypass diode, active bypass electronics, converter and/or PE 3202. Such electronics 1122 may act to process, bypass, and/or utilize the power produced by each half of distributed PV cell array 1010E. Electronics 1122 are shown outside of the conductive backsheet 901E for schematic purposes only. Electronics may be added (e.g., connected) to the distributed PV cell array of conductive backsheet 901E at junction box 1142 or anywhere else on conductive backsheet 901E. Further, by not removing the conductive material between substring conductive regions 1112A-1112J adjacent distributed substrings upon substring conductive regions 1112A-1112J may be electrically connected in series-parallel with total-cross ties (TCT) (as discussed in relation to, for example, FIGS. 9B, 11L, 11M, and 13B). Such connection may further improve the partial shade condition and/or mismatch condition mitigation of the PV cell array. Such electrical connection may accompany high design and production cost without the use of conductive backsheets and rear contact PV cells.

FIG. 11M depicts an example conductive backsheet 901E of example distributed PV cell array 1010E having ten distributed substrings. According to aspects, distributed PV cell arrays may have any number of substrings (e.g., 2, 4, 10, 13, 20, 25, etc.). FIG. 11M depicts an example conductive backsheet 901E of example distributed PV cell array 1010E as being asymmetric over the longitudinal and latitudinal midlines. According to aspects herein, distributed PV cell arrays may be symmetric over the longitudinal and/or latitudinal midline (as described herein with relation to FIGS. 11F - 11G, 11J, and 11L). The PV cells of distributed PV cell array 1010E effectuated by conductive backsheet 901E may be adapted for monofacial applications (where substantially all irradiance occurs on a single face of the PV cell) or bifacial applications (where the PV cell and application are designed to be irradiated on both faces of the PV cells). Conductive backsheet 901E is depicted as effectuating distributed substrings of fifteen PV cells each. According to aspects herein, conductive backsheet may be adapted to effectuate distributed substrings having any number of PV cells (e.g., 10, 12, 16, 20, 25, 30, etc.).

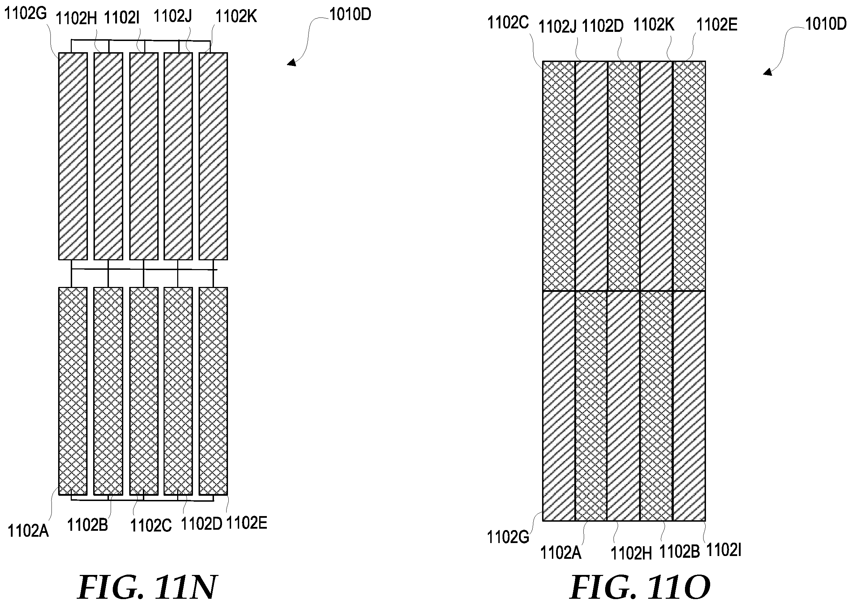

Referring to FIG. 11N, distributed substrings 1102A - 1102E of the same electrical row (and depicted with the same pattern) may be electrically parallelly connected to each other, and distributed substrings 1102G - 1102K of the same electrical row (and depicted with the same pattern) may be electrically parallelly connected to each other. Distributed substrings of the same electrical column of FIG. 11N (e.g., distributed substrings 1102G and 1102A) may be electrically serially connected to each other. Further, the electrical column midpoints of the array may be cross-tied (i.e., electrically connected) with the other electrical column midpoints of the PV cell array further parallelizing distributed PV cell array 1010D. The columns of FIG. 11N may be electrically parallelly connected to each other. The electrical interconnection between distributed substrings 1102A - 1102K may follow the schematic of FIG. 11N. The example 2x5 distributed PV cell array 1010D of FIG. 11N may be useful for providing shade robustness when an odd number of photovoltaic cell columns are desired.

FIG. 11O depicts an example physical arrangement of the example 2x5 distributed PV cell array 1010D of FIG. 11N. Referring to FIG. 11O, electrically parallelly connected distributed substrings 1102A - 1102K may be variously physically distributed in the PV cell array. Referring to FIG. 11F, distributed substrings 1102A - 1102L of the same electrical row (depicted with the same pattern) (e.g., distributed substrings 1102L and 1102G) may be electrically parallelly connected and distributed variously, for example, in an interleaved manner as shown in Fig. 11O). Distributed substrings 1102A - 1102B may be physically disposed at physical row 1, physical columns row 2, 4, respectively. Distributed substrings 1102G- 1102I may be physically disposed at physical row 1, physical columns 1, 3, 5, respectively. Distributed substrings 1102J - 1102K may be physically disposed at physical row 2, physical columns 2, 4, respectively. Distributed substrings 1102C - 1102E may be disposed at physical row 2, physical columns 1, 3, 5, respectively. In this way, electrically parallelly connected substrings of the same electrical row of FIG. 11F, may be physically distributed throughout a PV cell array variously. Such electrical connection and physical disposition may operate to distribute a shade pattern over distributed PV cell array 1010D and may allow for increased shade condition and/or other mismatch condition mitigation as described in more detail herein (e.g., with reference to FIGS. 12A - 12B). The distributed substrings physically disposed and arranged according to the arrangements of FIG. 11O may be electrically interconnected according to the schematics of FIG. 11N. The physical arrangements of the distributed substrings of FIG. 11N are not limited to those depicted in FIG. 11O, rather, according to aspects, distributed substrings may be distributed variously throughout distributed PV cell array 1010D. Interconnection of PV cells of the distributed substrings of FIG. 11N may be variously implemented, for example, using a conductive backsheet, conductive ribbons, silver fingers or other suitable conductive materials.

FIG. 12A depicts a partially shaded example physical distributed substring 1002 arrangement of the example 4x4 PV cell array of FIG. 12B according to one or more aspects. Shade conditions often occur from discrete objects, e.g., animals, tree limbs, structures, etc. Therefore, shade patterns are often concentrated as opposed to scattered. FIG. 12A depicts a shade condition covering a bottom portion of the distributed PV cell array. If the bottom row distributed substrings were electrically connected in parallel to one another, (e.g., if distributed substrings 1002C, 1002H, 1002L, and 1002P were electrically parallel) then the shade condition may affect the entire grouping. FIG. 12B depicts an example electrical interconnectivity scheme of the example partially shaded physical distributed substring arrangement of FIG. 12A according to one or more aspects. As it can be appreciated, the effects of the partial shade condition of the bottom row of FIG. 12A may be distributed throughout the distributed PV cell array based on the electrical interconnectivity of the distributed substrings 1002. Thereby, the effects of the example partial shade condition may be distributed and minimized. FIGS. 12A-12B depict a particular example shade pattern over a particular example distributed PV cell array arrangement. However, distribution of the shade condition may be achieved with other shade patterns and other distributed PV cell array layouts.

Further advantages may be realized when the static reconfigurations and conductive backsheet implementations of the present disclosure are practiced. As mentioned, it may be advantageous to mitigate the effects of mismatch or the partial shade condition to add electrical connections or cross ties between rows of otherwise series-parallel connected PV cells (e.g., rear contact PV cell 904) or PV cell groups (e.g., substrings 102) yielding a total-cross tied (TCT) electrical connection. Such an arrangement may allow for increased power production and increased mismatch or shade condition mitigation as compared to otherwise electrically connected (e.g., series-parallel) PV cell arrays. Practically, such cross ties between every row may be costly and/or prohibitive in terms of time, labor, and material. However, such cost may be reduced by aspects as described herein.

FIG. 13A depicts an example PV cell array effecting conductive backsheet 901F according to one or more aspects of the present disclosure. Conductive backsheet 901F may be similar to aspects of conductive backsheet 901A, 901B, 901C, 901D, 901E, 901G, and 901H (and that which is described in relation to conductive backsheets 901 generally) unless otherwise described in relation to conductive backsheet 901F. For purposes of example, FIG. 13A depicts four rows of three rear contact PV cells 904. Rear contact PV cells 904 are depicted as translucent for purposes of depiction. Black lines represent areas lacking conductive material in conductive backsheet 901F and white spaces between black lines represent conductive regions. By removing or not removing (or having or not having) specific areas of conductive backsheet 901F, cross ties between parallel connected rear contact PV cells 904 may be easily gained.

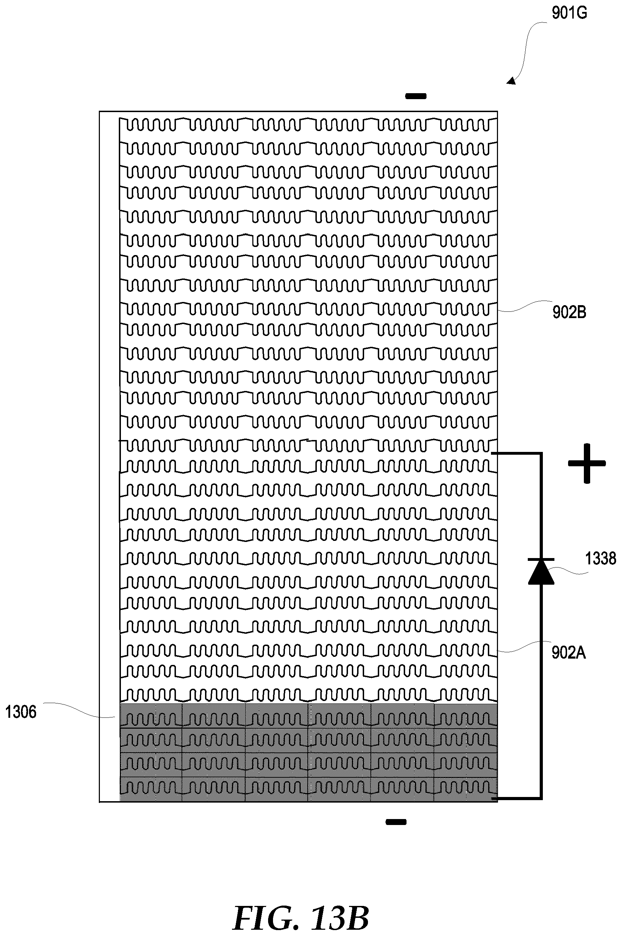

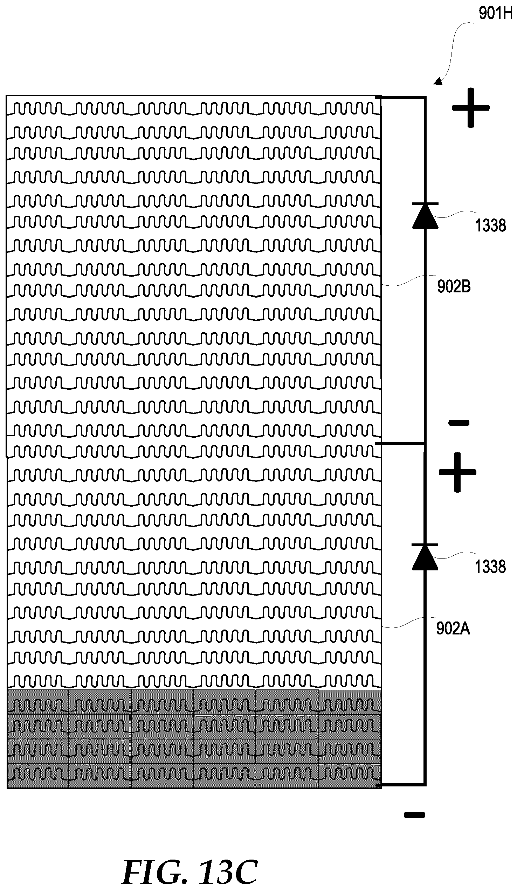

For example, FIG. 13A depicts twelve rear contact PV cells 904 (FIG. 13A does not depict the full distributed PV cell array but only twelve rear contact PV cells 904 out of the total rear contact PV cell array for clarity of depiction), four rows of three rear contact PV cells 904 each. Each row may contain three rear contact PV cells 904 electrically connected in parallel with each other (where the negative terminal of each rear contact PV cell 904 may be connected to the negative terminals of the other rear contact PV cells 904 and the positive terminal of each rear contact PV cell 904 may be connected to the positive terminal of the other rear contact PV cells 904). The rows may be connected to the rows above and/or below in series (where the negative contacts of each row may be connected to the positive contacts of the adjacent row). Further, by not removing the conductive material between rear contact PV cells 904 of a row, adjacent rows may be electrically connected in series-parallel with total-cross ties (TCT) as TCT substrings 902. FIG. 13 depicts the above arrangement with three rear contact PV cells 904 per row, however, aspects of the present disclosure may be practiced with any number of rear contact PV cells 904 per row (e.g., two rear contact PV cells per row (e.g., as depicted in FIG. 9B) four rear contact PV cells per row, five rear contact PV cells per row, etc.). Further, any number of rows per substring is further anticipated. A PV cell array and PV module may contain multiple TCT substrings 902 (e.g., four TCT substrings 902A, 902B, 902C, and 902D). The TCT substrings 902 may be connected to each other in series, parallel, in series-parallel, or TCT to yield the desired PV cell array characteristics. A bypass diode 1338 may be connected in parallel with each TCT substring 902. The diodes 1338 may be connected in the distributed PV cell array via the conductive backsheet conductive regions. Bypass diodes may allow for the bypass of TCT substrings 902 under mismatch or partial shade conditions. According to some aspects bypass diodes 1338 may not be used or may only be connected in parallel with some TCT substrings 902. According to some aspects of the present disclosure, power electronics as discussed herein may be utilized to, among other functions (e.g., DC-DC convert, invert, etc.), control the behavior of substrings under mismatch and/or the partial shade condition (e.g., by bypassing substrings and/or optimizing substrings, etc.).

FIG. 13B depicts an example PV cell array effecting conductive backsheet 901G according to one or more aspects of the present disclosure. Conductive backsheet 901G may be similar to aspects of conductive backsheet 901A, 901B, 901C, 901D, 901E, 901F, and 901H (and that which is described in relation to conductive backsheets 901 generally) unless otherwise described in relation to conductive backsheet 901G. For purposes of example, FIG. 13B depicts four rows of six rear contact PV cells 904 while the remaining rear contact PV cells (to complete the rear contact PV cell array) have been omitted for clarity of depiction. Rear contact PV cells 904 are depicted as translucent for purposes of depiction. Black lines represent areas lacking conductive material in conductive backsheet 901G and white spaces between black lines represent conductive regions. By removing or not removing specific areas of conductive backsheet 901G, cross ties between parallel connected rear contact PV cells 904 may be easily gained. FIG. 13B depicts sixteen rear contact PV cells 904 (FIG. 13B does not depict the full distributed PV cell array but only sixteen rear contact PV cells 904 out of the total rear contact PV cell array), four rows of six rear contact PV cells 904 each. Each row may contain six rear contact PV cells 904 electrically connected to each other in parallel (where the rear contact PV cell terminals of one polarity are electrically connected to the rear contact PV cell terminals, of the same polarity, of the other rear contact PV cells in the same row). Further, by not removing the conductive material between rear contact PV cells 904 of a row, adjacent rows may be electrically connected in series-parallel with TCT as TCT substrings 902. FIG. 13B, depicts the above configuration with six rear contact PV cells per row, however aspects may be practiced with any number of rear contact PV cells per row (e.g., two, three, four, five, etc. rear contact PV cells per row.) Further, TCT substrings 902 may include any number of rows. Referring to FIG. 13B, distributed PV cell array effectuated by conductive backsheet 901G may include two TCT substrings 902A and 902B. The two substrings may further be connected to each other in parallel. The negative terminal of the bottom row of TCT substring 902A may be connected to the negative terminal of the top row of TCT substring 902B via conductive trace 1306. Alternatively, the positive terminal of the bottom row of TCT substring 902A may be electrically connected to the positive terminal of top row of TCT substring 902B. The TCT substrings 902A and 902B may be oriented such that the positive terminal of bottom row of TCT substring 902B and the positive terminal of the top row of TCT substring 902A may be electrically connected via a conductive region. Alternatively, the TCT substrings 902A and 902B may be oriented such that the negative terminal of the bottom row of TCT substring 902B and the negative terminal of the top row of TCT substring 902A maybe electrically connected via conductive region. Thereby, TCT substrings 902A and 902 B may be electrically connected in parallel with one another.

Referring to FIG. 13B, bypass diodes 1338 may be added to TCT substring 902A. Bypass diode 1338 may be electrically connected in parallel with TCT substring 902A and may act to bypass substring 902A in cases of mismatch or partial shade condition. Additionally or alternatively, A bypass diode may be electrically connected in parallel with TCT substring 902B, such a bypass diode 1338 may be connected in parallel with TCT substring 902B alone or as well as a bypass diode 1338 connected in parallel with TCT substring 902A. According to some aspects bypass diodes 1338 may not be used. According to some aspects of the present disclosure, power electronics and as discussed herein may be utilized to, among other functions as described herein (e.g., DC-DC convert, invert, etc.), control the behavior of substrings under mismatch and/or the partial shade condition (e.g., by bypassing a substring and/or optimizing a substring, etc.).

FIG. 13C depicts an example PV cell array effecting conductive backsheet according to one or more aspects of the present disclosure. Conductive backsheet 901H may be similar to aspects of conductive backsheet 901A, 901B, 901C, 901D, 901E, 901F, and 901G (and that which is described in relation to conductive backsheets 901 generally) unless otherwise described in relation to conductive backsheet 901H. For purposes of example, FIG. 13C depicts four rows of six rear contact PV cells 904 while the remaining rear contact PV cells (to complete the rear contact PV cell array) have been omitted for clarity of depiction. Rear contact PV cells 904 are depicted as translucent for purposes of depiction. Black lines represent areas lacking conductive material in conductive backsheet 901H and white spaces between black lines represent conductive regions. By removing or not removing specific areas of conductive backsheet 901H, cross ties between parallel connected rear contact PV cells 904 may be easily gained. FIG. 13B depicts sixteen rear contact PV cells 904 (FIG. 13B does not depict the full distributed PV cell array but only sixteen rear contact PV cells 904 out of the total rear contact PV cell array), four rows of six rear contact PV cells 904 each. Each row may contain six rear contact PV cells 904 electrically connected to each other in parallel (where the rear contact PV cell terminals of one polarity are electrically connected to the rear contact terminals of the other PV cells in the row of the same polarity). Further, by not removing the conductive material between rear contact PV cells 904 of a row, adjacent rows may be electrically connected in series-parallel with TCT as TCT substrings 902. FIG. 13C, depicts the above configuration with six rear contact PV cells 904 per row, however aspects may be practiced with any number of rear contact PV cells 904 per row (e.g., two, three, four, five, etc. rear contact PV cells per row.) Further, TCT substrings 902 include any number of rows. Referring to FIG. 13C distributed PV cell array effectuated by conductive backsheet 901H may include two TCT substrings 902A and 902B. The two TCT substrings 902 may be connected to each other in series. The negative terminal of the top row of TCT substring 902A may be electrically connected to the positive terminal of the bottom row of TCT substring 902B effectively serially connecting TCT substrings 902A and 902B, and effectively connecting the rear contact PV cells of the PV cell array in series-parallel with TCT.

Referring to FIG. 13C, bypass diodes may be electrically connected in parallel to each TCT substring 902A and 902B. Bypass diodes 1338 may be connected between the positive and negative terminals of each TCT substring 902A and 902B. Additionally or alternatively, some configurations may omit bypass diodes 1338 for some or all TCT substrings 902. Additionally or alternatively, more bypass diodes may be used, for example, each row (or any subset of rows) may contain a bypass diode 1338 wired in parallel to bypass the respective rows. According to some aspects of the present disclosure, power electronics (e.g., PE 3202) as discussed herein may be utilized to, among other functions as described herein (e.g., DC-DC convert, invert, etc.), control the behavior of substrings under mismatch and/or the partial shade condition (e.g., by bypassing a substring and/or optimizing a substring, etc.). Power electronics may be utilized in conjunction with bypass diodes 1338 or without bypass diodes 1338.

Aspects of the present disclosure may relate to the manufacture and production of distributed PV cell arrays 1010 and distributed PV modules herein. An uncut, or otherwise unitary conductive backsheet 901 may be obtained. The conductive backsheet 901 may be cut (e.g., via laser cutter, plasma cutter, etc.) into patterns and conductive regions to effectuate the electrical interconnectivity and spatial arrangement of a desired distributed PV cell array 1010 and additional electronics as described herein. Additionally or alternatively, the conductive backsheet 901 may be etched (by, e.g., acidic etching solution) into patterns and conductive regions to effectuate the electrical interconnectivity and spatial arrangement of a desired distributed PV cell array 1010 and additional electronics as described herein. Additionally or alternatively, conductive material may be deposited on a backsheet in patterns and conductive regions which may create the conductive backsheet 901 that effects the electrical interconnectivity and spatial arrangement of a desired distributed PV cell array 1010 and additional electronics as described herein. The above methods of creating a conductive backsheet 901 are for purposed of example only and not intended to limit the scope of the present disclosure. Other methods of conductive backsheet 901 production will be known to those of ordinary skill in the art and are contemplated herein.

Conductive backsheet 901 may be placed on top of additional layers. For example, a conductive backsheet 901 may be placed on top of an encapsulant (e.g., ethylene vinyl acetate (EVA)) sheet or other encapsulant. The conductive backsheet 901 and encapsulant may be placed over or under a protective and/or electrically insulating backsheet (e.g., a double fluoropolymer backsheet, a single fluoropolymer backsheet, non-fluoropolymer backsheet (e.g., polyethylene terephthalate (PET) and ethylene vinyl acetate (EVA)), etc.). The cells may be placed on top of, and electrically connected to, the conductive backsheet 901. For example, conductive adhesive may be placed on top of the conductive backsheet 901 on the desired areas for rear contact PV cell 904 electrical connection. The rear contact PV cells 904 may be placed on the conductive adhesive on the conductive backsheet 901. An insulating layer may be placed between the conductive adhesive and rear contact PV cells 904. The rear contact PV cells may be placed and positioned as desired on the conductive backsheet 901 by, for example, an automated manipulator, a pick and place machine, a person, etc. Power electronics (e.g., optimizer, micro-inverter, DC-DC converter, etc.) and/or passive electronics (e.g., bypass diodes, blocking diodes, etc.) may be added to the conductive backsheet 901. A top encapsulant and/or glass may be added on top of the distributed PV cell array 1010. A PV module frame may be added. Post processing may be applied (e.g., in an oven, laminating machine, etc.).

According to aspects, the PV arrays herein may be packaged variously creating various PV modules. For example, any of the PV arrays herein may be packaged as described into tandalone PV modules. Additionally or alternatively, any PV arrays described herein may be combined with roofing tiles (e.g., asphalt roofing shingles, metal roofing shingles, wood roofing shingles, etc.), to create roofing tiles having the PV arrays as described herein. The PV arrays of the present disclosure may be encapsulated substantially as described above (with e.g., glass and/or EVA, etc.) and attached to the roofing tiles. The roofing tile may form an intrinsic part of the roof tile PV module (e.g., the asphalt roofing shingle may act as and/or be configured as a PV module backsheet). Alternatively, a finished PV module may be attached to a roof tile. The arrays of the present disclosure may provide roof tile PV module arrays with increased shade and/or other mismatch condition mitigation.

Two-row substring PV cell arrays, four-row substring PV cell arrays and PV cell arrays containing substrings 102 comprising any number of rows of the present disclosure may be similarly practiced utilizing conductive backsheets and rear contact PV cells. For example, referring to FIG. 3A, conductive backsheets may be fabricated to form conductive regions effectuating the PV cell 904 interconnectivity and two-row substring 102A interconnectivity depicted in FIG. 3A. Further, substring midpoint cross-ties 336A, 336B, may be patterned into a conductive backsheet. Referring to FIG. 4A, incorporating and/or adding bypass diodes 438 may be accomplished by similarly forming necessary conductive regions and conductive voids in a conductive backsheet as desired (e.g., plugging a bypass diode into an etched conductive backsheet).

Aspects of the present disclosure may be practiced with full PV cells 104 or full rear contact PV cells 904 of any size or with any $\frac{1}{N}$ cut PV cells of any size, where N is an integer. PV cells (e.g., PV cell 104, rear contact PV cells 904) may be cut to $\frac{1}{N}$ size, and may yield $\frac{1}{N}$ cut PV cells. N cut PV cells may have substantially the same voltage potential characteristics of the full PV cell but may have substantially $\frac{1}{N}$ the electrical current production of the full PV cell under the same conditions. Cutting PV cells in accordance with the present disclosure may allow for flexibility when designing PV modules to achieve desirable power characteristics, size, aspect ratio, shade tolerance, etc. For example, the present disclosure may be practiced with $\frac{1}{2}$ cut PV cells, $\frac{1}{3}$ cut PV cells, $\frac{1}{4}$ cut PV cells, etc. or any combination thereof. The cut PV cells may be obtained by, for example, cutting PV cells along a single dimension (e.g., by cutting a 210mmx210mm cell into seven strips, each approximately measuring 210x30mm) or along two dimension (e.g., smaller cut cells, which may increase cell granularity and improve design flexibility, may be obtained by cutting a 210mmx210mm cell once vertically and six times horizontally to obtain fourteen cut cells, each measuring approximately 105mmx30mm). FIG. 8 depicts an example two-row substring 102A PV module 800 with $\frac{1}{2}$ cut PV cell 804 array . Referring to FIG. 8, PV cell arrays with $\frac{1}{2}$ cut PV cells 804 (or any $\frac{1}{N}$ cut cells) may be arranged substantially according to the arrangements of the present disclosure (e.g., FIG. 8 depicts a PV module 800 and PV cell array 810 having a substantially similar configuration to FIG. 3A and a substantially similar electrical schematic to FIG. 3B, with ½ cut PV cells 804 instead of full PV cells). $\frac{1}{2}$ cut substrings 102 (substrings 102 comprising serially connected $\frac{1}{2}$ cut PV cells) may be arranged substantially as described herein. $\frac{1}{N}$ cut substrings may be arranged in rows of two sub-substrings 102A (as depicted in FIG. 8). In such aspects of the present disclosure, arrangements and electrical connection of such $\frac{1}{N}$ cut PV cell two-row substrings 102A may substantially mirror the arrangements and electrical connections of two-row substrings 102A as described in relation to FIGS. 1A-5B. N cut substrings may also be arranged in rows of four or more sub-substrings. In such aspects of the present disclosure, arrangements and electrical connection of such $\frac{1}{N}$ cut PV cell four-row substrings 102B may substantially mirror the arrangements and electrical connections of the four-row substrings 102B as described herein in relation to FIGS. 6A-7B. PV cell arrays comprising $\frac{1}{N}$ cut PV cell substrings may be arranged in portrait, landscape or square orientations as described herein. Rear contact PV cells 904 may similarly be cut yielding $\frac{1}{N}$ cut rear contact PV cells. $\frac{1}{N}$ cut rear contact PV cell substrings (comprising $\frac{1}{N}$ cut rear contact PV cells, e.g., distributed substring 1002 and TCT substring 902) may be arranged and electrically connected utilizing conductive backsheets 901 in substantially the same manner as rear contact PV cells 904 as described herein, for example, in relation to FIGS. 9A-13C. $\frac{1}{N}$ cut substrings may be arranged in distributed substrings as described herein. In such aspects of the present disclosure, arrangements and electrical connection of such $\frac{1}{N}$ cut PV cell distributed substrings may substantially mirror the arrangements and electrical connections of the distributed substrings as described herein, for example, in relation to FIGS. 9A, 10A-10B, 11A-12B. $\frac{1}{N}$ cut substrings may be arranged in TCT substrings as described herein. In such aspects of the present disclosure, arrangements and electrical connection of such $\frac{1}{N}$ cut PV cell TCT substrings may substantially mirror the arrangements and electrical connections of the TCT substrings as described herein, for example, in relation to FIGS. 9B, 13A-13C.

Aspects of the present disclosure relate to PV cell arrays and PV modules that may be combined with roof tiling (i.e., roofing shingles). Roof tile PV cell arrays and roof tile PV modules may be associated with particular considerations such as shape of the roof tile, size of the roof tile PV module in relation to the entire roof tile, designed open circuit voltage ($V_{OC}$) considerations, designed closed circuit current ($I_{SC}$) considerations, roof tile PV cell array topologies, shading and other mismatch condition considerations, productability concerns, etc. Additionally, roof tile PV cell arrays and/or PV modules may comprise materials and construction useful for roof tiles. For example, roof tile PV cell arrays and/or PV modules may comprise a backsheet, the backsheet may comprise, for example, materials and shapes useful for roof tiling (e.g., asphalt, wood, wood shake, metal, slate, etc.). In addition to comprising a photovoltaic cell array, roof tile PV cell arrays and/or modules may be mechanically configured as roof tiles (e.g., comprising material overlap, or to, for example, form a weatherproof layer when installed). When designing such roof tile PV cell arrays and modules any number of considerations may be balanced. For example, it may be desirable to increase partial shade or other mismatch condition mitigation, increase power production and efficiency, while decreasing cost and complexity of production and installation. Considering the above, aspects of the present disclosure relate to roof tile PV cell array topologies, electrical interconnection and electrical intraconnection of roof tile PV cell array topologies, power optimization of roof tile PV cell arrays, and production of roof tile PV cell arrays.

As described herein, PV generators (e.g., PV cell arrays, PV modules) may benefit from being electrically connected in total-cross-tie (TCT) configuration. TCT configuration may be understood as electrically parallelly connecting PV generators as groups of parallelly connected PV generators, and electrically serially connecting two or more groups of parallelly connected PV generators. TCT configuration, as compared to series configuration, parallel configuration, and series-parallel configuration, may enhance power generation, improve efficiency, and improve partial shade condition, and/or other mismatch condition, mitigation. However, TCT configuration may be associated with increased production cost and complexity (e.g., electrical connection complexity). Further still, as described herein, the power generation, efficiency, and mismatch condition mitigation may be further improved by spatially distributing electrically parallelly connected PV generators within an array. Such spatial distribution may serve to distribute the effects of, for example, the partial shade condition or other mismatch conditions. However, such spatial distribution may be associated with additional increased production cost and complexity. For example, a TCT spatially distributed array may be associated with conductor crossover of PV cell array conductors. Such conductor crossover may be associated with additional production steps, for example, additional layers of electrical insulator between the conductor layers. Thus, it is an aspect of the present disclosure to provide TCT spatially distributed PV cell arrays (e.g., TCT spatially distributed roof tile PV cell arrays) while reducing the complexity and cost of production.

FIG. 14A, depicts an example electrical interconnectivity of a 2x2 TCT spatially distributed roof tile PV cell array according to one or more aspects of the present disclosure. Referring to FIG. 14A, 2x2 TCT spatially distributed roof tile PV cell array may include substrings 1402A, 1402B, 1402C, and 1402D (referred to generally as substrings 1402). Substrings as depicted with the same pattern, in FIGS. 14A and 14B, may be understood as electrically parallelly connected to each other. Accordingly, substrings 1402A and 1402B may be electrically parallelly connected to each other as substring group A. Additionally, substrings 1402C and 1402D may be electrically parallelly connected to each other as substring group B. Substring group A may be electrically serially connected to substring group B to create a TCT PV cell array.

FIG. 14B, depicts an example spatially distributed physical arrangement of substrings of FIG. 14A. Referring to FIG. 14B, the substrings 1402A-1402D may be spatially distributed such that substrings that are electrically parallelly connected to each other may be disposed in a different row and/or column. (With larger PV cell arrays, electrically parallelly connected substrings may be disposed in the same row and/or column while maintaining overall spatial distribution of the PV cell array). Referring to the example 2x2 PV cell array of FIGS. 14A and 14B, as described, substring 1402A may be electrically parallelly connected to substring 1402B. Substring 1402A may be disposed at row/column 1,1 whereas substring 1402B may be disposed at row/column 2,2. Additionally, substring 1402D may be electrically connected to substring 1402C. Substring 1402C may be disposed at row/column 2,1 and substring 1402D may be disposed at row/column 1,2. As such the substrings may be TCT and spatially distributed. The spatial arrangement of FIG. 14B is a single example of possible spatial distribution. As such, it should be understood that the substrings of FIG. 14A may be distributed variously within the PV cell array.

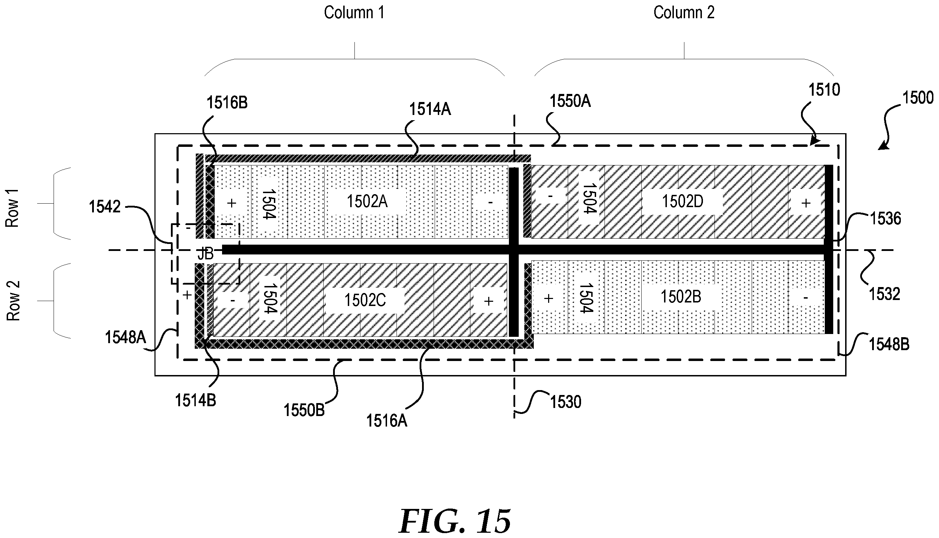

As described, generally, TCT PV cell arrays, and spatially distributed PV cell arrays may be associated with increased production complexity (e.g., complex electrical connection). Aspects of the present disclosure relate to TCT spatially distributed PV cell array topologies that may reduce the complexity of production. FIG. 15 depicts an example roof tile PV cell array topology of a 2x2 TCT and spatially distributed PV cell array and PV module of FIGS. 14A-14B according to one or more aspects of the present disclosure. Referring to FIG. 15, 2x2 substring TCT and spatially distributed roof tile PV module 1500 may include roof tile PV cell array 1510. Roof tile PV cell array 1510 may include four substrings 1502, substring 1502A, substring 1502B, substring 1502C, and substring 1502D in a 2x2 (i.e., two rows, two columns) arrangement (substring 1502A-1502D may correspond to substrings 1402A-1402D respectively, of FIGS. 14A-14B). Although four substrings 1502 are depicted, any number of substrings 1502 are contemplated. Substrings 1502 may be depicted with patterns. Substrings 1502 of similar patterns may be considered electrically connected in parallel (described in more detail). Referring to FIG. 15, substring 1502A may be electrically connected in parallel to substring 1502B. Substring 1502C may be electrically connected in parallel to substring 1502D. The parallel group of substrings 1502A and 1502B may be electrically connected in series with the parallel group of substrings 1502C and 1502D resulting in roof tile PV cell array 1510 that is TCT and spatially distributed.

Each of substring 1502A-1502D may include a number of electrically serially connected PV cells 1504. (For clarity of depiction, only one PV cell 1504 per substring 1502 is depicted with a reference numeral, however each PV cell 1504 (eight PV cells 1504 are depicted per substring 1502 of FIG. 15) should be considered substantially the same as one another). Each PV cell may have a positive terminal and a negative terminal (e.g., across which a PV cell open circuit voltage may be measured upon power production of the PV cell). Similarly, each substring 1502 (i.e., 1502A-1502D) of serially connected PV cells 1504 may include a substring positive terminal and a substring negative terminal (e.g., across which a substring open circuit voltage may be measured upon power production of the substring). The substrings 1502A-1502D may be arranged in relation to one another such that a TCT and spatially distributed topology may be achieved with reduced complexity of production. For example, the positive and negative substring terminals may be arranged variously such that conductor crossover on the roof tile PV module 1500, outside of junction box 1542 may be reduced. Roof tile PV module 1500 may include junction box 1542. Junction box 1542 may similarly be strategically placed to achieve the desired electrical interconnection and spatial distribution with reduced complexity of production. Conductor crossover inside of junction box 1542 may be less costly and less complex to achieve than conductor crossover on roof tile PV module 1500 outside of junction box 1542.

With continued reference to FIG. 15, roof tile PV cell array 1510 (and roof tile PV module 1500) may be rectangularly shaped with a long dimension, defined by two opposing long sides 1550 (first long reference side 1550A and second long reference side 1550B), and a short dimension defined by two opposing short sides 1548 (first short reference side 1548A and second short reference side 1548B). The PV cell array of FIG. 15 may be considered a horizontal array as each of the substrings 1502A-1502D extend horizontally (along the long dimension). The substrings may be disposed in two rows of two substrings (the rows extending along the long dimension); and two columns of two substrings (the columns extending along the short dimension). Junction box 1542 may be disposed proximate to the first short reference side 1548A and between the two rows of the roof tile PV cell array 1510. Substring 1502A may be disposed at the first row, first column of the roof tile PV cell array 1510. The first row may begin with the positive terminal of substring 1502A. Substring 1502A may extend into the first row, from its positive terminal, along the long dimension and terminate, at the negative terminal of substring 1502A, proximate to the middle of the first row (e.g., proximate to the longitudinal midline 1530). Substring 1502D may be disposed at the first row, second column of the roof tile PV cell array 1510. The negative terminal of substring 1502D may be disposed proximate to the middle of the first row (e.g., proximate to the longitudinal midline 1530). Substring 1502D may extend from its negative terminal proximate to the middle of the first row, along the long dimension of the PV cell array, and terminate, at the positive terminal of substring 1502D, proximate the second short reference side 1548B at the end of the first row.

Substring 1502C may be disposed at the second row, first column of the roof tile PV cell array 1510. The negative terminal of substring 1502C may be disposed proximate to the first short reference side 1548A at the start of the second row. Substring 1502C may extend into the second row, along the long dimension of the roof tile PV cell array 1510 and may terminate, at the positive terminal of substring 1502C, proximate to the middle of the second row (e.g., proximate to the longitudinal midline 1530). Substring 1502B may be disposed in the second row, second column. The positive terminal of substring 1502B may be disposed proximate to the middle of the second row (e.g., proximate to the longitudinal midline 1530). Substring 1502B may extend from its positive terminal, along the long dimension of the roof tile PV cell array 1510 to the negative terminal of substring 1502B. The negative terminal of substring 1502B may be disposed proximate to the second short reference side 1548 at the end of the second row of the PV cell array. The substring terminals may be considered arranged in the roof tile PV cell array 1510 as follows:

$$\begin{bmatrix} + & - & - & + \\ - & + & + & - \end{bmatrix}.$$

With the disposition of the substring terminals as described above, the complexity of the electrical connection of the TCT spatially distributed roof tile PV cell array 1510 may be reduced. For example, the TCT spatially distributed roof tile PV cell array electrical connections may be achieved without conductor crossover on the roof tile PV module (outside of junction box 1542). FIG. 15 depicts an example route of conductors (e.g., ribbon wire) that may be achieved on the roof tile PV module 1500. The conductors of FIG. 15 are depicted as paths (i.e., thick lines) (some patterned). Referring to FIG. 15, the positive terminal of substring 1502D may be disposed proximate to the negative terminal of substring 1502B. These terminals may be disposed proximate to the second short reference side 1548B of the PV cell array. Additionally, the negative terminal of substring 1502A may be disposed proximate to the positive terminal of substring 1502C. These terminals may be disposed proximate to the longitudinal midline 1530 of the TCT spatially distributed PV cell array 1510. Midpoint conductor 1536 (e.g., ribbon wire, conductive trace of conductive backsheet) may be electrically connected to the positive terminal of substring 1502D and the negative terminal of substring 1502B. The midpoint conductor 1536 may simply run proximate to the second short reference side 1548B of the PV cell array. Midpoint conductor 1536 may be electrically connected to the negative terminal of substring 1502A and the positive terminal of substring 1502C (disposed proximate to one another). Midpoint conductor may then be routed between the two rows of the PV cell array (in between substring 1502D and 1502B) (e.g., proximate to and along the transverse midline 1532), and connect.

Negative conductor 1514A may be connected to the negative terminal of substring 1502D, and may be routed toward the first long reference side 1550A and along the long dimension, proximate to the first long reference side 1550A, toward the first short reference side 1548A. Proximate to the first short reference side 1548A, the substring 1502D negative conductor 1514A may be routed into junction box 1542. Additionally, positive conductor 1516A may be connected to the positive terminal of substring 1502B, and may be routed toward the second long reference side 1550B and along the long dimension, proximate to the second long reference side 1550B, toward the first short reference side 1548A. Proximate to the first short reference side 1548A, the substring 1502B positive conductor 1516A may be routed into junction box 1542. The positive terminal of substring 1502A may terminate proximate to the first short reference side. As such, the positive terminal of substring 1502A may terminate proximate to junction box 1542. Positive conductor 1516B may be electrically connected to the positive terminal of substring 1502A and may be routed into junction box 1542. Similarly, the negative terminal of substring 1502C may terminate proximate to the first short reference side. As such, negative conductor 1514B may be electrically connected to the negative terminal of substring 1502C and may be routed into junction box 1542. The remaining electrical connections (e.g., negative conductor 1514A to negative conductor 1514B, positive conductor 1516A to positive conductor 1516B) may be achieved in junction box 1542 to achieve the desired TCT spatially distributed roof tile PV cell array 1510.

One or more active and/or passive electrical and/or power components (e.g., passive electronics and/or power electronics) may be connected with TCT spatially distributed roof tile PV cell array 1510, for example, at the junction box 1542. For example, one or more diodes (e.g., bypass diodes and/or blocking diodes) may be included in junction box 1542. Diodes may be included to allow for the bypass of one or more substrings (e.g., parallelly connected with each of one or more substrings 1502), for example, in the case of a mismatch condition and/or to block the backflow of current through the substrings 1502 and/or the TCT spatially distributed PV cell array 1510. Alternatively, diodes may not be used with the TCT spatially distributed roof tile PV cell array 1510. Additionally or alternatively, active power electronics, for example, DC-DC converters, power optimizer, micro-inverter, MPPTs, power electronics 3202, etc. may be attached to the TCT spatially distributed PV cell array 1510 to act on the power produced by the TCT spatially distributed roof tile PV cell array 1510. The power electronics connected to the TCT spatially distributed roof tile PV cell array 1510 may act on one or more of substrings 1502 to, for example, bypass one or more of substrings 1502, move the operating point of one or more of substrings 1502, etc. Following electrical connection in junction box 1542, and the optional inclusion of passive and/or active electronics, TCT spatially distributed roof tile PV cell array 1510 may electrically terminate with a positive roof tile PV cell array terminal and a negative roof tile PV cell array terminal. The positive and negative roof tile PV cell array terminals may avail the power produced by the roof tile PV cell array. Positive roof tile PV module lead and negative roof tile PV module lead may be incorporated with junction box 1542 and may extend from junction box 1542. Positive and negative roof tile PV module leads may be electrically connected to positive and negative roof tile PV cell array terminals respectively. Thus, the power produced by roof tile PV cell array 1510 may be availed at positive and negative roof tile PV module leads. PV module leads may include connectors (e.g., MC4 connectors) so that subsequent components (e.g., PV modules, active electronics, passive electronics, the grid, batteries, etc.) may be connected to, utilize, and/or act upon the power produced by roof tile PV cell array 1510 and roof tile PV module 1500.

The above description depicts the substrings 1502A-1502D of FIG. 15 with relative position based on the orientation of the PV cell array as depicted in FIG. 15. However, it should be understood that the orientation of FIG. 15 may vary. For example, When installed, the TCT spatially distributed roof tile PV cell array of FIG. 15 may be rotated, e.g., 90°, 180°, 270°, etc. Assuming the example where the PV cell array of FIG. 15 is rotated an exemplary 180°, substring 1502B may be considered disposed at position first row, first column. However, the relative position of each of the substring terminals may not change allowing for the same electrical interconnectivity scheme. It should additionally be recognized that aspects of the present disclosure may similarly be practiced where the disposition of each substring 1502A-1502D is rotated by 180°. Accordingly, the terminals of the roof tile PV cell array may be disposed as follows:

$$\begin{bmatrix} - & + & + & - \\ + & - & - & + \end{bmatrix}.$$

Junction box 1542 is depicted as being disposed proximate to the transverse midline 1532 (i.e., between the two rows) of the TCT spatially distributed roof tile PV cell array 1510. It should be recognized, that according to aspects, junction box 1542 may be moved variously. For example, junction box 1542 may be disposed proximate to the intersection of first short reference side 1548A and first long reference side 1550A. Alternatively, junction box 1542 may be disposed proximate to the intersection of first short reference side 1548A and second long reference side 1550B. Additionally, junction box 1542 may be disposed anywhere in between the above-mentioned positions. Additionally, roof tile PV module 1500 and TCT spatially distributed roof tile PV cell array 1510 is depicted as including one junction box 1542 in which both positive and negative connections may be completed. However, according to aspects, roof tile PV module 1500 and roof tile PV cell array 1510 may include two junction boxes (e.g., a positive junction box and a negative junction box) in which the positive connections and negative connections may be effectuated respectively.

As described herein, aspects of the present disclosure may be practiced with full PV cells or PV cells of any size or with any $\frac{1}{N}$ cut PV cells of any size, where N is an integer. Full PV cells may be cut to $\frac{1}{N}$ size to yield $\frac{1}{N}$ cut PV cells. As described, $\frac{1}{N}$ cut PV cells may produce substantially similar voltage potential characteristics to that of a PV cell from which the $\frac{1}{N}$ cut PV cell was cut. Whereas, $\frac{1}{N}$ cut PV cells may produce substantially $\frac{1}{N}$ times the current production as a full PV cell from which the $\frac{1}{N}$ cut PV cell was cut, under the same conditions (e.g., same irradiance conditions, environmental conditions, testing conditions, etc.).

The roof tile PV cell array 1510 of FIG. 15 is depicted as including eight PV cells 1504 per substring 1502, and the PV cells 1504 of substrings 1502 are depicted as $\frac{1}{2}$ cut PV cells. According to aspects of the present disclosure, substrings 1502, (i.e., 1502A-1502D) may include any number of PV cells 1504 per substring. Additionally, it is contemplated that the PV cells 1504 of substrings 1502 may be any $\frac{1}{N}$ cut PV cells (including full PV cells).

Referring to FIG. 15, it may be advantageous to route midpoint conductor 1536 to junction box 1542. Access to midpoint conductor 1536 in junction box 1542 may allow for further configurability with passive and/or active electronics. Accordingly, where desired midpoint conductor may be routed between the first row and second row (i.e., between substrings 1502A and 1502C) (e.g., proximate to and along transverse midline 1532) and into junction box 1542. There, the roof tile PV cell array electrical midpoint (e.g., via midpoint conductor 1536) may be availed, for example, for active and/or passive electronic incorporation.

Roof tile PV cell arrays and roof tile PV modules may be advantageously practiced with rear contact PV cell and conductive backsheets. As described herein, TCT connected spatially distributed PV cell arrays may come with increased production complexity. Such production complexity may be associated with electrical connection of the TCT spatially distributed PV cell array. Accordingly, the present disclosure contemplates utilizing rear contact PV cells (e.g., metal wrap through (MWT), interdigitated back contact (IBC), etc.) and conductive backsheets to reduce production complexities.

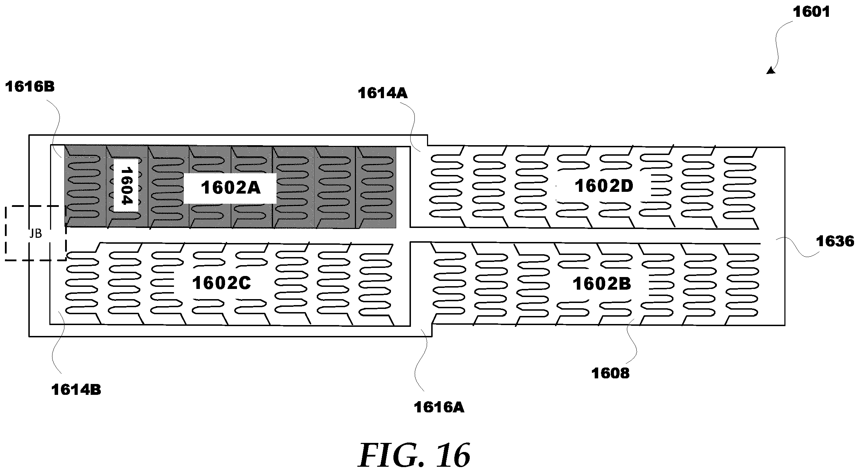

FIG. 16 depicts an example conductive backsheet 1601 that may effectuate the example TCT spatially distributed roof tile PV cell array of FIG. 15 according to the present disclosure. Conductive backsheet 1601 may be fabricated from any conductive material, for example, metal (e.g., copper, silver, etc.). Conductive backsheet 1601, may be cut (depicted as black lines in FIG. 16) via, for example, laser cutter, plasma cutter, etc., or any other method of cutting such conductive material, in particular patterns to form conductive regions (depicted as white spaces between cuts) as desired. Conductive regions may be categorized as conductive pads 1608 configured to electrically join adjacent rear contact PV cells 1604 (e.g., conductive pads 1608 configured to electrically serially connect two adjacent rear contact PV cells 1604) and conductive traces 1614 and 1616 configured to transmit electrical power (e.g., conductive traces 1614A, 1614B, 1616A, and 1616B). The terms conductive pads 1608 and conductive traces 1614 and 1616 are merely example terms of the more general conductive regions and should not be construed to limit the scope of the present disclosure. Conductive pads 1608 may terminate in conductive traces 1614 or 1616 (e.g., conductive trace 1616A; see also, e.g., conductive trace 960A of TCT substring 902A of FIG. 9B) and conductive traces 1614 or 1616 may terminate in conductive pads 1608. Additionally or alternatively, conductive regions may function as both conductive pads 1608 and conductive traces 1614 or 1616 or function as neither (e.g., conductive regions may be utilized as a conductive trace in an integrated circuit on rear contact backsheets). Rear contact PV cells 1604 may be electrically attached to conductive backsheet 1601 by, for example, conductive paste, forming a desired conductive backsheet PV cell array as described herein (note, rear contact PV cells 1604 are not all referenced with a numeral and are depicted as gray transparent shapes, PV of substrings 1602B, 1602C, and 1602D have been omitted for clarity of depiction). Such conductive backsheets 1601 may facilitate the incorporation of electronics (e.g., power electronics as discussed in further detail herein), with a conductive backsheet PV module by directly incorporating circuitry and circuit paths with the conductive backsheet 1601. Various forms of conductive backsheets 1601 are contemplated and some are described in more detail herein. All conductive backsheets described herein may be substantially similar and substantially similarly produced (other than the pattern) unless as explicitly described herein.

Referring to FIG. 16, substrings 1602A-1602D of FIG. 16 may be understood as corresponding to substrings 1502A-1502D, respectively, of FIG. 15. Additionally, conductive traces of FIG. 16 may be understood as corresponding to conductors of FIG. 15. Accordingly, conductive traces 1636, 1614A, 1614B, 1616A, and 1616B, of FIG. 16, may be understood as corresponding to conductors 1536, 1514A, 1514B, 1516A, and 1516B, respectively, of FIG. 15. Accordingly, it will be appreciated that the advantages of the topology of FIG. 15 may be achieved with various methods of production (e.g., ribbon wire, conductive backsheet). It may be appreciated that midpoint conductor 1536 may correspond to conductive trace 1636. Midpoint conductor 1536 and midpoint trace 1636 may add increased parallelization (e.g., TCT connection) to the roof tile PV cell array 1510 of FIG. 15. The midpoint conductor 1536 and the conductive trace 1636 may predominantly conduct in a case of mismatch (e.g., where a portion of the roof tile PV cell array 1510 is shaded). Accordingly, the midpoint conductor 1536 and conductive trace 1636 may be of decreased substantiality as compared to other conductors of roof tile PV cell array 1510 and/or conductive traces of conductive backsheet 1601. For example, conductive trace 1636 may be narrower and/or thinner than some or all of conductive traces 1614A, 1614B, 1616A, and 1616B. The same may hold true for all midpoint conductors and corresponding conductive traces of the present disclosure.

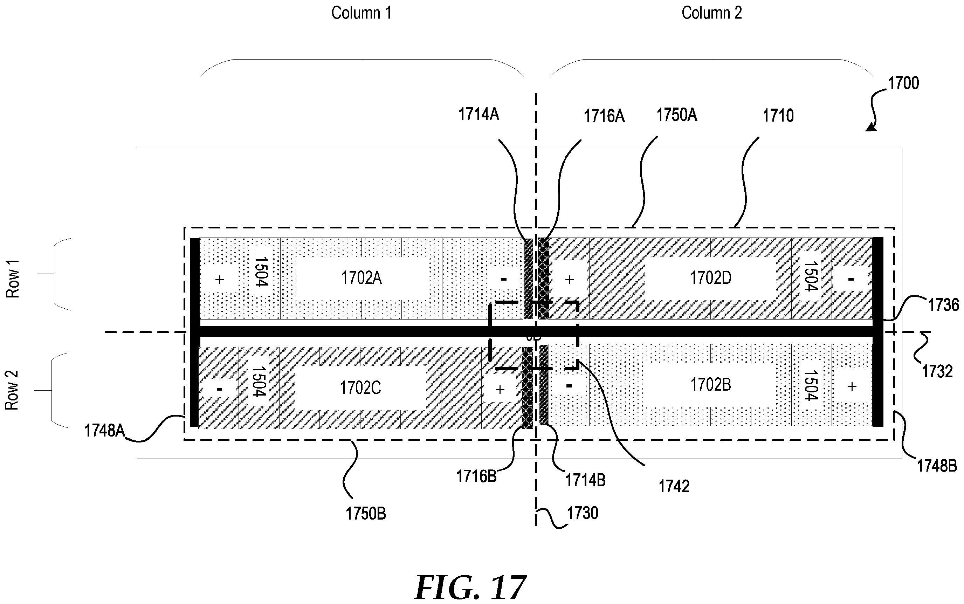

FIG. 17 depicts an example roof tile PV cell array 1710 and example roof tile PV module 1700 according to one or more aspects of the present disclosure. According to considerations, it may be advantageous for the junction box of a roof tile PV module to be disposed near a side of the roof tile PV module (e.g., the PV cell array and PV module of FIGS. 15 and 16). Alternatively, depending on considerations (e.g., installation considerations, shading considerations) it may be advantageous for the junction box to be disposed proximate to the middle of the module. As such, aspects of the present disclosure relate to TCT spatially distributed roof tile PV cell array and roof tile PV modules with one or more junction boxes disposed proximate to the middle of the PV cell array (e.g., between two substring columns). Accordingly, aspects additionally relate to the reduced complexity of production of such roof tile PV cell arrays and PV modules.

Referring to FIG. 17, each of substrings 1702A-1702D (generally substrings 1702) may include a number of electrically serially connected PV cells 1708. (For clarity of depiction, only one PV cell 1708 per substring 1702 is depicted with a reference numeral, however each PV cell 1708 (eight PV cells 1708 are depicted per substring 1702 of FIG. 17A) should be considered substantially the same as one another). The PV module 1700 and PV cell array 1710 of FIG. 17 may be understood as an additional example of the TCT spatially distributed PV cell array of FIGS. 14A-14B. Each PV cell may have a positive terminal and a negative terminal (e.g., across which a PV cell open circuit voltage may be measured upon power production of the PV cell). Similarly, each substring 1702 (1702A-1702D) of serially connected PV cells 1708 may include a substring positive terminal and a substring negative terminal (e.g., across which a substring open circuit voltage may be measured upon power production of the substring). The substrings 1702A-1702D may be arranged in relation to one another such that a TCT and spatially distributed topology, with a junction box proximate to the longitudinal midline 1730, may be achieved with reduced complexity of production. For example, the positive and negative terminals of each of substrings 1702 may be arranged variously such that conductor crossover on the roof tile PV module 1700, outside of junction box 1742 may be reduced. Roof tile PV module 1700 may include junction box 1742. Junction box 1742 may similarly be strategically placed to achieve the desired electrical interconnection and spatial distribution. Conductor crossover inside of junction box 1742 may be less costly and less complex to achieve than conductor crossover on roof tile PV module 1700 outside of junction box 1742.

Roof tile PV cell array 1710 (and roof tile PV module 1700) may be rectangularly shaped with a long dimension, defined by two opposing long sides 1750 (first long reference side 1750A and second long reference side 1750B), and a short dimension defined by two opposing short sides 1748 (first short reference side 1748A and second short reference side 1748B). The PV cell array of FIG. 17A may be considered a horizontal array as each of the substrings 1702A-1702D extend horizontally along the long dimension (the present description is for purposes of depiction only and the PV cell array may be installed variously (e.g., such that the long dimension extends vertically). The substrings 1702 may be disposed in two rows of two substrings (the rows extending along the long dimension); and two columns of two substrings (the columns extending along the short dimension). Junction box 1742 may be disposed proximate to the longitudinal midline 1730 of the roof tile PV cell array (the longitudinal midline 1730 may be considered the midline between the two columns of substrings). Substring 1702A may be disposed at the first row, first column of the roof tile PV cell array 1710. The first row may begin with the positive terminal of substring 1702A. Substring 1702A may extend into the first row, from its positive terminal, along the long dimension and terminate, at the negative terminal of substring 1702A proximate to the longitudinal midline 1730. Substring 1702D may be disposed at the first row, second column of the roof tile PV cell array 1710. The positive terminal of substring 1702D may be disposed proximate to the longitudinal midline 1730 of the roof tile PV cell array. Substring 1702D may extend from its positive terminal proximate to the longitudinal midline 1730 of the first row, along the long dimension of the PV cell array, and terminate, at the negative terminal of substring 1702D, proximate the second short reference side 1748B at the end of the first row.

Substring 1702C may be disposed at the second row, first column of the roof tile PV cell array 1710. The negative terminal of substring 1702C may be disposed proximate to the first reference short 1748A at the start of the second row. Substring 1702C may extend into the second row, along the long dimension of the roof tile PV cell array 1710 and may terminate, in the positive terminal of substring 1702C, proximate to the longitudinal midline 1730 at the second row. Substring 1702B may be disposed in the second row, second column. The negative terminal of substring 1702B may be disposed proximate to the longitudinal midline at the second row. Substring 1702B may extend from its negative terminal, along the long dimension of the roof tile PV cell array 1710 to the positive terminal of substring 1702B. The positive terminal of substring 1702B may be disposed proximate to the second short reference side 1748B at the end of the second row of the PV cell array. The substring terminals may be considered arranged in the roof tile PV cell array 1710 as follows:

$$\begin{bmatrix} + & - & + & - \\ - & + & - & + \end{bmatrix}.$$

With the disposition of the substring terminals as described above, the complexity of the electrical connection of the TCT spatially distributed roof tile PV cell array 1710 may be reduced. For example, the TCT spatially distributed roof tile PV cell array electrical connections may be achieved without conductor crossover on the roof tile PV module 1700 (outside of junction box 1742). FIG. 17 depicts an example route of conductors (e.g., ribbon wire, conductive traces of a conductive backsheet) that may be achieved on the roof tile PV module 1700. The conductors of FIG. 17 are depicted as paths (some patterned). Referring to FIG. 17, the negative terminal of substring 1702D may be disposed proximate to the positive terminal of substring 1702B. These terminals may be disposed proximate to the second short reference side 1748B of the roof tile PV cell array. Additionally, the positive terminal of substring 1702A may be disposed proximate to the negative terminal of substring 1702C. These terminals may be disposed proximate to the first short reference side 1748A. Midpoint conductor 1736 (e.g., ribbon wire, conductive trace of a conductive backsheet) may be electrically connected to the negative terminal of substring 1702D and the positive terminal of substring 1702B. The midpoint conductor 1736 may simply run proximate to the second short reference side 1748B of the roof tile PV cell array. The midpoint conductor 1736 may additionally be electrically connected to the positive terminal of substring 1702A and the negative terminal of substring 1702C (disposed proximate to one another). The midpoint conductor 1736 may then be routed between the two rows of the PV cell array (in between substring 1702D and 1702B) (e.g., proximate to and along the transverse midline 1732), and connect. This connection may or may not be effectuated in junction box 1742.

Negative terminal of substring 1702A, positive terminal of substring 1702D, positive terminal of substring 1702C, and negative terminal of substring 1702B may all be disposed proximate to the longitudinal midline 1730 (e.g., some on either side of the longitudinal midline 1730). Junction box 1742 may be disposed proximate to the longitudinal midline 1730. Accordingly, negative conductor 1714A may be connected to the negative terminal of substring 1702A and may be routed, proximate to the longitudinal midline 1730, into junction box 1742. Positive conductor 1716A may be connected to the positive terminal of substring 1702D and may be routed, proximate to the longitudinal midline 1730, into the junction box 1742. Positive conductor 1716B may be connected to the positive terminal of substring 1702C and may be routed, proximate to the longitudinal midline 1730, into the junction box 1742. Negative conductor 1714B may be connected to the negative terminal of substring 1702B and may be routed, proximate to the longitudinal midline 1730, into junction box 1742. The remaining electrical connections (e.g., negative conductor 1714A to negative conductor 1714B, positive conductor 1716A to positive conductor 1716B) may be achieved in junction box 1742 to achieve the desired TCT spatially distributed roof tile PV cell array 1710.

One or more active and/or passive electrical and/or power components may be included with roof tile PV cell array 1710 at and/or in the junction box 1742. For example, one or more diodes (e.g., bypass diodes and/or blocking diodes) may be included in junction box 1742. Bypass diodes may be included to allow for the bypass of one or more substrings in the case of a mismatch condition, and blocking diodes may be included to block the backflow of current into one or more substrings 1702 and/or the PV cell array 1710. Additionally or alternatively, active power electronics, for example, power optimizer, micro-inverter, MPPTs, DC-DC converters, etc. may be included in junction box 1742 to variously act on the power produced by the roof tile PV cell array 1710. Following electrical connection injunction box 1742, and the optional inclusion of passive and/or active electronics, roof tile PV cell array 1710 may electrically terminate with a positive roof tile PV cell array terminal and a negative roof tile PV cell array terminal. The positive and negative roof tile PV cell array terminals may avail the power produced by the roof tile PV cell array. Positive roof tile PV module lead and negative roof tile PV module lead may be incorporated with junction box 1742 and may extend from junction box 1742. Positive and negative roof tile PV module leads may be electrically connected to positive and negative roof tile PV cell array terminals respectively. Thus, the power produced by roof tile PV cell array 1710 may be availed at positive and negative roof tile PV module leads. PV module leads may include connectors (e.g., MC4 connectors) so that subsequent components (e.g., PV modules, active electronics, passive electronics, the grid, batteries, etc.) may be connected to, utilize, and/or act upon the power produced by roof tile PV cell array 1710 and roof tile PV module 1700.

The above description depicts the substrings 1702A-1702D of FIG. 17 with relative position based on the orientation of the PV cell array as depicted in FIG. 17. However, it should be understood that the orientation of the roof tile PV cell array 1710 and roof tile PV module 1700 of FIG. 17 may vary. For example, When installed, the roof tile PV cell module 1700 of FIG. 17 may be rotated, e.g., 90°, 180°, 270°, etc. Assuming the example where the PV cell module 1700 of FIG. 17 is rotated an exemplary 180°, substring 1702B may be considered disposed at position first row, first column. However, the relative position of each of the substring terminals may not change allowing for the same electrical interconnectivity scheme. It should additionally be recognized that aspects of the present disclosure may similarly be practiced where the disposition of each substring 1702A-1702D is rotated by 180°. Accordingly, the terminals of the roof tile PV cell array may be disposed as follows:

$$\begin{bmatrix} - & + & - & + \\ + & - & + & - \end{bmatrix}.$$

Junction box 1742 is depicted as being disposed proximate to the transverse midline 1732 (i.e., between the two substring rows) and proximate to the longitudinal midline 1730 (i.e., between the two substring columns) of the roof tile PV cell array. The junction box 1742 may be connected to the frontside of the roof tile PV module 1700 (e.g., on a non-conductive surface thereof) or to the backside of the roof tile PV module 1700. It should be recognized, that according to aspects, junction box 1742 may be moved variously. For example, junction box 1742 may be disposed anywhere proximate to the longitudinal midline 1730. Additionally, roof tile PV module 1700 and roof tile PV cell array 1710 is depicted in FIG. 17 as including one junction box 1742 in which both positive and negative connections may be completed. However, according to aspects, roof tile PV module 1700 and roof tile PV cell array 1710 may include two junction boxes (e.g., a positive junction box and a negative junction box) in which the positive connections and negative connections may be effectuated respectively.

As described herein, aspects of the present disclosure may be practiced with full PV cells or PV cells of any size or with any $\frac{1}{N}$ cut PV cells of any size, where N is an integer. Full PV cells may be cut to $\frac{1}{N}$ size to yield $\frac{1}{N}$ cut PV cells. As described, $\frac{1}{N}$ cut PV cells may produce substantially similar voltage potential characteristics to that of a PV cell from which the $\frac{1}{N}$ cut PV cell was cut. Whereas, $\frac{1}{N}$ cut PV cells may produce substantially $\frac{1}{N}$ times the current production as a full PV cell from which the $\frac{1}{N}$ cut PV cell was cut, under the same conditions (e.g., same irradiance conditions, environmental conditions, testing conditions, etc.).

The roof tile PV cell array 1710 of FIG. 17 is depicted as including eight PV cells 1708 per substring 1702, and the PV cells 1708 of substrings 1702 are depicted as $\frac{1}{2}$ cut PV cells. According to aspects of the present disclosure, substrings 1702, (i.e., 1702A-1702D) may include any number of PV cells 1708 per substring. Additionally, it is contemplated that the PV cells 1708 of substrings 1702 may be any $\frac{1}{N}$ cut PV cells (including full PV cells).

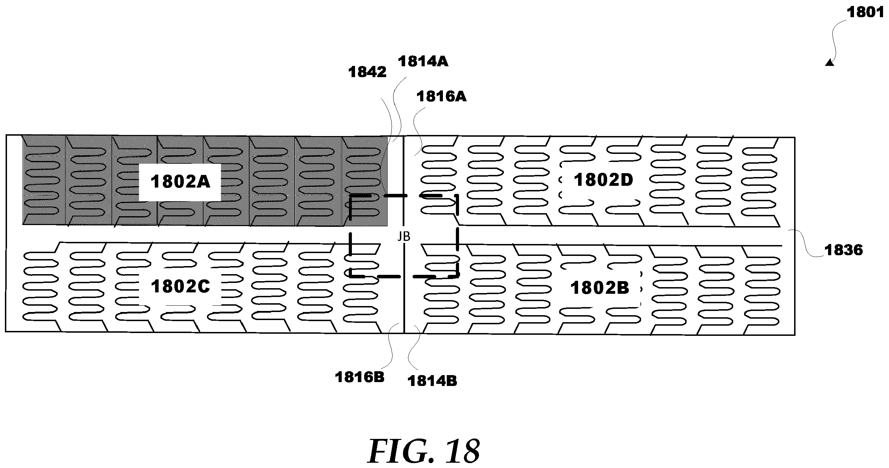

FIG. 18 depicts an example conductive backsheet 1601 to effectuate the example roof tile PV cell array of FIG. 17. Accordingly, substrings 1802A-1802D of FIG. 18 may be understood as corresponding to substrings 1702A-1702D, respectively, of FIG. 17. Additionally, conductive traces of FIG. 18 may be understood as corresponding to conductors of FIG. 17. Accordingly, conductive traces 1836, 1814A, 1814B, 1816A, and 1816B, of FIG. 18, may be understood as corresponding to conductors 1736, 1714A, 1714B, 1716A, and 1716B, respectively, of FIG. 17. Accordingly, it will be appreciated that with the installation of rear contact PV cells upon conductive backsheet 1801, roof tile PV cell array 1700 of FIG. 17 may be realized. Additionally, it may be appreciated that the topologies of FIG. 17 may be achieved variously (e.g., with ribbon wire, and/or with conductive backsheets). Midpoint conductor 1736 and midpoint trace 1836 may add increased parallelization (e.g., TCT connection) to the roof tile PV cell array 1710 of FIG. 17. The midpoint conductor 1736 and the conductive trace 1836 may predominantly conduct in a case of mismatch (e.g., where a portion of the roof tile PV cell array 1710 is shaded). Accordingly, the midpoint conductor 1736 and conductive trace 1836 may be of decreased substantiality as compared to other conductors of roof tile PV cell array 1710 and/or conductive traces of conductive backsheet 1801. For example, conductive trace 1836 may be narrower and/or thinner than some or all of conductive traces 1814A, 1814B, 1816A, and 1816B. The same may hold true for all midpoint conductors and corresponding conductive traces of the present disclosure.

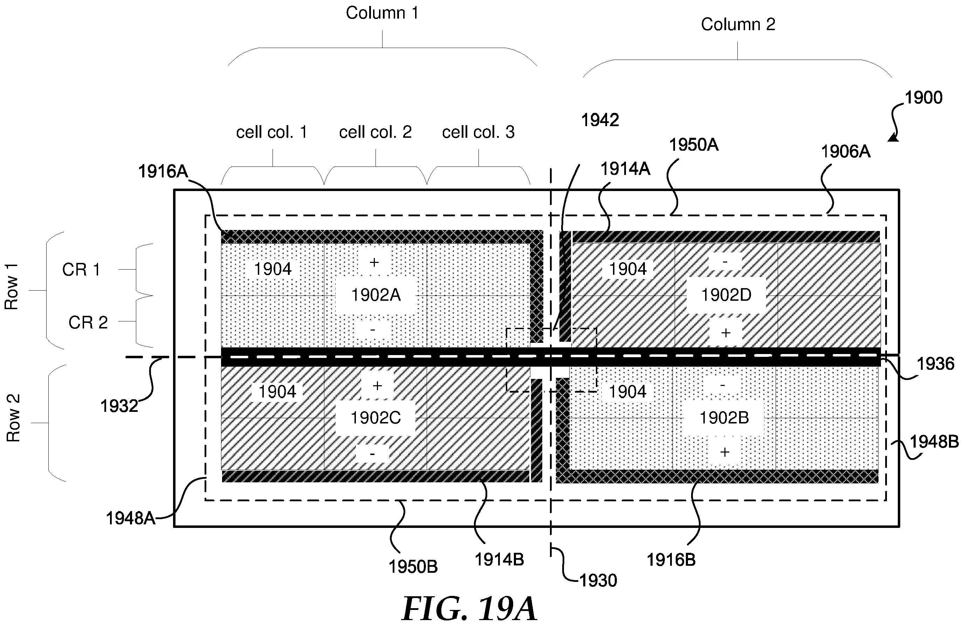

FIG. 19A depicts an example roof tile PV cell array topology of a 2x2 TCT and spatially distributed roof tile vertical PV cell array 1910A and PV module of FIGS. 14A-14B according to one or more aspects of the present disclosure. The electrical schematic of FIG. 14A with the spatial distribution of FIG. 14B may be achieved variously. Referring to FIG. 19A, roof tile vertical PV cell array 1910A may include four substrings: substring 1902A, substring 1902B, substring 1902C, and substrings 1902D (generally substrings 1902). The substrings 1902 may be arranged in a 2x2 array of substrings (two rows ("Row" in FIG. 19A) x two columns "Columns" in FIG. 19A). Each of substrings 1902A-1902D may include a 2x3 array of PV cells (two rows ("CR" in FIG. 19A) x three columns ("cell col." in FIG. 19A)). The PV cells 1908 of each column of each substring 1902A-1902D may be electrically serially connected to each other, and the columns of each substring 1902A-1902D may be electrically parallelly connected to each other. Substrings 1902A-1902D are depicted in FIG. 19A as including 2 rows and three columns for purposes of example only. Accordingly, substrings 1902A-1902D may include any number of rows of PV cells 1908 and any number of columns of PV cells per substring 1902. For clarity of depiction, only one PV cell 1908 per substring 1902 is depicted with a reference numeral, however each PV cell 1908 (six PV cells 1908 are depicted per substring 1902 of FIG. 19A) should be considered substantially the same as one another.

The substrings 1902A-1902D may be arranged in relation to one another such that a TCT and spatially distributed topology, with a junction box proximate to the longitudinal midline 1930, may be achieved with reduced complexity of production. For example, the positive and negative substring terminals may be arranged variously such that conductor crossover on the roof tile PV module 1900, outside of junction box 1942, may be reduced. Roof tile PV module 1900 may include junction box 1942. Junction box 1942 may similarly be strategically placed to achieve the desired electrical interconnection and spatial distribution. Conductor crossover inside of junction box 1942 may be less costly and less complex to achieve than conductor crossover on roof tile PV module 1900 outside of junction box 1942.

Referring to FIG. 19A, roof tile vertical PV cell array 1910A (and roof tile PV module 1900) may be rectangularly shaped with a long dimension, defined by two opposing long sides 1950 (first long reference side 1950A and second long reference side 1950B), and a short dimension defined by two opposing short sides 1948 (first short reference side 1948A and second short reference side 1948B). Whereas the PV cell array of FIGS. 15A, 15B, and 17, may be considered horizontal roof tile PV cell arrays, the roof tile PV cell array of FIG. 19A may be considered a vertical PV cell array as the serially connected PV cells 1908 of each substring 1902 (1902A-1902D) may extend vertically (i.e., extend parallel to the longitudinal midline 1930). The substrings 1902A-1902D may be disposed in two rows of two substrings (each row extending along the long dimension); and two columns of two substrings (each column extending along the short dimension). Junction box 1942 may be disposed proximate to the longitudinal midline (e.g., between the two columns).

Substring 1902A may be disposed at the Row 1, Column 1 of the roof tile vertical PV cell array 1910A. Substring 1902A may include columns of electrically serially connected PV cells 1908. The positive terminal of each column of substring 1902A (i.e., the positive terminal of substring 1902A) may be disposed proximate to the first long reference side 1950A of the PV cell array 1910. As each column of substring 1902A may extend from the first long reference side 1950A toward the second long reference side 1950B (and transverse midline 1932), the negative terminal of each column of substring 1902A (i.e., the negative terminal of substring 1902A) may be disposed proximate to the transverse midline 1932 of the PV cell array. Substring 1902D may be disposed at the Row 1, Column 2 of the roof tile vertical PV cell array 1910A. Substring 1902D may include columns of electrically serially connected PV cells 1908. The negative terminal of each column of substring 1902D (i.e.,

the negative terminal of substring 1902D) may be disposed proximate to the first long reference side 1950A of the PV cell array 1910. As each column of substring 1902D extends from the first long reference side 1950A toward the second long reference side 1950B (and transverse midline 1932), the positive terminal of each column of substring 1902D (i.e., the positive terminal of substring 1902D) may be disposed proximate to the transverse midline 1930 of the PV cell array 1910.

Substring 1902C may be disposed at the Row 2, Column 1 of the roof tile vertical PV cell array 1910A. Substring 1902C may include columns of electrically serially connected PV cells 1908. The positive terminal of each column of substring 1902C (i.e., the positive terminal of substring 1902C) may be disposed proximate to the transverse midline 1932 of the PV cell array 1910. As each column of substring 1902C extends from the transverse midline 1932 toward the second long reference side 1950B, the negative terminal of each column of substring 1902C (i.e., the negative terminal of substring 1902C) may be disposed proximate to the second long reference side 1950B of PV cell array. Substring 1902B may be disposed at the Row 2, Column 2 of the roof tile vertical PV cell array 1910A. Substring 1902B may include columns of electrically serially connected PV cells 1908. The negative terminal of each column of substring 1902B (i.e., the negative terminal of substring 1902B) may be disposed proximate to the lateral midline of the PV cell array 1910. As each column of substring 1902B extends from the lateral midline toward the second long reference side 1950B, the positive terminal of each column of substring 1902B (i.e., the positive terminal of substring 1902B) may be disposed proximate to the second long reference side 1950B of the PV cell array 1910. The substring terminals in the vertical PV cell array 1910A may be considered arranged in the roof tile vertical PV cell array 1910A as follows:

$$\begin{bmatrix} + & - \\ - & + \\ + & - \\ - & + \end{bmatrix}.$$

With the disposition of the substring terminals as described above, the complexity of the electrical connections of the TCT spatially distributed roof tile vertical PV cell array 1910A may be reduced. For example, the TCT spatially distributed roof tile PV cell array electrical connections may be achieved without conductor crossover on the roof tile PV module 1900 (outside of junction box 1942). FIG. 19A depicts the example route of conductors (e.g., ribbon wire, and/or conductive trace of conductive backsheet) that may be achieved on the roof tile PV module 1900. The conductors of FIG. 19A are depicted as paths (some patterned). Referring to FIG. 19A, the negative terminal of substring 1902A may be disposed proximate to the positive terminal of substring 1902C. These terminals may be disposed proximate to the transverse midline 1932 of the roof tile vertical PV cell array 1910A. Additionally, the positive terminal of substring 1902D may be disposed proximate to the negative terminal of substring 1902B. These terminals may also be disposed proximate to the transverse midline 1932 of roof tile vertical PV cell array 1910A. Midpoint conductor 1936 (e.g., ribbon wire, and/or conductive trace of conductive backsheet) may be electrically connected to the negative terminal of substring 1902A and the positive terminal of substring 1902C. Additionally, midpoint conductor 1936 may be electrically connected to the positive terminal of substring 1902D and the negative terminal of substring 1902B. The portion of midpoint conductor 1936 connecting substrings 1902A to 1902C may be connected to the portion of midpoint conductor 1936 connecting substrings 1902D and 1902B in side of the junction box 1942, or outside of the junction box 1942 (e.g., on the module). Midpoint conductor 1936 may assist in achieving the TCT connection by facilitating: serial connection of substring 1902A to substrings 1902C; serial connection of substring 1902B to 1902D; the parallel connection of 1902A to 1902B; and the parallel connection of 1902C to 1902D.

Junction box 1942 may be disposed proximate to the longitudinal midline 1930 of the PV cell array 1910A. According to aspects, junction box 1942 may additionally be disposed proximate to the transverse midline 1932 of the PV cell array 1910A. Positive terminal of substring 1902A, and negative terminal of substring 1902D may be disposed proximate to the first long reference side 1950A of the PV cell array 1910A. Accordingly, positive conductor 1916A may be connected to the positive terminals of the columns of substring 1902A (i.e., the positive terminal of substring 1902A) and may be routed, proximate to the longitudinal midline, into junction box 1942. Similarly, negative conductor 1914A may be connected to the negative terminals of the columns of substring 1902D (i.e., negative terminal of substring 1902D) and may be routed, proximate to the longitudinal midline, into junction box 1942. Positive terminal of substring 1902B, and negative terminal of substring 1902C may be disposed proximate to the second long reference side 1950B of the PV cell array 1910A. Accordingly, positive conductor 1916B may be connected to the positive terminals of the columns of substring 1902B (i.e., the positive terminal of substring 1902B) and may be routed, proximate to the longitudinal midline, into junction box 1942. Similarly, negative conductor 1914B may be connected to the negative terminals of the columns of substring 1902C (i.e., negative terminal of substring 1902C) and may be routed, proximate to the longitudinal midline, into junction box 1942. The remaining electrical connections (e.g., negative conductor 1914A to negative conductor 1914B, positive conductor 1916A to positive conductor 1916B) may be achieved injunction box 1942 to achieve the desired TCT spatially distributed roof tile vertical PV cell array 1910A.

One or more active and/or passive electrical and/or power components may be added with roof tile vertical PV cell array 1910A at the junction box. For example, one or more diodes (e.g., bypass diodes and/ blocking diodes) may be included in junction box 1942. Bypass diodes may be included to allow for the bypass of one or more substrings in the case of a mismatch condition and blocking diodes may prevent the backflow of excessive current into one or more of the substrings 1902 and/or the PV cell array 1910A. Additionally or alternatively, active power electronics, for example, power optimizer, micro-inverter, MPPTs, DC-DC converters etc. may be included injunction box 1942 to variously act on the power produced by the roof tile vertical PV cell array 1910A. Following electrical connection in junction box 1942, and the optional inclusion of passive and/or active electronics, roof tile vertical PV cell array 1910A may electrically terminate with a positive roof tile PV cell array terminal and a negative roof tile PV cell array terminal. The positive and negative roof tile PV cell array terminals may avail the power produced by the roof tile PV cell array. Positive roof tile PV module lead and negative roof tile PV module lead may be incorporated with junction box 1942 and may extend from junction box 1942. Positive and negative roof tile PV module leads may be electrically connected to positive and negative roof tile PV cell array terminals respectively. Thus, the power produced by roof tile vertical PV cell array 1910A may be availed at positive and negative roof tile PV module leads. PV module leads may include connectors (e.g., MC4 connectors) so that subsequent components (e.g., PV modules, active electronics, passive electronics, the grid, batteries, etc.) may be connected to, utilize, and/or act upon the power produced by roof tile vertical PV cell array 1910A and roof tile PV module 1900.

The above description depicts the substrings 1902A-1902D of FIG. 19A with relative position based on the orientation of the PV cell array as depicted in FIG. 19A. However, it should be understood that the orientation of the roof tile vertical PV cell array 1910A and roof tile PV module 1900 of FIG. 19A may vary. For example, When installed, the roof tile PV cell module 1900 of FIG. 19A may be rotated, e.g., 90°, 180°, 270°, etc. Assuming the example where the PV cell module 1900 of FIG. 19A is rotated an exemplary 180°, substring 1902B may be considered disposed at position first row, first column. However, the relative position of each of the substring terminals may not change allowing for the same electrical interconnectivity scheme. It should additionally be recognized that aspects of the present disclosure may similarly be practiced where the disposition of each substring 1902A-1902D is rotated by 180°. Accordingly, the terminals of the roof tile PV cell array may be disposed as

follows:
$$\begin{bmatrix} - & + \\ + & - \\ - & + \\ + & - \end{bmatrix}.$$

Junction box 1942 is depicted as being disposed proximate to the transverse midline 1932 (i.e., between the two substring rows) and proximate to the longitudinal midline 1930 (i.e., between the two substring columns) of the roof tile PV cell array. It should be recognized, that according to aspects, junction box 1942 may be moved variously. For example, junction box 1942 may be disposed anywhere proximate to the longitudinal midline 1930. Additionally, roof tile PV module 1900 and roof tile vertical PV cell array 1910A is depicted in FIG. 19A as including one junction box 1942 in which both positive and negative connections may be completed. However, according to aspects, roof tile PV module 1900 and roof tile vertical PV cell array 1910A may include two junction boxes (e.g., a positive junction box and a negative junction box) in which the positive connections and negative connections may be effectuated respectively.

As described herein, aspects of the present disclosure may be practiced with full PV cells or PV cells of any size or with any $\frac{1}{N}$ cut PV cells of any size, where N is an integer. Full PV cells may be cut to $\frac{1}{N}$ size to yield $\frac{1}{N}$ cut PV cells. As described, $\frac{1}{N}$ cut PV cells may produce substantially similar voltage potential characteristics to that of a PV cell from which the $\frac{1}{N}$ cut PV cell was cut. Whereas, $\frac{1}{N}$ cut PV cells may produce substantially $\frac{1}{N}$ times the current production as a full PV cell from which the $\frac{1}{N}$ cut PV cell was cut, under the same conditions (e.g., same irradiance conditions, environmental conditions, testing conditions, etc.).

The roof tile vertical PV cell array 1910A of FIG. 19A is depicted as including six PV cells 1908 per substring 1902, and the PV cells 1908 of substrings 1902 are depicted as $\frac{1}{2}$ cut PV cells. According to aspects of the present disclosure, substrings 1902, (i.e., 1902A-1902D) may include any number of PV cells 1908 per substring. Additionally, it is contemplated that the PV cells 1908 of substrings 1902 may be any $\frac{1}{N}$ cut PV cells (including full PV cells). Additionally, substrings 1902A-1902D are depicted as including two rows and three columns of PV cells. It is contemplated that substrings 1902A-1902D may include any number of rows and any number of columns of PV cells 1908.

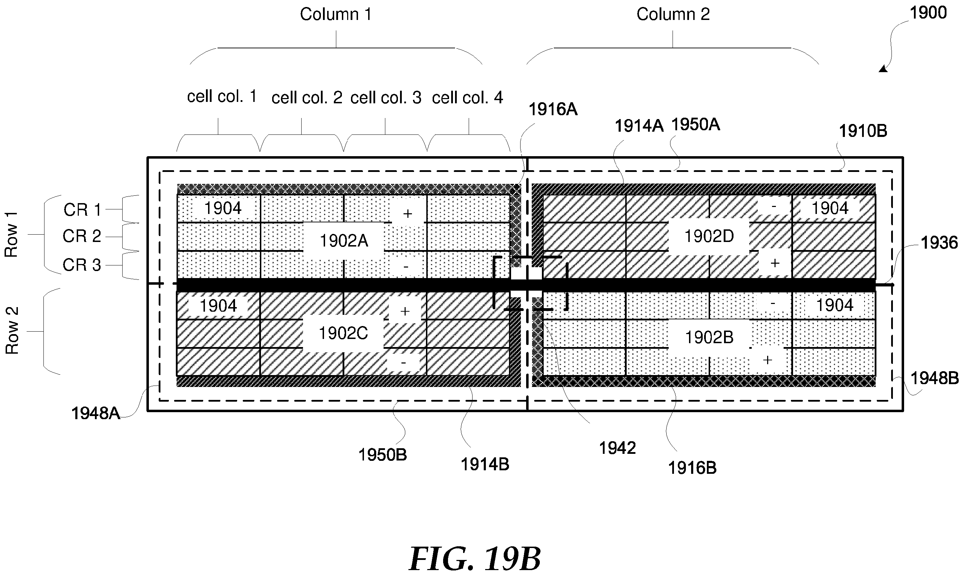

FIG. 19A, depicts an example roof tile vertical PV cell array 1910A wherein each substring 1902A-1902D includes six $\frac{1}{2}$ cut PV cells 1908 arranged in two rows and three columns. However, according to aspects, PV cells of substrings 1902A-1902D of vertical roof tile vertical PV cell array 1910A may be variously $\frac{1}{N}$ cut and may be variously arranged. FIG. 19B depicts an example vertical roof tile PV cell array according to one or more aspects of the present disclosure. The vertical roof tile PV cell array of FIG. 19B may be considered substantially identical to the vertical roof tile PV cell array of FIG. 19A unless expressly stated otherwise herein. Referring to FIG. 19B, substrings 1902A-1902B may each include twelve $\frac{1}{3}$ cut PV cells 1908. The PV cells 1908 may be arranged in each of substrings 1902A-1902D in three rows by four columns. Thus, it may be appreciated that the topologies of FIGS. 19A-19B may be variously configured to produce varying operating points (e.g., varying $V_{oc}$, $I_{sc}$, $V_{mp}$, $I_{mp}$, etc.) while maintaining simplified TCT spatially distributed roof tile vertical PV cell array 1910A.

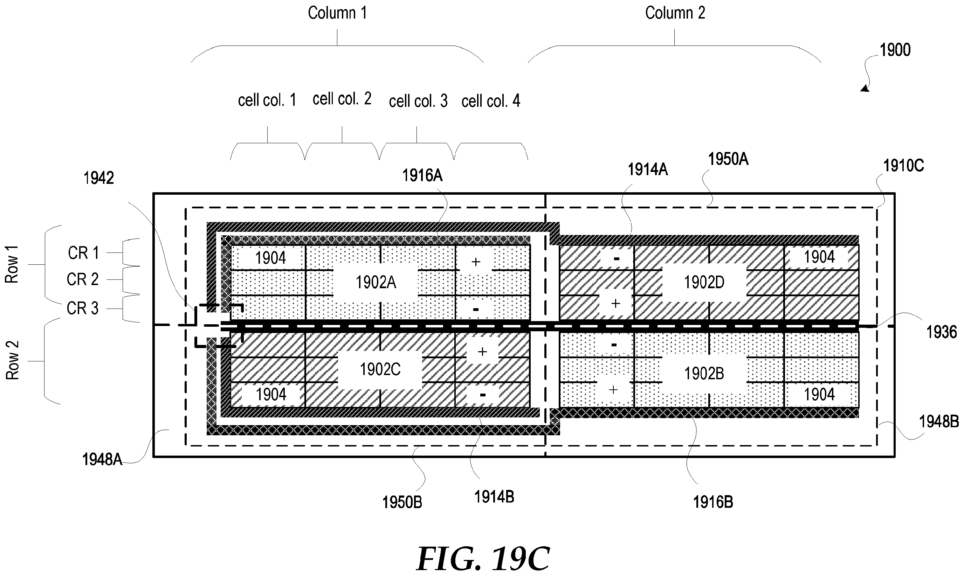

FIGS. 19A-19B depict example TCT spatially distributed roof tile vertical PV cell arrays 1910 with junction box 1942 disposed proximate to the longitudinal midline of the roof tile vertical PV cell arrays 1910. According to final roof tile PV module 1900 installation considerations (e.g., considerations if installing roof tile PV module 1900 of a roof) it may be advantageous for junction box 1942 to be disposed variously. FIG. 19C depicts an example TCT spatially distributed roof tile vertical PV cell array 1910C with an example junction box 1942 disposed proximate to the PV cell array 1910 side. Referring to FIG. 19C, according to aspects, junction box 1942 may be disposed proximate to a short side (e.g., first short reference side 1948A and/or second short reference side 1948B). Accordingly, roof tile vertical PV cell array 1910B may be considered substantially identical to roof tile PV cell array unless expressly described otherwise herein.

Advantages of the configuration of FIG. 19C may be achieved by variously routing conductors of roof tile vertical PV cell array 1910B. Referring to FIG. 19C, positive conductor 1916A, electrically connected to the positive terminal of substring 1902A, may be routed proximate to the first long reference side 1950A toward first short reference side 1948A and, proximate to the first short reference side 1948A, into junction box 1942. Negative conductor 1914A, electrically connected to negative terminal of substring 1902D may be routed along the roof tile vertical PV cell array 1910B, proximate to the first long reference side 1950A toward the first short reference side 1948A. negative conductor 1914A may then be routed, proximate to the first short reference side 1948A into junction box 1942. Negative conductor 1914B, electrically connected to the negative terminal of substring 1902C, may be routed proximate to the second long reference side 1950A, toward first short reference side 1948A and, proximate to the first short reference side 1948A, into junction box 1942. Positive conductor 1916B, electrically connected to the positive terminal of substring 1902B may be routed along the roof tile PV cell array 1910, proximate to the second long reference side 1950B toward the first short reference side 1948A. Positive conductor 1916B may then be routed, proximate to the first short reference side 1948A into junction box 1942. As would be appreciated by persons of ordinary skill in the art, junction box 1942 may alternatively be disposed proximate to the second short reference side 1948B. Accordingly, one or more advantages of the present disclosure may be realized with roof tile vertical PV cell array 1910B and a side disposed junction box 1942 (e.g., proximate to the first short reference side 1948A or proximate to the second short reference side 1948B).

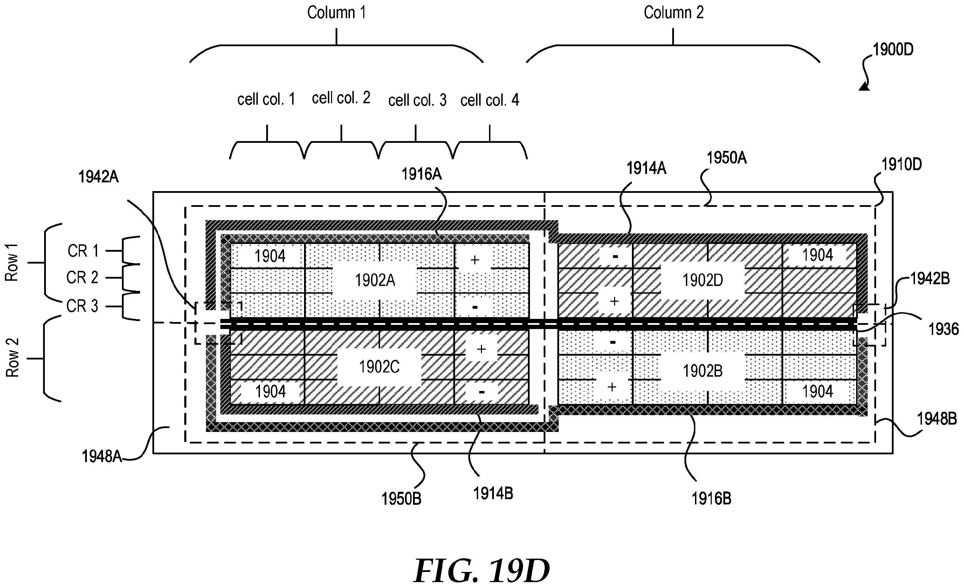

FIG. 19D depicts an example TCT spatially distributed roof tile vertical PV cell array 1910D with two junction boxes 1942A and 1942B (generally, junction boxes 1942). FIGS. 19A-19D depict roof tile vertical PV cell arrays 1910 and roof tile vertical PV modules 1900 as including one junction box 1942 in which positive and negative (and midpoint) electrical connections may be effectuated. According to aspects, it is contemplated that such PV cell arrays may include two junction boxes, for example, one with positive connections and one with negative connections or both junction boxes 1942A and 1942B with both positive and negative connections. Additionally, such multiple junction boxes may be disposed proximate to a single line (e.g., both junction boxes disposed proximate to the longitudinal midline, the first short reference side 1948A, or the second short reference side 1948B). Alternatively, each of the multiple junction boxes may be disposed proximate to different lines (e.g., one junction box disposed proximate to the first short reference side 1948A and a second junction box disposed proximate to the second short reference side).

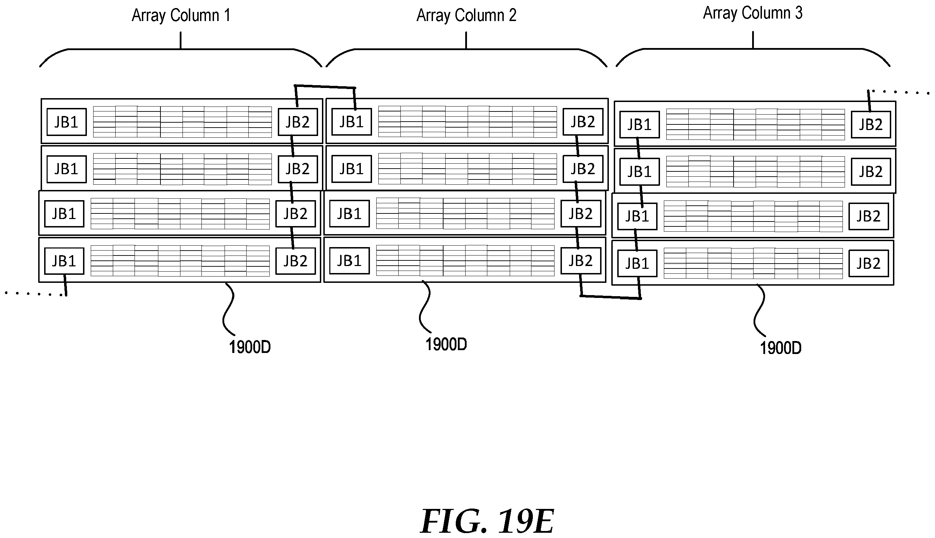

FIG. 19E depicts a system of connected roof tile PV modules of the present disclosure. Certain advantages of PV modules having two junction boxes may be understood with reference to FIG. 19E. In PV module arrays generally, but particularly in roof tile PV module arrays, PV modules may be installed in multiple columns, and all (or a portion) of the PV modules of the array may be electrically connected in series. The electrical connection may turn corners when transitioning between columns. By using two junction boxes 1942A ("JB1" in FIG. 19E) and 1942B ("JB2" in FIG. 19E) (both of which may avail both positive and negative busses), one on either side of the PV modules 1900D, the electrical connection of roof tile PV module arrays may be simplified, and efficiency of the array may be improved.

Referring to FIG. 19E, each PV module 1900D (only one PV module 1900D per column is referenced for clarity of depiction) may be connected to a PV module 1900D above, below and/or a module of an adjacent column. Each PV module 1900D of the same column may be connected to the other modules of the same column using the junction box on the same side. For example, each PV module 1900D of column 2 may be electrically connected to each other (e.g., in series) using each PV module's second junction box ("JB2" in FIG. 19E). Column 1 may be to the left of column 2, and column 3 may be to the right of column 2. Therefore, where column 2 connects to column 1 (e.g., the column to the left), the junction box 1942 on the left side of the transitioning PV module 1900D (e.g., JB1 in FIG. 19E) of column 2 may be near (e.g., proximate to) and connect to the junction box on the right side of the transitioning PV module 1900D of column 1 (e.g., JB2 in FIG. 19E). Further, where column 2 connects to column 3 (e.g., the column to the right), the junction box 1942 on the right side of the transitioning PV module 1900D (e.g., JB2 in FIG. 19E) of column 2 may be near (e.g., proximate to) and connect to the junction box on the left side of the transitioning PV module 1900D of column 3 (e.g., JB1 in FIG. 19E). Thus, the electrical connection for turning corners (e.g., transitioning between columns) may be simplified. Assuming all PV modules 1900D have two junction boxes, the serial connection of each column may proceed down either side of the PV modules 1900D. Alternatively, only transitioning modules may comprise two junction boxes, and non-transitioning PV modules 1900D may only comprise one junction box 1942. As will be appreciated, the advantages of such two junction box PV modules may be practiced with any of the PV modules and/or PV arrays of the present disclosure.

It will be appreciated from FIG. 19E that depending on the connections desired, both or either of the two junction boxes may be used. Additionally, junction boxes may be associated with an increased cost of production. Therefore, junction boxes 1942 may be produced as junction box bases and covers. Junction box bases may simply comprise positive and negative terminals to avail the power produced by the PV module 1900D. Junction box covers may be applied to the junction box bases. Different junction box covers may be applied for different uses. For example, one cover may be a dummy cover (e.g., a simple plastic cover) which may be installed for a junction box base that will not be used. Another junction box cover may comprise the junction box, for example, comprising circuitry and/or electrical connections to complete (if necessary) the connections of the PV cell array of the PV module 1900D. Such junction box covers may additionally or alternatively comprise junction box leads to avail the power produced by the PV module 1900D (e.g., to connect to other PV modules 1900D). Additionally or alternatively, the junction box covers may comprise active and/or passive electronics (e.g., PE 3202). Junction box covers may be produced specifically for different PV modules 1900D (e.g., having different electronics and/or connections for different PV array topologies).

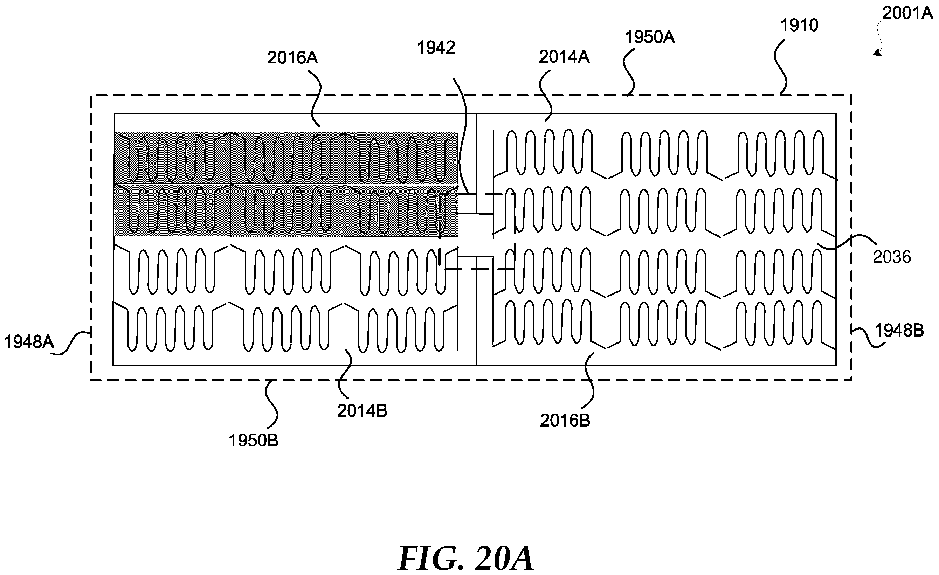

FIG. 20A depicts an example conductive backsheet 2001A that may effectuate the example roof tile vertical PV cell array of FIG. 19A. Accordingly, substrings 2002A-2002D of FIG. 20A may be understood as corresponding to substrings 1902A-1902D, respectively, of FIG. 19A. Additionally, conductive traces of FIG. 20A may be understood as corresponding to conductors of FIG. 19A. Accordingly, conductive traces 2036, 2014A, 2014B, 2016A, and 2016B, of FIG. 20A, may be understood as corresponding to conductors 1936, 1914A, 1914B, 1916A, and 1916B, respectively, of FIG. 19A. Accordingly, it will be appreciated that with the installation of rear contact PV cells upon conductive backsheet 2001A, roof tile vertical PV cell array 1910A of FIG. 19A may be realized. Additionally, it may be appreciated that the topologies of FIG. 19A may be realized variously (e.g., ribbon wire connected, conductive backsheet connected).

Further with reference to FIG. 20A it may be appreciated that with conductive backsheet 2001A, PV cells of each row of each of substrings 2002A-2002D may be electrically connected to each other in parallel. These connections may be gained by not cutting (or otherwise separating) the conductive backsheet between adjacent columns of the substrings. Further, PV cells of each column of each of substrings 2002A-2002D may be electrically connected to each other in series. Therefore, the PV cells of each of substrings 2002A-2002D, connected by conductive backsheet 2001A, may be considered electrically connected in series-parallel with total-cross-ties (i.e., connected in TCT). Such connection may further parallelize the roof tile vertical PV cell array and may allow for increased mismatch condition mitigation.

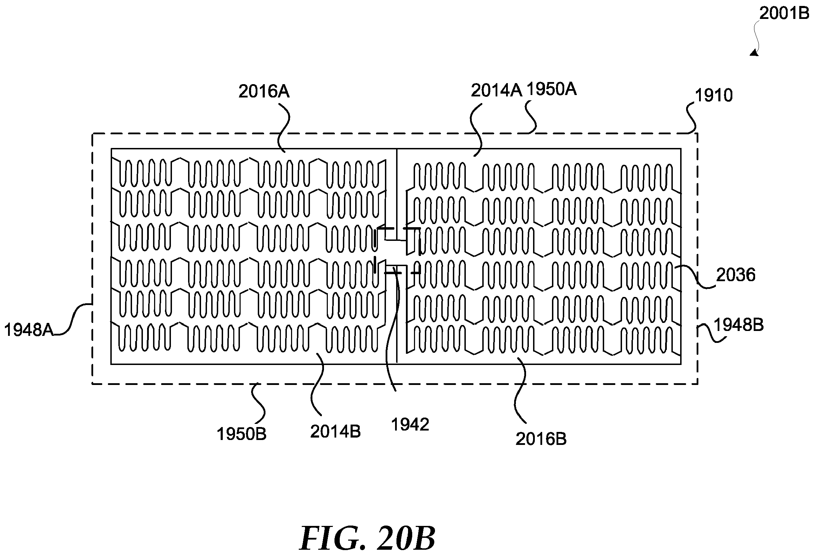

FIG. 20B depicts an example conductive backsheet 2001B that may effectuate the example roof tile vertical PV cell array of FIG. 19B. Accordingly, substrings 2002A-2002D of FIG. 20B may be understood as corresponding to substrings 1902A-1902D, respectively, of FIG. 19B. Additionally, conductive traces of FIG. 20B may be understood as corresponding to conductors of FIG. 19B. Accordingly, conductive traces 2036, 2014A, 2014B, 2016A, and 2016B, of FIG. 20B, may be understood as corresponding to conductors 1936, 1914A, 1914B, 1916A, and 1916B, respectively, of FIG. 19B. Accordingly, it will be appreciated that with the installation of rear contact PV cells upon conductive backsheet 2001B, roof tile vertical PV cell array 1910B of FIG. 19B may be realized. Additionally, it may be appreciated that the topologies of FIG. 19B may be realized variously (e.g., ribbon wire connected, conductive backsheet connected).

Further with reference to FIG. 20B it may be appreciated that with conductive backsheet 2001B, PV cells of each row of each of substrings 2002A-2002D may be electrically connected to each other in parallel. These connections may be gained by not cutting (or otherwise separating) the conductive backsheet between adjacent columns of the substrings. Further, PV cells of each column of each of substrings 2002A-2002D may be electrically connected to each other in series. Therefore, the PV cells of each of substrings 2002A-2002D, connected by conductive backsheet 2001B, may be considered electrically connected in series-parallel with total-cross-ties (i.e., connected in TCT). Such connection may further parallelize the roof tile vertical PV cell array and may allow for increased mismatch condition mitigation.

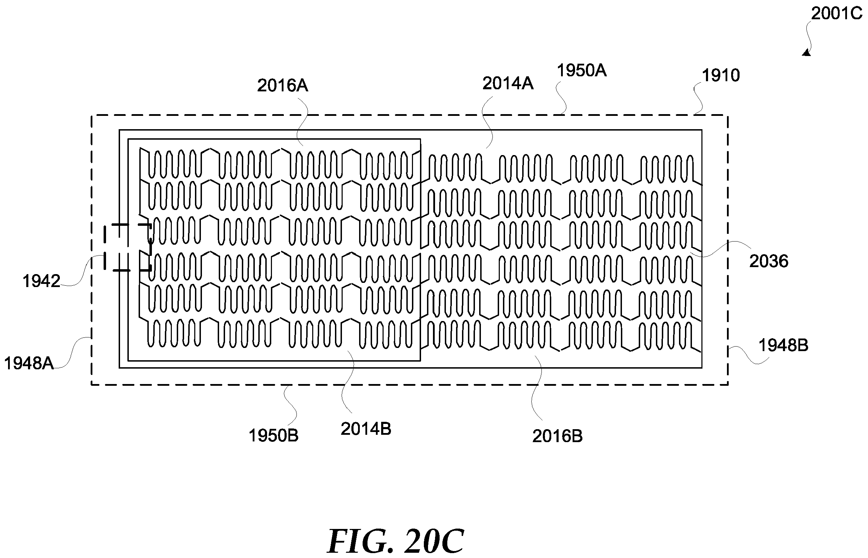

FIG. 20C depicts an example conductive backsheet 2001C that may effectuate the example roof tile vertical PV cell array of FIG. 19C. Accordingly, substrings 2002A-2002D of FIG. 20C may be understood as corresponding to substrings 1902A-1902D, respectively, of FIG. 19C. Additionally, conductive traces of FIG. 20C may be understood as corresponding to conductors of FIG. 19C. Accordingly, conductive traces 2036, 2014A, 2014B, 2016A, and 2016B, of FIG. 20C, may be understood as corresponding to conductors 1936, 1914A, 1914B, 1916A, and 1916B, respectively, of FIG. 19C. Accordingly, it will be appreciated that with the installation of rear contact PV cells upon conductive backsheet 2001C, roof tile vertical PV cell array 1910C of FIG. 19C may be realized. Additionally, it may be appreciated that the topologies of FIG. 19C may be realized variously (e.g., ribbon wire connected, conductive backsheet connected).

Further with reference to FIG. 20C it may be appreciated that with conductive backsheet 2001C, PV cells of each row of each of substrings 2002A-2002D may be electrically connected to each other in parallel. These connections may be gained by not cutting (or otherwise separating) the conductive backsheet between adjacent columns of the substrings. Further, PV cells of each column of each of substrings 2002A-2002D may be electrically connected to each other in series. Therefore, the PV cells of each of substrings 2002A-2002D, connected by conductive backsheet 2001C, may be considered electrically connected in series-parallel with total-cross-ties (i.e., connected in TCT). Such connection may further parallelize the roof tile vertical PV cell array and may allow for increased mismatch condition mitigation.

The midpoint conductors 1936 of FIGS. 19A-19C correspond to the conductive traces 2036 of FIGS. 20A-20C respectively. The midpoint conductors 1936 of FIGS. 19A-19C and the midpoint traces 2036 of FIGS. 20A-20C may add increased parallelization (e.g., TCT connection) to the roof tile PV cell arrays 1910. The midpoint conductors 1936 and the conductive traces 2036 may predominantly conduct in a case of mismatch (e.g., where a portion of the roof tile PV cell array 1910 is shaded). Accordingly, the midpoint conductors 1936 and conductive traces 2036 may be of decreased substantiality as compared to other conductors of roof tile PV cell array 1910 and/or conductive traces of conductive backsheet 2001. For example, conductive trace 2036 may be narrower and/or thinner than some or all of conductive traces 2014A, 2014B, 2016A, and 2016B. The same may hold true for all midpoint conductors and corresponding conductive traces of the present disclosure.

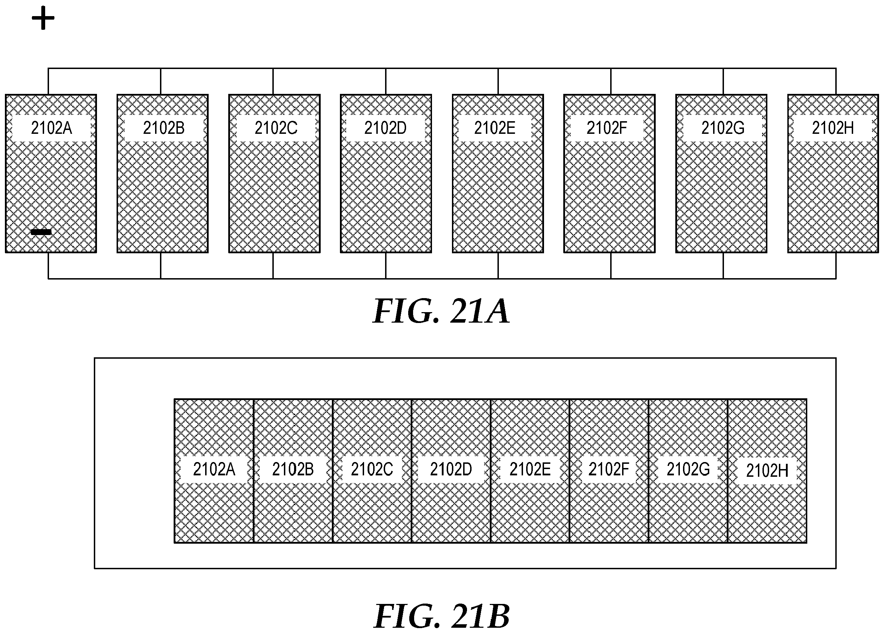

Similar to the above, aspects of the present disclosure relate to topologies of fully parallel roof tile PV cell arrays and PV modules and the improved productability of the same. FIG. 21A depicts an example electrical schematic of a 1x8 fully parallel roof tile PV cell array according to one or more aspects of the present disclosure. Referring to FIG. 21A, 1x8 fully parallel roof tile PV cell array may include substrings 2102A, 2102B, 2102C, 2102D, 2102E, 2102F, 2102G, and 2102H (referred to generally as substrings 2102). Substrings depicted with the same pattern may be electrically parallelly connected to each other. Accordingly, substrings 2102A-2102H may be electrically parallelly connected to each other as fully parallel roof tile PV cell array. FIG. 21B depicts an example physical arrangement of the fully parallel PV cell array of FIG. 21A.

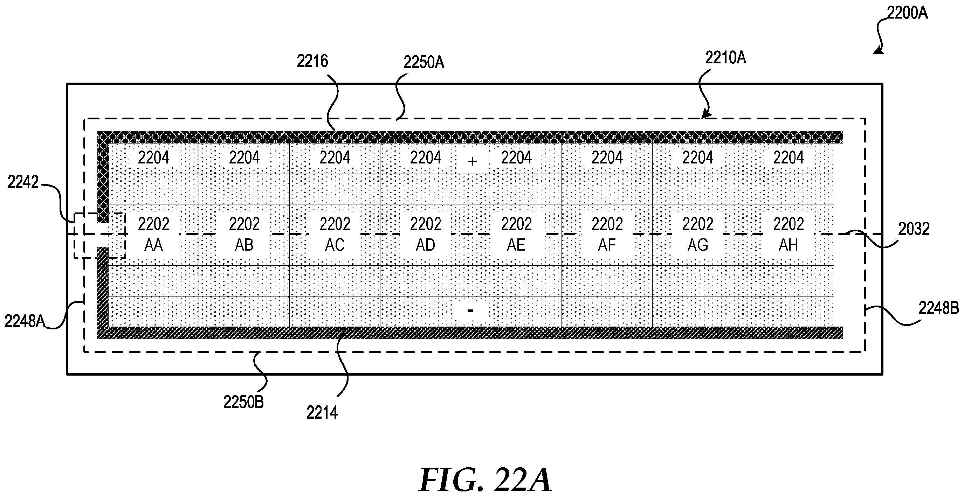

FIG. 22A depicts an example fully parallel roof tile PV cell array 2210A and an example fully parallel roof tile PV module 2200A. Referring to FIG. 22A, fully parallel roof tile PV cell array 2210A may include substrings 2202A-2202H (referred to generally as substrings 2202). Substrings 2202A-2202H may be arranged in a single row of substring columns. Fully parallel roof tile PV cell array 2210A is depicted as comprising eight columns (and one substring 2202 per column). Fully parallel roof tile PV cell array 2210A may include any number of substrings 2202 (and any number of columns). Each of substrings 2202A-2202H may include a number of serially connected PV cells 2204. Substrings 2202A-2202H are depicted as comprising six $\frac{1}{2}$ cut PV cells 2204. Substrings 2202A-2202H may include any number of any $\frac{1}{N}$ cut (including whole) PV cells.

Fully parallel roof tile PV cell array 2210A (and fully parallel roof tile PV module 2200A) may be quadrilateral shaped, the quadrilateral shape may have a long dimension and a short dimension. The rectangular shaped fully parallel roof tile PV cell array may comprise a first long reference side 2250A and a second long reference side 2250B. Additionally, the rectangular shaped fully parallel PV cell array 2210A may comprise a first short reference side 2248A and a second short reference side 2248B. The row of substrings 2202A-2202H may extend from the first short reference side 2248A to the second short reference side 2248B. Each of substrings 2202A-2202H (i.e., each column) may extend from the first long reference side 2250A to the second long reference side 2250B. Accordingly, substrings 2202 may be considered to extend vertically. Substrings 2202 may terminate in two terminals, a positive terminal and a negative terminal. Accordingly, one terminal of each substring 2022 may be disposed proximate to one long side 2250 and another terminal of each substring 2202 may be disposed proximate to another long side 2250.

With continued reference to FIG. 22A, the positive terminals of each of substrings 2202A-2202H may be disposed proximate to the first long reference side 2250A. A positive conductor 2216 (e.g., ribbon wire, conductive region of conductive backsheet) may be electrically connected to the positive terminals of each of the substrings 2202. Accordingly, the positive conductor 2216 may be disposed proximate to the first long reference side 2250A. Similarly, the negative terminals of each of substring 2202A-2202H may be disposed proximate to the second long reference side 2250B. A negative conductor 2214 (e.g., ribbon wire, conductive region of conductive backsheet) may be electrically connected to the negative terminals of each of the substrings 2202. Accordingly, the negative conductor 2214 may be disposed proximate to the second long reference side 2250B. As will be appreciated, the described topology and electrical connection of fully parallel roof tile PV cell array 2210A may allow for simplified electrical parallel connection (e.g., according to the example schematic of FIG. 8) of all of substrings 2202.

Fully parallel roof tile PV module 2200A and fully parallel roof tile PV cell array may further comprise a junction box 2242. The junction box 2242 may function substantially similar to other junction boxes described herein. The junction box 2242 may be disposed proximate to the first short reference side 2248A. Accordingly, positive conductor 2216 and negative conductor 2214 may simply be routed from the first long reference side 2250A and the second long reference side 2250B, respectively, into the junction box 2242. Accordingly, any further necessary electrical connections may be effectuated in the junction box 2242 and the power produced by fully parallel roof tile PV cell array 2210A may be availed at a positive module terminal and a negative module terminal. Positive and negative leads may be electrically connected to the positive module terminal and negative module terminal respectively. Accordingly, the power produced by the fully parallel roof tile PV module 2200A and fully parallel roof tile PV cell array 2210A may be availed to a load (e.g., battery, additional PV modules, an array of PV modules, the utility grid) from the positive and negative leads. Further, as described herein, passive and/or active electronics (e.g., power electronics) may be connected between the PV module positive and negative terminals and/or the PV module positive and negative leads. Such electronics may variously act on, and/or affect the power production of the fully parallel roof tile PV module.

FIG. 22A depicts the substrings 2202 arranged such that the positive terminals of each substring 2202 are disposed proximate to the first long reference side 2250A and the negative terminals of each substring 2202 are disposed proximate to the second long reference side 2250B. Accordingly, FIG. 22A depicts the positive conductor disposed proximate to the first long reference side 2250A and the negative conductor disposed proximate to the second long reference side 2250B. It will be appreciated that this arrangement may be revered (i.e., negative conductor 2214 proximate to first long reference side 2250A, etc.). Additionally, FIG. 22A depicts the junction box 2242 as being disposed proximate to the first short reference side 2248A. It will be appreciated that the junction box 2242 may similarly be disposed proximate to the second short reference side 2248B. FIG. 22A depicts the junction box 2242 as being disposed proximate to the transverse midline 2032. It should be appreciated that junction box 2242 may be disposed at any position along the short dimension of the fully parallel roof tile PV cell module 2200A.

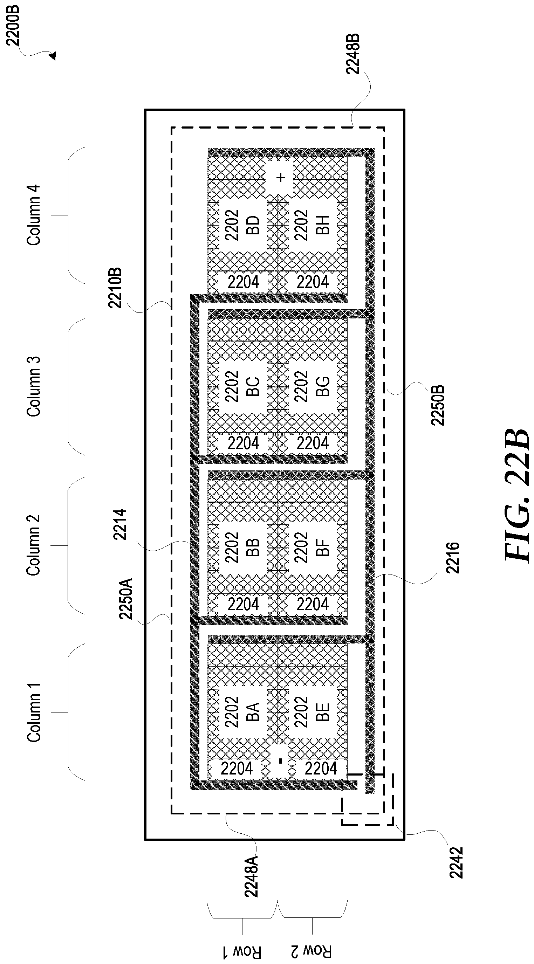

FIG. 22A depicts an example topology of an example fully parallel roof tile PV cell array 2210A comprising vertical substrings (i.e., substrings that extend vertically in the example orientation of FIG. 22A). Illustrative topologies of PV cell arrays may, additionally or alternatively, comprise horizontal substrings. For example, considering partial shading concerns of a particular roof tile PV module installation, horizonal substrings may be preferable over vertical substrings as different arrangements may operate more efficiently depending on shading concerns (e.g., shading patterns of a particular installation). FIG. 22B depicts another example topology of an example fully parallel roof tile PV module 2200B and example fully parallel roof tile PV cell array 2210B. Referring to FIG. 22B, fully parallel roof tile PV cell array 2210B may comprise substrings 2202BA-2202BH (Referred to generally as substring 2202B). Substrings 2202BA-2202BH may be disposed in fully parallel roof tile PV cell array 2210B and on fully parallel roof tile PV module 2200B in rows of columns. Substrings 2202B may be disposed in two rows of four columns each. Each substring may include a number of electrically serially connected PV cells. Substrings 2202BA-2202BH are depicted as comprising six $\frac{1}{2}$ cut PV cells 2204. Substrings 2202A-2202H may include any number of any $\frac{1}{N}$ cut (including whole) PV cells. Fully parallel PV cell array 2210B is depicted as including two rows of four columns, fully parallel PV cell array 2210B may include any number of rows and columns.

Fully parallel roof tile PV cell array 2210A (and fully parallel roof tile PV module 2200A) may be rectangularly shaped having a long dimension and a short dimension. The rectangular shaped fully parallel roof tile PV cell array may comprise a first long reference side 2250A and a second long reference side 2250B. Additionally, the rectangular shaped fully parallel PV cell array 2210A may comprise a first short reference side 2248A and a second short reference side 2248B. Each row of substrings (e.g., first row of substrings 2202BA-2202BD; and second row of substrings 2202BE-2202BH) may extend along the long dimension, from the first short reference side 2248A to the second short reference side 2248B. Substrings 2202BA-2202BH may be horizonal substrings. Accordingly, each substring 2202B may extend along a portion of the long dimension (i.e., each substring 2202B may extend, horizontally, across the width of each column, from the start of the first side of the column to the second side of the column).

Substring 2202BA may be disposed at row 1 column 1. Substring 2202BA may extend, horizontally, from the first side of column 1 to the second side of column 1. Accordingly, the negative terminal of substring 2202BA may be disposed proximate to the first side of row 1 column 1, and the positive terminal of substrings 2202BA may be disposed proximate to the second side of row 1 column 1. Substring 2202BB may be disposed at row 1 column 2. Substring 2202BB may extend, horizontally, from the first side of column 2 to the second side of column 2. Accordingly, the negative terminal of substring 2202BB may be disposed proximate to the first side of row 1 column 2, and the positive terminal of substring 2202BB may be disposed proximate to the second side of row 1 column 2. Substring 2202BC may be disposed at row 1 column 3. Substring 2202BC may extend, horizontally, from the first side of column 3 to the second side of column 3. Accordingly, the negative terminal of substring 2202BC may be disposed proximate to the first side of row 1 column 3, and the positive terminal of substrings 2202BA may be disposed proximate to the second side of row 1 column 3. Substring 2202BD may be disposed at row 1 column 4. Substring 2202BD may extend, horizontally, from the first side of column 4 to the second side of column 4. Accordingly, the negative terminal of substring 2202BD may be disposed proximate to the first side of row 1 column 4, and the positive terminal of substrings 2202BD may be disposed proximate to the second side of row 1 column 1. The substrings of row 2 (i.e., substrings 2202BE-2202BH) may extend substantially identically to that which is described above with respect to substrings 2202B of row 1.

Accordingly, the negative terminals of substrings 2202BA and 2202BE (of the first column) may be disposed proximate to the first side of column 1 (i.e., proximate to the first short reference side 2248A), and the positive terminals of substrings 2202BA and 2202BE may be disposed proximate to the second side of column 1. The negative terminals of substrings 2202BB and 2202BF (of column 2) may be disposed proximate to the first side of column 2, and the positive terminals of substrings 2202BB and 2202BF may be disposed proximate to the second side of column 2. The negative terminals of substrings 2202BC and 2202BG (of column 3) may be disposed proximate to the first side of column 3, and the positive terminals of substrings 2202BB and 2202BF may be disposed proximate to the second side of column 3. The negative terminals of substrings 2202BD and 2202BH (of column 4) may be disposed proximate to the first side of column 4, and the positive terminals of substrings 2202BD and 2202BH may be disposed proximate to the second side of column 4. Accordingly, the terminals of the substrings 2202B may be arranged as follows:

$$\begin{bmatrix} - & + & - & + & - & + & - & + \\ - & + & - & + & - & + & - & + \end{bmatrix}.$$

Substrings 2202BA-2202BG may all be electrically connected to each other in parallel (e.g., according to the example schematic of FIG. 8). Accordingly, conductors (i.e., ribbon wire, conductive regions of conductive backsheets) may be electrically connected to the terminals which may effectuate the desired electrical connection. Negative conductor 2214 may be electrically connected to the negative terminals of substrings 2202BD and 2202BH and routed toward the first long reference side 2250A. The negative conductor 2214 may similarly be connected to the negative terminals of the remaining substrings 2202 (i.e., substrings 2202BC, 2202BG, 2202BB, 2202BF, 2202BA, and 2202BE) and similarly routed toward the first long reference side 2250A. Additional negative conductor 2214 may be utilized to connect all of the described negative conductors of FIG. 22B. Such an additional negative conductor 2214 may be routed along the long dimension proximate to the first long reference side 2250B. The negative conductor 2214 may be routed toward the first short reference side 2248A. Similarly, the positive conductor 2216 may be electrically connected to the positive terminals of the substrings 2202BA-220BH) and routed along the opposing long side, the second long reference side 2250B, and toward the first short reference side 2248A.

Fully parallel roof tile PV cell array 2210B and fully parallel roof tile PV module 2200B may further comprise a junction box 2242. The junction box 2242 may be disposed proximate to the first short reference side 2248 and second long reference side 2250B. Accordingly, negative conductor 2214 may be routed from the terminals of substrings 2202BA and 2202BE into the junction box 2242. Additionally, the positive conductor 2216 may be routed, proximate to the second long reference side 2250B into the junction box 2242. The power produced by fully parallel roof tile PV cell array 2210B and fully parallel roof tile PV cell module 2200B may be variously acted on and affected by passive and/or active electronics, for example, as described with relation to FIGS. 32-34B, and may be availed substantially as described with relation to FIG. 22A.

FIG. 22B depicts negative terminals as being disposed at the first side of each column and the positive terminals as being disposed at the second side of each column. It should be appreciated that this arrangement may be reversed. Additionally, FIG. 22B depicts negative connections (i.e., negative conductor 2214) as being routed to, and along, first long reference side 2250A and positive connections (i.e., positive conductor 2216) as being routed to, and along) second long reference side 2250B. It should be appreciated that this arrangement may similarly be reversed. FIG. 22B depicts the junction box 2242 as being disposed proximate to the first short reference side 2248A. It should be appreciated the junction box 2242 may similarly be disposed proximate to the second short reference side 2248B. Additionally, FIG. 22B depicts the junction box 2242 as being disposed proximate to the second long reference side 2250B. It should be appreciated that, for some arrangements, the junction box 2242 may similarly be placed proximate to the first long reference side 2250A. Additionally, all of the above may be effectuated and utilized in various combination as would be understood by persons of ordinary skill in the art.

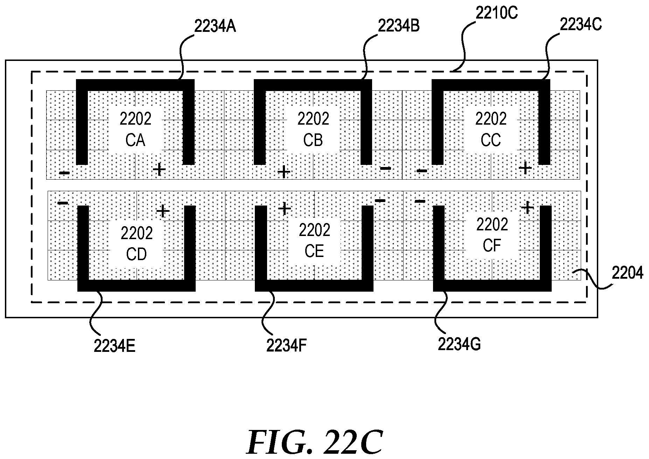

FIG. 22C depicts an example topology of an example fully parallel roof tile PV cell array 2210C comprising U-shaped substrings 2202CA-2202CF (generally U-shaped substrings 2202C). The PV cells 2204 of the U-shaped substrings 2202C may be serially connected. The serial connection and/or conductive path of the PV cells 2204 of U-shaped substrings 2202C may be depicted as a solid black path in FIG. 22C. The conductive path may be through any number of different conductive media, for example, through PV cells, silver fingers, busbars, conductive backsheets, ribbon wire, etc. The electrical connections of FIG. 22C may be achieved by conductors 2234A-2234F. The topology and connection of the fully parallel roof tile PV cell array 2210C of FIG. 22C may be understood as corresponding to the PV cell arrays of FIGS. 1A-5B. Accordingly, The fully parallel roof tile PV cell array may be understood according to the description of FIGS. 1A-5B unless expressly stated otherwise herein. While the substrings (and sub-substrings) of FIGS. 1A-5B extend serially into the length of the PV cell array, the substrings (and sub-substrings) of FIG. 22C may extend serially into the width of PV cell array (additionally, similar topologies and connections may be achieved in a substantially square shaped, or alternatively shaped PV cell array and PV module).

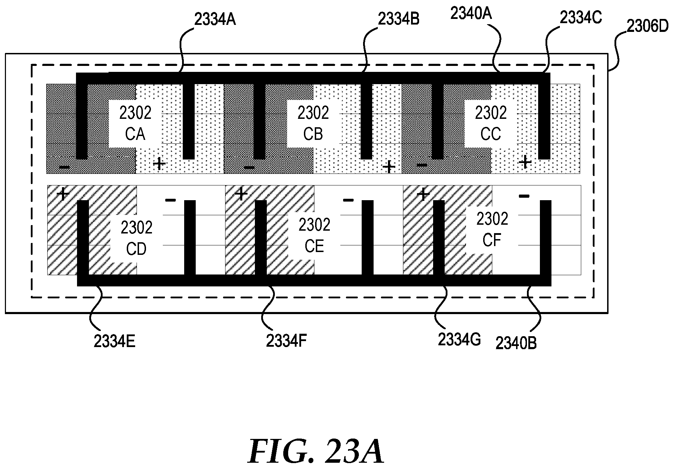

FIG. 23A depicts an example topology of an example fully parallel roof tile PV cell array 2306D comprising U-shaped substrings 2302DA-2302DF (generally U-shaped substrings 2302D). FIG. 23A depicts an example fully parallel roof tile PV cell array wherein substrings are arranged such that the positive terminals of neighboring substrings are disposed proximate to each other, and similarly, the negative terminals of neighboring substrings are disposed proximate to each other (e.g., as follows $\begin{bmatrix} - & + & + & - & - & + \\ - & + & + & - & - & + \end{bmatrix}$. However, it may be advantageous to arrange the U-shaped substrings 2302DA-2302DF such that terminals of alternating polarity are disposed proximate to each other (e.g., interleaved), for example, as follows: $\begin{bmatrix} - & + & - & + & - & + & - & + \\ + & - & + & - & + & - & + & - \end{bmatrix}$. Additionally, similar to that which is described herein, for example, in relation to FIGS. 1A-5B, such U-shaped substrings may include midpoint cross-ties (e.g., electrically connecting the midpoints of some or all of the substrings 2302D, for example, first midpoint cross-tie 2340A and second midpoint cross-tie 2340B). Further, the midpoint cross-ties 2340A and 2340B may be electrically connected to each other further parallelizing the fully parallel roof tile PV cell array 2306D.

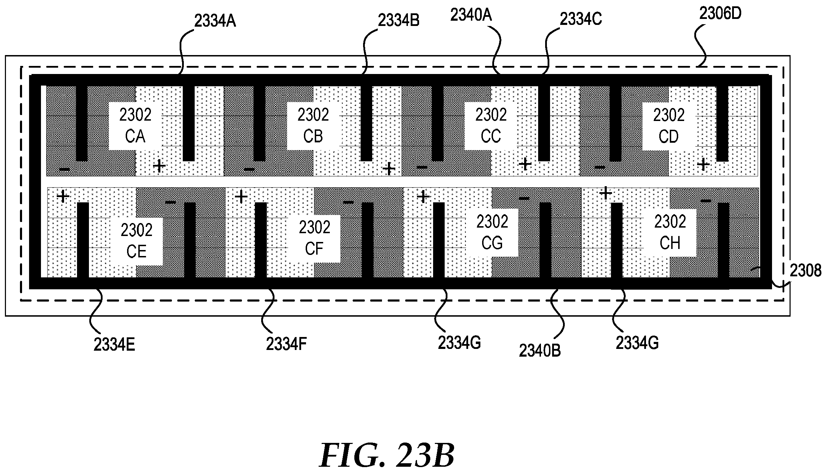

Advantages of the topology of FIG. 22C have been described above (and see advantages described herein, for example, in relation to FIGS. 1A-5B). Additionally, the topology of FIG. 23A may be advantageous depending on shading concerns. For example, referring to FIG. 22C, assume a shade condition covered the last column of each of substrings 2302CC and 2302CF. Such a shade condition may effectively reduce the production of about a third of the PV cell array 2306C, since two sub-substrings of the same potential may be affected (e.g., two sub-substrings connected between the negative potential terminal and the midpoint potential). However, referring to FIG. 23A, assuming the same shade condition as described immediately above, only about a sixth of the production of the PV cell array 2306D may be reduced, since the two sub-substrings affected are of different potentials (one sub-substring disposed between the negative potential terminal the midpoint, and a second sub-substring disposed between the midpoint and the positive potential terminal). FIG. 23B depicts the topology of FIG. 23A with an even number of substrings (i.e., eight substrings) with four substrings per each half of the PV cell array, and with the substrings midpoints of both sides connected. It may be understood that the topologies of FIGS. 23A and 23B relate to the topologies of FIG. 22C. Similarly, it may be understood that the topology of FIG. 22C corresponds to the topologies of FIGS. 1A-5B (in particular, the topology of FIG. 23B may be understood to correspond to the topology of FIG. 3G). Accordingly, a topology, similar to that of FIGS. 23A and 23B may be understood to correspond to FIGS. 1A-5B in a similar manner to the manner in which FIGS. 23A and 23B relate to FIG. 22C.

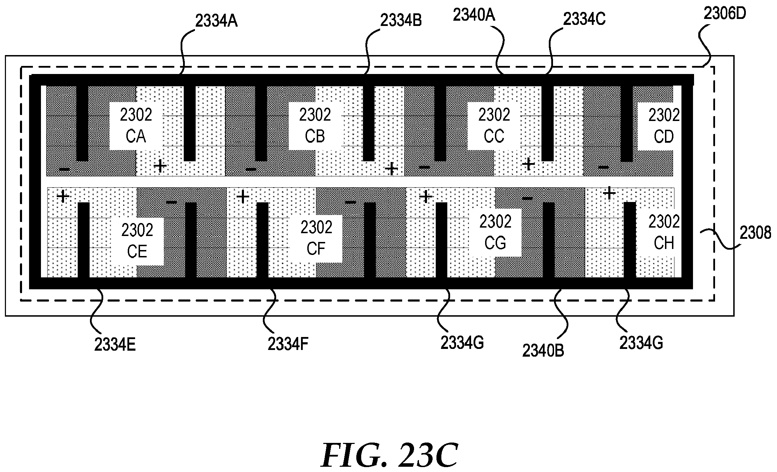

FIG. 23C depicts a topology similar to that of FIG. 23A with an odd number of substrings (i.e., seven substrings) with three and a half substrings per each half of the PV cell array. Each half PV cell array comprises three full substrings, and half of a substring. This arrangement may be useful when a size of a photovoltaic module is sized to prefer an odd number of PV cell columns and/or when a preferred total current of the photovoltaic module corresponds to an odd number of PV cell columns. For example, where 210mm-wide solar cells are used and a roof tile of under 1500mm is desired, it may be preferable to arrange seven columns of solar cells in the manner depicted in Fig. 23C.

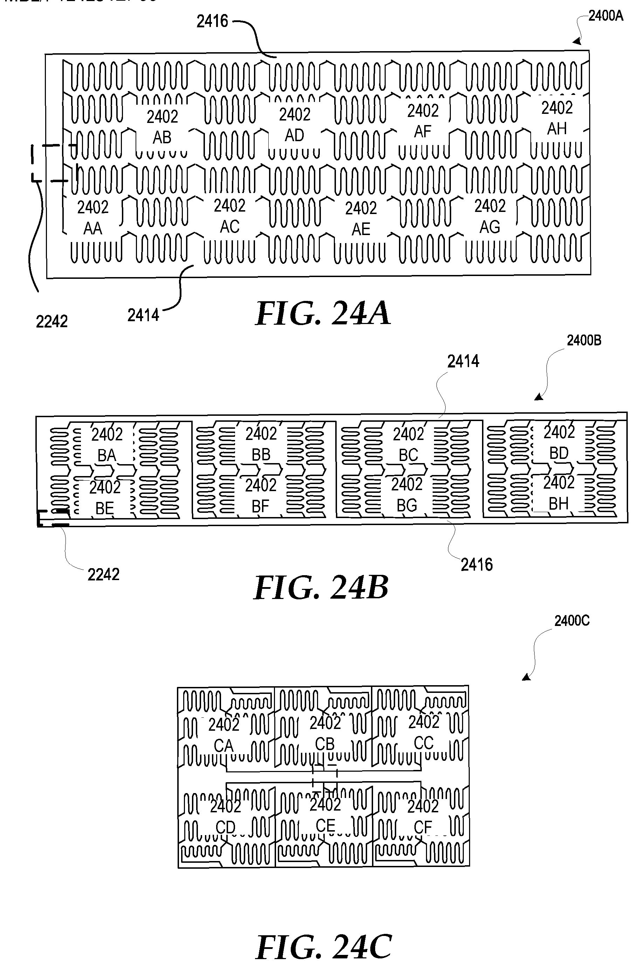

FIG. 24A depicts an example conductive backsheet 2400A that may effectuate the example roof tile vertical PV cell array of FIG. 20A. Accordingly, substrings 2402AH-2402AH of FIG. 24A may be understood as corresponding to substrings 2002AA-2002AH, respectively, of FIG. 20A. Additionally, conductive traces of FIG. 24A may be understood as corresponding to conductors of FIG. 20A. Accordingly, conductive traces 2414 and 2416, of FIG. 24A, may be understood as corresponding to conductors 2014 and 2016, respectively, of FIG. 20A. Accordingly, it will be appreciated that with the installation of rear contact PV cells upon conductive backsheet 2400A, PV cell array 2210A of FIG. 20A may be realized.

Additionally, it may be appreciated that the topologies of FIG. 20A may be realized variously (e.g., ribbon wire connected, conductive backsheet connected).

FIG. 24B depicts an example conductive backsheet 2400B that may effectuate the example roof tile vertical PV cell array of FIG. 20B. Accordingly, substrings 2402BA-2402BH of FIG. 24B may be understood as corresponding to substrings 2002BA-2002BH respectively, of FIG. 20B. Additionally, conductive traces of FIG. 24B may be understood as corresponding to conductors of FIG. 20B. Accordingly, conductive traces 2414 and 2416, of FIG. 24B, may be understood as corresponding to conductors 2014 and 2016, respectively, of FIG. 20B. Accordingly, it will be appreciated that with the installation of rear contact PV cells upon conductive backsheet 2400B, PV cell array 2210B of FIG. 20B may be realized. Additionally, it may be appreciated that the topologies of FIG. 20B may be realized variously (e.g., ribbon wire connected, conductive backsheet connected).

FIG. 24C depicts an example conductive backsheet 2400C that may effectuate the example roof tile vertical PV cell array of FIG. 20C. Accordingly, substrings 2402CA-2402CF of FIG. 24C may be understood as corresponding to substrings 2002CA-2002CF respectively, of FIG. 20C. Additionally, conductive traces of FIG. 24C may be understood as corresponding to conductors of FIG. 20C (or FIG. 3A with substrings of fewer PV cells). Accordingly, it will be appreciated that with the installation of rear contact PV cells upon conductive backsheet 2400C, PV cell array 2210C of FIG. 20C may be realized. Additionally, it may be appreciated that the topologies of FIG. 20C may be realized variously (e.g., ribbon wire connected, conductive backsheet connected).

Further with reference to FIG. 24A it may be appreciated that with conductive backsheet 2400A, PV cells of each column may be electrically connected to each other in parallel. These connections may be gained by not cutting (or otherwise separating) the conductive backsheet between adjacent columns of the substrings. Therefore, the PV cells of each of substrings 2402A-2402D, connected by conductive backsheet 2001A, may be considered electrically connected in series-parallel with total-cross-ties (i.e., connected in TCT). Such connection may further parallelize the roof tile vertical PV cell array and may allow for increased mismatch condition mitigation. Similarly, referring to FIG. 24B, PV cells of the same column may be connected in TCT.

Aspects of the present disclosure relate to electronics, for example, power devices (e.g., DC-DC converter, optimizers, MPPT controllers, inverters, micro-inverters, etc.), variously connected and/or included with PV cell arrays and PV modules. Additionally or alternatively, aspects of the present disclosure relate to replaceability and/or ease thereof of power devices. PV generators (e.g., PV cells, PV cell arrays, PV modules) may produce electrical power when irradiated with light energy. Various conditions may affect the power production of a PV generator. For example, a partial shade condition may adversely affect the power production of a PV generator. Further, a PV generator may be connected to a load (e.g., battery, grid, appliance, inverter, etc.). The load itself (e.g., the impedance of the load) may affect the power production of the PV generator to which the load is connected, an issue often exasperated by environmental conditions. Often it may be desirable to positively affect the power production of a PV module. This may be done by variously connecting electronics, e.g., optimizers, DC-DC converters, and/or micro-inverters in line with the power output of a PV module. For example, as described above, the load itself may affect the power generated by a PV module. Accordingly, a PV module under particular conditions may have a load impedance at which the power generation may be at a maximum. Accordingly, an optimizer and/or DC-DC converter may be connected to the power output (e.g., positive and negative leads of a PV module) to positively affect the power produced by the PV generator. According to examples, this may be accomplished by power point tracking (PPT) and/or maximum power point tracking (MPPT) to vary the impedance experienced by the PV generator to achieve increased power output of the PV generator at any particular time and condition. Accordingly, power may be effectively harvested from the PV module installation. In an alternative configuration, micro-inverters may be connected to the power output of a PV module. According to such an example, the power may be more effectively combined and harvested from a PV module installation.

Often, PV cell arrays of PV modules are electrically connected to a junction box. The junction box is often disposed on a surface (e.g., front surface, back surface) of the PV module. The junction box often includes a positive lead and a negative lead which may extend from the junction box and which may avail the power produced by the PV generator. The PV generator leads often include detachable connectors (e.g., MC4 connectors) allowing connection to further components having complementary connectors. Accordingly, additional components, e.g., additional PV modules, electronics, power devices, loads, etc. may be connected and disconnected from the PV module at the detachable PV module connectors connected to the leads extending from the junction box. However, such detachable connectors may be associated with drawbacks. For example, according to an arrangement where a power device, e.g., DC-DC converter, optimizer and/or micro-inverter, is connected to PV module leads, often the PV module leads are produced with connectors, the power device inputs are produced with associated connectors, and the power device outputs (e.g., to be connected to additional components) are produced with associated connectors. Each connector is associated with increased cost of production. Additionally, detachable connectors are often associated with a decreased reliability, e.g., increase in mean time before failure (MTBF), as compared to integrated connections (e.g., soldered connections, crimped connections, screwed connections). Additionally, detachable connectors may be associated with increased resistance, and therefore reduced PV generator performance, as compared to integrated connections. Accordingly, solutions have been proposed to incorporate power devices, e.g., optimizers, inverters, etc. in the PV module junction box. Such solutions, however, may suffer from additional issues, for example poor thermal management and increased thermal degradation. Accordingly, aspects herein relate to solutions to the above identified problems.

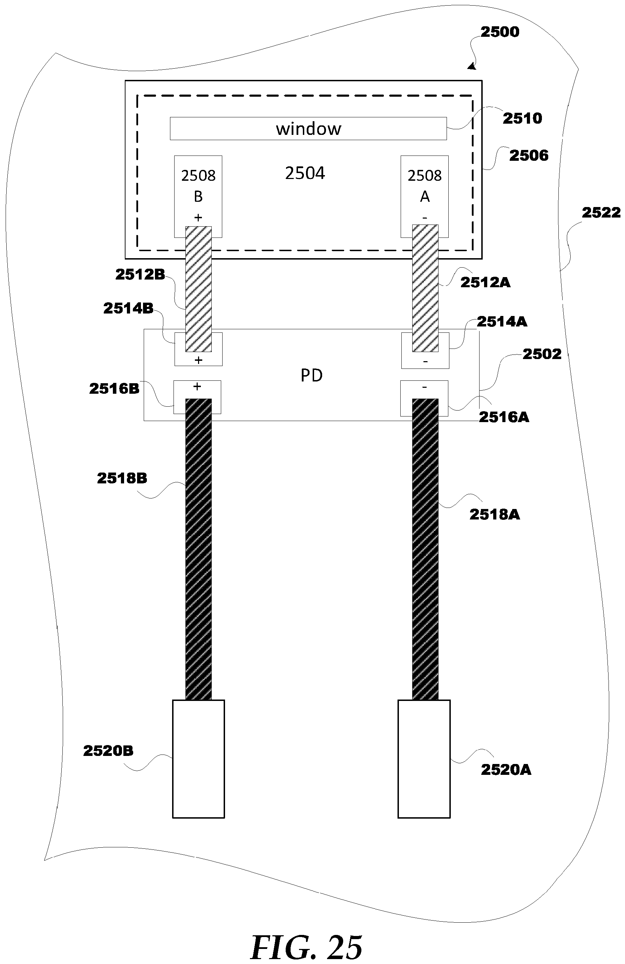

FIG. 25 depicts an example extension integrated power device 2500 according to one or more aspects of the present disclosure. Referring to FIG. 25, an extension integrated power device 2500 may comprise a power device 2502 (power device may be substantially similar to, and/or comprise, and/or be comprised by PE 3202). The power device 2502 may comprise power device electronic components and circuitry. For example, the power device may comprise electronic components and circuitry to, for example, optimize the power production of a PV generator (e.g., PV cell array, PV module), DC-DC convert the power produced by the PV generator, and/or invert the power produced by the PV generator (e.g., a micro-inverter). The power device may additionally or alternatively include passive electronic components (e.g., diodes) to variously act on the power production of the PV generator. The power device 2502 may further comprise first input terminal 2514A and second input terminal 2514B. Power, from the PV generator, may be input into power device 2502 at first and second input terminals 2514A and 2514B. Additionally, power device 2502 may further comprise first output terminal 2516A and second output terminal 2516B. The power, produced by the PV generator, and upon which the power device 2502 may have acted, may be availed at the first and second output terminals 2516A and 2516B.

The extension integrated power device 2500 may further comprise a junction box 2504. The junction box 2504 may include a junction box housing 2506. The junction box housing 2506 may be mechanically configured to be mounted to a surface of a PV module 2522 (only a portion of PV module 2522 is depicted in FIG. 25). For example, the junction box 2504 may be mounted to a non-conducting surface of the PV module 2522. For example, the junction box 2504 may be mounted to the back surface of the PV module 2522. Alternatively, the junction box 2504 may be mounted to a front surface of the PV module 2522 (e.g., on a roof tile PV module). The junction box 2504 may comprise an opening 2510 to receive a cell conductor coupled to at least a portion of PV cells of the PV module to which the junction box 2504 is mounted. Accordingly, positive PV cell conductors and negative PV cell conductors may be routed through the junction box opening 2510 and into the junction box 2504. The junction box 2504 may further comprise a first conductive contact 2508A and second conductive contact 2508B. The negative PV cell conductor may be electrically connected to the first conductive contact 2508A and the positive PV cell conductor may be electrically connected to the second conductive contact 2508B. Accordingly, the open circuit voltage of the PV cell module (and PV cell array) may be measured across the first conductive contact 2508A and the second conductive contact 2508B.

Extension integrated power device 2500 may further comprise first input conductor 2512A and second input conductor 2512B. First input conductor 2504A and second input conductor 2512B may extend from the junction box 2504 and junction box housing 2506. Inside the junction box 2504, a first end of the first input conductor 2512A may be electrically coupled to, and integrally coupled to, the first conductive contact 2508A. Further, inside the junction box 2504, a first end of the second input conductor 2504B may be electrically coupled to, and integrally coupled to, the second conductive contact 2508B. As used herein "integrally" and "integrated," for example, "integrally" coupled to, "integrally" coupled with, "integrally" connected to, or "integrated" with may means, for example, coupled via a "permanent" attachment method wherein the area of connection may be altered if the connection is broken. Example methods of coupling that may be considered, "integrally" coupled to, or "integrated" with may include soldered connections, crimped connections, and/or screw connections. Connection via detachable connectors (e.g., MC4 connectors) may not be considered "integrally" coupled to or "integrated" with. Outside of the junction box 2504, the second end of the first conductor 2512A may be electrically connected to, and integrally connected to the first input terminal 2514A of the power device 2502. Additionally, outside of the junction box 2504, the second end of the second conductor 2512B may be electrically connected to, and integrally connected to the second input terminal 2512B of the power device 2502.

The power device 2502 may be distanced from the junction box 2504 (e.g., by the distance of the length of the first and second conductors 2512A and 2512B). Accordingly, simplified thermal management may be appreciated as compared to arrangements wherein a power device is disposed in a junction box. For example, by being disposed outside of junction box 2504, the thermal requirements of the power device 2502 and the junction box components (e.g., electrical connections, electronic components) may be more easily managed as the thermal considerations for the power device and the internal junction box components may be managed separately. Additionally, with the power device external to the junction box, increased heating of the power device and junction box internal components due to co-packaging of the power device and junction box internal components, may be avoided. Further still, with this arrangement, additional thermal management of the power device 2502 may be obtained. For example, PV modules often comprise metal frames around a perimeter of the PV module. First and second input conductors 2512A and 2512B may be of sufficient length to allow the power device 2502 to reach a portion of the PV module frame. The power device 2502 may be mechanically configured to be mounted to the PV module frame. Additionally, the power device 2502 may be mechanically configured to allow heat transfer to the PV module frame if mounted to the PV module frame (e.g., to allow the PV module frame to act as a heat sink). Additionally or alternatively, the power device 2502 may be mechanically configured to be mounted to a surface of the PV module, (e.g., non-conducting surface (e.g., back surface or front surface (e.g., of a roof tile PV module) of the PV module).

With continued reference to FIG. 25, the first and second input conductors 2512A and 2512B may extend some length between the junction box 2504 and the power device 2502. The first and second input conductors 2512A and 2512B may be of sufficient length such that it is possible to cut the first and second input conductors 2512A and 2512B (e.g., to remove the power device 2502) and connect a replacement power device to a remaining portion of the first and second input conductors 2512A and 2512B that may still be coupled to the first and second conductive contacts 2508A and 2508B respectively. For example, the first and second input conductors 2512A and 2512B may be cut yielding two new second ends of the first and second input conductors 2512A and 2512B, and power device 2502 may be removed. The new second ends of the first and second input conductors 2512A and 2512B may be integrally connected to first and second input terminals, respectively, of a replacement power device. For example, the first and second input conductors 2512A and 2512B may be soldered, crimped, or screwed to the first and second input terminals of the replacement power device. Additionally or alternatively, the replacement power device may have its own first and second input conductors. Accordingly, the first and second input conductors of the replacement power device may be integrally connected, for example, soldered, crimped, or screwed (e.g., via a screw terminal block) to the remaining first and second input conductors 2512A and 2512B respectively. Accordingly, the first and second input conductors 2512A and 2512B may be at least 1.5 inches to 2 inches in length. Any length of the first and second input conductors 2512A and 2512B is contemplated herein.

The extension integrated power device 2500 may further comprise first output conductor 2518A and second output conductor 2518B. First and second output conductors may extend from power device 2502. First output conductor 2518A may, at a first end thereof, be integrally electrically connected to the first output terminal 2516A of the power device 2502. The second output conductor 2518B may, at a second end, be integrally electrically connected to the second output terminal 2516B of the power device. The first and second output conductors 2518A and 2518B may extend from the power device. A first detachable connector 2520A (e.g., MC4 connector) may be coupled with the first output conductor 2518A at a second end thereof. A second detachable connector 2520B (e.g., MC4 connector) may be coupled with the second output conductor 2518B at a second end thereof. Accordingly, the power, produced by the PV module to which the junction box 2504 may be attached, and acted on by the power device 2502, may be availed (e.g., to a load, to be connected with one or more additional PV modules) at the first detachable connector 2520A and the second detachable connector 2520B. For example, the first and second detachable connectors 2520A and 2520B may be connected to additional PV modules, the utility grid, a battery, and/or additional electronic components (e.g., inverter). Accordingly, a power device 2502, configured to act on power produced by a PV generator, and/or to act with power produced by a PV generator (e.g., DC-DC converter, optimizer, inverter, micro-inverter, etc.) is contemplated herein as only including two detachable connectors. Such a configuration may be advantageous as detachable connectors may be associated with an increased cost of production. Additionally, detachable connections of detachable connectors may be associated with an increased MTBF and decreased efficiency as compared with integrated connections.

Often, in the production flow a PV module, PV module producers (e.g., manufacturers) may purchase an "off-the-shelf' cable assembly (e.g., comprising a junction box, leads, and connectors) to be added to the PV module. Additionally, if use of a power device is desired, the power device may be added, as a separate component, to the leads using detachable connectors. According to the present disclosure, power device 2502 may be integrally connected and produced with the junction box 2504 as an "off-the-shelf' cable assembly. Accordingly, cost of production may be reduced while part reliability may be increased.

According to the present disclosure, the first and second input conductors 2512A and 2512B may be made of a first type of metal, and the first and second output conductors 2518A and 2518B may be made of a second type of metal that is different from the first type of metal. For example, the first and second input conductors 2512A and 2512B may be made of copper and the first and second output conductors 2518A and 2518B may be made of aluminum. Accordingly, in the location where power device replacement may be executed, a superior conductor may be utilized (e.g., copper), for example, to improve ease of replacement and long term reliability. Additionally, where replacement parts are less of a concern (e.g., at the first and second output conductors), alternative (e.g., aluminum) conductors may be utilized to improve cost effectiveness. It is contemplated herein that the first and second input conductors 2512A and 2512B, and the first and second output conductors 2518A and 2518B may be made of the same metal (e.g., all copper, all aluminum, etc.). It may be understood that replacement power devices may be provided as replacement power device assemblies. Such replacement power device assemblies may include first and second output conductors 2518A and 2518B as well as first and second detachable connectors 2520A and 2520B.

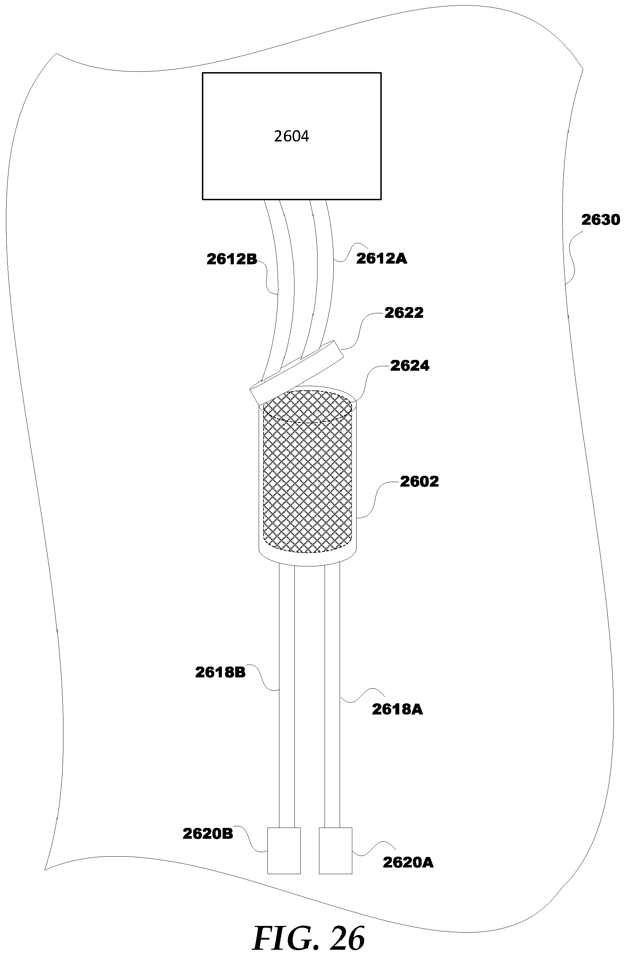

The power device 2502 in FIG. 25 is depicted as being rectangular, however power devices 2502 of varying shapes are contemplated herein. For example, according to aspects, power device 2502 may be can (e.g., cylindrical) shaped (see e.g., FIG. 26). Can shaped power devices 2502 may be advantageous in terms of packaging, as a cylindrical shape may more easily correspond to the shape of the conductor(s) to which it may be integrally attached.

Additionally, it is contemplated herein that extension integrated power device may comprise a power device cartridge body with replaceable power device components. FIG. 26 depicts an example extension integrated cartridge power device 2600. Referring to FIG. 26, an extension integrated cartridge power device 2600 may comprise an openable cartridge body 2602. The openable cartridge body 2602 may include an openable access 2622. The openable access 2622 may be opened to reveal openable cartridge body 2602 internals. Power device electronic components package 2624 (e.g., power device components, circuit boards, etc.) may be disposed inside of the cartridge body. Accordingly, power device may effectively be removed and/or replaced by removing power device electronic components package 2624 from the cartridge body 2602 and inserting a replacement power device electronic components package 2624. Such an extension integrated cartridge power device 2600 may accompany all of the advantages of the extension integrated power device as described hereinabove. Additionally, the extension integrated cartridge power device 2600 may be replaced without cutting and repairing cabling. Accordingly, such extension integrated cartridge power device 2600 may be associated with increased ease of replaceability.

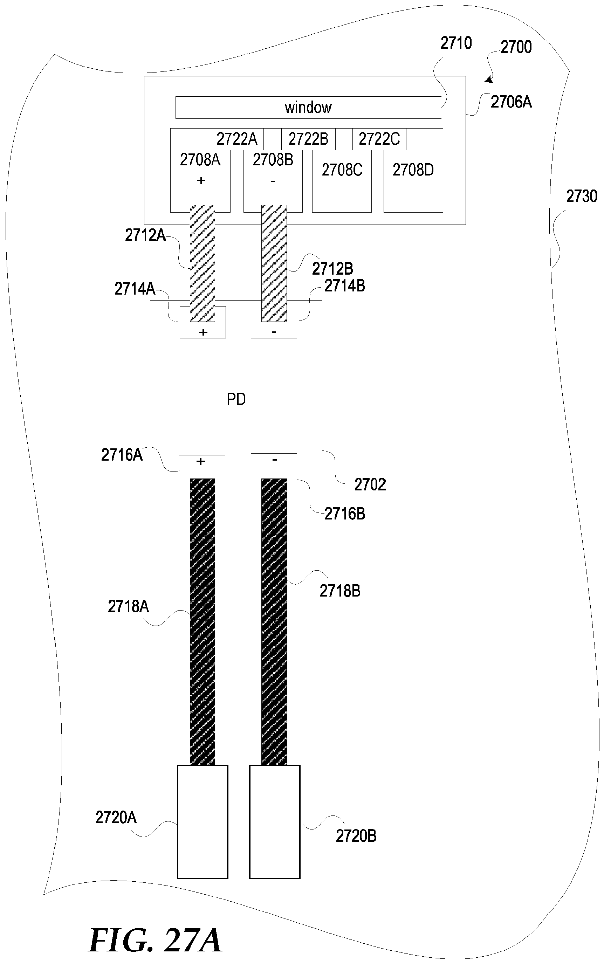

According to aspects, extension integrated power devices may be variously integrated with a PV module junction box and PV cell arrays. FIG. 27A depicts an example extension integrated power device according to one or more aspects of the present disclosure. Referring to FIG. 27A, extension integrated power devices 2700 may include junction box contacts 2708 in various configurations. Referring to FIG. 27A, junction box 2706 may include additional contacts 2708 for the electrical connection of additional substrings of a PV cell array of the PV module 2730 to which the junction box 2706 may be coupled. Junction box 2706 may include first contact 2708A, second contact 2708B, third contact 2708C, and fourth contact 2708D. PV cell array conductors (e.g., ribbon wire) connected to one or more of the PV cell substrings of the PV cell array and PV module 2730 may be connected to the first through fourth contacts 2708A-2708D. For example, the PV cell array to which the junction box may be connected may include three serially connected substrings of serially connected PV cells. Accordingly, the PV cell array may be connected to four contacts 2708A-2708D of the junction box 2706. First input conductor 2712A, at a first end thereof, may be integrally electrically connected to the first contact 2708A (e.g., negative contact of the PV cell array), and the second input conductor 2712B, at a first end thereof, may be integrally electrically connected to the second contact 2708B (e.g., positive contact of the PV cell array). The power device may comprise a first input terminal 2714A and a second input terminal 2714B. Power may be input into the power device (from, for example, a PV module, PV cell array, PV power generator) at the first and second input terminals 2714A and 2714B. The first input conductor 2712A, at a second end thereof, may be integrally electrically connected to the first input terminal 2714A (e.g., negative input terminal), and the second input conductor 2712B, at a second end thereof, may be integrally electrically connected to the second input terminal 2714B (e.g., positive input terminal). The first and second input conductors 2712A and 2712B may extend a length between the junction box 2706 and the power device 2702. The power device 2702 may act on the input power (e.g., DC-DC convert the power, optimize the power, invert the power, etc.) and may avail the power for output at first output terminal 2716A and second output terminal 2716B. A first output conductor 2718A, at a first end thereof, may be integrally (e.g., soldered, crimped, screwed) electrically connected to the first output terminal 2716A, and a second output conductor 2718B, at a first end thereof, may be integrally electrically connected to the second output terminal 2716B. The first and second output conductors may extend a length from the power device. A first detachable connector 2720A may be connected to the first output conductor 2718A, at a second end thereof, and a second detachable connector 2720B may be connected to the second output conductor 2718B at a second end thereof. The power produced by the PV cell array and acted on by the power device 2702 may be availed (e.g., to be connected to, for example one or more of, a load, a string inverter, the grid, other PV cell arrays, etc.) across the first and second connectors 2720A and 2720B.

With continued reference to FIG. 27A, various additional components and connections may be included in junction box 2706. Junction box 2706 may further comprise first diode 2722A, second diode 2722B and third diode 2722C (generally diode 2722). First through third diodes 2722A-2722C may comprise, for example, bypass diodes (e.g., P-N junction silicon diodes, Schottky barrier diode). First through third diodes 2722A-2722C may be connected between contacts 2708A to 2708D, effectively being installed between the example three substrings of the PV cell array to which junction box 2706 is attached. Accordingly, diodes 2722A-2722C may allow for the bypass of one or more substrings of the PV cell array to which junction box 2706 may be attached. A diode 2722 may be activated to bypass a substring of the PV cell array to which junction box 2706 may be attached when the substrings (or a portion thereof) across which the diode 2722 may be connected, may be experiencing a reverse bias (e.g., under a partial shade condition). Additionally or alternatively, one or more of diodes 2722A may be installed as, for example, blocking diodes. Such diodes 2722 installed as blocking diodes may allow for the prevention of backflow of current through the substrings to which the blocking diode may be connected. Diodes 2722 installed as bypass diodes may be installed across a substring (and/or an array) for substrings (and/or arrays) that are serially connected to each other. And diodes 2722, installed as blocking diodes, may be installed to substrings (and/or arrays) for substrings (and/or arrays) that are parallelly connected to each other. Diode 2722A may be installed across contacts 2708A and 2708B, diode 2722B may be installed across contacts 2708B and 2708C, and diode 2722C may be installed across contacts 2708C and 2708D. While FIG. 27A depict a junction box for a PV cell array having 3 substrings, the same principles may apply for a junction box 2706 connected to a PV cell array having any number of substrings.

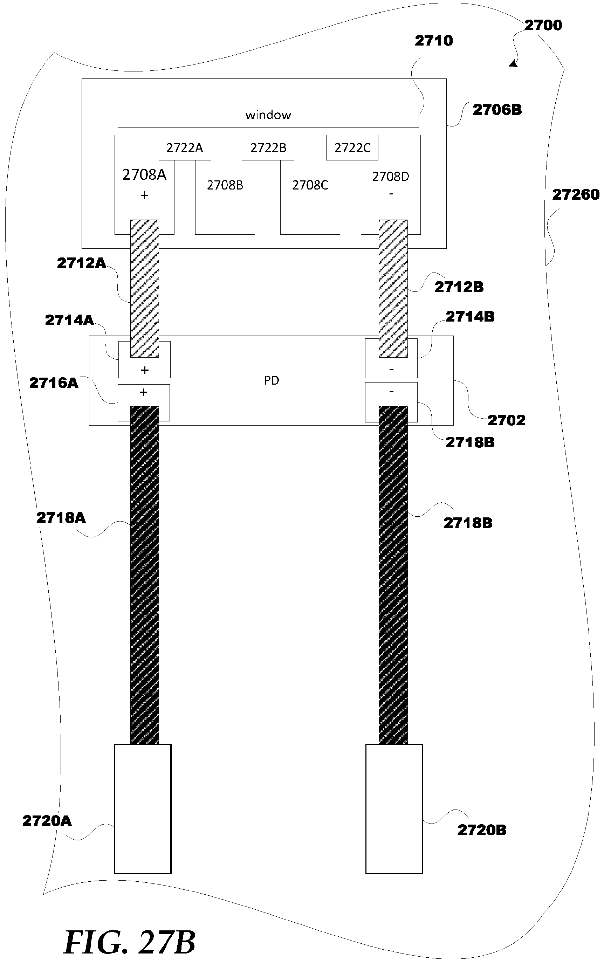

FIG. 27B depicts another example extension integrated power device 2700 according to one or more aspects of the present disclosure. The example extension integrated power device 2700 of FIG. 27B may be substantially identical to the example extension integrated power device of FIG. 27A unless expressly described otherwise herein. Referring to FIG. 27B, the substrings of the PV cell array to which junction box 2706B may be attached may be variously connected and arranged. Accordingly, it may be advantageous and/or desirable to variously arrange the contacts of the junction box 2706 to best suit the arrangement and electrical connections of the PV cell array to which the junction box 2706 may be attached. For instance, the junction box 2706A of FIG. 27A may comprise positive and negative contacts (2708A, and 2708B respectively) to which first and second input conductors 2712A and 2712B may be connected. The first and second contacts 2708A and 2708B may be adjacent contacts. Referring to FIG. 27B, the junction box 2706B of FIG. 27B may similarly comprise positive and negative contacts (2708A and 2708D respectively), however the positive and negative contact may be variously distributed. For example, the positive and negative contacts may not be adjacent and/or may be disposed on opposing ends of the arrangement of contacts.

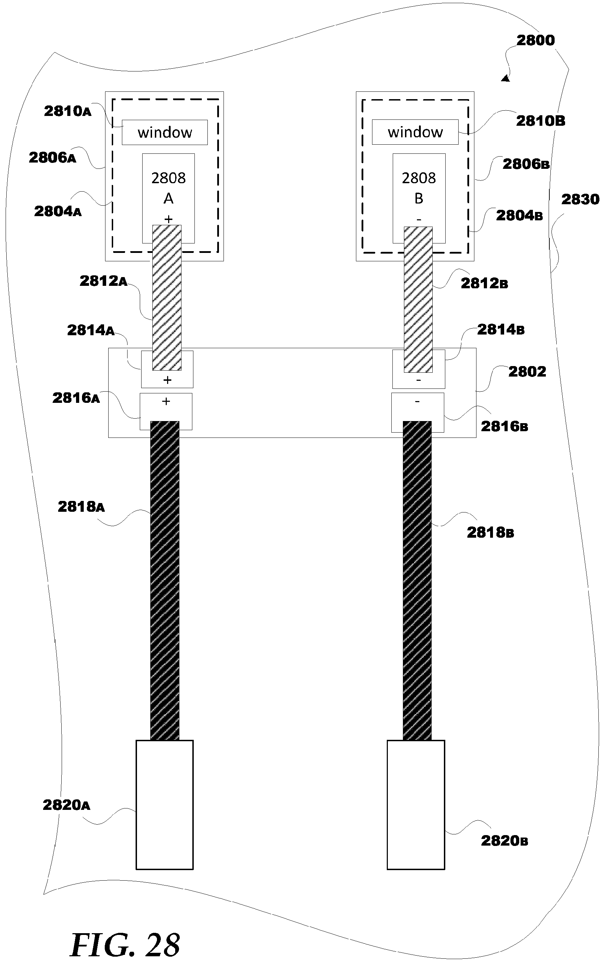

FIGS. 25-27B depict example extension integrated power devices having a single junction box. FIG. 28 depicts an example split junction box extension integrated power device according to one or more aspects of the present disclosure. Referring to FIG. 28, some PV module may utilize split junction boxes, a first split junction box 2806A and a second split junction box 2806B. The first split junction box 2806A may be, for example, a positive junction box. Accordingly, the first split junction box 2806A may have a contact 2808A (e.g., a positive contact). One or more positive conductors (e.g., ribbon wire) from one or more PV cells of the PV cell array of the PV module 2830 to which the first split junction box may be connected may extend through the first opening 2810A and may be connected to the first contact 2808A. Similarly, the second split junction box 2806B may have a contact 2808B (e.g., a negative contact). While first and second split junction boxes 2806A and 2806B are depicted as having one contact 2808 each, any number of contacts 2808 per split junction box 2806 is contemplated herein. One or more negative conductors (e.g., ribbon wire) from one or more PV cells of the PV cell array of the PV module 2830 to which the second split junction box may be connected may extend through the first opening 2810B and may be connected to the second contact 2808B. First split junction box 2806A may include a first split junction box housing 2804A which may be mechanically configured to be mounted to a surface of a PV module 2830. Similarly, second split junction box 2806B may include a second split junction box housing 2804B that may be mechanically configured to be mounted to a surface of the same PV module.

Similar to the example extension integrated power devices of FIGS. 25-27B, the example split junction box extension integrated power device 2800 of FIG. 28 may further comprise a power device 2802 (power device 2802 may be substantially the same as power device 2502, 2502 and 2702). The power device 2802 may include first and second input terminals 2814A and 2814B, and first and second output terminals 2816A and 2816B. First input conductor 2812A may be connected to first contact 2808A and first input terminal 2814A. First input conductor 2812A may extend some length between the first split junction box 2806A and the power device 2802. Similarly, the second input conductor 2812B may be connected to second contact 2808B and second input terminal 2814B. Second input conductor 2812B may extend some length between the second split junction box 2806B and the power device 2802. First and second output conductors 2818A and 2818B, at first ends thereof, may be connected to first and second output terminals 2816A and 2816B respectively. The first and second output conductors 2818A and 2818B may extend from the power device. First connector 2820A may be connected to the first output conductor 2818A, at a second end thereof, and second connector 2818B may be connected to the second output conductor 2818B, at a second end thereof.

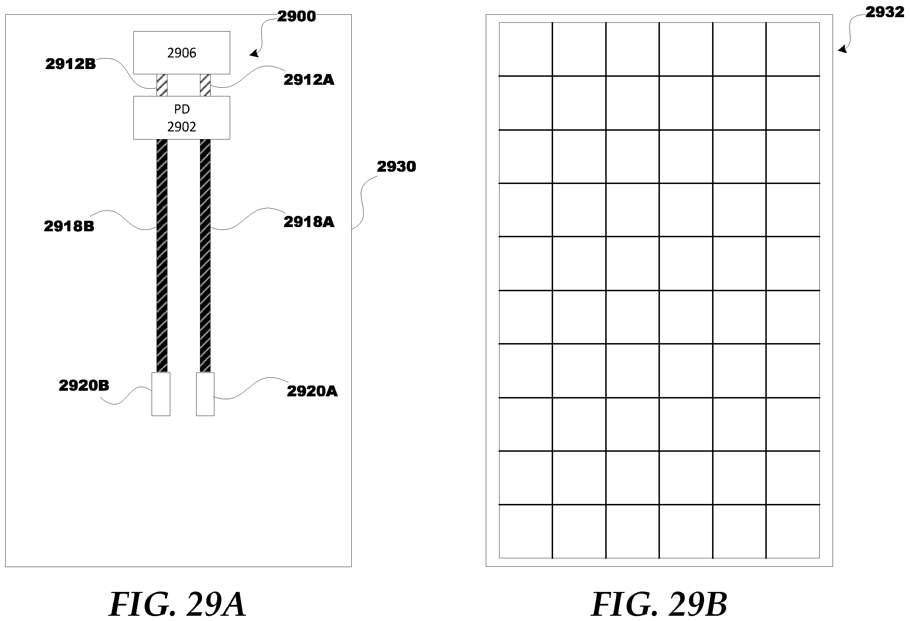

FIGS. 29A-29B, depict an example extension integrated power device 2900 in context of PV module 2930 and PV cell array 2932 according to one or more aspects of the present disclosure. FIG. 29A shows a view of a backside of an example PV module 2930 with an example extension integrated power device 2900 installed thereto according to one or more aspects of the present disclosure. FIG. 29B shows a view of a frontside of the example PV module 2900 of FIG. 29A having example PV cell array 2932. Referring to FIG. 29A, junction box 2906 may be mechanically configured to be attached to the backside of the PV module 2930. Additionally or alternatively, junction box 2906 may include a junction box housing that may be mechanically configured to be attached to the backside of PV module 2930. First and second input conductors 2912A and 2912B may be connected to the junction box (as described herein) and the power device (as described herein) and may extend some length (e.g., 1.5 in, 2 in, 12 in) between the junction box 2906 and the power device 2902. First and second output conductors 2918A and 2918B may be connected to the power device 2902 and extend some length from the power device 2902. First and second connectors 2920A and 2920B may be connected to first and second output conductors 2918A and 2918B. Power device 2902 may be mechanically configured to be attached to the backside surface of the PV module 2930. Referring to FIG. 29B, the front side of the PV module may include PV cell array 2932. PV cell array 2932 may include any number of serially and/or parallelly connected PV cells. The PV cell array may produce power when irradiated by light energy. Referring to FIG. 29A, the power produced by the PV cell array may be input into the junction box 2906 (via, for example, electrical connection of the PV cell array 2932 to the junction box 2906), and from the junction box 2906 into the power device 2902 (via, for example first and second input conductors 2912A and 2912B). The power device may variously act on the power produced by the PV cell array (e.g., DC-DC convert the power, invert the power, optimize the power, etc.). The power acted on by the power device may then be availed at the first and second connectors 2920A and 2920B.

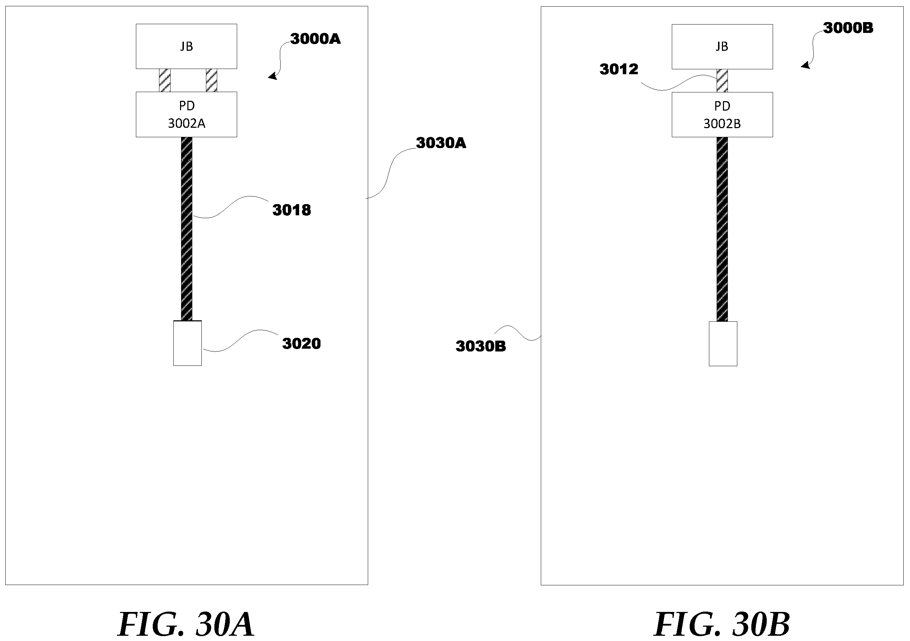

FIGS. 30A-30B depict example alternative configurations of example extension integrated power devices 3000A and 3000B according to the present disclosure. The example extension integrated power devices of FIGS. 30A and 30B may be substantially similar to the example extension integrated power device as depicted in FIGS. 25-29B unless explicitly stated otherwise. The example extension integrated power devices of FIGS. 25-29B have been depicted as having two input conductors and two output conductors that may be separate extensions (e.g., separate cables, separate leads). Referring to FIG. 30, the output conductor 3018 may be a single extension (e.g., single cable, single lead). The single output extension 3018 may comprise, for example, a multi-conductor single extension (e.g., multiwire cable). Accordingly, the single output extension 3018 may comprise multiple internal conductors. Each conductor may connect to the power device 3002A substantially as described herein (e.g., with reference to FIG. 25). Additionally, a single detachable connector 3020 may connected to the single output extension to avail the power produced by the PV cell array of the PV module 3030A to which extension integrated power device 3000A may be connected. Referring to FIG. 30B, similarly to extension integrated power device 3000A, and similar to single output extension 3018, the input conductors may be packaged as a single input extension 3012. The single input extension 3012 may comprise a multi-conductor single extension (e.g., multiwire cable). The multiple conductors of the single input extension may be connected substantially as described in relation to input conductors of FIG. 25.

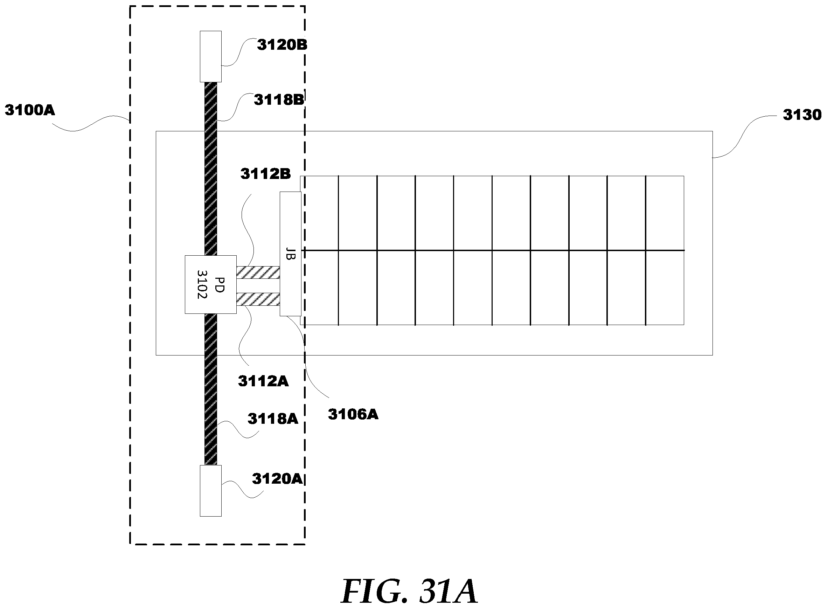

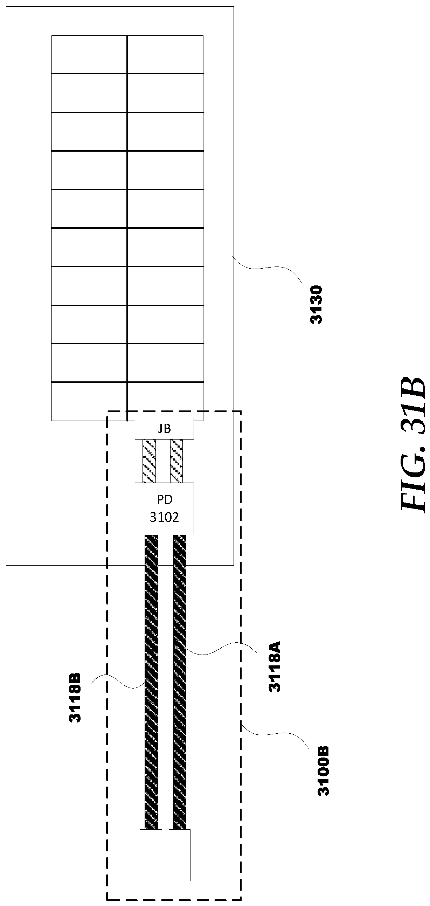

FIGS. 31A and 31B depict example extension integrated power devices 3100A and 3100B in the context of being installed to an example roof tile PV module 3130 according to the present disclosure. Example extension integrated power devices 3100A and 3100B may be substantially similar to example extension integrated power devices 2500-3000B of FIGS. 25-30B unless explicitly stated otherwise herein. Referring to FIG. 31A, roof tile PV modules 3130 may be installed on a solid surface (e.g., a roof). Accordingly, it may be advantageous to place components on the front side surface of the roof tile PV module 3130. Accordingly, frontside junction box 3106A may be installed to the roof tile PV module 3130 on the frontside surface thereof. First and second input conductors 3112A and 3112B may, at a first ends thereof, be integrally connected to the frontside junction box 3106A (e.g., at contacts of the frontside junction box 3106A). First and second input conductors 3112A and 3112B may, at second ends thereof be integrally connected to power device 3102 (e.g., DC-DC converter, inverter, micro-inverter, optimizer, etc.). first and second input conductors 3112A and 3112B may extend some length between the frontside junction box 3106A and the power device 3102. First and second output conductors 3118A and 3118B, at first ends thereof, may be electrically integrally connected to power device 3102. First and second conductors 3118A and 3118B may extend some distance from the power device 3102. First and second detachable connectors 3120A and 3120B (e.g., MC4 connectors) may be attached to the first and second output conductors 3118A and 3118B at second ends thereof. Power produced by roof tile PV module 3130, and affected by power device 3102, may be availed at first and second connectors 3120A and 3120B.

Referring to FIG. 31A, first output conductor 3118A may extend from power device 3102 in a first direction, and second output conductor 3118B may extend from power device 3102 in a second direction. The first and second directions may be substantially opposed to one another. Such an arrangement may prove advantageous depending on installation considerations. For example, often, roof tile PV modules (e.g., roof tile PV module 3130) may be installed in columns, for example on a rooftop. In order to extract power having desired power characteristics, a number of roof tile PV modules (e.g., all roof tile PV modules in a column) may be electrically serially connected to each other in a string of roof tile PV modules 3130 (e.g., to increase available voltage). Accordingly, the negative output conductor (e.g., output conductor 3118A) of one roof tile PV module 3130 (e.g., via detachable connector 3120A) may be connected to the positive output conductor (e.g., output conductor 3118B) of an adjacent roof tile PV module 3130 (e.g., via second detachable connector 3120B). Accordingly, configuring extension integrated power device 3100A according to FIG. 31A where the output conductors 3118A and 3118B extend in substantially opposed directions, may allow for simplified serial connection of a plurality of roof tile PV modules 3130 in a roof tile PV module 3130 installation.

Referring to FIG. 31B, the extension integrated power device 3100B of FIG 31B may be substantially identical to the extension integrated power device 3100A of FIG. 31A unless explicitly stated otherwise herein. Referring to FIG. 31B, first and second output conductors 3118A and 3118B may extend from the power device 3120 in the same direction. Although FIG. 31B depicts the first and second output conductors 3118A and 3118B as extending parallel with the roof tile PV modules 3130 long axis, it is contemplated herein that the first and second output conductors 3118A and 3118B may extend from the power device in any direction. Such a configuration may be advantageously associated with reduced cost of production over other some other configurations.

Depictions of some electrical connections have been omitted from some extension integrated power devices of FIGS. 25-31B. It is to be understood that extension integrated power devices 2500-3100B of FIGS. 25-31B may comprise elements (e.g., contacts) for electrically connecting the components described herein (for example as depicted in FIG. 25).

As described herein, all PV arrays of the present disclosure may incorporate the use of diodes (e.g., bypass diodes) to bypass one or more PV generators (e.g., PV cells, PV strings, etc.). Additionally or alternatively, all PV arrays of the present disclosure may not incorporate (e.g., may omit) diodes. According to such configurations, power electronics (e.g., PD 3102 (e.g., PE 3202)) may be connected to the PV arrays of the present disclosure. The power electronics may act on the PV array to which it is connected, for example, to bypass one or more strings of the PV array and/or to change (e.g., set) the operating point of one or more strings of the PV array to which it is connected (e.g., to move the operating point of one or more strings of the PV array to a safe operating point). For example, referring to FIG. 31B, a plurality of roof tile PV modules 3130 may be connected to each other in series. One (or more) of the serially connected roof tile PV modules 3130 may experience reduced irradiance as compared to the other connected roof tile PV modules 3130 (e.g., a partial shade condition). The power electronics (e.g., PD 3102 (e.g., PE 3202)) may detect (e.g., sense) such a partial shade condition and move the shaded roof tile PV module 3130 to a safe operating point.

In addition to static reconfiguration of substrings as discussed herein, the substrings and PV modules may be variously actively optimized, utilized, converted, and/or inverted using power electronics (PEs) 3202. PEs 3202 may act at the substring 102 level, the multi-substring level (e.g., PE acting on 2, 3, 4, etc. substrings 102), the PV module level, and/or the multi-PV module level (e.g., PE acting on 2, 3, 4, etc. PV modules). Reference is now made to FIG. 32, which depicts an example PE 3202 according to one or more aspects. PE 3202 may include a casing 3231. The casing 3231 may house circuitry 3230 (depicted functionally). Additionally or alternatively, the PE 3202 may be disposed directly on a conductive backsheet 901 (e.g., conductive backsheet 901A-901H) or PV module substrate. PE 3202 may be epoxy coated or otherwise encapsulated (e.g., utilizing a resin) on the conductive backsheet Additionally or alternatively, PE 3202 may be housed in a junction box (e.g., junction box 242A, 942, etc.). Additionally or alternatively, casing 3231 and junction box (e.g., junction box 242A, 942, etc.) may be one and the same. PE 3202 may include power converter 3240. Power converter 3240 may include a direct current-direct current (DC-DC) converter such as a buck, boost, buck+boost, flyback, Cuk, buck and boost in any order, and/or forward converter. Power converter 3240 may include a direct current - alternating current (DC/AC) converter (e.g., an inverter, or a micro-inverter designed to convert a smaller portion of power from DC to AC) instead of, or in addition to, a DC-DC converter. Positive and negative terminals of the PV generator (e.g., terminals 105 and 103 of substrings 102) may be electrically connected to input terminals of power converter 3240, and power converter 3240 may be configured to converter DC electrical power generated by the PV generator to a different form of electrical power, for example, to DC power at a different voltage or current level, or to AC power.

According to Illustrative aspects of the present disclosure, circuitry 3230 may include Maximum Power Point Tracking (MPPT) circuit 3295, configured to extract increased power from the PV generator (e.g., PV cells, substrings, PV cell arrays, PV modules, PV module arrays etc.) to which PE 3202 is coupled. MPPT circuit 3295 may track the characteristics of the power being produced by a PV generator, for example, the I-V curve (current-voltage curve), and adjust the load (impedance) presented to the PV generator to keep the power transfer at its substantially maximum power point (MPP). Power converter 3240 may include MPPT 3295, rendering a separate MPPT circuit 3295 unnecessary. Circuitry 3230 may further comprise control device 3270 such as a microprocessor, Digital Signal Processor (DSP) and/or a Field Programmable Gate Array (FPGA). Control device 3270 may control and/or communicate with other elements of circuitry 3230 over common bus 3290. In some aspects, control device 3270 may control power converter 3240 to perform the functions of MPPT circuit 3295, by receiving voltage and/or current measurements at the input and/or output of the power converter 3240, and based on those measurements, control the power converter 3240 to adjust its input voltage or current, or adjust its output voltage or current such that power generated by the PV generator is increased. Circuitry 3230 may include circuitry and/or sensors/sensor interfaces 3280 configured to measure parameters directly or receive measured parameters from connected sensors on or near the PV generator, such as the voltage and/or current output by the module, the power output by the module, the irradiance received by the module and/or the temperature on or near the module. Circuitry 3230 may include communication device 3250, configured to transmit and/or receive data and/or commands to/from other devices. Communication device 3250 may communicate using, for example, Power Line Communication (PLC) technology, acoustic communications technologies, or wireless technologies such as BlueTooth™, ZigBee™, Wi-Fi™, cellular communication or other wireless methods.

Circuitry 3230 may include safety devices 3260 (e.g. fuses, circuit breakers and Residual Current Detectors, etc.). For example, fuses may be connected in series with some or all of conductors (e.g., in series with a power path from the terminals of the PV generator to the output of the junction box). As another example, PE 3202 may include a circuit breaker, with control device 3270 configured to activate the circuit breaker and disconnect PE 3202 from a PV string or a PV generator in response to detecting a potentially unsafe condition or upon receiving a command (e.g. via communication device 3250) from a system control device. As yet another example, PE 3202 may include a bypass circuit featuring a switch, with control device 3270 configured to activate the bypass circuit in response to detecting a potentially unsafe condition or upon receiving a command (e.g. via communication device 3250) from a system control device 3270. The bypass circuit, when activated, may short-circuit the input and/or output terminals of PE 3202 (e.g., connected to the positive and negative terminals of the PV generator). Additionally or alternatively, the bypass circuit may disconnect the input terminals from the output terminals of PE 3202.

According to aspects of the present disclosure, PEs 3202 may also be utilized to mitigate adverse effects of mismatch or the partial shade conditions, such as "hotspotting" as described herein. PEs 3202 may monitor the performance and power characteristics of a PV generator (e.g., PV cell, substring, PV cell array, PV module, PV module array). The PEs 3202 may detect, based on the PV generator performance (e.g., I-V curve) and power characteristics, that a portion of the overall PV generator (e.g., a single PV cell in a PV module or a single PV cell in a substring) is being reversed biased and/or "hot-spotting" due to reduced irradiance from, for example, the partial shading condition. The PEs 3202 may then operate to mitigate the reverse bias or "hot-spotting." PEs 3202 may counteract such PV generator reverse bias in a number of ways. For example, the PEs 3202 may alter the amount of current being drawn from the overall PV generator (e.g., PV module, substring, (e.g., substrings 102, 1002, etc.)) to match the current being produced by the reduced PV generator (e.g., the shaded PV cell). In that way, the reduced PV generator may no longer be reverse biased (or may be less reverse biased) and the negative effects such as "hot-spotting" may be mitigated. Additionally or alternatively, PEs 3202 may bypass the reduced PV generator (e.g., substring). According to aspects, PEs 3202 may be able to act on a more granular level. For example, PEs 3202 may be connected with, or have control of a PV cell array on a substring level (as discussed in further detail below). In such examples, PEs 3202 acting on substring levels may or may not be connected with additional PEs 3202 acting on a less granular level, for example on a PV module level. In such examples, multiple PEs3202 may be acting on the same system at different levels of granularity. Further in such examples, PEs 3202 may be able to detect on a substring level, based on power characteristics and performance, whether a portion of the substring is experiencing the mismatch condition and/or "hot-spotting" due to for example, reduced irradiance or partial shading. The PEs may then either move the portion to a safe operating point (for e.g., by reducing the current draw to match the reduced portion), or alternatively bypass the reduced portion. In another aspect, PEs may utilize thermocouples to detect when a PV generator is "hot-spotting" and act on the PV generator accordingly, as described herein.

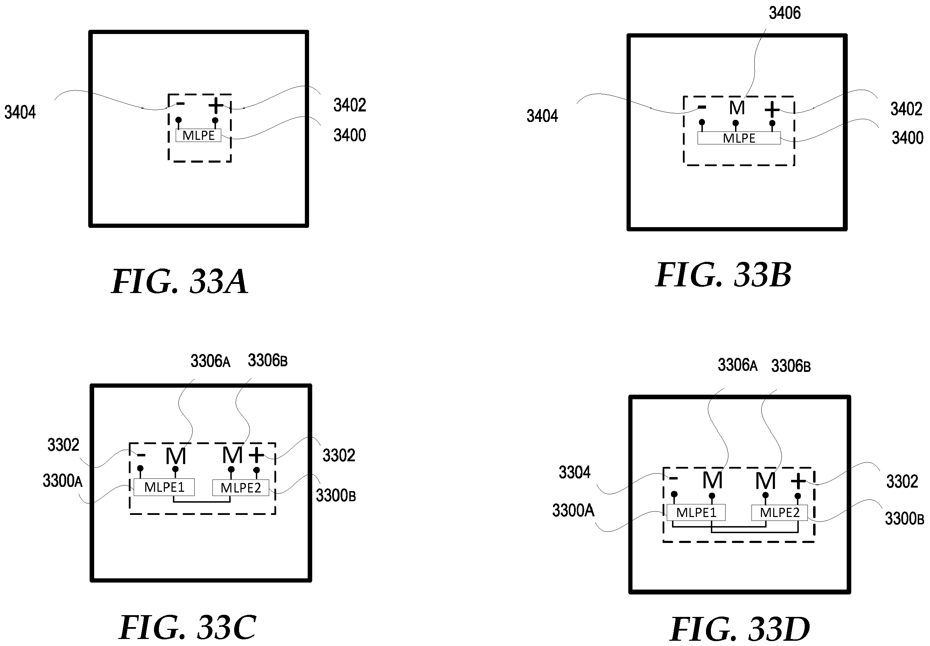

PEs may be utilized on a panel level, where the power production of an entire PV module may be acted upon. After being acted upon, the power from a PV module may be joined with that of other PV modules electrically connected in any of various methods including for example in series, in parallel, in series-parallel, TCT, etc. If the direct current (DC) power has not yet been inverted at a more granular level (e.g., the substring level), the power may then be inverted to AC and utilized (e.g., at load 3402). Alternatively, the power may not be inverted and it may be utilized (e.g., at load 3402). FIGS. 33A-33D depict various examples of module level power electronic (MLPE) 3300 incorporation according to one or more aspects of the present disclosure. MI,PE 3300 may perform the same (or substantially the same) and comprise some or all of the same components as PE 3202 as described herein. For purposes of this disclosure MLPE 3300 may be considered a type of PE 3202. MI,PE 3300 may include a casing (e.g., substantially similar to casing 3231). The casing may house PE 3202 components (e.g., power converter 3240, sensor(s)3280, communication device 3250, safety device 3260, components to effectuate MPPT 3295, control device 3270, etc.) as described in relation to FIG. 32. MLPEs 3300 may be disposed in a junction box (e.g., junction box 242, 942, etc.), on a panel, on a PV cell substrate, on a conductive backsheet (e.g., conductive backsheet 901A-901H), or may be connected to PV module leads and added to a PV module that previously lacked MLPE 3300. Referring to FIG. 33A, MLPE 3300 may be electrically connected to a PV module positive terminal 3302 or lead and PV module negative terminal 3304 or lead. The MLPE may then monitor, collect data, communicate the data, optimize, and/or invert the power, bypass substrings, etc.

and avail the power as described herein with positive and negative terminals or leads. Referring to FIG. 33B, MI,PE 3300 may be electrically connected to PV module positive terminal 3302 or lead, PV module negative terminal 3304 or lead and substring midpoint terminal 3306. Substring midpoint terminal 3306 may be the terminal of the electric potential midpoint of some or all substring midpoints in a PV cell array. Referring to FIGS. 33C-33D, aspects may utilize multiple MLPEs 3300, for example, MLPE1 3300A and MLPE2 3300B. The use of multiple MLPEs 3300 may allow for increased granularity in optimization, data tracking, communication, switching, monitoring, inverting, etc. For example, referring to FIG. 33C, two MLPEs 3300 may be utilized. Each of MI,PE1 3300A and MLPE2 3300B may be connected to electric potential midpoints 3306A and 3306B respectively of subsets of the substrings. MLPE1 and MLPE2 may then operate on the PV module and power generated by the PV module as described herein. MLPE1 3300A and MLPE2 3300B may be connected in series. Alternatively, and referring to FIG. 33D, MI,PE1 3300A and MLPE2 3300B may be connected in parallel.

It may be advantageous to connect PEs 3202 on a more or less granular level. For example, it may be advantageous to connect PEs 3202 on a substring 102 level, a multi-substring level (e.g., 1, 2, 3, etc. substring acted on by a single PE), a PV module level, and/or a multi-PV module level (e.g., 1, 2, 3, etc. PV modules acted on by a single PE 3202). For example, in a commercial PV power station (e.g., solar park, solar farm, etc.) in an open area, partial shading may be less of a concern and cost savings may be more of a concern. In such examples PEs may be utilized on a less granular level, for example, one PE 3202 for every 3, 4, 5, etc. PV modules. In such examples, the PEs may operate substantially as described above (e.g., monitoring, optimizing, mitigating mismatch, mitigating "hot-spotting," inverting, communicating etc.) but on a less granular level. Additionally or alternatively, "central" PEs 3202 (e.g., one PE 3202 for every 3, 4, 5, etc. PV modules) may be able to optimize, control, communicate on a more granular level. For example, a "central" PE 3202 (e.g., connected to four PV modules), may still be able optimize each of the four modules separately. Such a scheme may be effectuated by, for example, smart switching by the PE 3202 between the PV modules. Additionally or alternatively, it may be advantageous to mix levels of granularity. For example, it may be advantageous to have some control with a PE 3202 at the substring 102 level and have additional control with an additional PE 3202 at the PV module level.

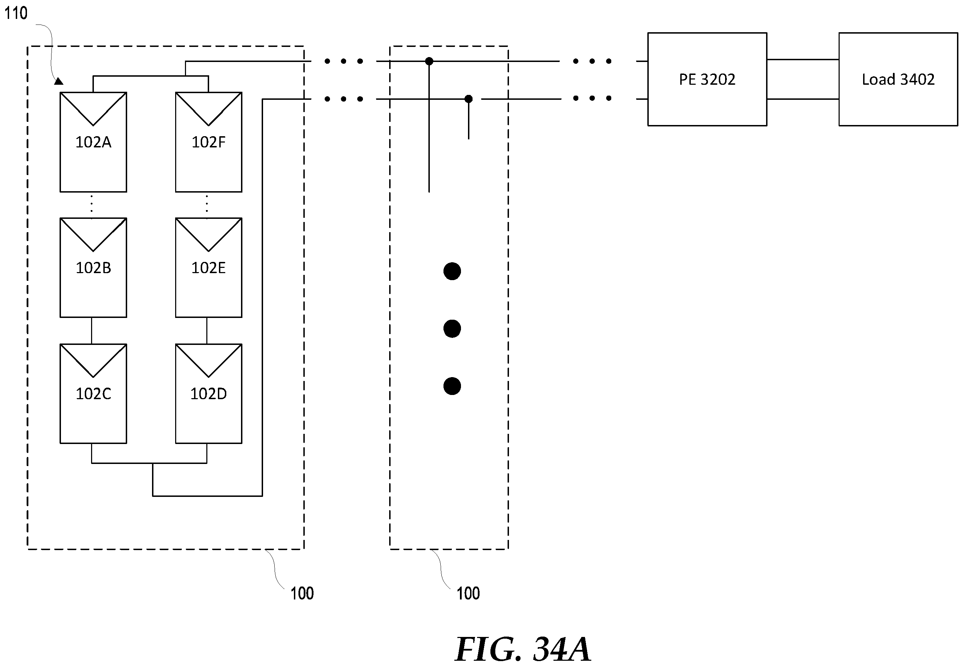

FIG. 34A depicts an example PV module and PV cell array circuit with PE 3202 incorporation on the PV module, or multi-module level. As described herein, a PV module may contain a PV cell array (e.g., PV cell array 110, 1010, etc.) of multiple electrically parallel connected substrings (e.g., substring 102, distributed substrings 1002, etc.). PV modules may then be connected to PE 3202, and PE 3202 may act upon, track, optimize, convert, invert, communicate with/to, etc. the PV module. Additionally or alternatively, PV module may be connected to other PV modules in one of various methods of electrical connection, for example, series, parallel, series-parallel, TCT, etc. The multi-module arrangement may then be connected to PE 3202 as described herein and PE 320 may act upon, track, optimize, convert, invert, communicate with/to, etc. multi-module arrangement. PE 3202 may be connected to the PV module or multi-module arrangement in one of various methods of electrical connection including, for example, in series, parallel, etc. A PE3202 connected to a multi-module arrangement may control each PV module in the arrangement separately, and/or the entire arrangement together. PE 3202 connected on the module or multi-module level may be able to act on a more granular level, for example, on each individual substring. For example, each substring may be electrically connected to a single PE 3202 in a junction box disposed on the PV module. PE 3202 may then be able to act on each substring by either smart switching between substrings to act on each substring discretely. For example, if PE 3202 detects a decrease in production from the module, it may be able to discretely switch through the substrings to determine the mismatched and/or reduced substring. The PE 3202 may then act to mitigate the mismatch by, for example, bypassing the reduced substring or moving the substring to a safe operating point (by, for example, only drawing the amount of current such that the reverse bias of the reduced PV generator (e.g., PV cell, substring) is mitigated or substantially eliminated. Additionally or alternatively, in such an aspect, PE 3202 may be able to accommodate and/or process all substrings substantially at the same time. PE 3202 may then periodically check the bypassed or reduced substring to determine whether its maximum operating point has changed. PE 3202 may avail the power from the PV generator to load 3402. Load 3402 may include, for example, the grid, an appliance, a battery, etc.

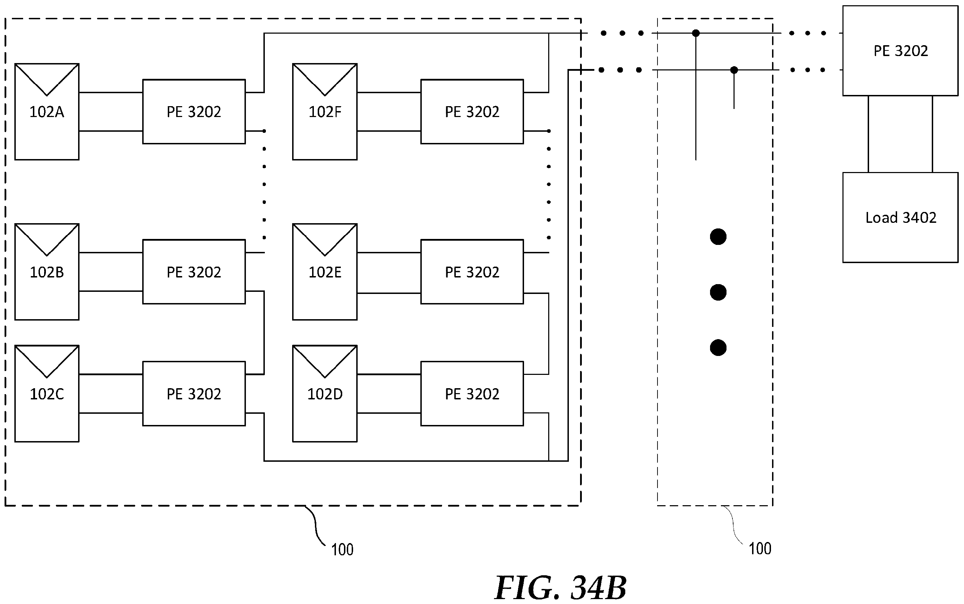

As described herein, in some instances, it may be advantageous to connect PEs 3202 on a more granular level, for example, the substring or multi-substring level. FIG. 34B depicts an example PV module and PV cell array circuit with PE 3202 incorporation on the substring level and PV module or multi-PV module level. Referring to FIG. 34B, each substring may have a dedicated PE 3202. For example, a PV module may have six substrings (e.g., two-row substrings, 102A, four-row substring 102B, distributed substring 1002, or TCT substring 902) electrically connected in parallel. Each substring in a PV cell array or PV module (e.g., substring 102A-102D) may have a dedicated PE 3202. The PE 3202 may act directly on the substring substantially as described in relation to PEs 3202 herein (e.g., MPPT, control, communication, DC-DC conversion, inversion, etc.). For example, if a PV cell in a substring (e.g., substring 102) is shaded and is "hot spotting," PE 3202 acting on the particular substring may only draw current to match that which is produced by the shaded cell. PV modules with substring level PEs 3202 may then be connected to additional PV modules in one of various methods of electrical connection, for example, series, parallel, series-parallel, TCT, etc. The multi-module arrangement may then be connected to PE 3202 as described herein; and PE 3202 may act upon, track, optimize, convert, invert, communicate with/to, etc. multi-module arrangement. A PE3202 connected to a multi-module arrangement may control each PV module in the arrangement separately, and/or the entire arrangement together. PE 3202 may avail the power from the PV generator to load 3402. Load 3402 may include, for example, the grid, an appliance, a battery, etc. Additionally or alternatively, PV module may be connected to an additional PE 3202 before being connected to additional PV modules. PE 3202 may act on the PV module substantially as described in relation to PE 3202 herein (e.g., MPPT, control, communication, DC-DC conversion, inversion, etc.). Such a PE 3202 connected on the PV module level may operate on the entire module (e.g., the power of all the substrings 102) or on a more granular level (e.g., on the substrings, e.g., two-row substrings, 102A, four-row substring 102B, distributed substring 1002, or TCT substring 902). For example, PE 3202 directly connected to substring 102A, may effectuate MPPT on substring 102A. PE 3202 connected to the PV module may then additionally effectuate MPPT on the PV module level, invert the power of the module, DC-DC convert the power, communicate data, invert the power, etc. Power may then be made available to a load 3402 (e.g., the grid, an appliance, a battery, etc.) either directly from the PV module or from the PE 3202 connected to the PV module. Additionally or alternatively, it may be advantageous to further process, and/or utilize the power before making available to load 3402. Outputs of multiple PEs 3202 may be serially connected, as shown in Fig. 34B, or may be connected in parallel.

Several alternative examples have been described and depicted herein. A person of ordinary skill in the art would appreciate the features of the individual aspects, and the possible combinations and variations of the components. A person of ordinary skill in the art would further appreciate that any of the example configurations maybe provided in any combination with the other example configurations disclosed herein. The present examples and aspect, therefore, are to be considered in all aspects as examples and not restrictive, and the invention is not to be limited to the details given herein. Terms such as "top," "bottom," "left, "right," "front," back," "outward," "inward," "leftmost," "rightmost," "upward," "downward," and the like, as used herein, are relative terms intended for purposes of example only and do not limit the scope of the disclosure. Additionally, terms such as "rows" should not be limited to the horizontal orientation only but may be understood to include the vertical orientation (for example, where example orientations and/or configurations are rotated). Similarly, terms such as "columns" should not be limited to the vertical orientation only but may be understood to include the horizontal orientation (for example, where orientations and/or configurations are rotated). Nothing in this specification should be construed as requiring specific three-dimensional orientation of structures in order to fall within the scope of the disclosure, unless explicitly specified by the claims. Additionally, the term "plurality" as used herein, indicates any number greater than one, either disjunctively or conjunctively, as necessary, up to an infinite number. Accordingly, while the specific examples have been depicted and described, numerous modifications come to mind without significantly departing from the spirit of the disclosure and the scope of protection is only limited by the scope of the accompanying claims.

The present application also discloses the subject matter of the following claim-like clauses which includes subject matter derived from the claims of the priority-providing applications.

Clause 1: A photovoltaic module system comprising:

a photovoltaic module; and

a plurality of substrings disposed on the photovoltaic module and electrically connected to each other in parallel,

wherein each substring of the plurality of substrings includes:

a plurality of photovoltaic cells electrically connected to each other in series;

a positive terminal; and

a negative terminal, and

wherein the plurality of substrings have an orientation on the photovoltaic module such that the positive terminal of each substring terminates proximate to and electrically connects to the positive terminal of a first neighboring substring, and the negative terminal of each substring terminates proximate to and electrically connects to the negative terminal of a second neighboring substring.

Clause 2: The photovoltaic module system of clause 1, wherein the negative terminal of each of the plurality of substrings electrically connect, in a junction box, to the negative terminal of the first neighboring substring, and the positive terminal of each of the plurality of substrings electrically connect, in a junction box, to the positive terminal of the second neighboring substring.

Clause 3: The photovoltaic module system of clause 1, wherein each of the plurality of substrings terminates proximate to a midline of the photovoltaic module.

Clause 4: The photovoltaic module system of clause 1, wherein a portion of the plurality of photovoltaic cells comprise 1/N cut photovoltaic cells,

wherein N is an integer.

Clause 5: The photovoltaic module system of clause 1, wherein the plurality of substrings comprise:

a first substring, a second substring, and a third substring disposed on a first half of the photovoltaic module, and
a fourth substring, a fifth substring, and a sixth substring disposed on a second half of the photovoltaic module,
wherein the plurality of substrings are arranged such that:

a negative terminal of the first substring terminates proximate to and electrically connects to a negative terminal of the second substring defining a first-second negative electrical connection,
a positive terminal of the second substring terminates proximate to and electrically connects to a positive terminal of the third substring defining a second-third positive electrical connection,
a negative terminal of the third substring terminates proximate to and electrically connects to a negative terminal of the fourth substring defining a third-fourth negative electrical connection,
a positive terminal of the fourth substring terminates proximate to and electrically connects to a positive terminal of the fifth substring defining a fourth-fifth positive electrical connection,
a negative terminal of the fifth substring terminates proximate to and electrically connects to a negative terminal of the sixth substring defining a fifth-sixth negative electrical connection, and
a positive terminal of the sixth substring terminates proximate to and electrically connects to a positive terminal of the first substring defining a sixth-first positive electrical connection.

Clause 6: The photovoltaic module system of clause 5, wherein the electrical connections are disposed/effected on the photovoltaic module outside of a junction box.

Clause 7: The photovoltaic module system of clause 5, wherein the second-third positive connection, the fourth-fifth positive connection and the sixth-first positive connection are connected to each other in a junction box, and wherein the first-second negative connection, the third-fourth negative connection and the fifth-sixth negative connection are connected to each other in the junction box.

Clause 8: The photovoltaic module system of clause 1, wherein a total number of the plurality of substrings are divided into a first half of substrings and a second half of substrings and wherein the first half of substrings are disposed on a first half of the photovoltaic module and the second half of substrings are disposed on a second half of the photovoltaic module.

Clause 9: The photovoltaic module system of clause 8, wherein each of the plurality of substrings comprise:

a first sub-substring comprising a first half of the substring and a second sub-substring comprising a second half of the substring,

wherein each substring is arranged on the photovoltaic module in two rows including:

a first row comprising the first sub-substring, and
a second row comprising the second sub-substring.

Clause 10: The photovoltaic module system of clause 9, wherein each sub-substring extends from a substring terminal proximate to a photovoltaic module midline to a substring midpoint proximate to a photovoltaic module outer edge,

wherein the substring midpoint comprises a substring electric potential midpoint.

Clause 11: The photovoltaic module system of clause 10, further comprising:

a cross-tie electrically connecting substring midpoints of at least two substrings.

Clause 12: The photovoltaic module system of clause 11, further comprising:

a first bypass diode connecting a positive terminal of the photovoltaic module to the cross-tie; and
a second bypass diode connecting a negative terminal of the photovoltaic module to the cross-tie.

Clause 13: The photovoltaic module system of clause 10, further a comprising:

a first cross-tie electrically connecting substring midpoints of the first half of substrings; and
a second cross-tie electrically connecting substring midpoints of the second half of substrings.

Clause 14: The photovoltaic module system of clause 13, further comprising:

a first bypass diode connecting a positive terminal of the photovoltaic module to at least one of the first or second cross-ties; and
a second bypass diode connecting a negative terminal of the photovoltaic module and at least one of the first or second cross-ties.

Clause 15: The photovoltaic module system of clause 8, wherein each of the plurality of substrings comprise:

a first sub-substring, a second sub-substring, a third sub-substring, and a fourth sub-substring,

wherein each substring is arranged in four rows:

a first row comprising the first sub-substring,
a second row comprising the second sub-substring,
a third row comprising the third sub-substring, and
a fourth row comprising the fourth sub-substring.

Clause 16: The photovoltaic module system of clause 15, wherein each of the plurality of substrings are disposed such that the first sub-substring extends from a substring positive terminal proximate to a photovoltaic module midline to a substring quarter point proximate to a photovoltaic module edge, wherein the second sub-substring extends from the substring quarter point to a substring midpoint proximate to the photovoltaic module midline, wherein the third sub-substring extends from the substring midpoint to a substring three-quarter point proximate to the photovoltaic module edge, and wherein the fourth sub-substring extends from the substring three-quarter point to a substring negative terminal proximate the photovoltaic module midline.

Clause 17. The photovoltaic module system of clause 16, further comprising:

a first cross-tie,
wherein the first cross-tie electrically connects the substring three-quarter point of a first substring to the substring three-quarter point of a second substring; and

a second cross-tie,

wherein the second cross-tie electrically connects the substring quarter point of the first substring to the substring quarter point of a third substring,

wherein the substring three-quarter point comprises a substring electric potential three quarter point and the substring quarter point comprises a substring electric potential quarter point.

Clause 18: A method of arranging substrings of a photovoltaic module comprising:

disposing a plurality of substrings on a photovoltaic module,
wherein each of the plurality of substrings comprise a plurality of serially connected photovoltaic cells, and wherein respective ends of each of the plurality of substrings terminate in a positive terminal and a negative terminal;
arranging each of the plurality of substrings such that the negative terminal of each of the plurality of substrings terminates proximate to the negative terminal of a first neighboring substring and the positive terminal of each of the plurality of substrings terminates proximate to the positive terminal of a second neighboring substring;
electrically connecting the negative terminal of each of the plurality of substrings to the negative terminal of the first neighboring substring; and
electrically connecting the positive terminal of each of the plurality of substrings to the positive terminal of the second neighboring substring.

Clause 19: The method of clause 18, wherein arranging each of the plurality of substrings includes arranging each of the plurality of substrings to terminate proximate a midline of the photovoltaic module.

Clause 20: The method of clause 18, further comprising:

electrically connecting the positive terminal of each of the plurality of substrings to the first neighboring substring in a junction box; and
electrically connecting the negative terminal of each of the plurality of substrings to the negative terminal of the second neighboring substring in a junction box.

Clause 21: The method of clause 18, wherein arranging each of the plurality of substrings comprises:

disposing a first, a second, and a third substring on a first half of the photovoltaic module;
disposing a fourth, a fifth, and a sixth substring on a second half of the photovoltaic module;
arranging the plurality of substrings such that a negative terminal of the first substring terminates proximate to a negative terminal of the second substring, a positive terminal of the second substring terminates proximate to a positive terminal of the third substring, a negative terminal of the third substring terminates proximate to a negative terminal of the fourth substring, a positive terminal of the fourth substring terminates proximate to a positive terminal of the fifth substring, a negative terminal of the fifth substring terminates proximate to a negative terminal of the sixth substring, and a positive terminal of the sixth substring terminates proximate a positive terminal of the first substring; and
wherein electrically connecting the negative terminal of each of the plurality of substrings to the negative terminal of the first neighboring substring comprises: electrically connecting the negative terminal of the first substring to the negative terminal of the second substring thereby defining a first-second negative connection, the negative terminal of the third substring to the negative terminal of the fourth substring thereby defining a third-fourth negative connection, and the negative terminal of the fifth substring to the negative terminal of the sixth substring thereby defining a fifth-sixth negative connection; and
wherein electrically connecting the positive terminal of each of the plurality of substrings to the positive terminal of the second neighboring substring comprises:

electrically connecting the positive terminal of the second substring to the positive terminal of the third substring thereby defining a second-third positive connection, the positive terminal of the fourth substring to the positive terminal of the fifth substring thereby defining a fourth-fifth positive connection, and a positive terminal of the sixth substring to the positive terminal of the first substring thereby defining a sixth-first positive connection.

Clause 22: The method of clause 21, further comprising:

electrically connecting the second-third positive connection, the fourth-fifth positive connection, and the sixth-first positive connection in a junction box; and electrically connecting the first-second negative connection, the third-fourth negative connection and the fifth-sixth negative connection in a junction box.

Clause 23: The method of clause 18, wherein disposing a plurality of substrings on a photovoltaic module comprises:
disposing a first half of substrings on a first half of the photovoltaic module and a second half of substrings on a second half of the photovoltaic module.

Clause 24: The method of clause 23, wherein disposing a plurality of substrings on a photovoltaic module further comprises:
disposing each of the plurality of substrings on the photovoltaic module in two rows, a first row comprising a first sub-substring, and a second row comprising a second sub-substring,
wherein the first sub-substring comprises a first half of the substring and the second sub-substring comprises a second half of the substring.

Clause 25: The method of clause 24, wherein disposing the first half of substrings, and disposing the second half of substrings further comprises:
extending each sub-substring from a substring terminal proximate a photovoltaic module midline to a substring midpoint proximate a photovoltaic module edge.

Clause 26: The method of clause 25, further comprising:

connecting a first cross-tie to the first half of substrings thereby connecting substring midpoints of the first half of substrings; and
connecting a second cross-tie to the second half of substrings thereby connecting substring midpoints of the second half of substrings.

Clause 27: The method of clause 23, wherein disposing a plurality of substrings on a photovoltaic module further comprises:
disposing each of the plurality of substrings on the photovoltaic module in four rows of sub-substrings,

wherein each sub-substring comprises a quarter of the substring.

Clause 28: The method of clause 27, wherein disposing each of the plurality of substrings on a photovoltaic module further comprises:

extending a first sub-substring from a substring positive terminal proximate a photovoltaic module midline to a substring quarter point proximate a photovoltaic module edge;
extending a second sub-substring from the substring quarter point to a substring midpoint proximate the photovoltaic module midline;
extending a third sub-substring from the substring midpoint to a substring three-quarter point proximate the photovoltaic module edge; and
extending a fourth sub-substring from the substring three-quarter point to a substring negative terminal proximate the photovoltaic module midline.

Clause 29: The method of clause 28, wherein disposing a plurality of substrings on a photovoltaic module further comprises:
electrically connecting, via a first cross-tie, the three-quarter point of a first substring to the three-quarter point of the second substring; and
electrically connecting, via a second cross-tie the quarter point of the first substring to the quarter point of a third substring.

Clause 30: A photovoltaic module comprising:

an array of photovoltaic cells comprising a plurality of parallelly connected substrings, each substring comprising:

a plurality of serially connected photovoltaic cells;
a positive terminal; and
a negative terminal, and

wherein the plurality of substrings are orientated array such that the positive terminal of each substring terminates proximate to and electrically connects to the positive terminal of a first neighboring substring, and the negative terminal of each substring terminates proximate to and electrically connects to the negative terminal of a second neighboring substring.

Clause 31: The photovoltaic module of clause 30, wherein the negative terminal of each of the plurality of substrings electrically connect, in a junction box, to the negative terminal of the first neighboring substring, and the positive terminal of each of the plurality of substrings electrically connect, in a junction box, to the positive terminal of the second neighboring substring.

Clause 32: The photovoltaic module of clauses 30 or 31, wherein each of the plurality of substrings terminates proximate to a midline of the array.

Clause 33: The photovoltaic module of any of clauses 30-32, wherein a portion of the plurality of photovoltaic cells comprise 1/N cut photovoltaic cells, wherein N is an integer.

Clause 34: The photovoltaic module of any of clauses 30-33, wherein a total quantity of the plurality of substrings are divided into a first half of substrings and a second half of substrings and wherein the first half of substrings are disposed on a first half of the photovoltaic module and the second half of substrings are disposed on a second half of the photovoltaic module.

Clause 35: The photovoltaic module of clause 34, wherein the total quantity of substrings is in the series $\{a_n\} = \{6, 10, 14, 18, 22 ...\}$ and the quantity of substrings of each of the first half of substrings and second half of substrings is in the series $\{a_n\} = \{3, 5, 7, 9, 11 ... \}$.

Clause 36: The photovoltaic module of clause 34, wherein each of the plurality of substrings comprise two rows, a first row comprising a first half of each substring and a second row comprising a second half of each substring

wherein each row extends from one of the positive terminal or the negative terminal, proximate to an array midline, to a substring electric potential midpoint, proximate to an array outer edge.

Clause 37: The photovoltaic module of clause 36, further a comprising:

a first midpoint conductor electrically connecting substring electric potential midpoints of the first half of substrings; and
a second midpoint conductor electrically connecting substring electric potential midpoints of the second half of substrings.

Clause 38: The photovoltaic module of clause 37, further comprising:

a first bypass diode connecting a positive terminal of the photovoltaic module to at least one of the first or second midpoint conductors; and
a second bypass diode connecting a negative terminal of the photovoltaic module and at least one of the first or second midpoint conductors.

Clause 39: The photovoltaic module of clause 34, wherein each of the plurality of substrings comprise four rows comprising:

a first row comprising a first sub-substring,
a second row comprising a second sub-substring,
a third row comprising a third sub-substring, and
a fourth row comprising a fourth sub-substring.

Clause 40: The photovoltaic module of clause 39, wherein each of the plurality of substrings are disposed such that the first sub-substring extends from a substring positive terminal proximate to an array midline to a substring quarter point proximate to an array edge, wherein the second sub-substring extends from the substring quarter point to a substring midpoint proximate to the array midline, wherein the third sub-substring extends from the substring midpoint to a substring three-quarter point proximate to the array edge, and wherein the fourth sub-substring extends from the substring three-quarter point to a substring negative terminal proximate the array midline.

Clause 41. The photovoltaic module of clause 40, further comprising:

a first cross-tie conductor,
wherein the first cross-tie conductor electrically connects the substring three-quarter point of a first substring to the substring three-quarter point of a second substring; and
a second cross-tie conductor,
wherein the second cross-tie conductor electrically connects the substring quarter point of the first substring to the substring quarter point of a third substring,
wherein the substring three-quarter point comprises a substring electric potential three quarter point and the substring quarter point comprises a substring electric potential quarter point.

Clause 42: A method of arranging substrings of a photovoltaic module comprising:

disposing a plurality of substrings on a photovoltaic module, each substring comprising a plurality of serially connected photovoltaic cells, a positive terminal and a negative terminal;
arranging each of the plurality of substrings such that the negative terminal of each of the plurality of substrings terminates proximate to a negative terminal of a first neighboring substring and the positive terminal of each of the plurality of substrings terminates proximate to a positive terminal of a second neighboring substring;
electrically connecting the negative terminal of each of the plurality of substrings to the negative terminal of the first neighboring substring; and
electrically connecting the positive terminal of each of the plurality of substrings to the positive terminal of the second neighboring substring.

Clause 43: The method of clause 42, further comprising:

electrically connecting the positive terminal of each of the plurality of substrings to the first neighboring substring in a junction box; and
electrically connecting the negative terminal of each of the plurality of substrings to the negative terminal of the second neighboring substring in a junction box.

Clause 44: The method of clauses 42 or 43, wherein disposing a plurality of substrings on a photovoltaic module comprises:
disposing a first half of substrings on a first half of the photovoltaic module and a second half of substrings on a second half of the photovoltaic module.

Clause 45. The method of any of clauses 42-44, wherein disposing a plurality of substrings on a photovoltaic module further comprises:
disposing each of the plurality of substrings on the photovoltaic module in two rows, a first row comprising a first half of each substring, and a second row comprising a second half of each substring,
wherein each row extends from one of the substring positive terminal or the substring negative terminal, proximate to a photovoltaic module midline, to a substring electric potential midpoint, proximate to a photovoltaic module outer edge.

Clause 46: The method of any of clauses 42-45, further comprising:

connecting a first midpoint conductor to the electric potential midpoints of the first half of the substrings; and
connecting a second midpoint conductor to the electric potential midpoints of the second half of the substrings.

Clause 47: The method of any of clauses 42-44, wherein disposing a plurality of substrings on a photovoltaic module further comprises:
disposing each of the plurality of substrings on the photovoltaic module in four rows,
wherein each row comprises a quarter of the substring.

Clause 48: The method of clause 47, wherein disposing each of the plurality of substrings on a photovoltaic module further comprises:

extending a first row from a substring positive terminal, proximate a photovoltaic module midline, to a substring quarter point, proximate a photovoltaic module edge;
extending a second row from the substring quarter point to a substring midpoint, proximate the photovoltaic module midline;
extending a third row from the substring midpoint to a substring three-quarter point, proximate the photovoltaic module edge; and
extending a fourth row from the substring three-quarter point to a substring negative terminal, proximate the photovoltaic module midline.

Clause 49: The method of clause 48, wherein disposing a plurality of substrings on a photovoltaic module further comprises:

electrically connecting, via a first conductor, the three-quarter point of a first substring to the three-quarter point of a second substring; and
electrically connecting, via a second cross-tie the quarter point of the first substring to the quarter point of a third substring.

Clause 50: A photovoltaic module comprising:

a conductive backsheet fabricated to form a plurality of conductive regions; and

a plurality of substrings disposed on the conductive backsheet,

wherein each substring of the plurality of substrings includes:
a plurality of photovoltaic cells electrically connected to each other in series via at least one conductive region of the plurality of conductive regions, and
wherein at least one other conductive region of the plurality of conductive regions electrically connects at least two nonadjacent substrings in parallel.

Clause 51: The photovoltaic module of clause 50, wherein the plurality of photovoltaic cells comprise rear contact photovoltaic cells that include contacts of a positive polarity and contacts of a negative polarity disposed on a rear side thereof.

Clause 52: The photovoltaic module of clause 50, wherein the plurality of photovoltaic cells comprise at least one of:

metal wrap through photovoltaic cells,
interdigitated back contact photovoltaic cells, or
emitter wrap-through photovoltaic cells.

Clause 53: The photovoltaic module of clause 50, wherein at least one of the plurality of photovoltaic cells comprise 1/N cut photovoltaic cells,
wherein N is an integer.

Clause 54: The photovoltaic module of clause 50, wherein the plurality of substrings comprise:

a first substring,
wherein each of the plurality of photovoltaic cells of the first substring have a first surface area; and
a second substring,
wherein each of the plurality of photovoltaic cells of the second substring have a second surface area equal to 1/N of the first surface area, where N is an integer greater than one.

Clause 55: The photovoltaic module of clause 50, further comprising:
electronics,
wherein at least one of the plurality of conductive regions electrically connects the electronics with at least one substring.

Clause 56: The photovoltaic module of clause 50, further comprising:
a junction box,
wherein at least two conductive regions are electrically connected to each other in the junction box.

Clause 57: The photovoltaic module of clause 50, wherein the at least one region of the plurality of conductive regions that electrically connects the plurality of photovoltaic cells is shaped such that electrical contacts of one polarity of a photovoltaic cell are electrically connected to electrical contacts of an opposite polarity of an adjacent photovoltaic cell.

Clause 58: The photovoltaic module of clause 50, wherein the conductive backsheet is fabricated from copper.

Clause 59: The photovoltaic module of clause 50, wherein the plurality of conductive regions are formed from patterns cut into the conductive backsheet.

Clause 60. The photovoltaic module of clause 50, wherein the plurality conductive regions are formed from patterns etched into the conductive backsheet.

Clause 61: The photovoltaic module of clause 50, wherein the plurality of conductive regions comprise a conductive material deposited on a nonconductive substrate.

Clause 62: The photovoltaic module of clause 50, wherein the conductive backsheet comprises a conductive sheet of nonuniform thickness.

Clause 63: The photovoltaic module of clause 50, wherein the plurality of conductive regions comprises:

at least one conductive pad configured to electrically connect adjacent photovoltaic cells; and
at least one conductive trace configured to transmit electrical power produced by at least one substring to at least one other substring.

Clause 64: The photovoltaic module of clause 63, wherein the at least one conductive trace is thicker than the at least one conductive pad.

Clause 65: The photovoltaic module of clause 65, wherein the plurality of conductive regions comprise:

a plurality of conductive pads,
wherein each conductive pad is configured to serially connect two adjacent photovoltaic cells in the substrings; and
a plurality of conductive traces configured to transmit electrical power from at least one substring to at least one other substring.

Clause 66: The photovoltaic module of clause 65, further comprising a junction box,
wherein at least two conductive traces are electrically connected to each other in the junction box.

Clause 67: The photovoltaic module of clause 50, wherein the conductive backsheet comprises:

a multilayer backsheet comprising:

at least one conductive layer; and
at least one dielectric layer.

Clause 68: The photovoltaic module of clause 67, wherein the at least one conductive layer comprises:
at least two conductive layers,
wherein the at least one dielectric layer separates the at least two conductive layers.

Clause 69: The photovoltaic module of clause 68, wherein the plurality of photovoltaic cells are electrically connected via at least one conductive region on a first conductive layer of the at least two conductive layers and the at least two nonadjacent substrings are electrically connected via at least one conductive region on a second conductive layer of the at least two conductive layers.

Clause 70: The photovoltaic module of clause 69, wherein conductive regions on the first conductive layer comprise at least one conductive pad adapted to electrically connect adjacent photovoltaic cells, and
wherein conductive regions on the second layer comprise at least one conductive trace adapted to transmit electrical power produced by at least one substring to at least one other substring.

Clause 71: The photovoltaic module of clause 70, wherein the at least one conductive pad is electrically connected to the at least one conductive trace via holes through an at least one dielectric layer separating the first conductive layer and the second conductive layer.

Clause 72: The photovoltaic module of clause 50, wherein the plurality of conductive regions comprise:
a plurality of conductive pads,

wherein each conductive pad is configured to connect at least one photovoltaic cell to a first adjacent photovoltaic cell in parallel such that contacts of a first polarity on the at least one photovoltaic cell are electrically connected to contacts of the first polarity on the first adjacent photovoltaic cell,

wherein each conductive pad is further configured to connect the at least one photovoltaic cell to a second adjacent photovoltaic cell in serial such that electrical contacts of the first polarity on the at least one photovoltaic cell are electrically connected to contacts of a second polarity on the second adjacent photovoltaic cell.

Clause 73: A method of producing a photovoltaic module comprising:

fabricating a conductive backsheet to form a plurality of conductive regions; and

disposing a plurality of substrings on the conductive backsheet,

wherein each substring of the plurality of substrings includes:

a plurality of photovoltaic cells electrically connected to each other in series via the conductive regions of the conductive backsheet,

wherein a portion of the conductive regions electrically connect at least two spatially nonadjacent substrings in parallel.

Clause 74: A photovoltaic module comprising:

an array of photovoltaic cells arranged in rows and columns of substrings, each substring comprising a plurality of serially connected photovoltaic cells; a conductive backsheet on which the array is disposed and configured to form a plurality of conductive regions to electrically connect the photovoltaic cells of the array, the plurality of conductive regions further configured to electrically parallelly connect substrings of different rows and different columns, the plurality of conductive regions further configured to electrically parallelly connect a first substring of a first row and first column with a second substrings of a second row and second column.

Clause 75: The photovoltaic module of clause 74, wherein the plurality of photovoltaic cells comprise rear contact photovoltaic cells comprising contacts of a positive polarity and contacts of a negative polarity disposed on a rear side thereof.

Clause 76: The photovoltaic module of clauses 74 or 75, wherein the plurality of photovoltaic cells comprise at least one of:

metal wrap through photovoltaic cells; interdigitated back contact photovoltaic cells; or emitter wrap-through photovoltaic cells.

Clause 77: The photovoltaic module of any of clauses 74-76, wherein at least one of the plurality of photovoltaic cells comprise 1/N cut photovoltaic cells, wherein N is an integer.

Clause 78: The photovoltaic module of any of clauses 74-77, wherein the plurality of substrings comprise:

a first substring, wherein each of the plurality of photovoltaic cells of the first substring have a first surface area; and a second substring, wherein each of the plurality of photovoltaic cells of the second substring have a second surface area equal to 1/N of the first surface area, where N is an integer greater than one.

Clause 79: The photovoltaic module of any of clauses 74-78, further comprising: electronics, wherein at least one of the plurality of conductive regions electrically connects the electronics with at least one substring.

Clause 80: The photovoltaic module of any of clauses 74-79, further comprising: a junction box, wherein at least two conductive regions are electrically connected to each other in the junction box.

Clause 81: The photovoltaic module of any of clauses 74-80, wherein the at least one region of the plurality of conductive regions that electrically connects the plurality of photovoltaic cells is configured such that electrical contacts of one polarity of a photovoltaic cell are electrically connected to electrical contacts of an opposite polarity of an adjacent photovoltaic cell.

Clause 82: The photovoltaic module of clauses 74-81, wherein the plurality of conductive regions are formed from at least one of:

patterns cut into the conductive backsheet; patterns etched into the conductive backsheet; or patterns of conductive material deposited on a substrate.

Clause 83: The photovoltaic module of any of clauses 74-82, wherein the conductive backsheet comprises a conductive backsheet having multiple thicknesses.

Clause 84: The photovoltaic module of any of clauses 74-83, wherein the plurality of conductive regions comprises:

at least one conductive pad configured to electrically connect adjacent photovoltaic cells; and at least one conductive trace configured to electrically connect at least two substrings.

Clause 85: The photovoltaic module of clause 84, wherein the at least one conductive trace is thicker than the at least one conductive pad.

Clause 86: The photovoltaic module of any of clauses 74-85, wherein the plurality of conductive regions comprise:

a plurality of conductive pads, each conductive pad configured to serially connect two adjacent photovoltaic cells; and a plurality of conductive traces, each conductive trace configured to connect a plurality of substrings.

Clause 87: The photovoltaic module of clause 86, further comprising a junction box, wherein at least two conductive traces are electrically connected to each other in the junction box.

Clause 88: The photovoltaic module of any of clauses 74-87, wherein the conductive backsheet comprises:
a multilayer backsheet comprising:

> at least one conductive layer; and
> at least one dielectric layer.

Clause 89: The photovoltaic module of clause 88, wherein the at least one conductive layer comprises:
at least two conductive layers,
wherein the at least one dielectric layer separates the at least two conductive layers.

Clause 90: The photovoltaic module of clause 89, wherein the plurality of photovoltaic cells of each substring are electrically serially connected via a plurality of conductive regions on a first conductive layer of the at least two conductive layers and at least two substrings are electrically connected via at least one conductive region on a second conductive layer of the at least two conductive layers.

Clause 91: The photovoltaic module of clause 90, wherein conductive regions on the first conductive layer comprise conductive pads to electrically connect adjacent photovoltaic cells, and
wherein conductive regions on the second layer comprise conductive traces adapted to transmit electrical power produced by one substring to at least one other substring.

Clause 92: The photovoltaic module of clause 91, wherein the at least one conductive pad is electrically connected to the at least one conductive trace via holes through an at least one dielectric layer separating the first conductive layer and the second conductive layer.

Clause 93: The photovoltaic module of any of clauses 71-92, wherein the plurality of conductive regions comprise:
a plurality of conductive pads,

> wherein each conductive pad is configured to connect at least one photovoltaic cell to a first adjacent photovoltaic cell in parallel such that contacts of a first polarity of the at least one photovoltaic cell are electrically connected to contacts of the first polarity of the first adjacent photovoltaic cell,
> wherein each conductive pad is further configured to connect the at least one photovoltaic cell to a second adjacent photovoltaic cell in serial such that electrical contacts of the first polarity on the at least one photovoltaic cell are electrically connected to contacts of a second polarity on the second adjacent photovoltaic cell.

Clause 94: An apparatus comprising:
a power device configured to affect power produced by a photovoltaic module, the power device comprising:

> a first input terminal;
> a second input terminal;
> a first output terminal;

a second output terminal; and
only two detachable connectors.

Clause 95: The apparatus of clauses 94, further comprising:

> a junction box mechanically configured to be mounted to a photovoltaic module comprising a first contact and a second contact;
> a first input conductor coupled to the first input terminal and the first contact;
> a second input conductor coupled to the second input terminal and the second contact;
> a first output conductor coupled to the first output terminal and a first detachable connector; and
> a second output conductor coupled to the second output terminal and a second detachable connector.

Clause 96: The apparatus of clause 95, wherein the first input conductor is coupled to the first input terminal and first contact, and wherein the second input conductor is coupled to the second input terminal and second contact, by being at least one of:

> soldered;
> screwed; or
> crimped.

Clause 97: The apparatus of clauses 95 or 96, wherein the first output conductor is coupled to the first output terminal, and wherein the second output conductor is coupled to the second output terminal by being at least one of:

> soldered;
>
> screwed; or
>
> crimped.

Clause 98: The apparatus of any of clauses 95-97, wherein the first input conductor and the second input conductor are at least 2 inches in length.

Clause 99: A photovoltaic module comprising:
a photovoltaic array comprising a plurality of substrings comprising serially connected photovoltaic cells, the plurality of substrings disposed in a grid of rows and columns, the photovoltaic array further comprising:

> a plurality of groups of substrings, each group of substrings comprising a plurality of electrically parallelly connected substrings,
> wherein the groups of substrings are electrically serially connected to each other, and
> wherein substrings of a same group are disposed in different columns.

Clause 99a: The photovoltaic module of clause 99, comprising a midpoint cross-tie common to at least two groups of substrings.

Clause 100: A photovoltaic module comprising: a photovoltaic array comprising a plurality of substrings comprising serially connected photovoltaic cells, the plurality of substrings disposed in a grid of rows and columns, the photovoltaic array further comprising:

a plurality of groups of substrings, each group of substrings comprising a plurality of electrically parallelly connected substrings,
wherein the groups of substrings are electrically serially connected to each other, and
wherein substrings of a same group are disposed in different rows.

Clause 101: A photovoltaic module comprising:

a photovoltaic cell array comprising a plurality of strings, each string comprising a plurality of serially connected substrings disposed in rows and columns, each substring comprising a plurality of serially connected photovoltaic cells,
wherein each substring is electrically parallelly connected to one other substring of each string, and
wherein electrically parallelly connected substrings are disposed in different rows and different columns.

Clause 102: A photovoltaic module comprising: a photovoltaic cell array comprising a plurality of substrings of serially connected photovoltaic cells, the substrings disposed in rows and columns, the photovoltaic cell array further comprising:

a first string comprising a first plurality of serially connected substrings; and
a second string comprising a second plurality of serially connected substrings, each of the first plurality of substrings being parallelly connected to one of the second plurality of substrings,
wherein parallelly connected substrings are disposed in different rows and different columns.

Clause 103: The photovoltaic module of any of clauses 99-102, wherein the photovoltaic (cell) array comprises a same quantity of rows as columns.

Clause 104: The photovoltaic module of clause 103, wherein the photovoltaic (cell) array comprises at least one of:

2 rows and 2 columns;
3 rows and 3 columns; or
4 rows and 4 columns.

Clause 105: The photovoltaic module of any of clauses 99-102, wherein the photovoltaic cell array comprises a first quantity of rows and a second quantity of columns wherein the first quantity is different than the second quantity.

Clause 106: The photovoltaic module of clause 105, wherein the photovoltaic array comprises at least one of: 3 rows and 2 columns; 2 rows and 5 columns; or 2 rows and 6 columns.

Clause 107: The photovoltaic module of any of clauses 99-106, wherein the photovoltaic cells of each substring are further electrically totally cross-tied with photovoltaic cells of a parallel-connected substring.

Clause 108: A photovoltaic module comprising: a plurality of substrings disposed in a grid/array of rows and columns, the plurality of substrings electrically connected in total cross-tie,
wherein parallelly connected substrings are disposed in different rows and different columns.

Clause 109: The photovoltaic module of any of clauses 99-108, further comprising:

a conductive backsheet comprising a plurality of conductive regions,
wherein the photovoltaic array is electrically connected via the conductive backsheet.

Clause 110: The photovoltaic module of any of clauses 99-108, further comprising:

a backsheet,
wherein the backsheet comprises a roof tile.

Clause 111: The photovoltaic module of any of clauses 99-110, wherein the photovoltaic cells of each substring are further electrically connected in series-parallel.

Clause 112: The photovoltaic module of any of clauses 99-111, wherein a first substring of a first column terminates in a first polarity at a first end of the first column, and wherein a second substring of the first column terminates in a second polarity at the first end of the first column.

Clause 113: The photovoltaic module of any of clauses 99-112, wherein a first substring of a first row terminates in a first polarity proximate a photovoltaic cell array midline, and wherein a second substring of the first row terminates in a second polarity proximate the photovoltaic cell array midline.

Clause 114: A photovoltaic module comprising: a photovoltaic array comprising a plurality of substrings of serially connected photovoltaic cells, the substrings disposed in a grid of rows and columns, the photovoltaic array further comprising:

a plurality of groups of substrings, each group comprising a plurality of electrically parallelly connected substrings,
wherein the plurality of groups of substrings are electrically serially connected to each other, and
wherein first portions of each group are disposed in a first row, and second portions of each group are disposed in a second row.

Clause 115: The photovoltaic module of clause 114, wherein a quantity of substrings of the first portions is equivalent to a quantity of substrings of the second portions.

Clause 116: The photovoltaic module of clause 114, wherein a quantity of substrings of the first portions is different than a quantity of substrings of the second portions.

Clause 117: The photovoltaic module of any of clauses 114-116, wherein the photovoltaic array further comprises two rows of substrings, wherein a first row substantially comprises a first half of the photovoltaic array and wherein a second row substantially comprises a second half of the photovoltaic array.

Clause 118: The photovoltaic module of any of clauses 114-117, wherein each group of substrings comprises an even number of substrings, and wherein a first quantity of substrings of each of the first portions is equivalent to a second quantity of substrings of each of the second portions.

Clause 119: The photovoltaic module of any of clauses 114-117, wherein each group of substrings comprises an even number of substrings, wherein a first quantity of substrings of each of the first portions is different than a second quantity of substrings of each of the second portions.

Clause 120: The photovoltaic module of any of clauses 114-117, wherein each group of substrings comprises an odd number of substrings, wherein a first quantity of substrings of each of the first portions is different than a second quantity of substrings of each of the second portions.

Clause 121: The photovoltaic module of any of clauses 114-120, wherein a first portion of a first group and a first portion of a second group are disposed in the first row, and wherein the substrings of the first portion of the first group are arranged to terminate in a first polarity proximate to a photovoltaic array midline, and the substrings of the first portion of the second group are arranged to terminate in a second polarity proximate to the photovoltaic array midline.

Clause 122: A photovoltaic module comprising: a photovoltaic array comprising a plurality of substrings of serially connected photovoltaic cells, the substrings disposed in a grid of rows and columns, the photovoltaic array further comprising:

a plurality of groups of substrings, each group comprising a plurality of electrically parallelly connected substrings, wherein the plurality of groups of substrings are electrically serially connected to each other, and wherein a first portion of the parallelly connected substrings are disposed in a first row, and a second portion of the parallelly connected substrings are disposed in a second row.

Clause 123: The photovoltaic module of any of clauses 114-122, wherein all photovoltaic cells of each group are electrically totally cross-tied to each other.

Clause 124: A photovoltaic module comprising:

a plurality of substrings disposed in a grid/array of rows and columns, the plurality of substrings electrically connected in total cross-tie, wherein a portion of parallelly connected substrings are disposed in different rows and different columns.

Clause 125: A photovoltaic module comprising:

a plurality of substrings disposed in a grid of rows and columns, the plurality of substrings electrically connected in total cross-tie, wherein serially connected substrings are disposed in different columns of the same row.

Clause 126: The photovoltaic module of any of clauses 114-126, further comprising a conductive backsheet comprising conductive regions, the photovoltaic array electrically connected via the conductive backsheet.

Clause 127: A photovoltaic module comprising: a photovoltaic cell array comprising a plurality of photovoltaic cells, wherein all of the plurality of photovoltaic cells are electrically totally cross-tied.

Clause 128: A system comprising:

a plurality of photovoltaic modules, each photovoltaic module having an independent photovoltaic module output, each photovoltaic module comprising:

a plurality of substrings disposed in a grid of rows and columns, the plurality of substrings electrically connected in total cross-tie, wherein parallelly connected substrings are disposed in different rows and different columns;

a plurality of power devices each having a power device output, an input of each power device independently connected to one independent photovoltaic module output, wherein the power device outputs are connected in series.

Clause 129: A system comprising:

a plurality of photovoltaic modules, each photovoltaic module having an independent photovoltaic module output, each photovoltaic module comprising:

a plurality of substrings disposed in a grid of rows and columns, the plurality of substrings electrically connected in total cross-tie, wherein parallelly connected substrings are disposed in different rows and different columns;

a plurality of power devices each having a power device output, an input of each power device independently connected to one independent photovoltaic module output,
wherein the power device outputs are connected in parallel.

## Claims

1. An apparatus comprising:

   a power device comprising an input terminal and an output terminal;
   a junction box comprising:

   a conductive contact; and
   a junction box housing mechanically configured to be mounted to a surface of a photovoltaic module;

   an input conductor integrally coupled to the conductive contact, extending from the junction box housing, and integrally coupled to the input terminal; and
   an output conductor coupled between the output terminal and an output connector.

2. The apparatus of claim 1, wherein the junction box housing comprises an opening configured to receive a photovoltaic cell conductor coupled to at least a portion of photovoltaic cells of the photovoltaic module.

3. The apparatus of claims 1 or 2, further comprising: the photovoltaic module, wherein at least a portion of photovoltaic cells of the photovoltaic module are connected to the conductive contact of the junction box.

4. The apparatus of any preceding claim, wherein the input conductor is integrally coupled to the conductive contact by being at least one of:

   soldered to the conductive contact;
   screwed to the conductive contact; or
   crimped to the conductive contact.

5. The apparatus of any preceding claim, wherein the input conductor is integrally coupled to the input terminal by at least on of:

   soldered to the input terminal;
   screwed to the input terminal; or
   crimped to the input terminal.

6. The apparatus of any preceding claim, wherein the output conductor is integrally coupled the output terminal.

7. The apparatus of any preceding claim, wherein the input conductor is made of a first type of metal and the output conductor is made of a second type of metal that is different from the first type of metal.

8. The apparatus of claim 7, wherein the input conductor is made of copper and the output conductor is made of aluminum.

9. The apparatus of any preceding claim 1, wherein the input conductor is of sufficient length to cut the input conductor and connect a replacement power device to a remaining portion of the input conductor that remains coupled to the conductive contact.

10. The apparatus of any preceding claim, wherein the input conductor is at least 1.5 inches in length.

11. The apparatus of any preceding claim, wherein the input conductor is at least 2 inches in length.

12. The apparatus of any preceding claim, wherein the power device is mechanically configured to be mounted to a surface of the photovoltaic module.

13. The apparatus of any preceding claim, wherein the power device is mechanically configured to be mounted to a frame of the photovoltaic module.

14. The apparatus of any preceding claim, wherein the power device comprises:

    an openable cartridge body; and
    removeable power device electronics,
    wherein, the removeable power device electronics may be removed and replaced in the openable cartridge body.

15. The apparatus of any preceding claim, wherein the junction box housing is mechanically configured to be mounted on a non-conductive surface of the photovoltaic module.

*FIG. 1A*

*FIG. 1B*

*FIG. 2A*

*FIG. 2B*

EP 4 199 347 A1

**FIG. 3A**

**FIG. 3B**

EP 4 199 347 A1

**FIG. 3C**

**FIG. 3D**

EP 4 199 347 A1

*FIG. 3E*

*FIG. 3F*

EP 4 199 347 A1

**FIG. 3G**

**FIG. 3H**

*FIG. 3I*

**FIG. 3J**

**FIG. 3K**

EP 4 199 347 A1

*FIG. 3L*

*FIG. 3M*

*FIG. 4A*

*FIG. 4B*

*FIG. 5A*

*FIG. 5B*

**FIG. 6A**

**FIG. 6B**

FIG. 7A

**FIG. 7B**

**FIG. 8**

**FIG. 9A**

**FIG. 9B**

FIG. 9C

FIG. 9D

| 1002G | 1002D | 1002A |
|-------|-------|-------|
| 1002H | 1002E |  |
|  |  |  |
| 1002B |  |  |
| 1002I | 1002F | 1002C |

*FIG. 10B*

1010A

+

| 1002G | 1002H | 1002I |
|-------|-------|-------|
| 1002D | 1002E | 1002F |
| 1002A | 1002B | 1002C |

−

1010A

1040D

1040C

1040B

1040A

*FIG. 10A*

1010B

| 1002M | 1002I | 1002E | 1002A |
|-------|-------|-------|-------|
| 1002F | 1002B | 1002O | 1002J |
| 1002K | 1002N | 1002D | 1002G |
| 1002C | 1002H | 1002L | 1002P |

*FIG. 11B*

1010B

+

| 1002M | 1002N | 1002O | 1002P |
|-------|-------|-------|-------|
| 1002I | 1002J | 1002K | 1002L |
| 1002E | 1002F | 1002G | 1002H |
| 1002A | 1002B | 1002C | 1002D |

−

*FIG. 11A*

1010C

1002E

1002C

1002A

1002B

1002F

1002D

*FIG. 11D*

1010C

1140D

1140C

1140B

1140A

1002F

1002D

1002B

1002E

1002C

1002A

+

−

*FIG. 11C*

901C

1002B    1002E

1140B
1140A    1140D    1140C

1002F    1002C

1140C    1140C
1140D    1140B

942

1140B

1140B    1140A
1140C

1002D    1002A

904
904
904
904

*FIG. 11E*

*FIG. 11G*

*FIG. 11F*

*FIG. 11I*

*FIG. 11H*

FIG. 11J

**FIG. 11K**

**FIG. 11L**

**FIG. 11M**

FIG. 11O

FIG. 11N

*FIG. 12B*

*FIG. 12A*

FIG. 13A

FIG. 13B

901H

1338

902B

1338

902A

## FIG. 13C

Group A

+

1402A

1402B

1402C

1402D

Group B

−

*FIG. 14A*

1402A | 1402D

1402C | 1402B

*FIG. 14B*

*FIG. 15*

*FIG. 16*

*FIG. 17*

1801

1836

1802D

1802B

1814A
1816A
1842

JB

1814B
1816B

1802A

1802C

FIG. 18

FIG. 19A

*FIG. 19B*

EP 4 199 347 A1

*FIG. 19C*

FIG. 19D

Array Column 1                    Array Column 2                    Array Column 3

| JB1 | | JB2 | | JB1 | | JB2 | | JB1 | | JB2 |

| JB1 | | JB2 | | JB1 | | JB2 | | JB1 | | JB2 |

| JB1 | | JB2 | | JB1 | | JB2 | | JB1 | | JB2 |

| JB1 | | JB2 | | JB1 | | JB2 | | JB1 | | JB2 |

1900D                    1900D                    1900D

EP 4 199 347 A1

*FIG. 19E*

*FIG. 20A*

**FIG. 20B**

**FIG. 20C**

**FIG. 21A**

**FIG. 21B**

FIG. 22A

**FIG. 22B**

EP 4 199 347 A1

*FIG. 22C*

EP 4 199 347 A1

*FIG. 23A*

FIG. 23B

FIG. 23C

FIG. 24A

FIG. 24B

FIG. 24C

FIG. 25

*FIG. 26*

**FIG. 27A**

**FIG. 27B**

**FIG. 28**

**FIG. 29A**

**FIG. 29B**

EP 4 199 347 A1

FIG. 30B

3000B

JB

PD
3002B

3012

3030B

FIG. 30A

3000A

JB

PD
3002A

3018

3020

3030A

**FIG. 31A**

*FIG. 31B*

**FIG. 32**

FIG. 33B

3406

3402
3400

3404

FIG. 33A

3402
3400

3404

FIG. 33D

3302
3300B

3306A 3306B

3304
3300A

FIG. 33C

3302
3300B

3306A 3306B

3302
3300A

*FIG. 34A*

**FIG. 34B**

EP 4 199 347 A1

Europäisches
Patentamt

European
Patent Office

Office européen
des brevets

## EUROPEAN SEARCH REPORT

**Application Number**

**EP 22 21 4740**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/061705 A1 (CROFT STEVEN [US] ET AL) 17 March 2011 (2011-03-17) * paragraphs [0027] - [0037]; figures 1-5 * | 1-15 | INV. H02S40/34 |
| X | US 2012/033392 A1 (GOLUBOVIC BORIS [US] ET AL) 9 February 2012 (2012-02-09) * paragraphs [0033] - [0041], [0061] - [0063]; figures 1-11 * | 1-15 | |
| A | US 2018/102735 A1 (NAM HYUKJIN [KR]) 12 April 2018 (2018-04-12) * paragraphs [0038] - [0129]; figures 1-9 * | 1-15 | |

TECHNICAL FIELDS
SEARCHED     (IPC)

H02S

The present search report has been drawn up for all claims

| Place of search | Date of completion of the search | Examiner |
|---|---|---|
| Berlin | 20 March 2023 | Stirn, Jean-Pierre |

EPO FORM 1503 03.82 (P04C01)

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
 
& : member of the same patent family, corresponding
    document

## ANNEX TO THE EUROPEAN SEARCH REPORT
## ON EUROPEAN PATENT APPLICATION NO.

EP 22 21 4740

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2023

| Patent document cited in search report | | Publication date | Patent family member(s) | | Publication date |
|---|---|---|---|---|---|
| US 2011061705 | A1 | 17-03-2011 | NONE | | |
| US 2012033392 | A1 | 09-02-2012 | TW | 201230574 A | 16-07-2012 |
| | | | US | 2012033392 A1 | 09-02-2012 |
| | | | WO | 2012021266 A2 | 16-02-2012 |
| US 2018102735 | A1 | 12-04-2018 | CN | 107919851 A | 17-04-2018 |
| | | | EP | 3309958 A1 | 18-04-2018 |
| | | | JP | 7182757 B2 | 05-12-2022 |
| | | | JP | 2018064449 A | 19-04-2018 |
| | | | KR | 20180040000 A | 19-04-2018 |
| | | | US | 2018102735 A1 | 12-04-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63423182
- US 63300847
- US 63290767
- US 63290983